# EUROPEAN PATENT SPECIFICATION

(11) **EP 2 940 097 B1**
(45) Date of publication and mention of the grant of the patent: **20.03.2019**
(21) Application number: 13868888.2
(22) Date of filing: 23.07.2013
(51) Int. Cl.: C09K 11/06, H01L 51/54

(54) **ORGANIC OPTOELECTRONIC DEVICE, AND DISPLAY DEVICE INCLUDING SAME**
ORGANISCHE OPTOELEKTRONISCHE VORRICHTUNG UND ANZEIGEVORRICHTUNG DAMIT
DISPOSITIF ORGANIQUE OPTOÉLECTRONIQUE ET DISPOSITIF D'AFFICHAGE L'INCLUANT

(30) Priority: 31.12.2012 KR 20120158654
(43) Date of publication of application: 04.11.2015
(60) Divisional application: 17155734.1
(73) Proprietor: Cheil Industries Inc., Gumi-si, Gyeongsangbuk-do 730-030 (KR)
(72) Inventor: RYU, Dong-Wan, Uiwang-si Gyeonggi-do 437-711 (KR); JUNG, Sung-Hyun, Uiwang-si Gyeonggi-do 437-711 (KR); HUH, Dal-Ho, Uiwang-si Gyeonggi-do 437-711 (KR); HONG, Jin-Seok, Uiwang-si Gyeonggi-do 437-711 (KR); KIM, Youn-Hwan, Uiwang-si Gyeonggi-do 437-711 (KR); KIM, Jun-Seok, Uiwang-si Gyeonggi-do 437-711 (KR); RYU, Dong-Kyu, Uiwang-si Gyeonggi-do 437-711 (KR); LEE, Nam-Heon, Uiwang-si Gyeonggi-do 437-711 (KR); LEE, Han-Ill, Uiwang-si Gyeonggi-do 437-711 (KR); JANG, Yu-Na, Uiwang-si Gyeonggi-do 437-711 (KR); JO, Young-Kyoung, Uiwang-si Gyeonggi-do 437-711 (KR); CHAE, Mi-Young, Uiwang-si Gyeonggi-do 437-711 (KR)
(74) Representative: Michalski Hüttermann & Partner Patentanwälte mbB
(86) International application number: PCT/KR2013/006587
(87) International publication number: WO 2014/104514

(56) References cited:
- EP-A1- 2 399 906
- EP-A2- 2 450 975
- EP-A2- 2 629 346
- WO-A1-2007/145129
- WO-A1-2011/125020
- KR-A- 20100 003 624
- KR-A- 20110 117 548
- US-A1- 2008 124 572
- US-A1- 2011 031 482
- US-A1- 2011 272 684
- US-A1- 2012 074 395

## Description

### [Technical Field]

An organic optoelectronic device and a display device including the same are disclosed.

### [Background Art]

An organic optoelectronic device is a device requiring a charge exchange between an electrode and an organic material by using holes or electrons.

An organic optoelectronic device may be classified as follows in accordance with its driving principles. A first organic optoelectronic device is an electronic device driven as follows: excitons are generated in an organic material layer by photons from an external light source; the excitons are separated into electrons and holes; and the electrons and holes are transferred to different electrodes as a current source (voltage source).

A second organic optoelectronic device is an electronic device driven as follows: a voltage or a current is applied to at least two electrodes to inject holes and/or electrons into an organic material semiconductor positioned at an interface of the electrodes, and the device is driven by the injected electrons and holes.

An organic light emitting diode (OLED) that is a representative of organic optoelectronic device has recently drawn attention due to an increase in demand for flat panel displays. In general, organic light emission refers to conversion of electrical energy into photo-energy using an organic material.

Such an organic light emitting diode converts electrical energy into light by applying current to an organic light emitting material. It has a structure in which a functional organic material layer is interposed between an anode and a cathode. The organic material layer may include a multi-layer including different materials, for example a hole injection layer, a hole transport layer, an emission layer, an electron transport layer, and an electron injection layer, in order to improve efficiency and stability of an organic light emitting diode.

In such an organic light emitting diode, when a voltage is applied between an anode and a cathode, holes from the anode and electrons from the cathode are injected to an organic material layer and recombined to generate excitons having high energy. The generated excitons generate light having certain wavelengths while shifting to a ground energy state.

The light emitting material may be classified as blue, green, and red light emitting materials according to emitted colors, and yellow and orange light emitting materials to emit colors approaching natural colors.

When one material is used as a light emitting material, a maximum light emitting wavelength is shifted to a long wavelength or color purity decreases because of interactions between molecules, or device efficiency decreases because of a light emitting quenching effect. Therefore, a host/dopant system is included as a light emitting material in order to improve color purity and increase luminous efficiency and stability through energy transfer.

In order to implement excellent performance of an organic light emitting diode, a material constituting an organic material layer, for example a hole injection material, a hole transport material, a light emitting material, an electron transport material, an electron injection material, and a light emitting material such as a host and/or a dopant, should be stable and have good efficiency. However, development of an organic material layer forming material for an organic light emitting diode has thus far not been satisfactory and thus there is a need for a novel material. This material development is also required for other organic optoelectronic devices.

Optoelectronic devices are inter alia known from the KR 2011 0117548, US 2008/124572 and US 2012/074395.

EP 2 629 346 A2 discloses an organic light-emitting device including a first electrode, a second electrode opposite to the first electrode, a phosphorescent layer disposed between the first electrode and the second electrode, an electron transport layer disposed between the phosphorescent emission layer and the second electrode, and an electron control layer disposed between the phosphorescent emission layer and the electron transport layer. An organic light-emitting display apparatus including the OLED is also disclosed.

EP 2 399 906 A1 provides an organic electroluminescence device and an aromatic amine derivative that realizes the device.

### [Disclosure]

### [Technical Problem]

A compound for an organic optoelectronic device that may act as light emitting, or hole injection and transport material, and also act as a light emitting host along with an appropriate dopant is provided.

In addition, the compound for an organic optoelectronic device is appropriately combined in a hole layer to provide an organic optoelectronic device having excellent characteristics.

### [Technical Solution]

In one embodiment of the present invention, an organic optoelectronic device includes an anode, a cathode and at least one organic thin layer interposed between the anode and the cathode, wherein the organic thin layer includes an emission layer and a plurality of hole transport layers, the hole transport layer contacting the emission layer among the plurality of hole transport layers includes a compound represented by a combination of the following Chemical Formula 1; Chemical Formula 2 or 3; and Chemical Formula 4, and one of the hole transport layers not contacting the emission layer includes a compound represented by the following Chemical Formula B-1.

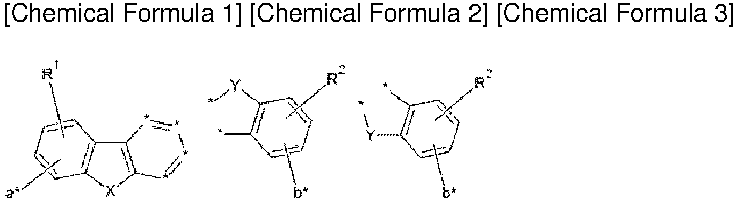

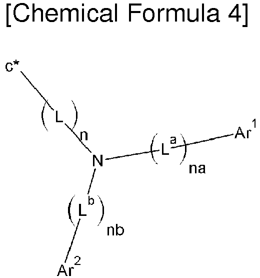

In Chemical Formulae 1 to 4,
X is O, S, N(-d*), SO₂(O=S=O), PO(P=O), or CO(C=O),
Y is O, S, SO₂(O=S=O), PO(P=O), CR'R" or NR', wherein R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L, L^{a} and L^{b} are independently, a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof,
n, na and nb are independently integers of 0 to 3,
the two adjacent two *'s of Chemical Formula 1 are bound to the two adjacent *'s of Chemical Formula 2 or 3 to provide a fused ring, and
a* of Chemical Formula 1, d* of Chemical Formula 1 or b* of Chemical Formula 2 or 3 is linked to c* of Chemical Formula 4 by a sigma bond, and the remaining a*; d* or b* that is not bound to c* is hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group or a combination thereof. 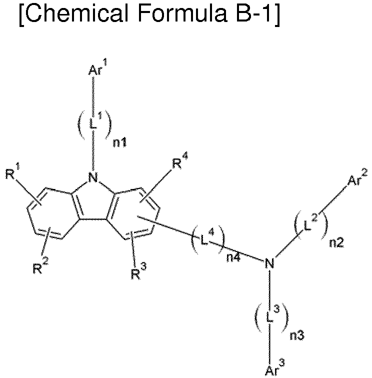
In Chemical Formula B-1,
R¹ to R⁴ are independently, hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof,
R¹ and R² are independently present or bound toeach other to provide a fused ring,
R³ and R⁴ are independently present or bound to each other to provide a fused ring,
Ar¹ to Ar³ are independently a substituted or unsubstituted C6 to C30 aryl group or a substituted or unsubstituted C2 to C30 heteroaryl group,
L¹ to L⁴ are independently, a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, and
n1 to n4 are independently integers of 0 to 3, except a combination, wherein one hole transport layer comprises a compound represented by the Chemical Formula Z-1 of claim 1 and one hole transport layer comprises a compound represented by the Chemical Formula Z-2 of claim 1.

In another embodiment not forming part of the present invention, an organic optoelectronic device includes an anode, a cathode and at least one organic thin layer interposed between the anode and the cathode, wherein the organic thin layer includes an emission layer and a plurality of a hole transport layers, the hole transport layer contacting the emission layer among the plurality of hole transport layers includes a compound represented by the following Chemical Formula 11, and one of the hole transport layers not contacting the emission layer includes a compound represented by the following Chemical Formula B-1.

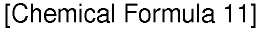

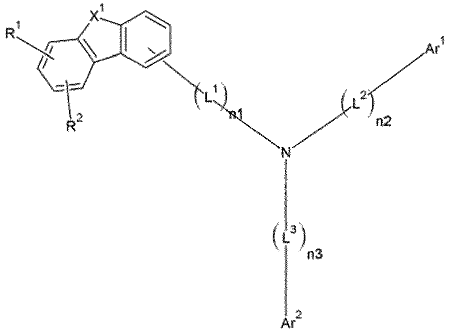

In Chemical Formula 11, X¹ is O, S, SO₂ (O=S=O), PO (P=O), or CR'R " , wherein R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L¹ to L³ is independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n1 to n3 are independently integers of 0 to 3.

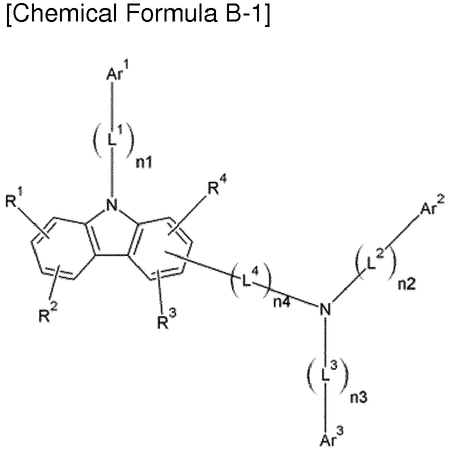

In Chemical Formula B-1, R¹ to R⁴, Ar¹ to Ar³, L¹ to L⁴ and n1 to n4 are the same as described above.

In yet another embodiment of the present invention, a display device including the organic light emitting diode according to the embodiment of the present invention is provided.

### [Advantageous Effect]

The compound for an organic optoelectronic device acts as a light emitting, or hole injection and transport material, and acts as a light emitting host with an appropriate dopant. In addition, the compound for an organic optoelectronic device is appropriately combined in a hole layer to provide an organic optoelectronic device having excellent characteristics.

### [Description of Drawings]

FIGS. 1 to 5 are cross-sectional views showing organic light emitting diodes according to various embodiments of the present invention using a compound for an organic optoelectronic device according to one embodiment of the present invention.
FIGS. 6 and 7 show ¹H-NMR results for C-5 of Example 15 and A-23 of Example 31.
FIG. 8 shows PL wavelength measurement results of Example 15 and 31.

### [Best Mode]

Hereinafter, embodiments of the present invention are described in detail. However, these embodiments are exemplary, and do not limit the present invention, and the present invention is defined by the scope of the claims which will be described later.

In the present specification, when specific definition is not otherwise provided, "hetero" refers to one including 1 to 3 hetero atoms selected from the group consisting of N, O, S, and P, and remaining carbons in one compound or substituent.

In the present specification, when a definition is not otherwise provided, the term "combination thereof" refers to at least two substituents bound to each other by a linker, or at least two substituents condensed to each other.

In the present specification, when a definition is not otherwise provided, "alkyl group" refers to an aliphatic hydrocarbon group.

The alkyl group may have 1 to 20 carbon atoms. The alkyl group may be a medium-sized alkyl group having 1 to 10 carbon atoms. The alkyl group may be a lower alkyl group having 1 to 6 carbon atoms.

For example, a C1 to C4 alkyl group may include 1 to 4 carbon atoms in an alkyl chain, and the alkyl chain may be selected from methyl, ethyl, propyl, isopropyl, n-butyl, iso-butyl, sec-butyl and t-butyl.

Typical alkyl group may be individually independently one or more selected from methyl, ethyl, propyl, isopropyl, butyl, isobutyl, t-butyl, pentyl, hexyl, cyclopropyl, cyclobutyl, cyclopentyl, and cyclohexyl.

The alkyl group may be a branched, linear, or cyclic alkyl group.

The "alkenyl group" refers to a substituent consisting of at least one carbon-carbon double bond of at least two carbons, and the "alkynylene group" refers to a substituent consisting of at least one carbon-carbon triple bond of at least two carbons.

The "aryl group" refers to an aryl group including a carbocyclic aryl (e.g., phenyl) having at least one ring having a covalent pi electron system. The term also refers to monocyclic or fused ring polycyclic (i.e., rings sharing adjacent pairs of carbon atoms) groups.

The term "heteroaryl" refers to an aryl group including a heterocyclic aryl (e.g., pyridine) having at least one ring having a covalent pi electron system. The term also refers to monocyclic or fused ring polycyclic (i.e., groups sharing adjacent pairs of carbon atoms) groups.

More specifically, the substituted or unsubstituted C6 to C30 aryl group and/or the substituted or unsubstituted C2 to C30 heteroaryl group may be a substituted or unsubstituted phenyl group, a substituted or unsubstituted naphthyl group, a substituted or unsubstituted anthracenyl group, a substituted or unsubstituted phenanthryl group, a substituted or unsubstituted naphthacenyl group, a substituted or unsubstituted pyrenyl group, a substituted or unsubstituted biphenylyl group, a substituted or unsubstituted p-terphenyl group, a substituted or unsubstituted m-terphenyl group, a substituted or unsubstituted chrysenyl group, a substituted or unsubstituted triphenylenyl group, a substituted or unsubstituted perylenyl group, a substituted or unsubstituted fluorene group, a substituted or unsubstituted indenyl group, a substituted or unsubstituted furanyl group, a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, a substituted or unsubstituted dibenzofuranyl group, a substituted or unsubstituted dibenzothiophenyl group, a substituted or unsubstituted carbazolyl group, or a combination thereof, but are not limited thereto.

In the present specification, when a definition is not otherwise provided, the term "substituted" refers to one substituted with a C1 to C30 alkyl group, a C1 to C10 alkylsilyl group, a C3 to C30 cycloalkyl group, a C6 to C30 aryl group, a C2 to C30 heteroaryl group, a C1 to C10 alkoxy group, a fluoro group, a C1 to C10 trifluoroalkyl group such as a trifluoromethyl group, a C12 to C30 carbazole group, a C6 to C30 arylamine group, a C6 to C30 substituted or unsubstituted aminoaryl group, or a cyano group.

In one embodiment of the present invention, an organic optoelectronic device includes an anode, a cathode and at least one organic thin layer interposed between the anode and the cathode, wherein the organic thin layer includes an emission layer, a hole transport layer, a hole injection layer, an electron transport layer, an electron injection layer, or a combination thereof, the organic thin layer includes an emission layer and a plurality of a hole transport layers, the hole transport layer contacting the emission layer among the plurality of hole transport layer includes a compound represented by a combination of the following Chemical Formula 1; Chemical Formula 2 or 3; and Chemical Formula 4, and one of the hole transport layers not contacting the emission layer includes a compound represented by the following Chemical Formula B-1.

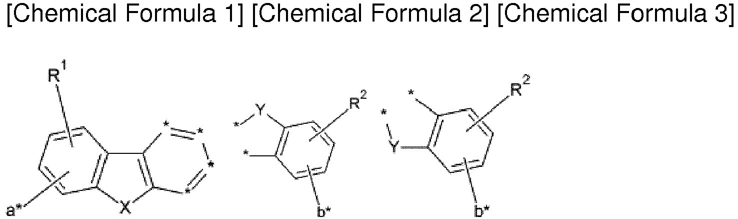

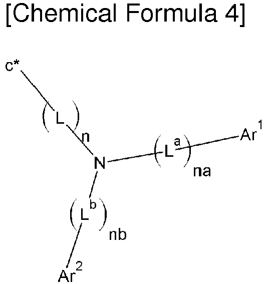

In Chemical Formulae 1 to 4,
X is O, S, N(-d*), SO₂(O=S=O), PO(P=O), or CO(C=O),
Y is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof, Ar¹ and Ar² are independently a substituted or unsubstituted C6 to C30 aryl group or a substituted or unsubstituted C2 to C30 heteroaryl group,
L, L^{a} and L^{b} are independently, a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof,
n, na and nb are independently integers of 0 to 3,
the two adjacent two *'s of Chemical Formula 1 are bound to the two adjacent *'s of Chemical Formula 2 or 3 to provide a fused ring, and a* of Chemical Formula 1, d* of Chemical Formula 1 or b* of Chemical Formula 2 or 3 is linked to c* of Chemical Formula 4 by a sigma bond, and the remaining a*; d* or b* that is not bound to c* is hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group or a combination thereof. 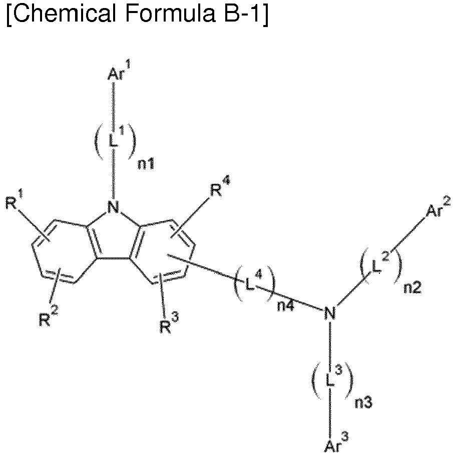
In Chemical Formula B-1,
R¹ to R⁴ are independently, hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof,
R¹ and R² are linked to each other to provide a fused ring,
R³ and R⁴ are linked to each other to provide a fused ring,
Ar¹ to Ar³ are independently a substituted or unsubstituted C6 to C30 aryl group or a substituted or unsubstituted C2 to C30 heteroaryl group,
L¹ to L⁴ are independently, a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, and
n1 to n4 are independently integers of 0 to 3, except a combination, wherein one hole transport layer comprises a compound represented by the Chemical Formula Z-1 of claim 1 and one hole transport layer comprises a compound represented by the Chemical Formula Z-2 of claim 1.

As described above, an organic optoelectronic device according to one embodiment of the present invention may include a plurality of a hole transport layers. In this case, electrons hop more smoothly to increase hole transport efficiency rather than a single hole transport layer. In addition, an organic optoelectronic device according to one embodiment of the present invention has excellent electrochemical and thermal stability and has improved life-span characteristics and high luminous efficiency at a low driving voltage.

More specifically, the hole transport layer contacting the emission layer of the plurality of hole transport layers may include the compound represented by a combination of the Chemical Formula 1; the Chemical Formula 2 or 3; and the Chemical Formula 4.

The compound represented by a combination of the Chemical Formula 1; the Chemical Formula 2 or 3; and the Chemical Formula 4 has a structure where a substituted or unsubstituted amine group is bound to a core including a fused ring bound to a carbazole derivative represented by the Chemical Formula 1.

In addition, the compound represented by a combination of the Chemical Formula 1; the Chemical Formula 2 or 3; and the Chemical Formula 4 includes the core moiety and various substituents for a substitutent for substituting the core moiety, and thereby a compound having various energy bandgaps may be synthesized, and the compound may satisfy various conditions required for a hole transport layer.

The compound may have an appropriate energy level depending on the substituents and thus, may fortify hole transport capability or electron transport capability of an organic optoelectronic device and bring about excellent effects on efficiency and driving voltage and also, have excellent electrochemical and thermal stability and thus, improve life-span characteristics during the operation of the organic optoelectronic device.

The L, L^{a} and L^{b} of the compound represented by a combination of the Chemical Formula 1; the Chemical Formula 2 or 3; and the Chemical Formula 4 and L¹ to L⁴ of the Chemical Formula B-1 may control a pi conjugation length (π-conjugation length) to enlarge a triplet energy bandgap, and thereby the compound may be usefully applied to a hole layer of an organic optoelectronic device as a phosphorescent host.

More specifically, one of the hole transport layers not contacting the emission layer may include a compound represented by the following Chemical Formula B-1.

The compound represented by the Chemical Formula B-1 is an amine-based compound where at least one substituent of amine is substituted with a carbazole group.

In the Chemical Formula B-1, R¹ and R² are linked to each other to provide a fused ring, and R³ and R⁴ are linked to each other to provide a fused ring. For example, R¹ and R² may be linked to each other to be an aryl fused with a phenyl ring of core carbazole, and R³ and R⁴ may be linked to each other to be an aryl fused with a phenyl ring of core carbazole. Therefore, when they are fused in these ways, the phenyl group of the core carbazole may be a naphthyl group. In this case, thermal stability may be increased, and electron transport and injection characteristics are increased.

In one embodiment of the present invention, Ar¹ of the Chemical Formula B-1 may be a substituted or unsubstituted phenyl group, substituted or unsubstituted biphenyl group, and Ar² and Ar³ are independently one of a substituted or unsubstituted phenyl group, a substituted or unsubstituted biphenyl group, a substituted or unsubstituted fluorene group, a substituted or unsubstituted bisfluorene group, a substituted or unsubstituted triphenylene group, a substituted or unsubstituted anthracene group, a substituted or unsubstituted terphenyl group, a substituted or unsubstituted dibenzofuran group, and a substituted or unsubstituted dibenzothiophenyl group.

More specifically, in an organic optoelectronic device according to one embodiment of the present invention, the compound represented by a combination of the Chemical Formula 1; the Chemical Formula 2 or 3; and the Chemical Formula 4 and the compound represented by the Chemical Formula B-1 may be combined to form a plurality of a hole transport layer, an energy level of the hole transport layer may be optimized for electron hopping to provide excellent electrochemical and thermal stability. Therefore, the organic optoelectronic device may have improved life-span characteristics, and high luminous efficiency at a low driving voltage.

More specifically, the compound represented by a combination of the Chemical Formula 1; the Chemical Formula 2 or 3; and the Chemical Formula 4 may be represented by a combination of the following Chemical Formula 5 and the Chemical Formula 4.

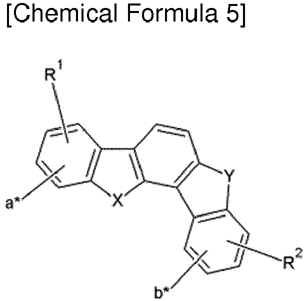

In Chemical Formula 5,
X is O, S, N(-d*), SO₂(O=S=O), PO(P=O), or CO (C=O),
Y is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
a* of Chemical Formula 5; d* of Chemical Formula 5; or b* of Chemical Formula 5 ; is linked to c* of Chemical Formula 4 by a sigma bond, and the remaining a*; d* or b* that is not bound to c* is hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group or a combination thereof.

In addition, the compound including the appropriately combined substituents may have excellent thermal stability or resistance against oxidation

As described above, when one of R¹ and R² substituents is the above substituent not hydrogen, electrical or optical properties, and thin film characteristics may be minutely controlled to optimize performance as a material for an organic photoelectric device while maintaining basic characteristics of a compound without the substituents.

In case of the structure of the Chemical Formula 5, the compound has advantages in terms of synthesis, and the structure is linked to a main chain at a meta position to provide high triplet energy.

More specifically, the compound represented by a combination of the Chemical Formula 1; the Chemical Formula 2 or 3; and the Chemical Formula 4 may be represented by the following Chemical Formula 6.

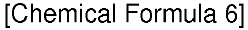

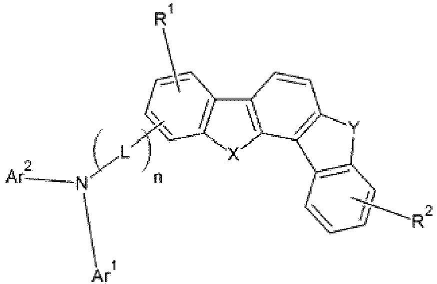

In Chemical Formula 6,
X is O, S, SO₂(O=S=O), PO(P=O), or CO(C=O),
Y is O, S, SO₂(O=S=O), PO(P=O), CR'R " or NR', and
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof, Ar¹ and Ar² are independently a substituted or unsubstituted C6 to C30 aryl group or a substituted or unsubstituted C2 to C30 heteroaryl group, L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, n is an integer of 0 to 3.

A structure having asymmetric bipolar characteristics due to an appropriate combination of the substituents may be prepared, and improves hole and/or electron transport capability and luminous efficiency and performance of a device may be improved.

In addition, the compound may be prepared to have a bulky structure and thus, lower crystalline by controlling substituents. The compound having lower crystalline may improve efficiency characteristic and life-span of a device.

More specifically, the compound represented by a combination of the Chemical Formula 1; the Chemical Formula 2 or 3; and the Chemical Formula 4 may be represented by the following Chemical Formula 7.

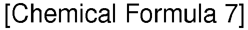

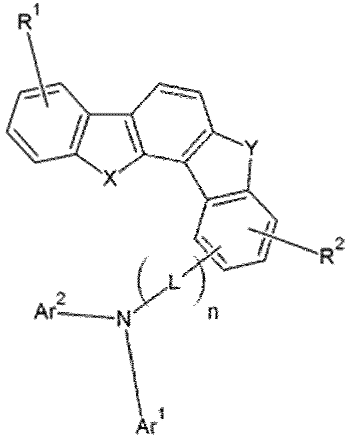

In Chemical Formula 7,
X is O, S, SO₂(O=S=O), PO(P=O), or CO(C=O),
Y is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n is an integer of 0 to 3.

A structure having asymmetric bipolar characteristics due to an appropriate combination of the substituents may be prepared, and improves hole and/or electron transport capability and luminous efficiency and performance of a device may be improved.

In addition, the compound may be prepared to have a bulky structure and thus, lower crystalline by controlling substituents. The compound having lower crystalline may improve efficiency characteristic and life-span of a device.

More specifically, the compound represented by a combination of the Chemical Formula 1; the Chemical Formula 2 or 3; and the Chemical Formula 4 may be represented by the following Chemical Formula 8.

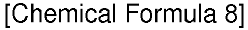

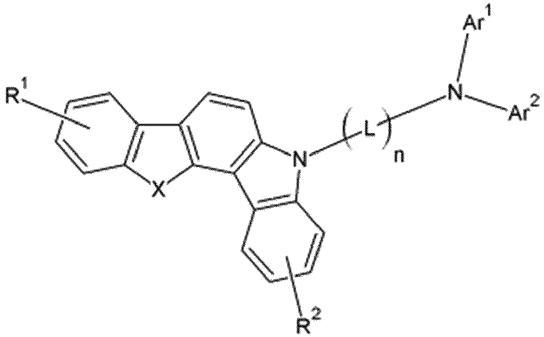

In Chemical Formula 8,
X is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof, Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n is an integer of 0 to 3.

In the case of the structure of the Chemical Formula 8, the compound has higher ionization potential energy than a conventional organic light emitting diode material having general hole characteristics and smaller ionization potential energy and relatively higher triplet energy than a phosphorescent light emitting host material or blue flourescent host material. When the compound of the Chemical Formula 8 is used in an auxiliary hole transport layer between the hole transport layer and the emission layer in a phosphorescent device and a blue device, high efficiency and long life-span characteristics of a device may be realized.

More specifically, the compound represented by a combination of the Chemical Formula 1; the Chemical Formula 2 or 3; and the Chemical Formula 4 may be represented by the following Chemical Formula 9.

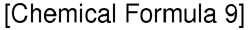

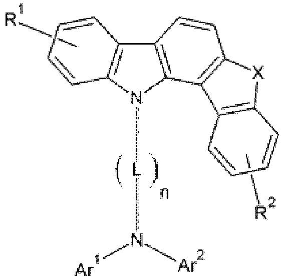

In Chemical Formula 9,
X is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof,
n is an integer of 0 to 3.

In the case of the structure of the Chemical Formula 9, the compound has higher ionization potential energy than a conventional organic light emitting diode material having general hole characteristics and smaller ionization potential energy and relatively higher triplet energy than a phosphorescent light emitting host material or blue flourescent host material. When the compound of the Chemical Formula 9 is used in an auxiliary hole transport layer between the hole transport layer and the emission layer in a phosphorescent device and a blue device, high efficiency and long life-span characteristics of a device may be realized.

More specifically, the compound represented by a combination of the Chemical Formula 1; the Chemical Formula 2 or 3; and the Chemical Formula 4 may be represented by the following Chemical Formula 10.

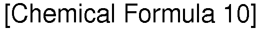

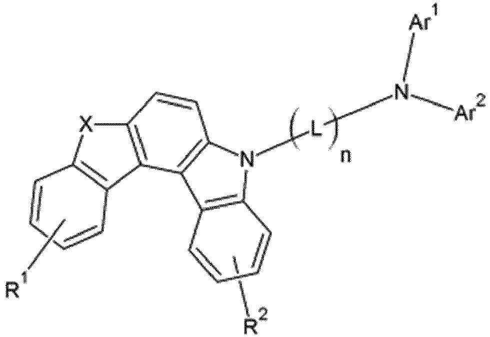

In Chemical Formula 10,
X is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n is an integer of 0 to 3.

In the case of the structure of the Chemical Formula 10, the compound has higher ionization potential energy than a conventional organic light emitting diode material having general hole characteristics and smaller ionization potential energy and relatively higher triplet energy than a phosphorescent light emitting host material or blue flourescent host material. When the compound of the Chemical Formula 10 is used in an auxiliary hole transport layer between the hole transport layer and the emission layer in a phosphorescent device and a blue device, high efficiency and long life-span characteristics of a device may be realized.

For more specific examples, the R', R " , R¹ and R² may be independently hydrogen, deuterium, a substituted or unsubstituted methyl group, a substituted or unsubstituted ethyl group, a substituted or unsubstituted propyl group, a substituted or unsubstituted phenyl group, a substituted or unsubstituted biphenyl group, a substituted or unsubstituted naphthyl group, a substituted or unsubstituted anthracenyl group, a substituted or unsubstituted phenanthrenyl group, or a substituted or unsubstituted C3 to C40 silyl group, but are not limited thereto.

The Ar¹ and Ar² are independently, a substituted or unsubstituted phenyl group, a substituted or unsubstituted biphenyl group, a substituted or unsubstituted fluorenyl group, a substituted or unsubstituted benzofuran, a substituted or unsubstituted benzothiophenyl group, a substituted or unsubstituted dibenzofuranyl group, or a substituted or unsubstituted dibenzothiophenyl group, but are not limited thereto.

In another embodiment of not forming part of the present invention, an organic optoelectronic device includes an anode, a cathode and at least one organic layer interposed between the anode and the cathode, the organic thin layer includes an emission layer, a hole transport layer, a hole injection layer, an electron transport layer, an electron injection layer, or a combination thereof, the organic thin layer includes an emission layer and a plurality of a hole transport layer, the hole transport layer contacting the emission layer of the plurality of hole transport layer includes a compound represented by the following Chemical Formula 11, and one of the hole transport layers not contacting the emission layer includes a compound represented by the following Chemical Formula B-1.

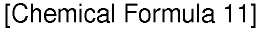

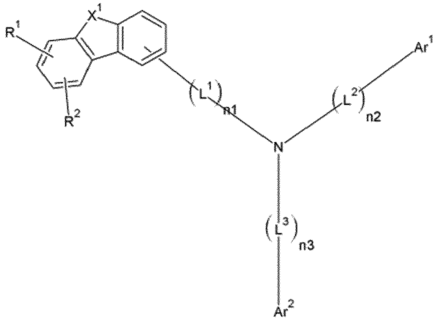

In Chemical Formula 11,
X¹ is O, S, SO₂(O=S=O), PO(P=O), or CR'R " ,
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
R¹ and R² are independently present or linked to each other to provide a fused ring,
Ar¹ and Ar² are independently a substituted or unsubstituted C6 to C30 aryl group or a substituted or unsubstituted C2 to C30 heteroaryl group,
L¹ to L³ are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n1 to n3 are independently integers of 0 to 3:

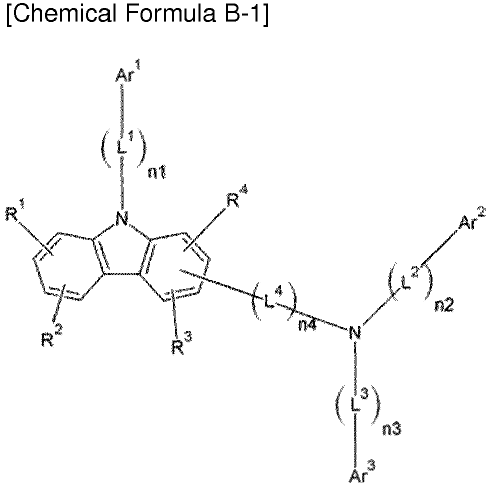

In Chemical Formula B-1,
R¹ to R⁴ are independently, hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof,
R¹ and R² may be independently present or linked to each other to provide a fused ring,
R³ and R⁴ may be independently present or linked to each other to provide a fused ring,
Ar¹ to Ar³ are independently a substituted or unsubstituted C6 to C30 aryl group or a substituted or unsubstituted C2 to C30 heteroaryl group, and
L¹ to L⁴ are independently, a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, n1 to n4 are independently integers of 0 to 3.

The descriptions for the compound represented by the Chemical Formula B-1 are the same as in one embodiment of the present invention and thus omitted herein.

When the hole transport layer contacting the emission layer of the plurality of hole transport layers includes the compound represented by the Chemical Formula 11, the compound has higher ionization potential energy than a conventional organic light emitting diode material having general hole characteristics and smaller ionization potential energy and relatively higher triplet energy than a phosphorescent light emitting host material or blue flourescent host material. When the compound is used in an auxiliary hole transport layer between the hole transport layer and the emission layer in a phosphorescent device and a blue device, high efficiency and long life-span characteristics of a device may be realized.

More specifically, the compound represented by Chemical Formula 11 may be represented by the following Chemical Formula 12.

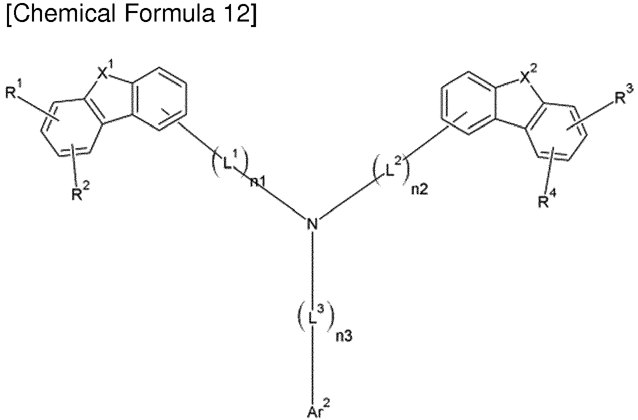

In Chemical Formula 12,
X¹ and X² are independently O, S, SO₂(O=S=O), PO(P=O), or CR'R " ,
R', R " and R¹ to R⁴ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
R¹ and R² are linked to each other to form a fused ring,
R³ and R⁴ are linked to each other to form a fused ring,
Ar² are independently a substituted or unsubstituted C6 to C30 aryl group or a substituted or unsubstituted C2 to C30 heteroaryl group,
L¹ to L³ are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n1 to n3 are independently integers of 0 to 3.

In the case of the structure of the Chemical Formula 12, the compound has higher ionization potential energy than a conventional organic light emitting diode material having general hole characteristics and smaller ionization potential energy and relatively higher triplet energy than a phosphorescent light emitting host material or blue flourescent host material. When the compound is used in an auxiliary hole transport layer between the hole transport layer and the emission layer in a phosphorescent device and a blue device, high efficiency and long life-span characteristics of a device may be realized.

More specifically, the compound represented by Chemical Formula 11 may be represented by the following Chemical Formula 13.

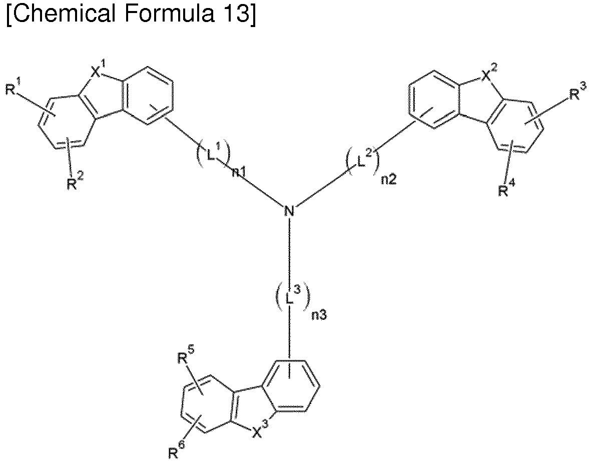

In Chemical Formula 13,
X¹ to X³ are independently O, S, SO₂(O=S=O), PO(P=O), or CR'R " ,
R', R" and R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof, R¹ and R² are linked to each other to form a fused ring,
R³ and R⁴ are linked to each other to form a fused ring,
R⁵ and R⁶ are linked to each other to form a fused ring, and
L¹ to L³ are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, n1 to n3 are independently integers of 0 to 3.

In the case of the structure of the Chemical Formula 13, the compound has higher ionization potential energy than a conventional organic light emitting diode material having general hole characteristics and smaller ionization potential energy and relatively higher triplet energy than a phosphorescent light emitting host material or blue flourescent host material. When the compound is used in an auxiliary hole transport layer between the hole transport layer and the emission layer in a phosphorescent device and a blue device, high efficiency and long life-span characteristics of a device may be realized.

At least one of R', R " , R¹ and R² of the Chemical Formulae 1 to 3 may be a substituted or unsubstituted C3 to C40 silyl group, and at least one of R', R " , R¹ and R² of the Chemical Formula 11 may be a substituted or unsubstituted C3 to C40 silyl group.

The silyl group may lower a deposition temperature during manufacture of an organic optoelectronic device, and increase solubility for a solvent to convert a manufacturing process of a device into a solution process. In addition, uniform thin film may be provided to improve thin film surface characteristics.

More specifically, at least one of R', R " , R¹ and R² of the Chemical Formulae 1 to 3 may be a substituted C3 to C40 silyl group, at least one of R', R " , R¹ and R² of the Chemical Formula 11 may be a substituted C3 to C40 silyl group, wherein at least one hydrogen of the substituted silyl group may be substituted with a C1 to C10 alkyl group or a C6 to C15 aryl group.

Specific examples of the substituted silyl group may be a trimethylsilyl group, triethylsilyl, tri-isopropylsilyl, tri tertiarybutyl silyl, a triphenylsilyl group, tritolylsilyl, trinaphthylsilyl, tribiphenylsilyl, dimethylphenylsilyl, diphenylmethylsilyl, diethylphenylsilyl, diphenylethylsilyl, ditolylmethylsilyl, dinaphthylmethylsilyl, dimethyltolylsilyl, dimethylnaphthylsilyl, dimethylbiphenylsilyl, and the like.

For more specific examples, the compound represented by a combination of the Chemical Formula 1; the Chemical Formula 2 or 3; and the Chemical Formula 4 may be represented by one of the following Chemical Formula A-1 to A-133, B-1 to B-28, C-1 to C-93, D-1 to D-20, E-1 to E-128 or K-1 to K-402, but are not limited thereto.

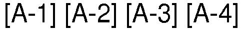

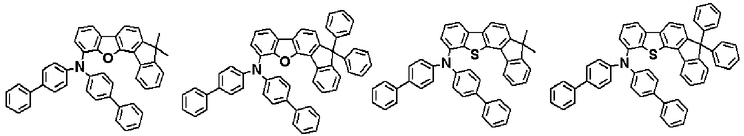

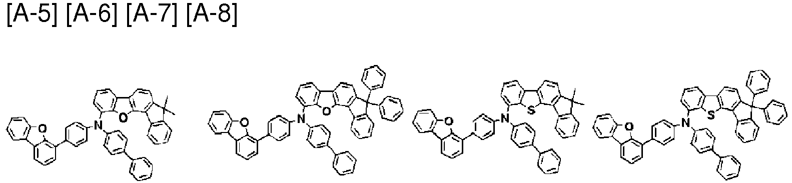

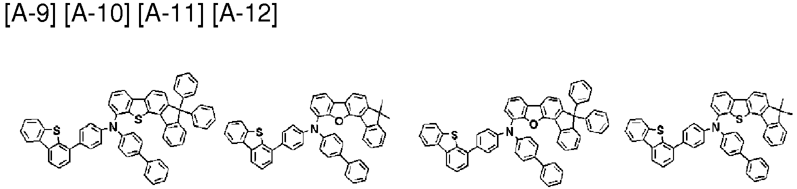

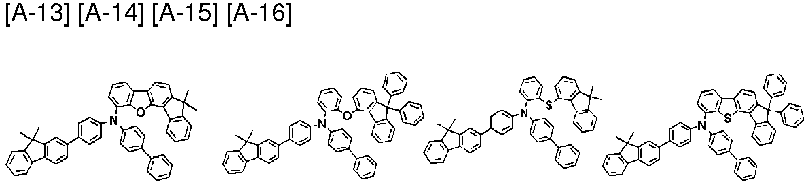

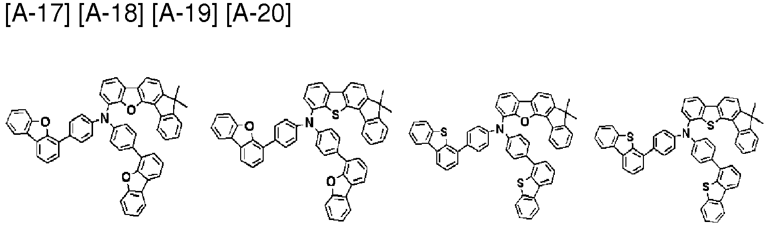

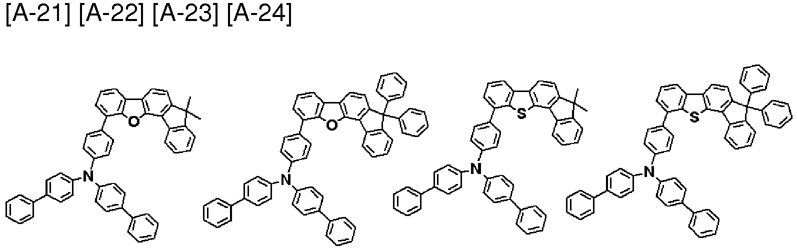

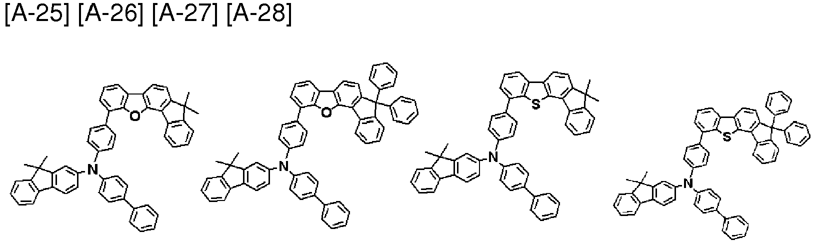

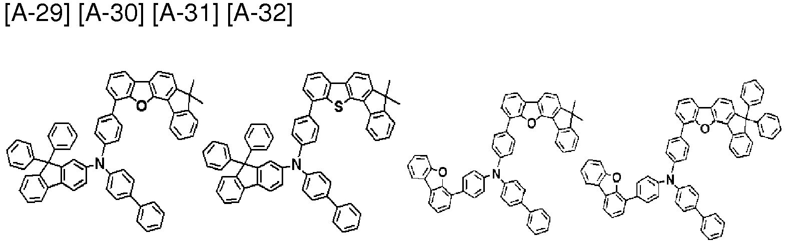

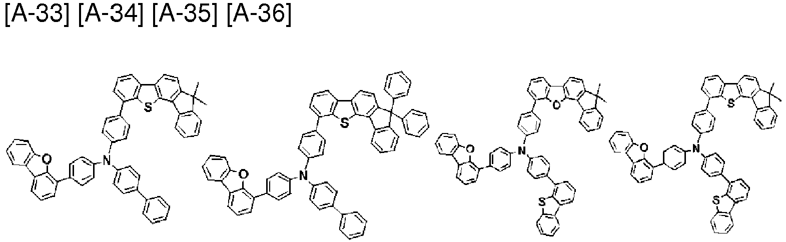

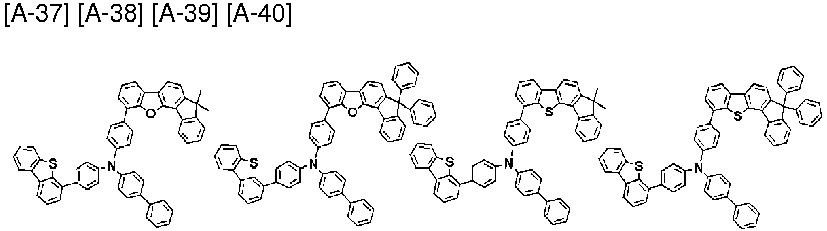

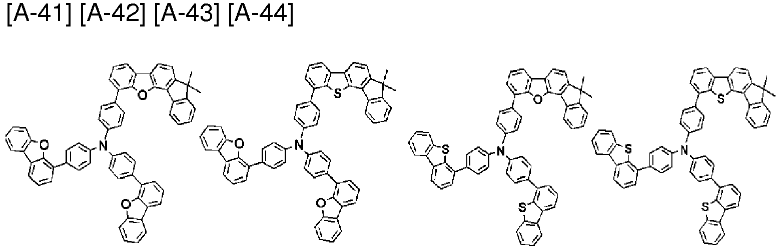

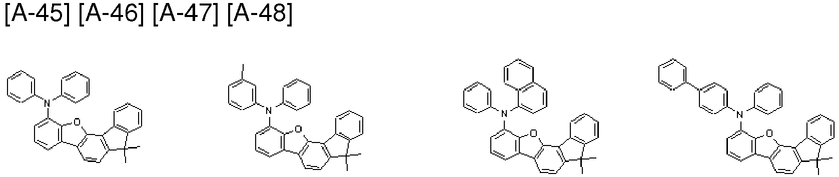

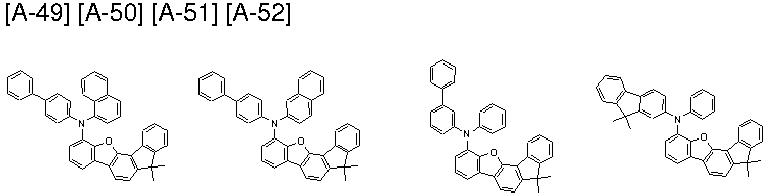

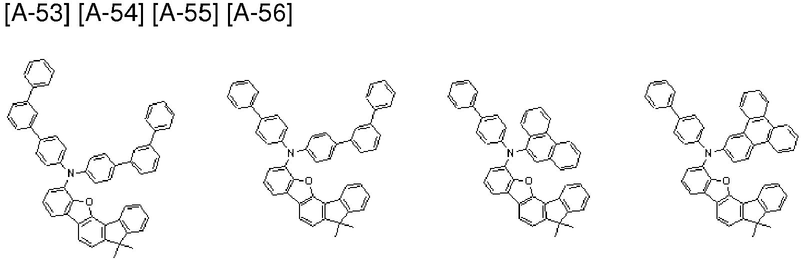

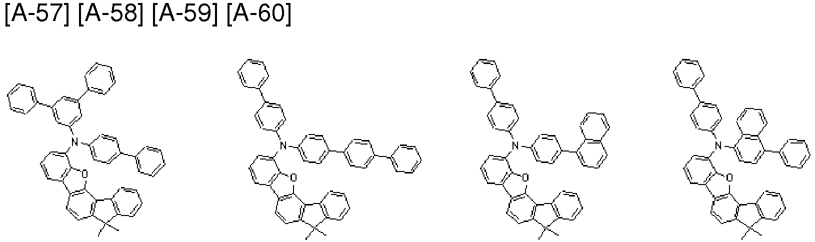

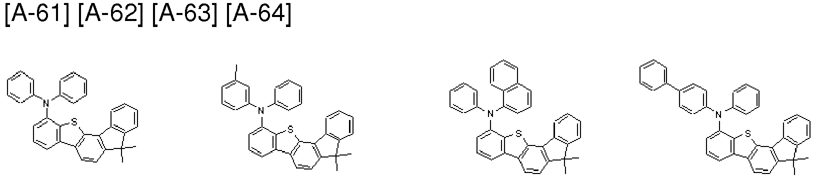

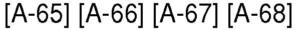

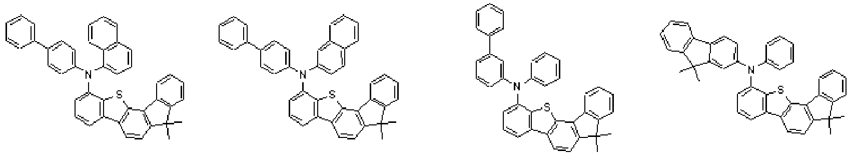

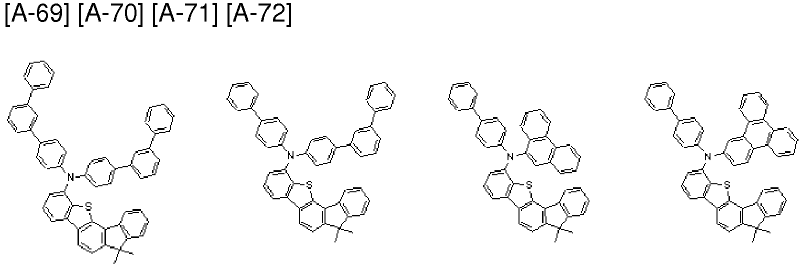

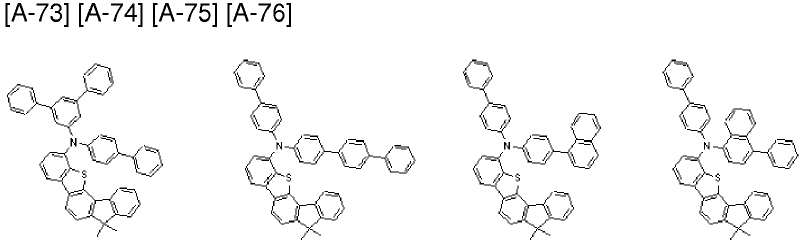

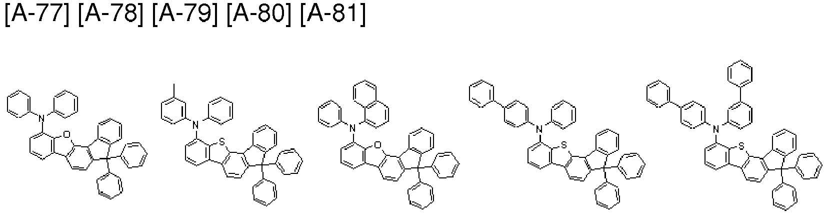

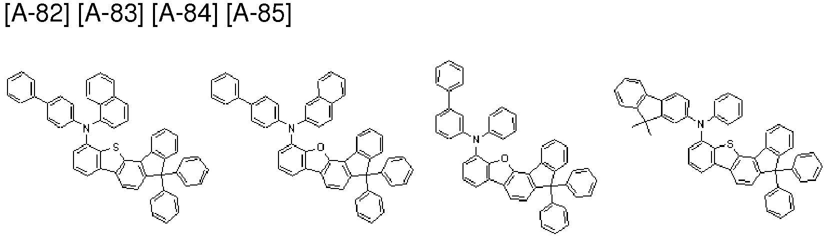

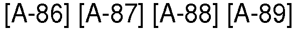

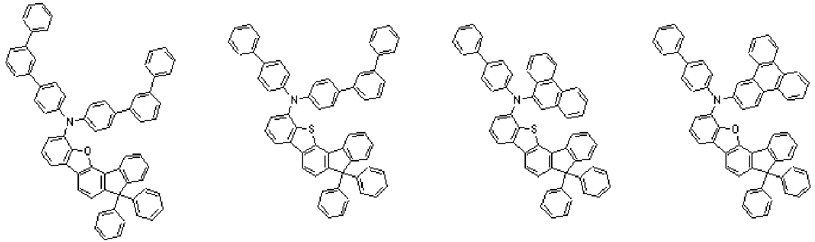

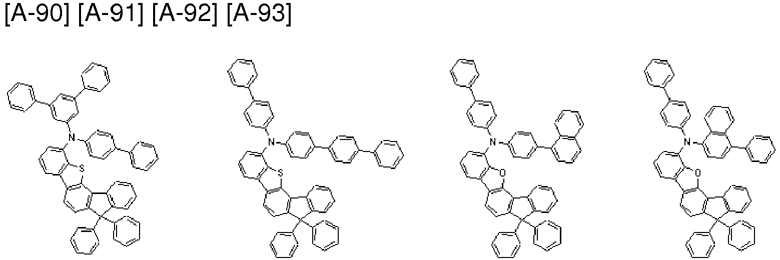

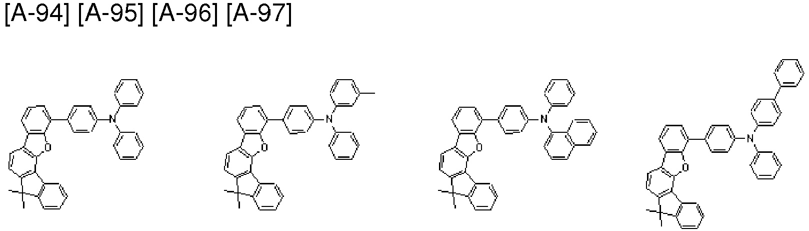

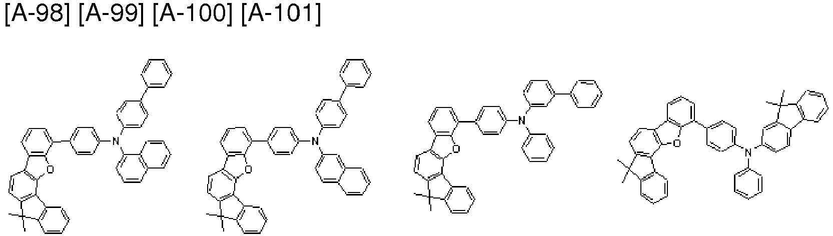

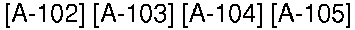

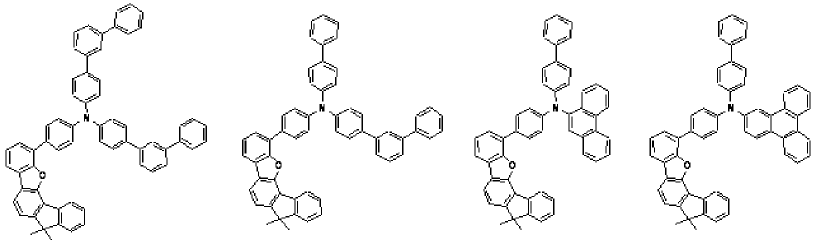

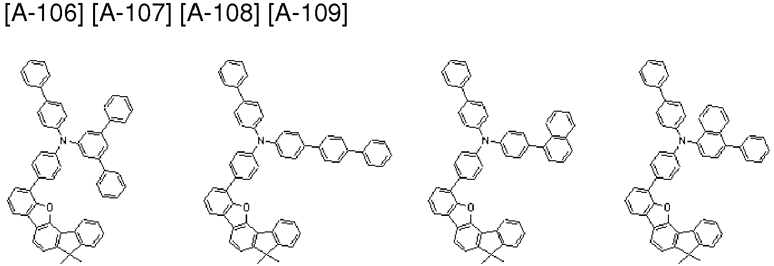

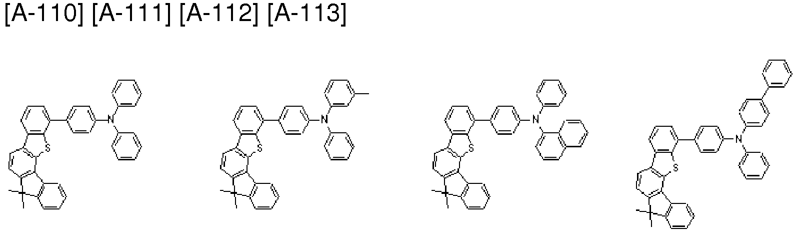

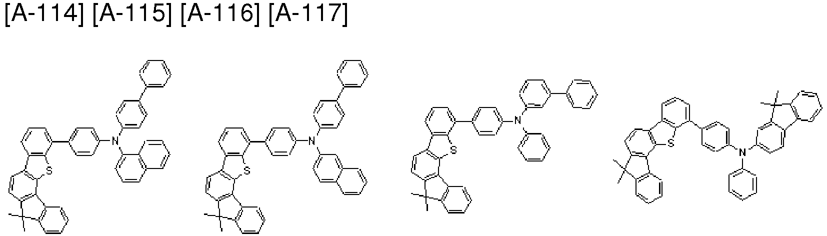

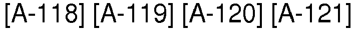

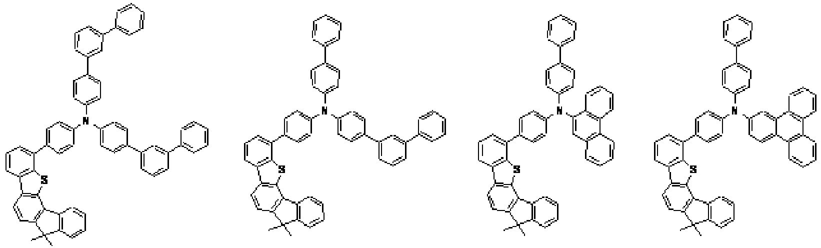

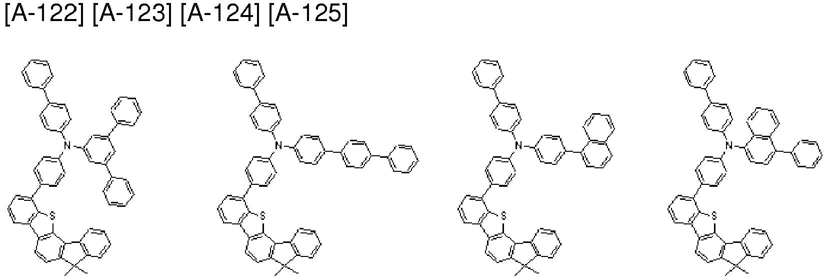

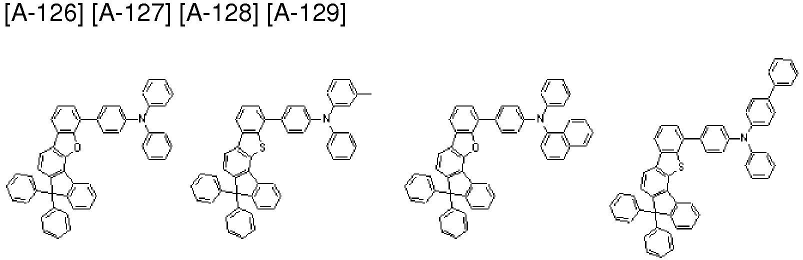

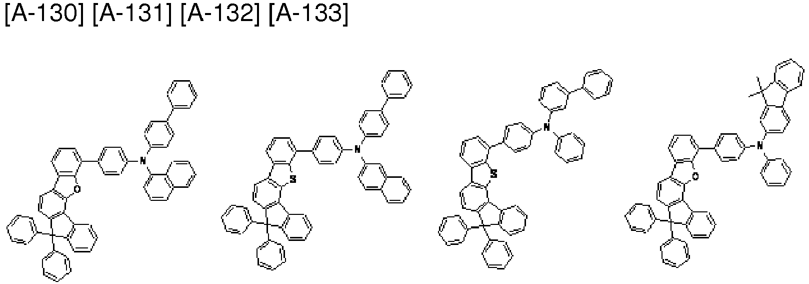

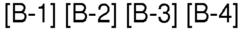

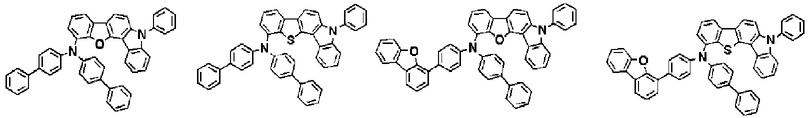

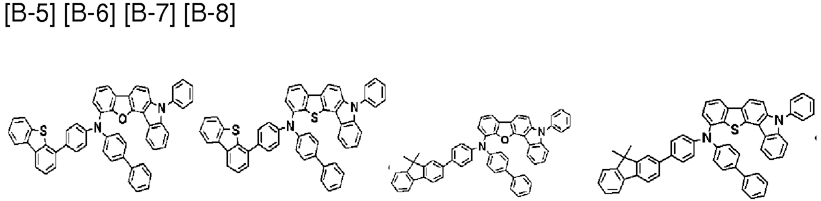

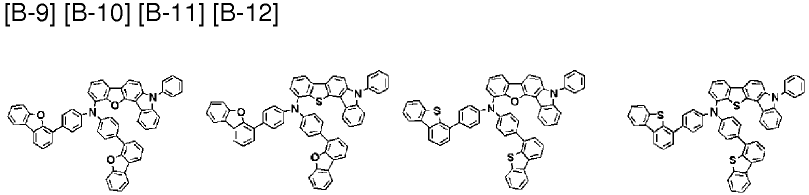

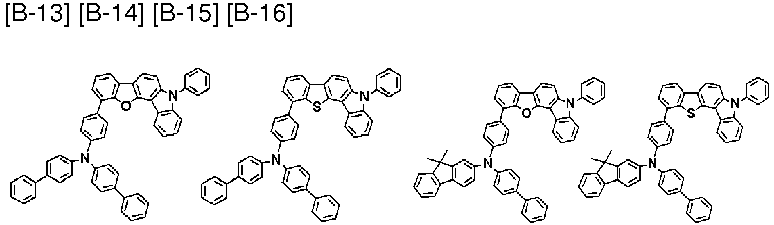

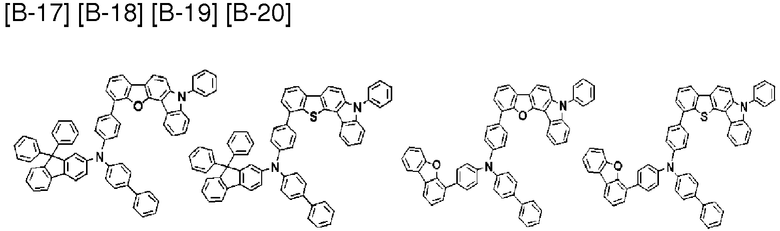

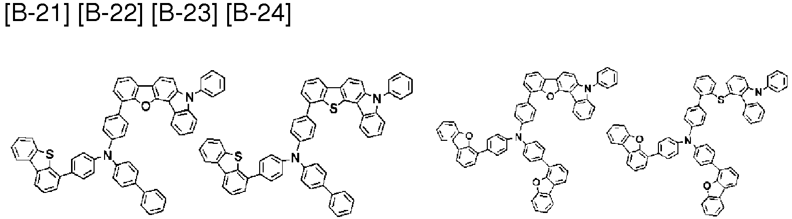

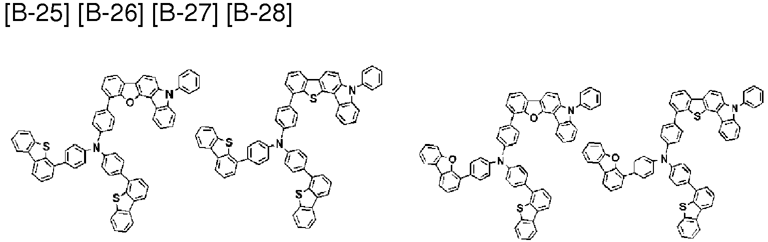

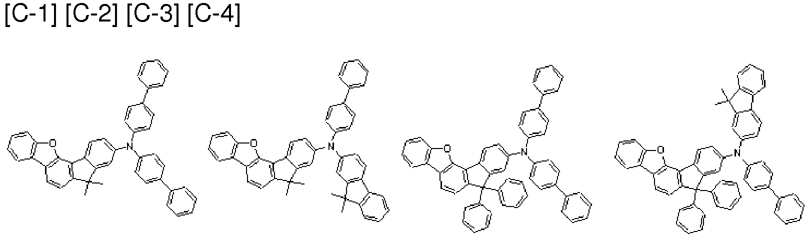

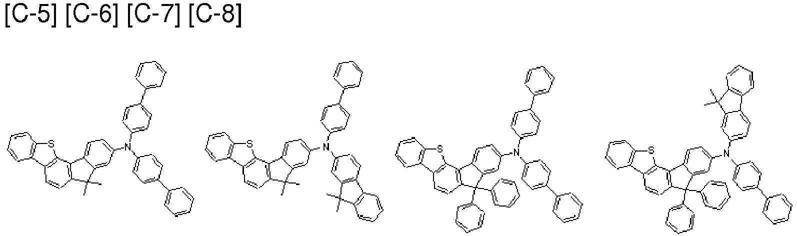

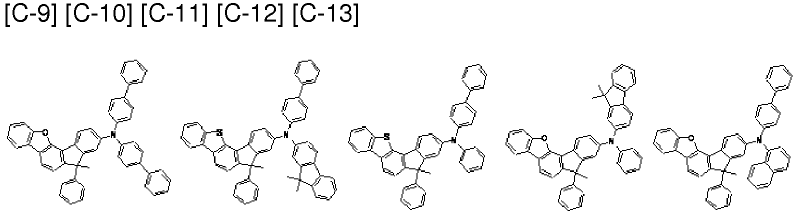

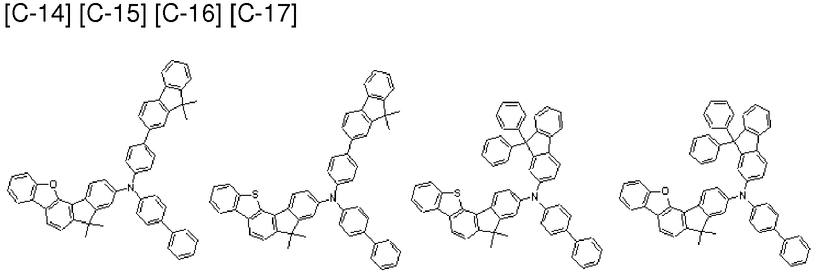

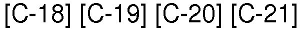

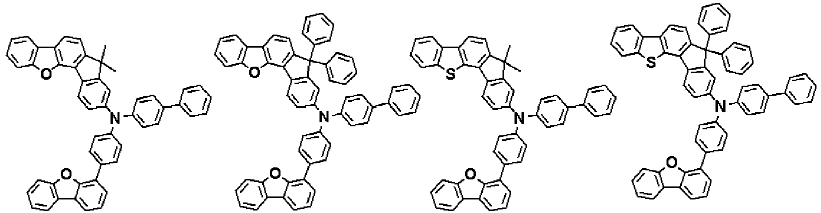

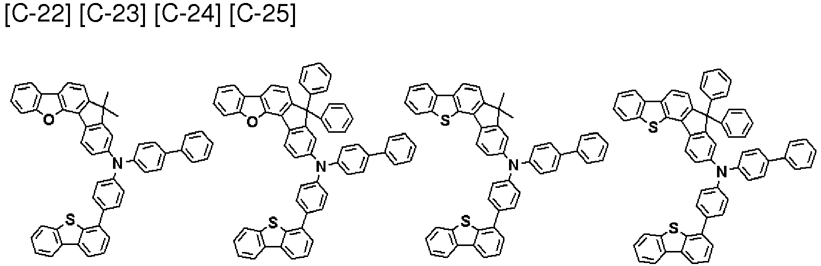

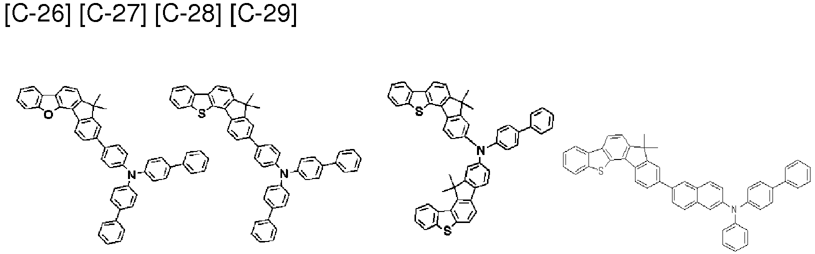

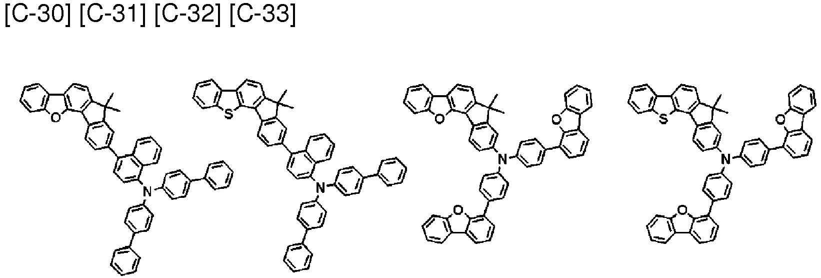

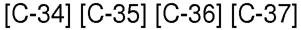

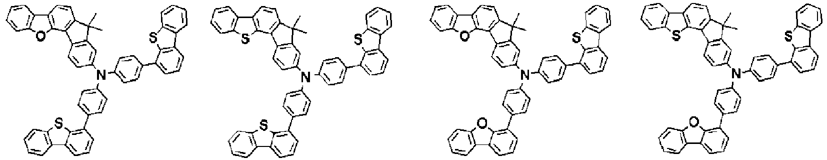

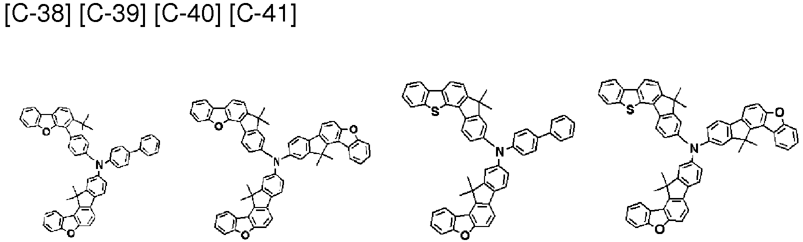

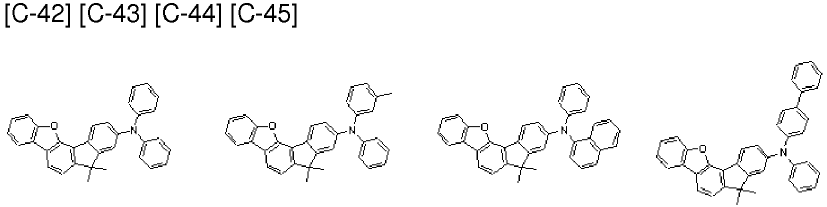

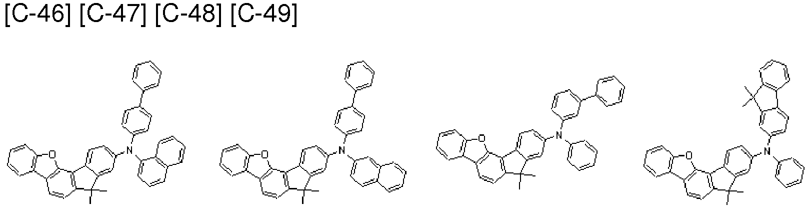

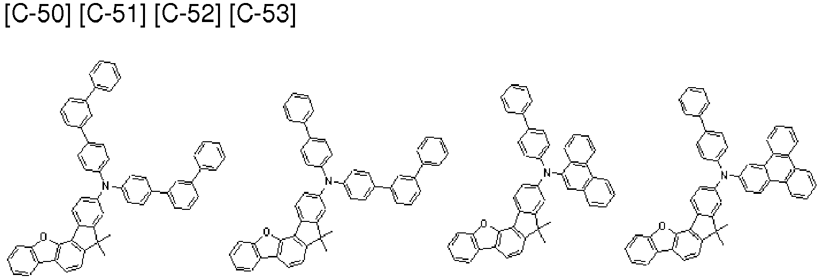

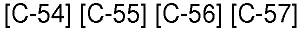

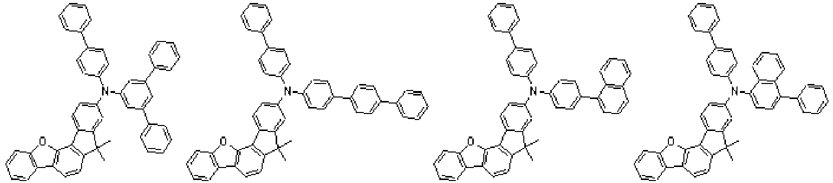

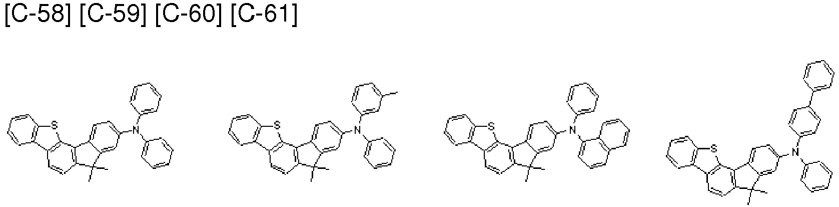

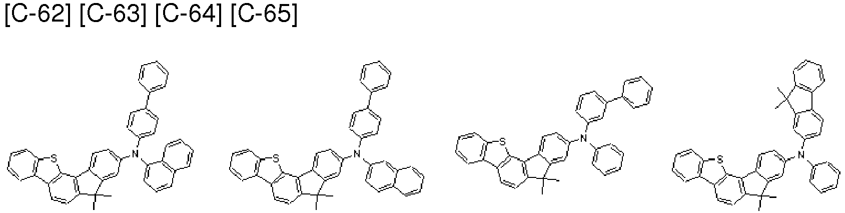

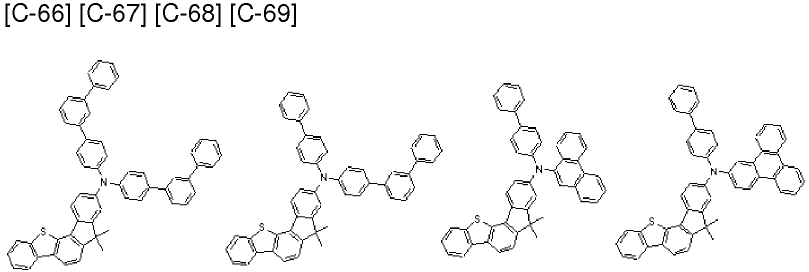

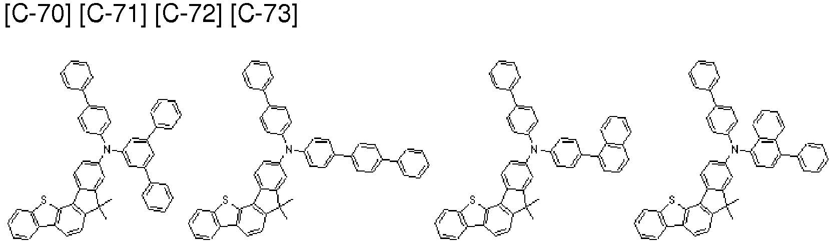

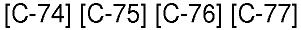

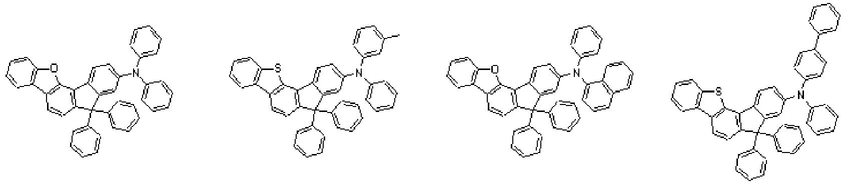

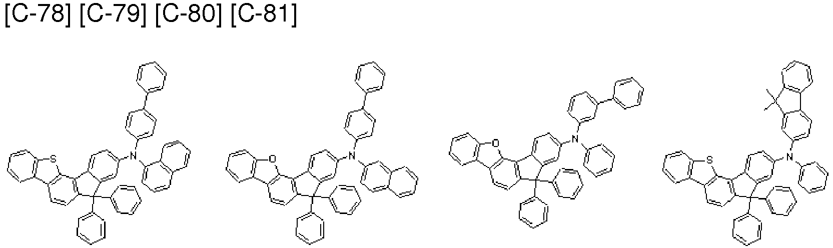

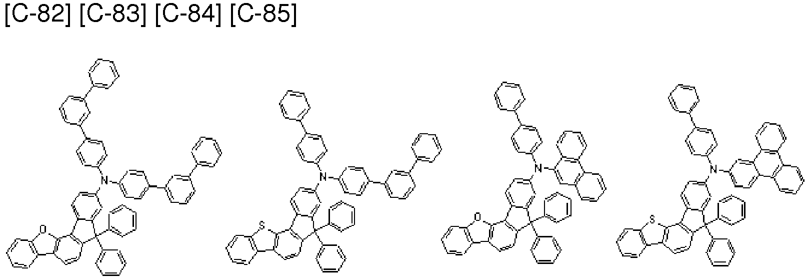

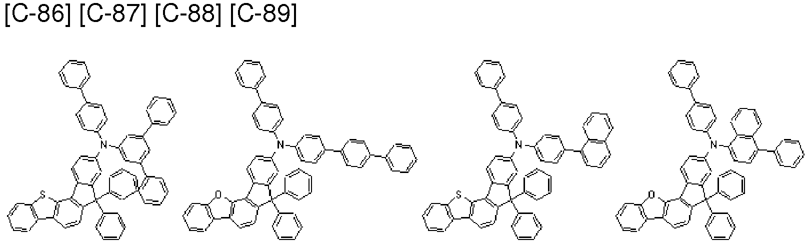

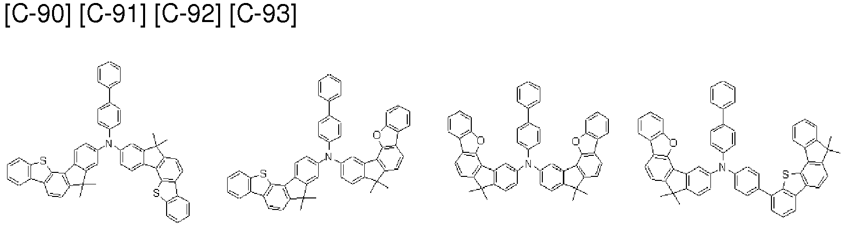

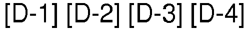

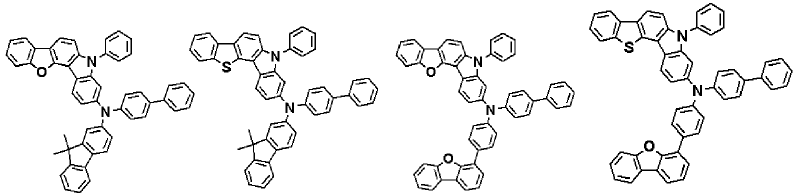

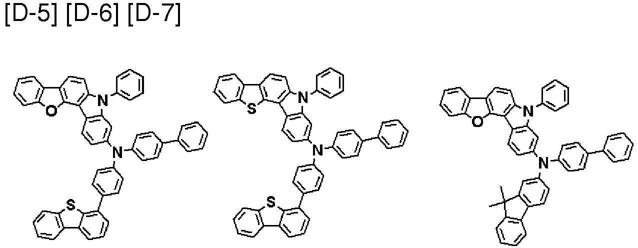

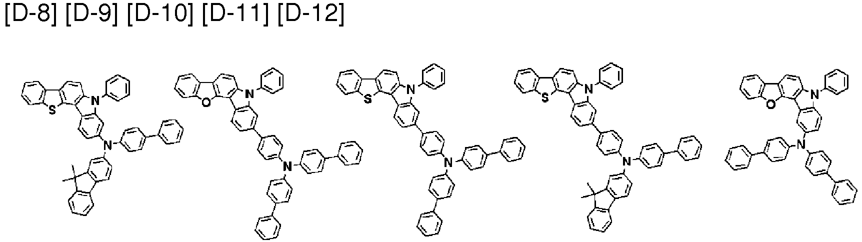

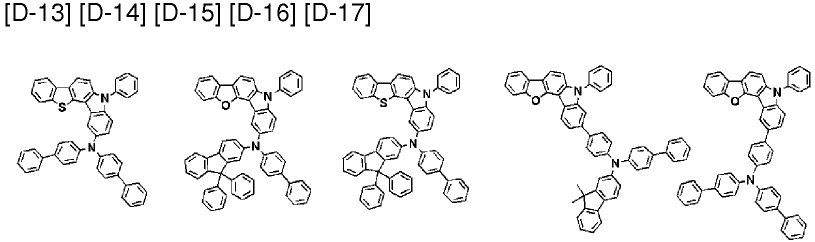

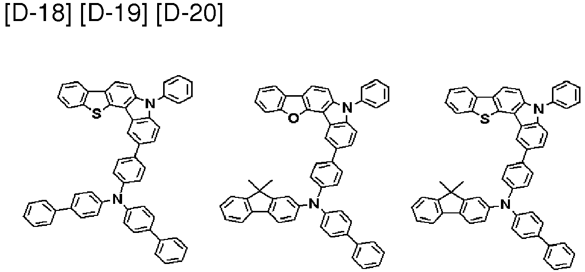

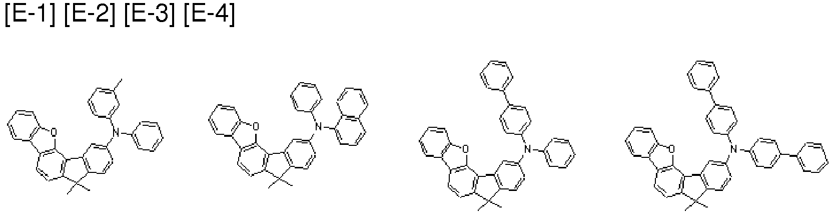

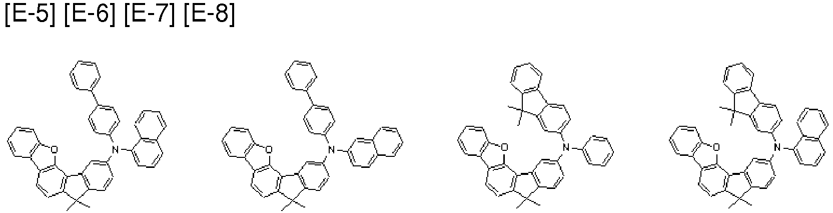

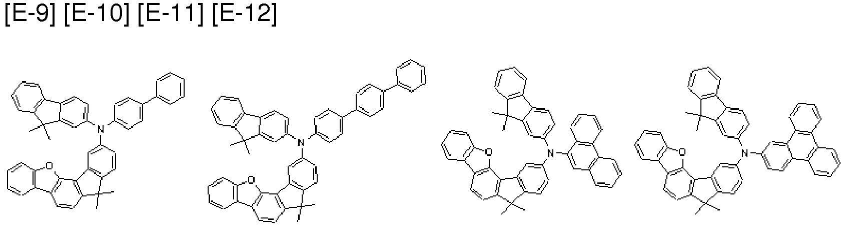

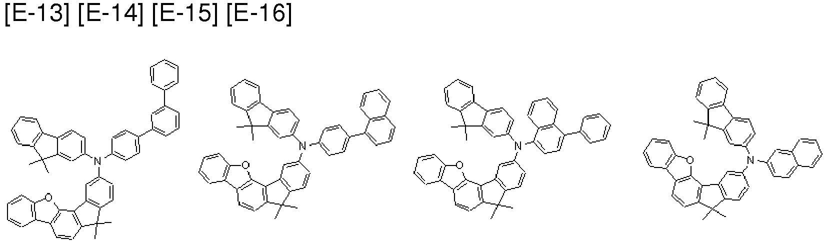

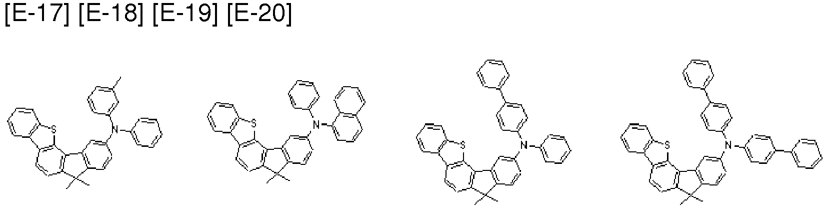

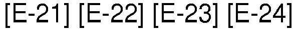

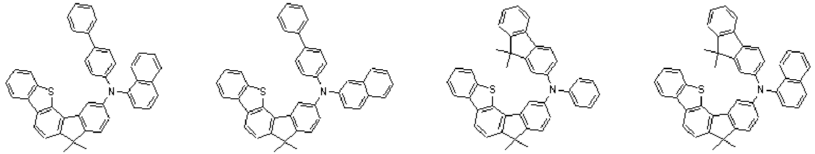

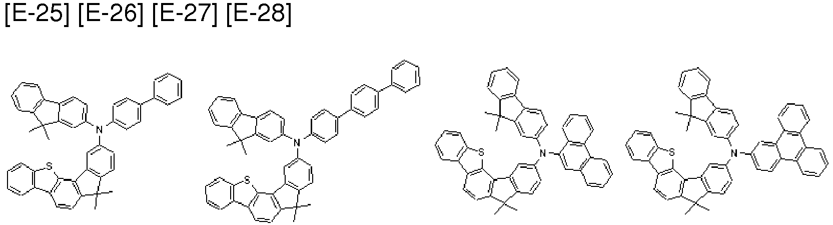

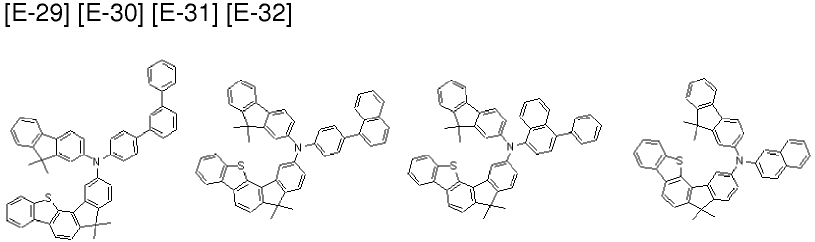

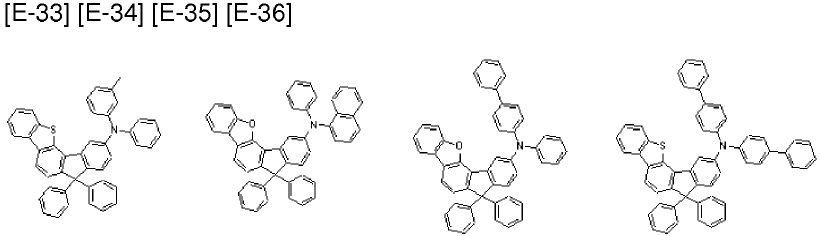

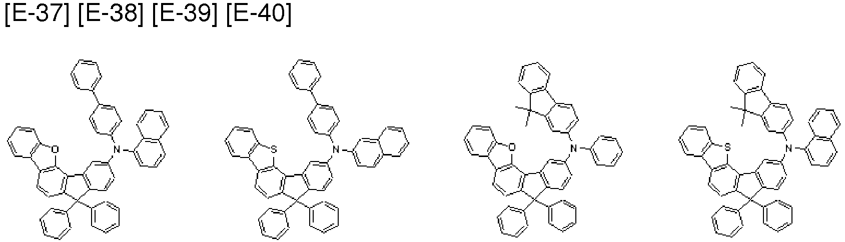

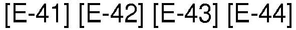

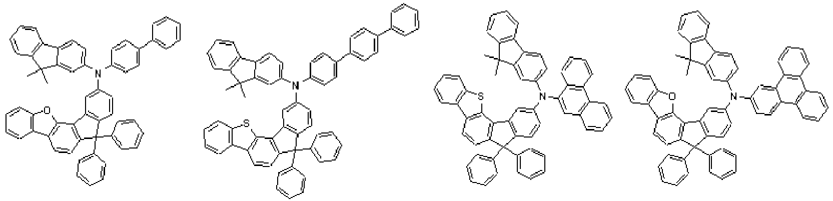

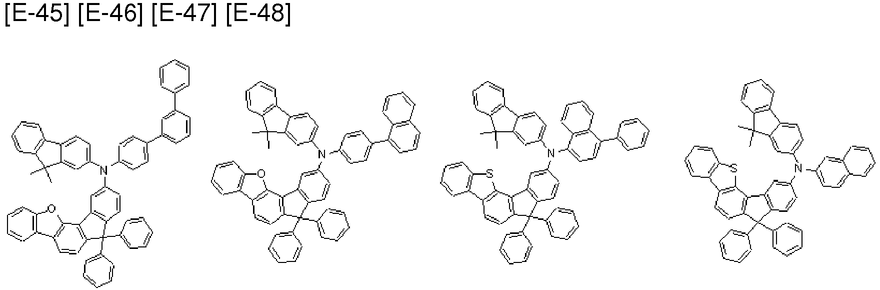

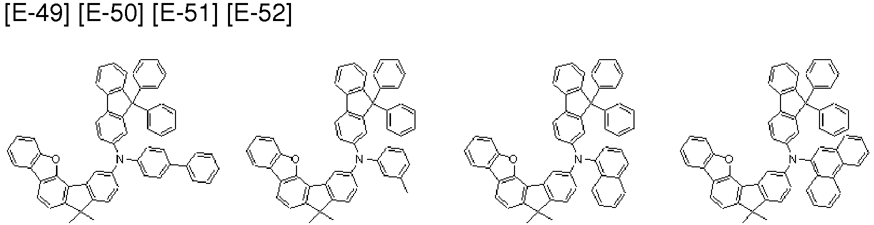

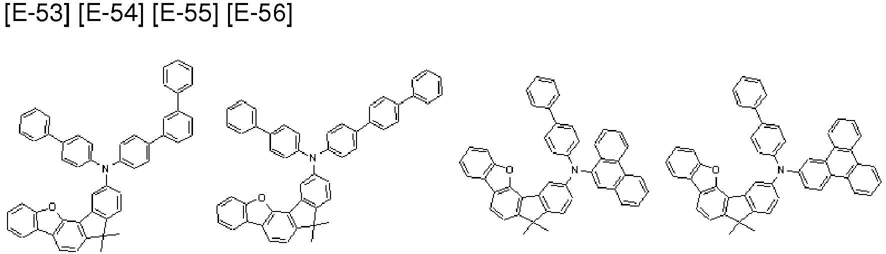

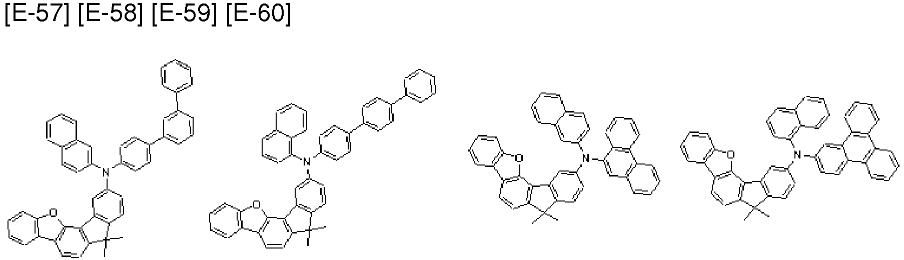

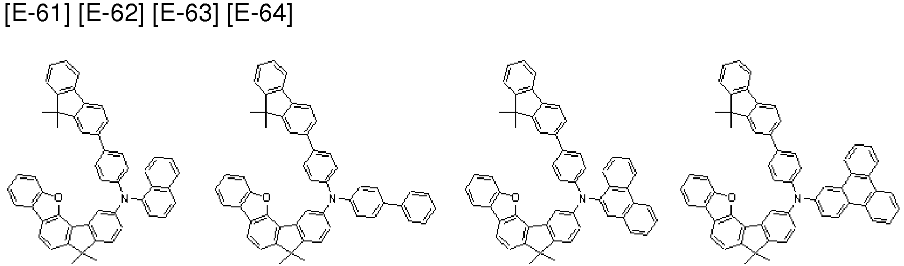

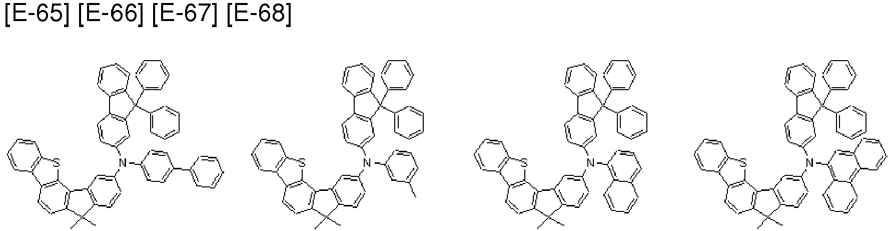

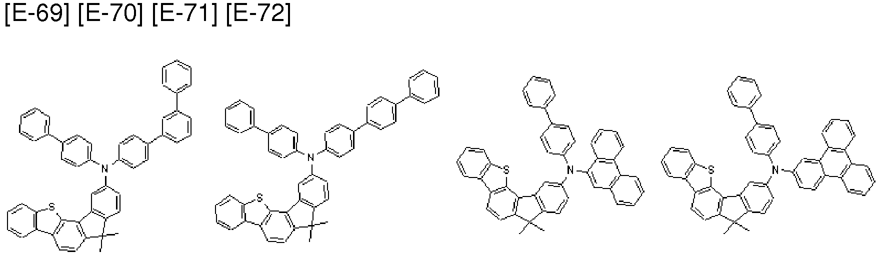

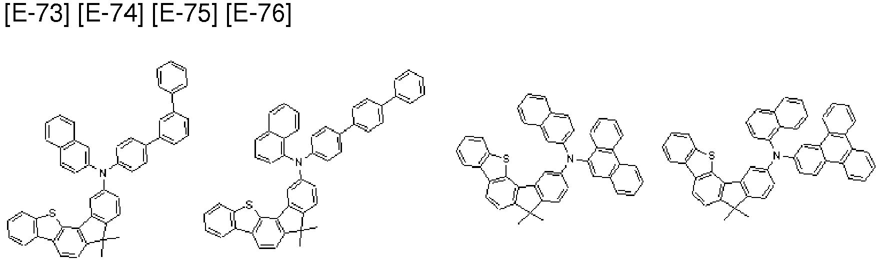

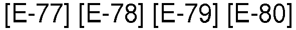

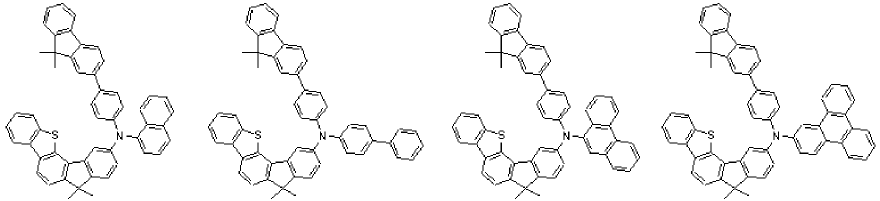

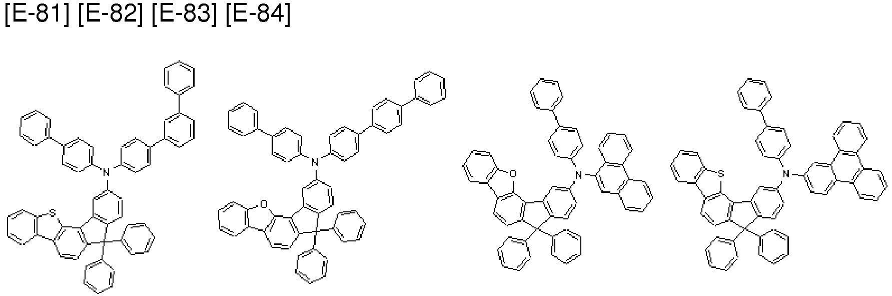

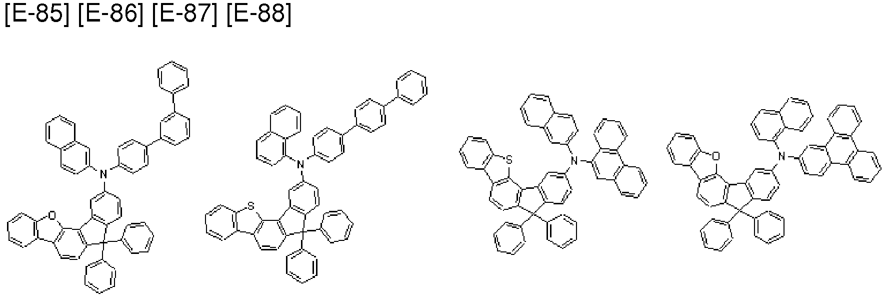

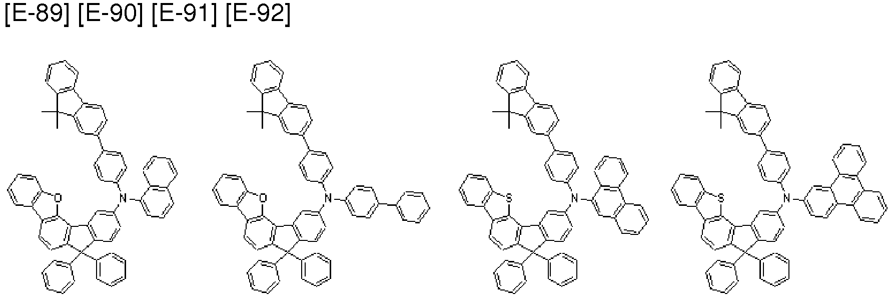

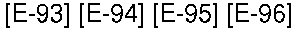

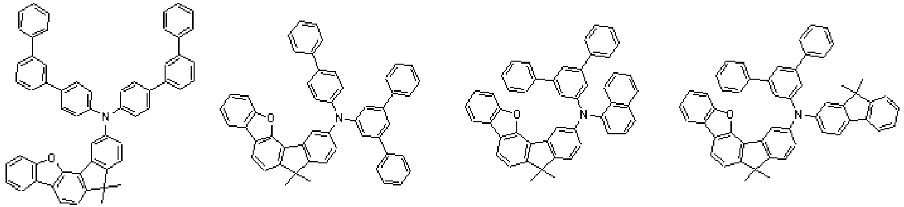

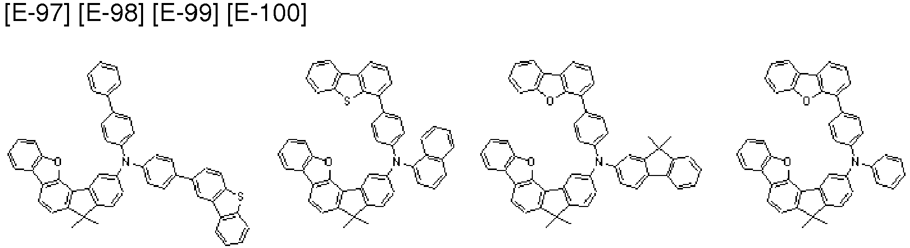

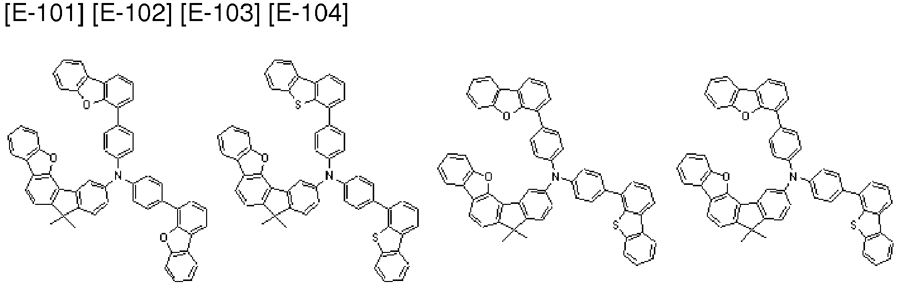

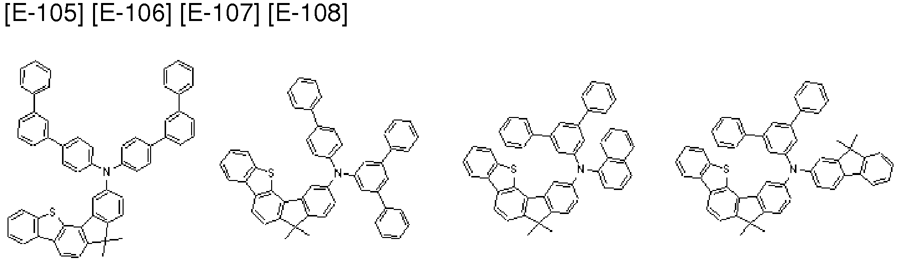

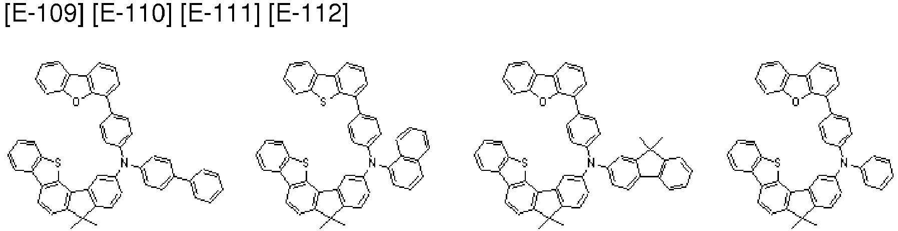

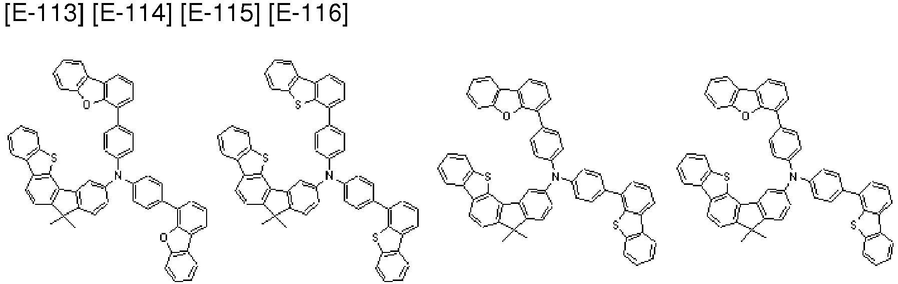

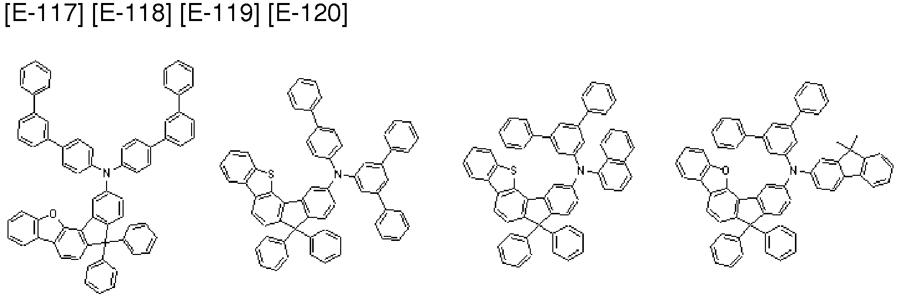

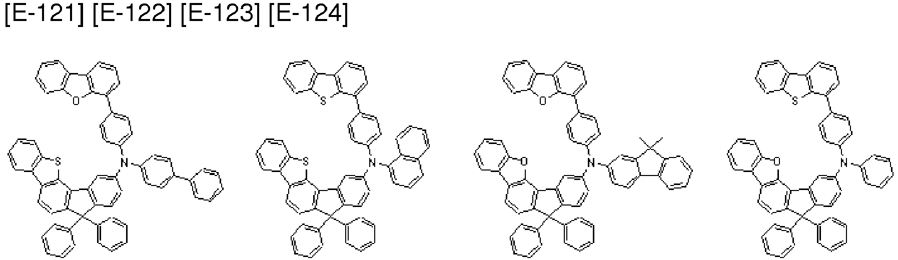

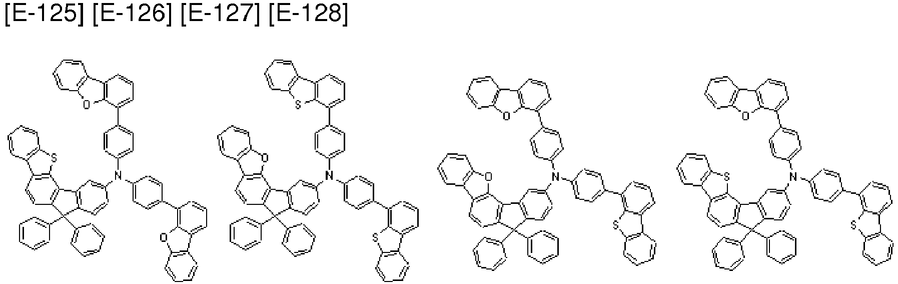

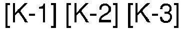

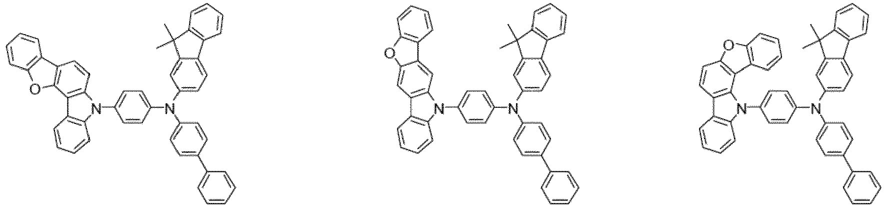

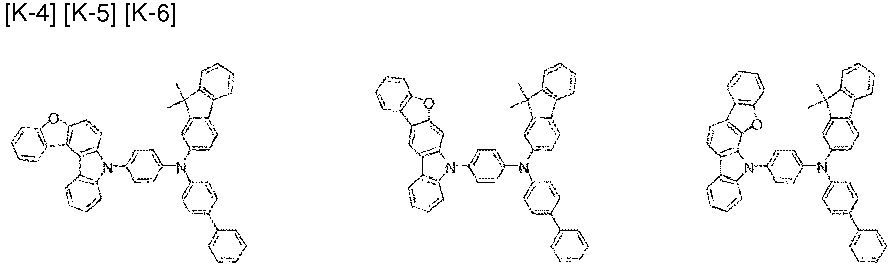

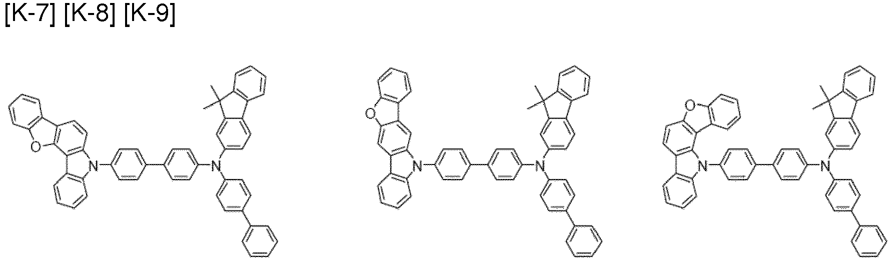

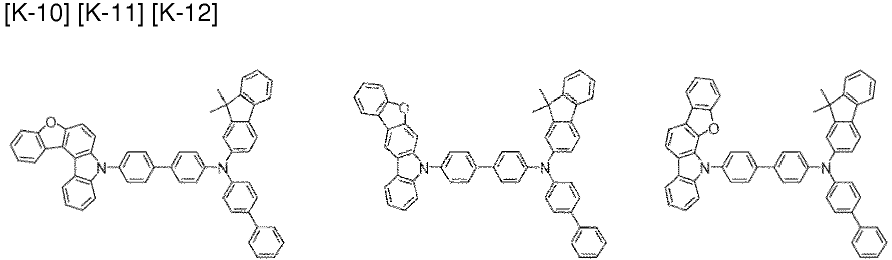

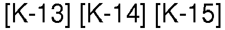

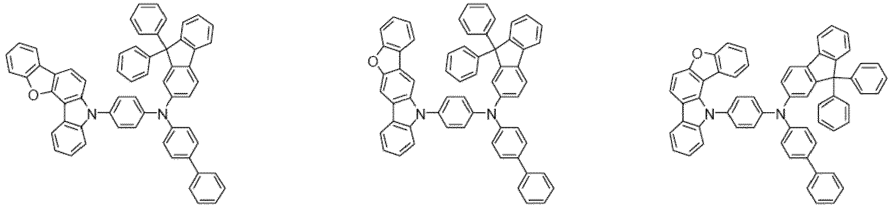

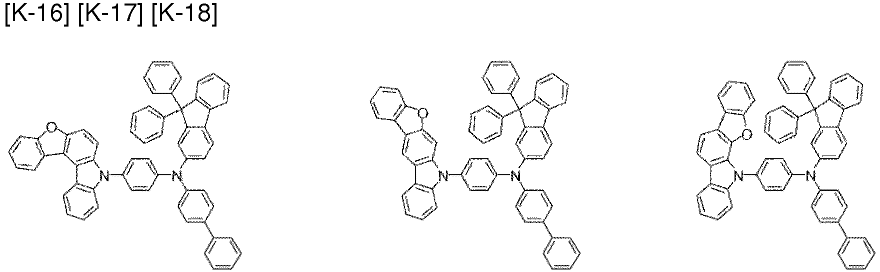

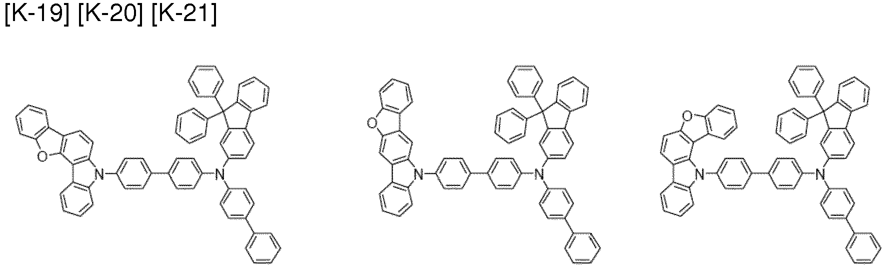

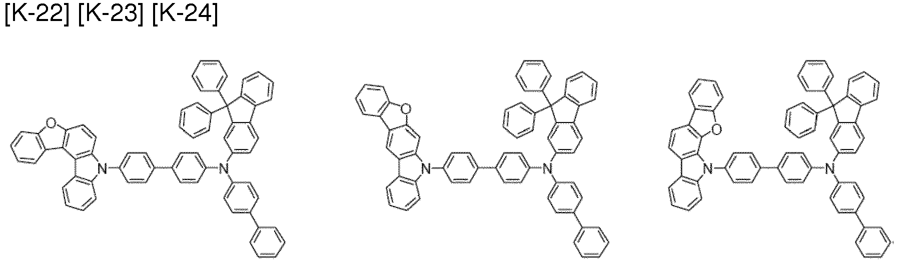

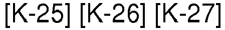

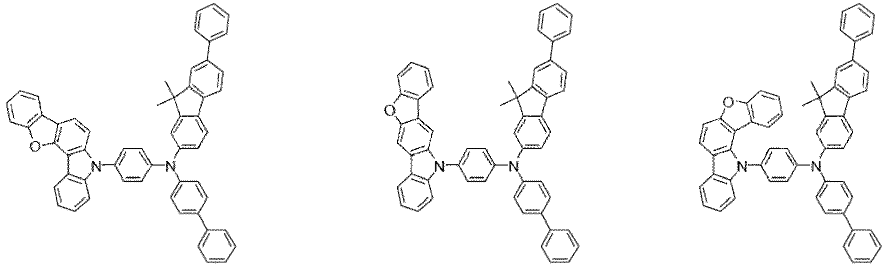

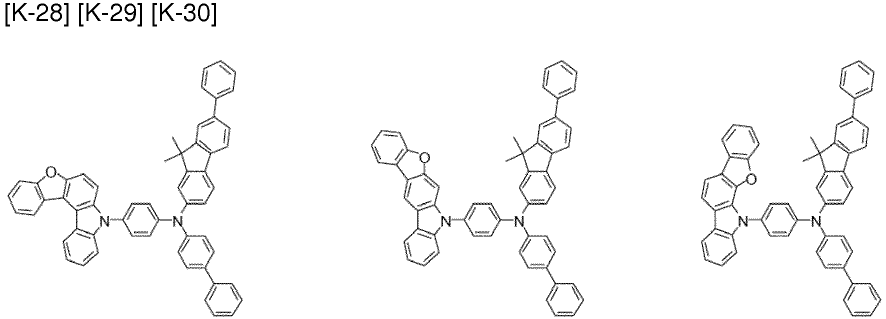

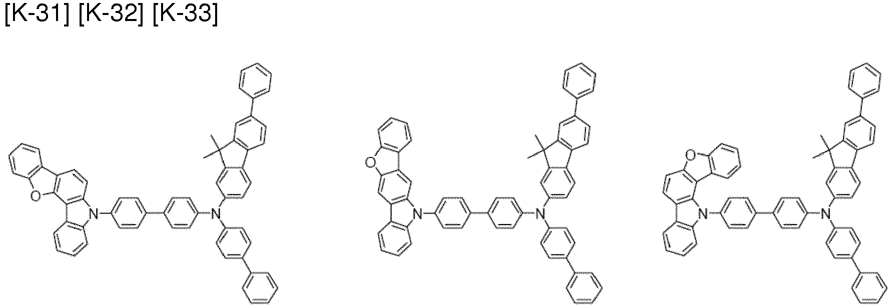

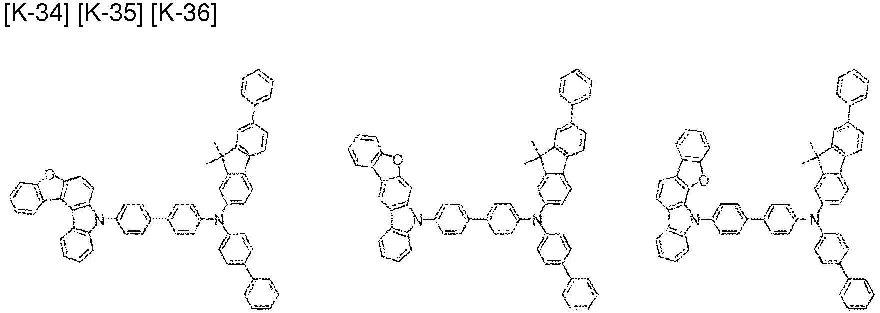

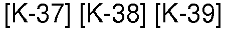

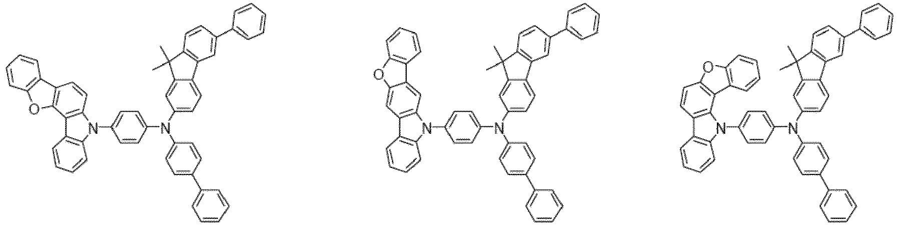

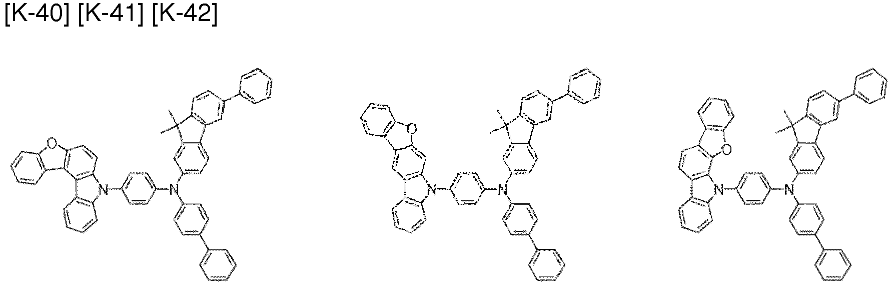

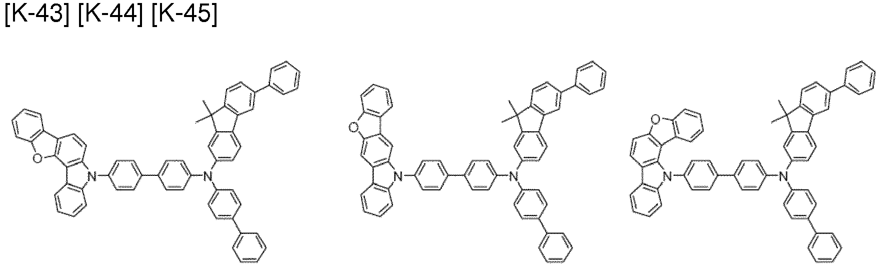

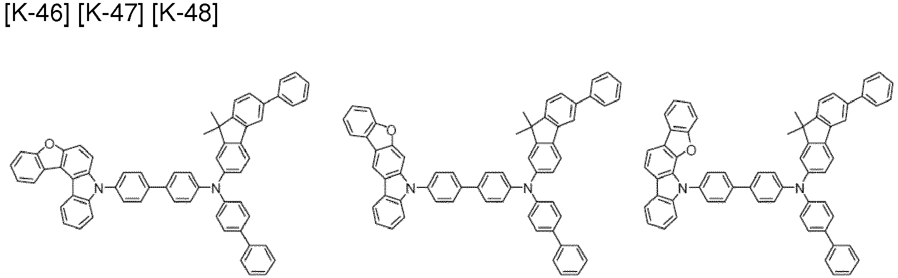

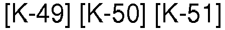

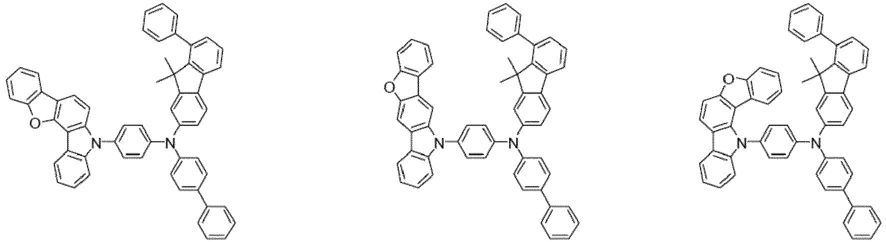

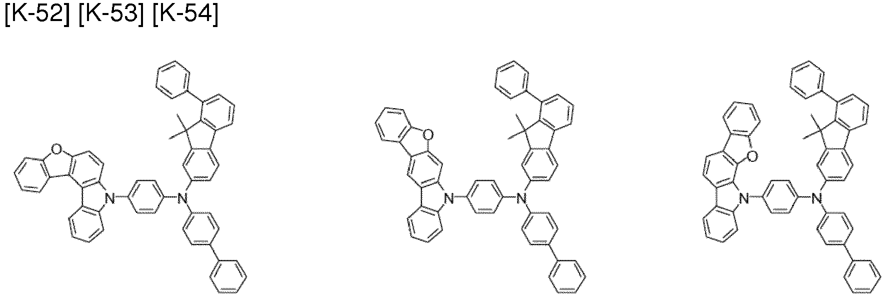

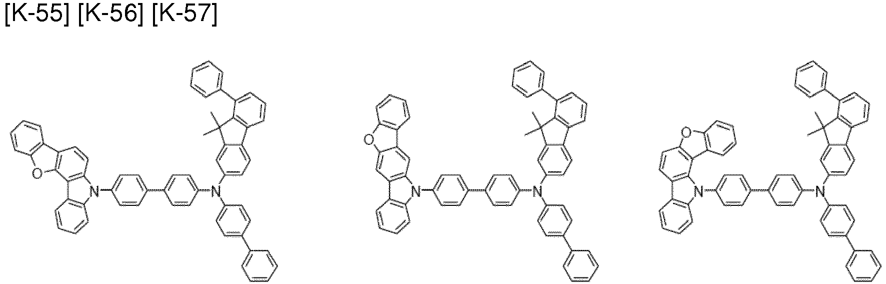

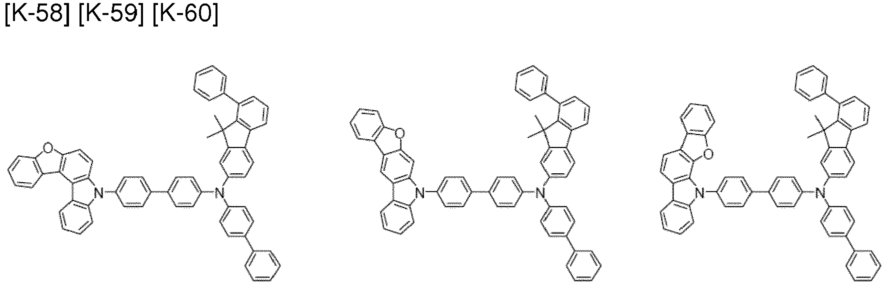

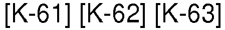

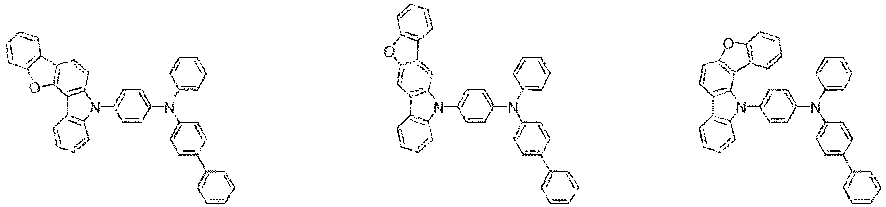

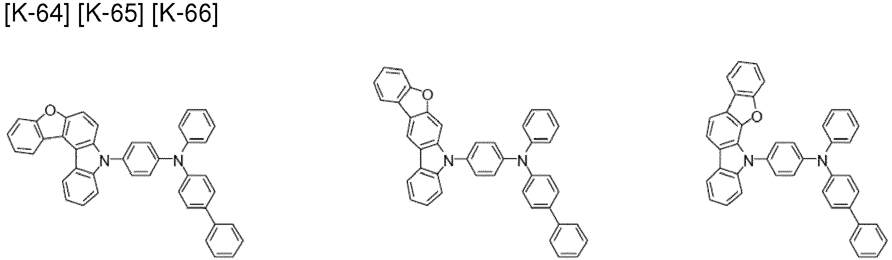

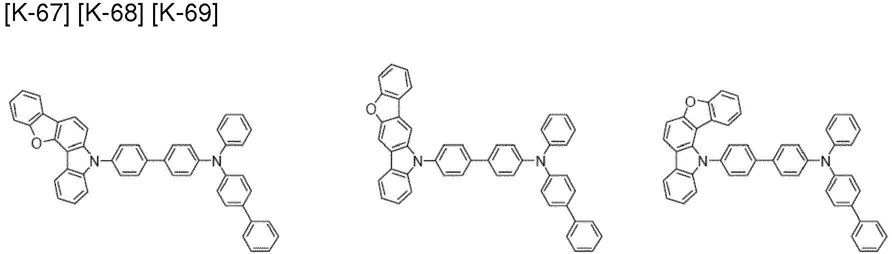

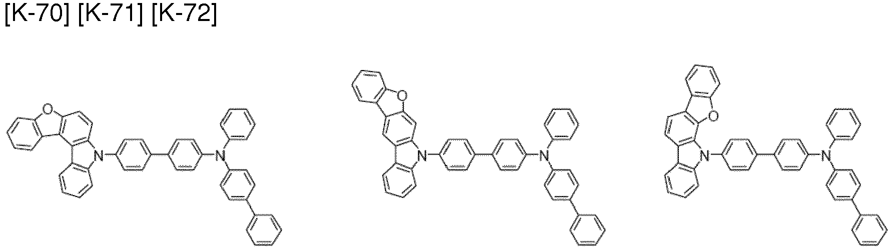

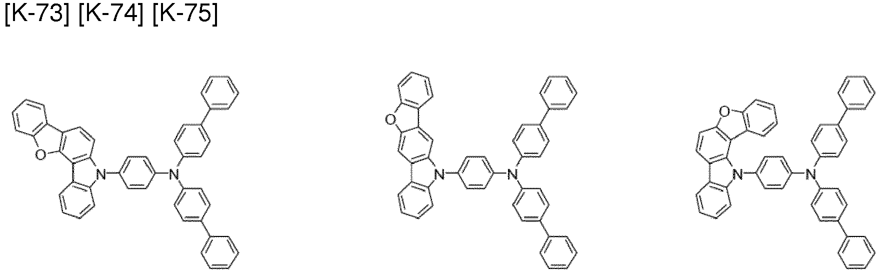

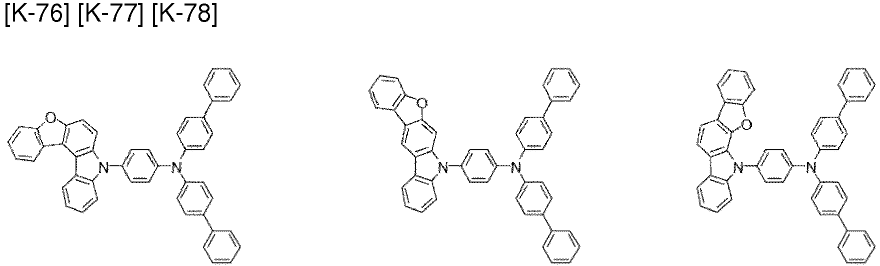

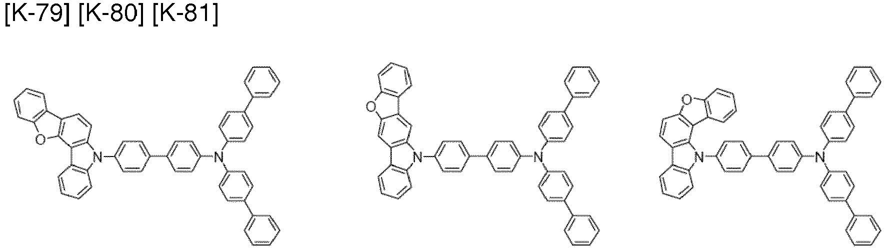

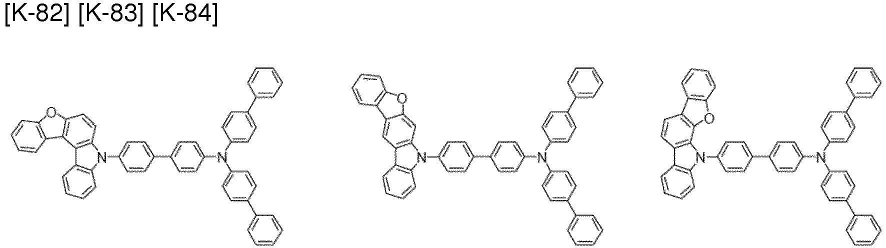

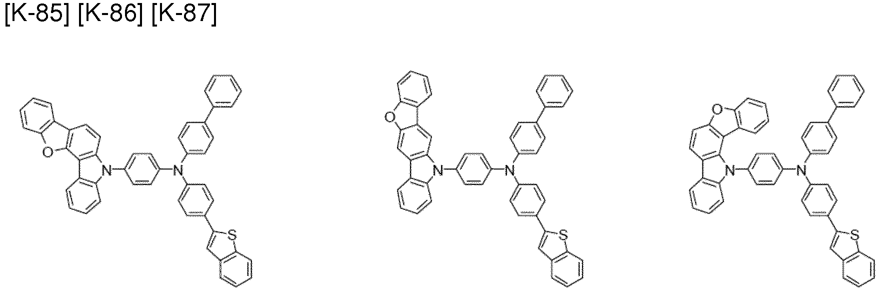

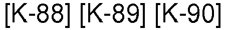

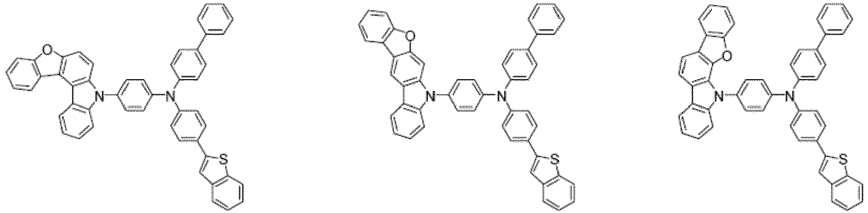

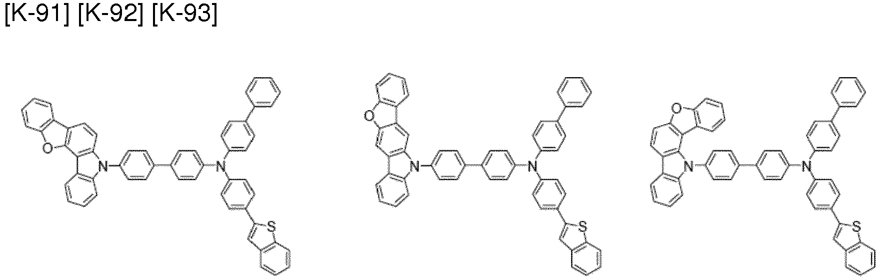

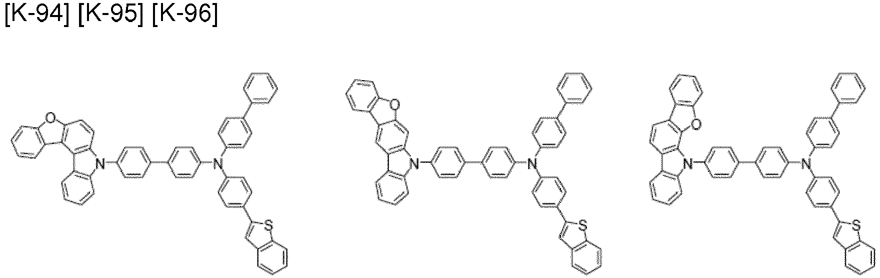

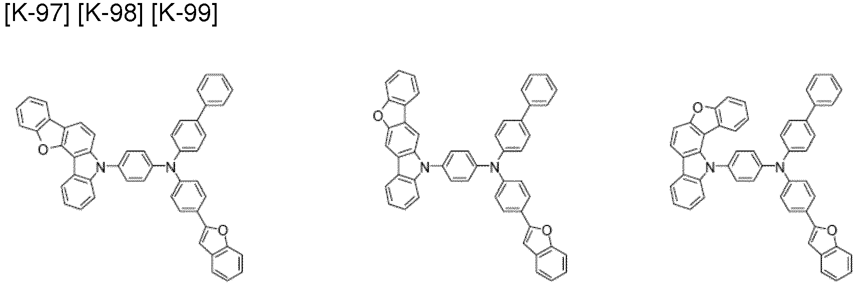

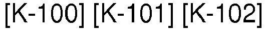

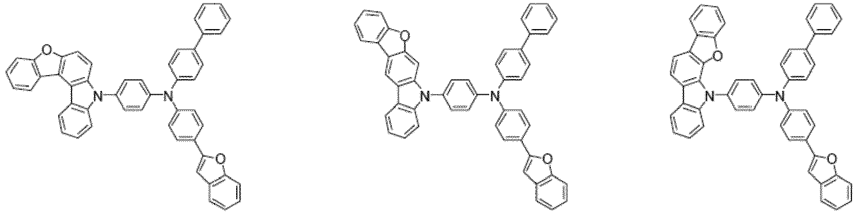

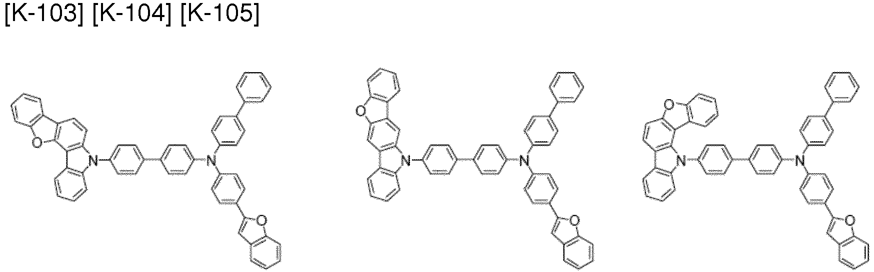

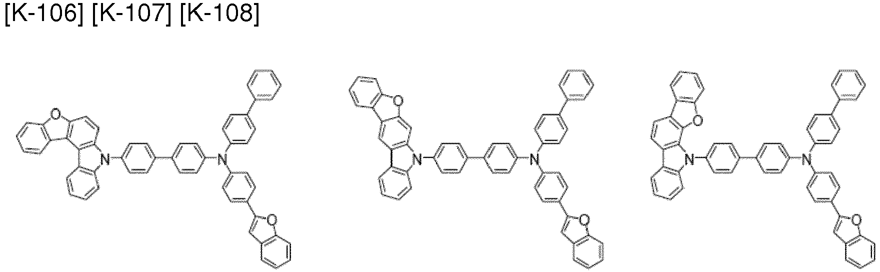

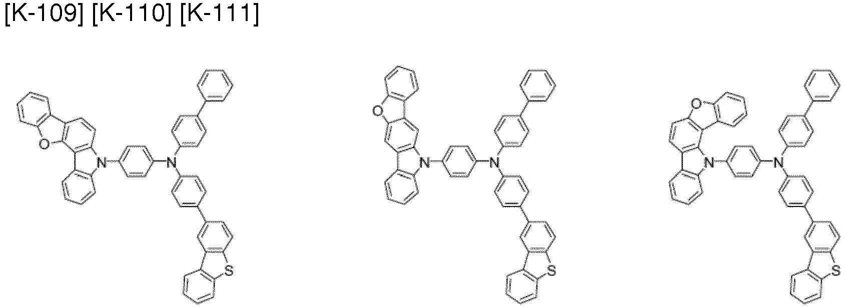

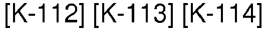

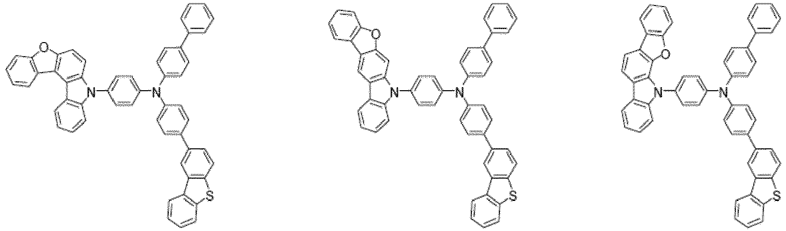

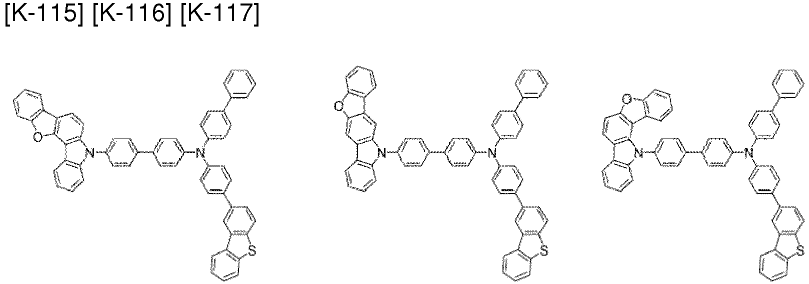

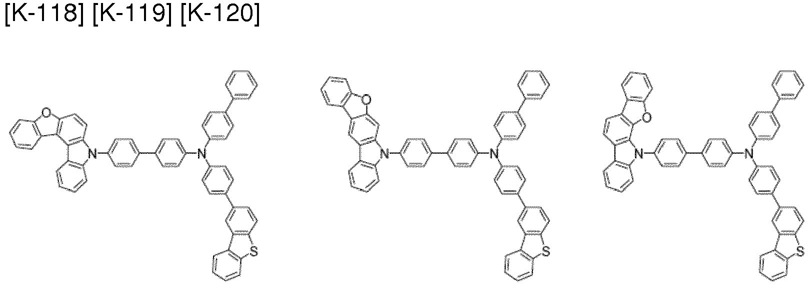

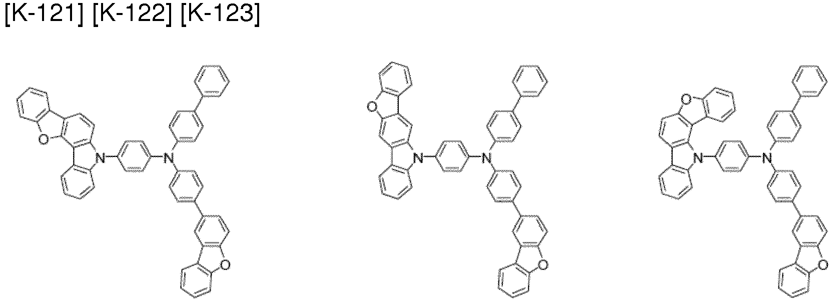

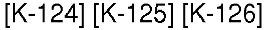

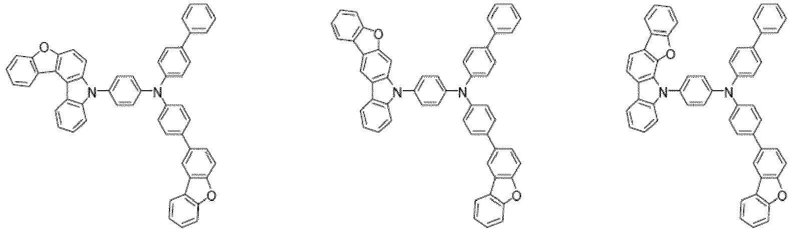

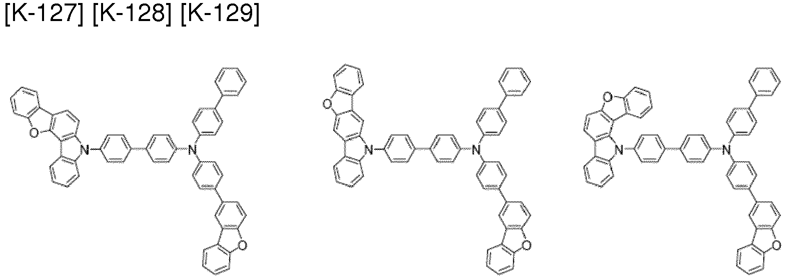

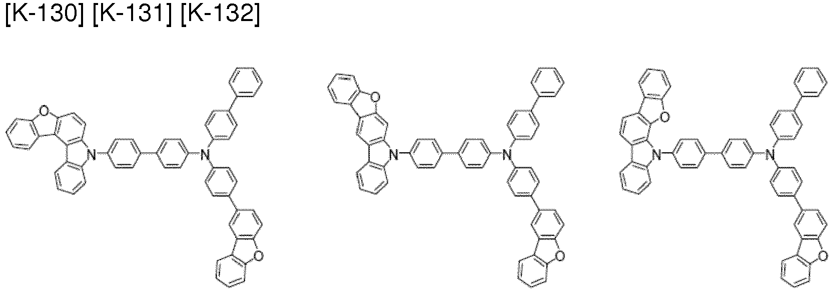

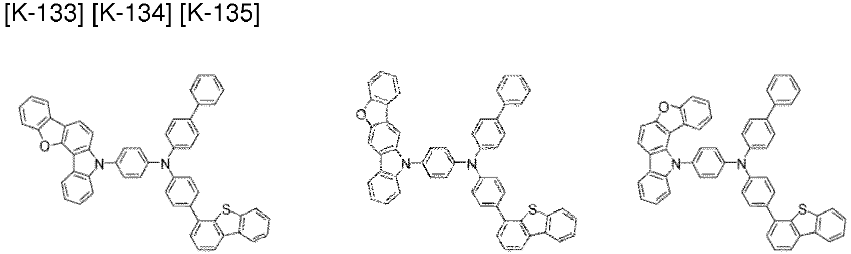

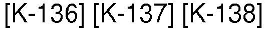

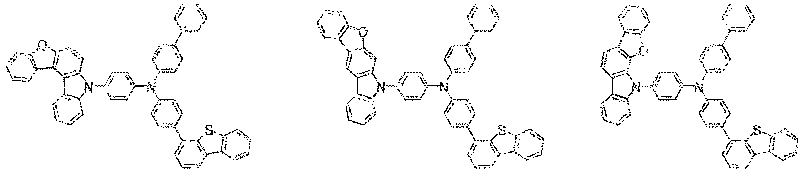

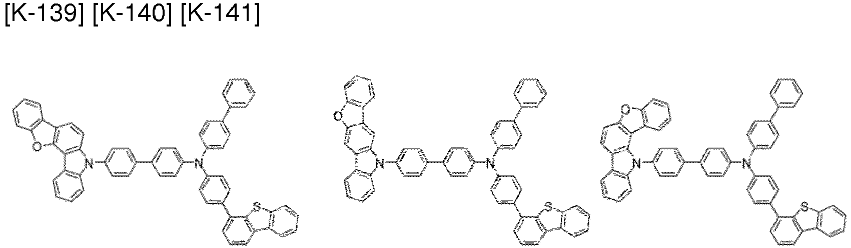

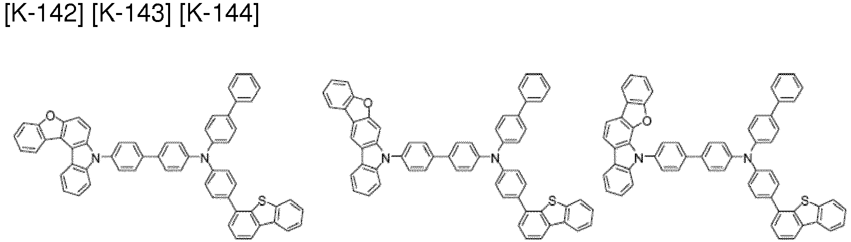

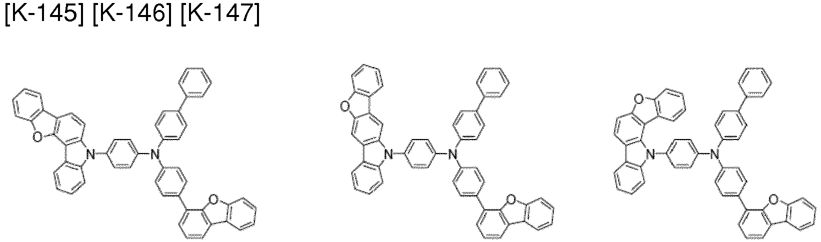

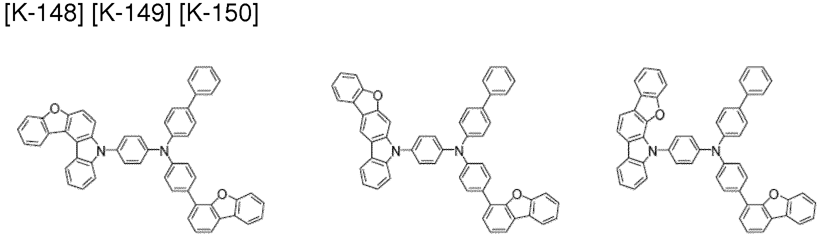

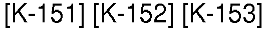

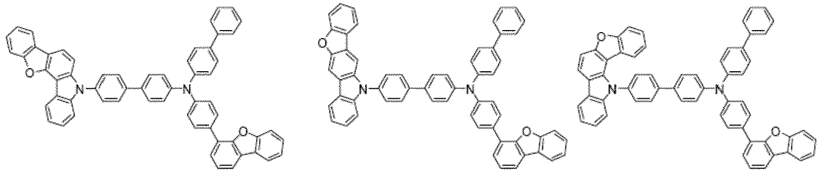

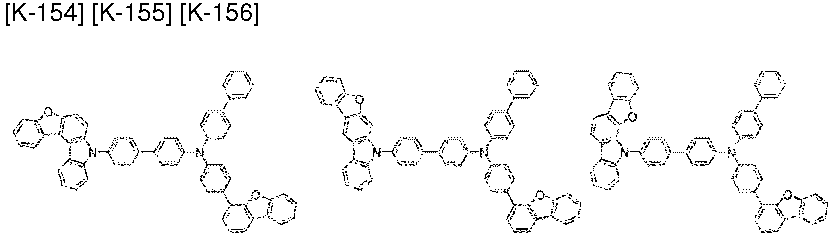

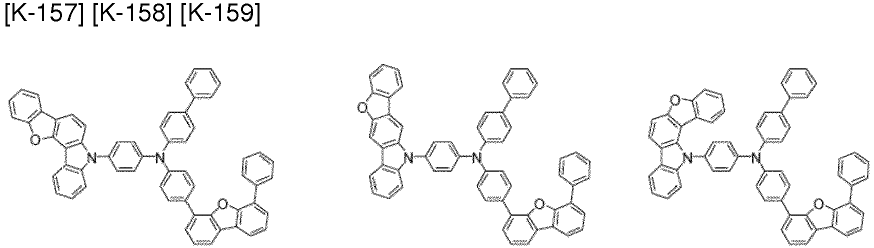

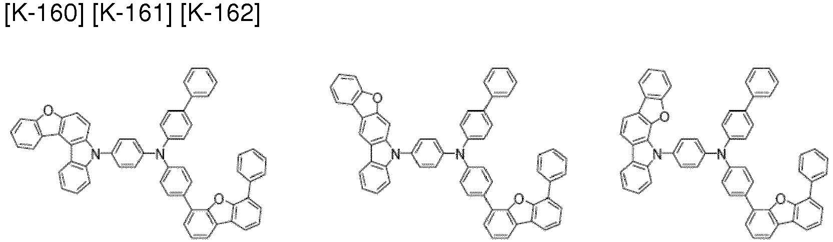

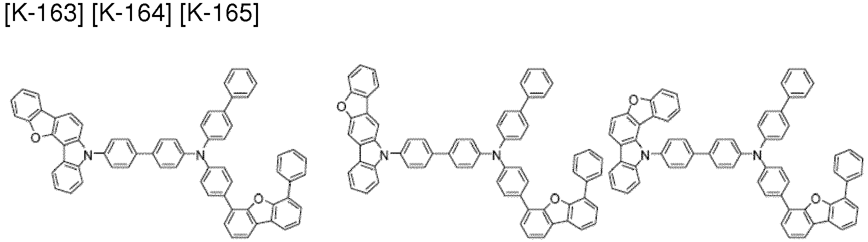

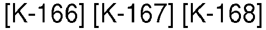

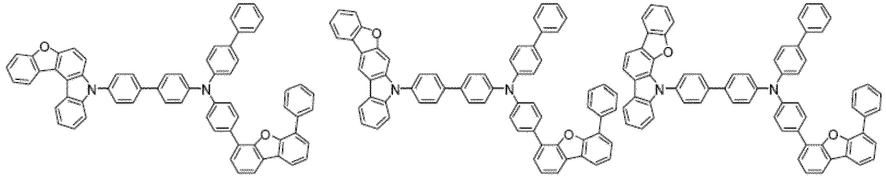

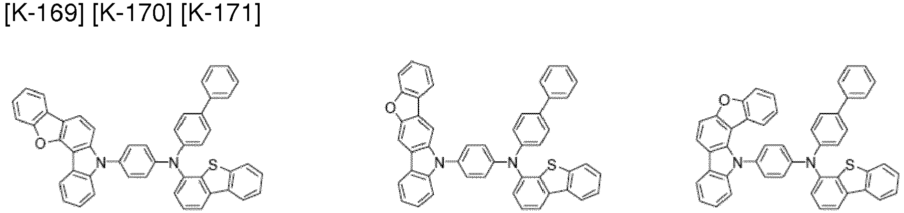

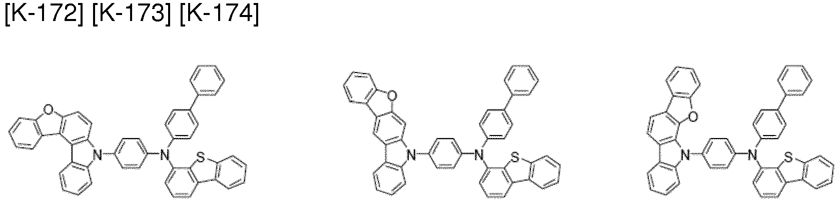

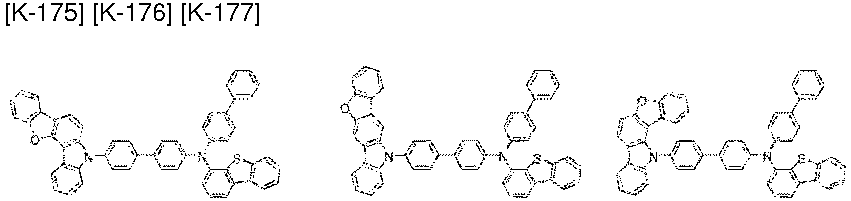

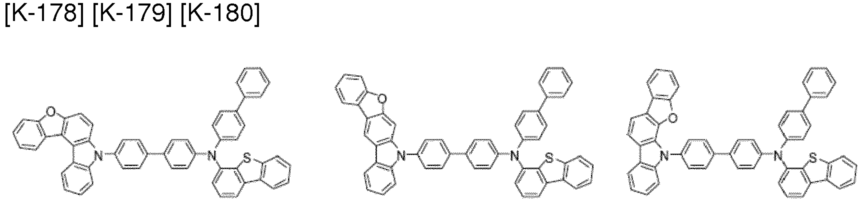

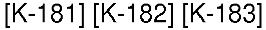

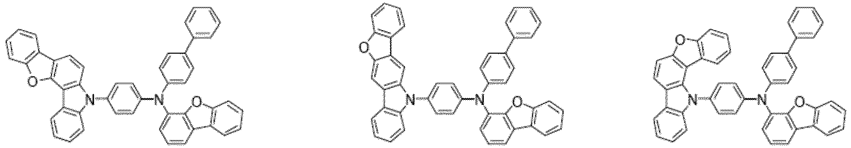

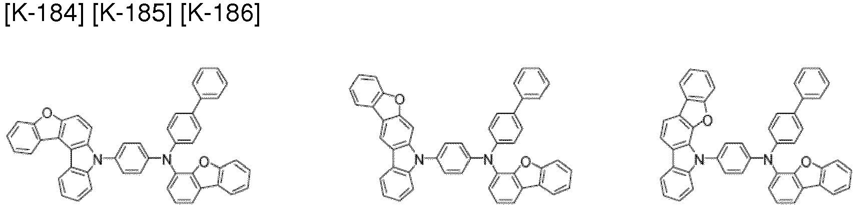

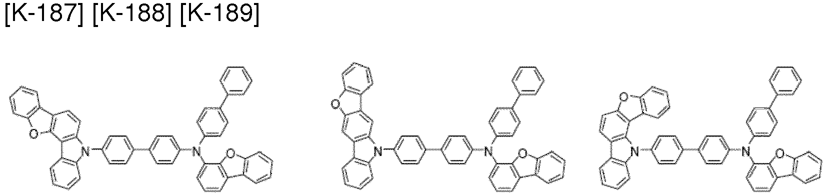

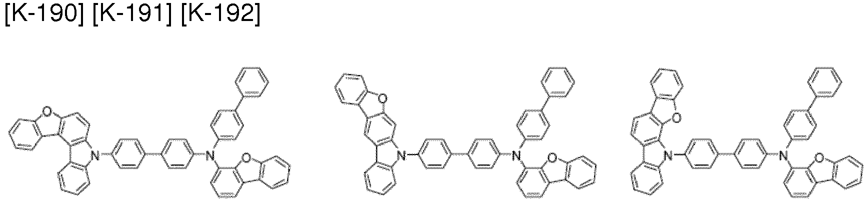

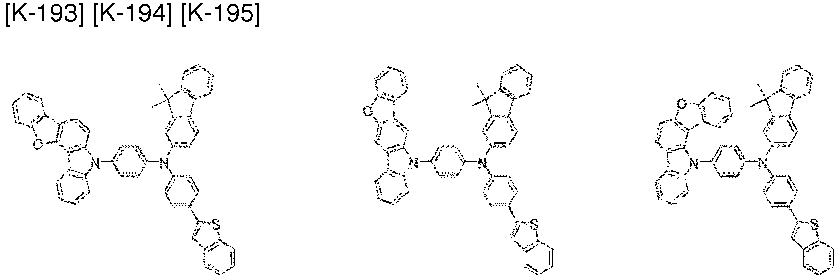

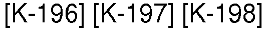

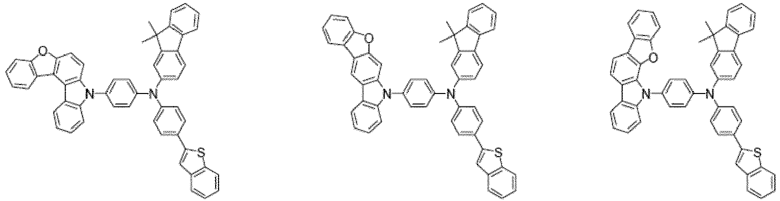

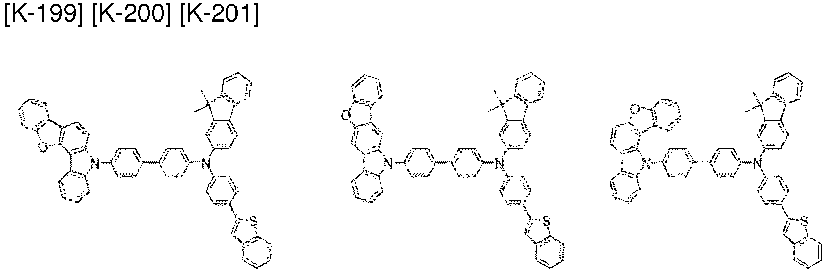

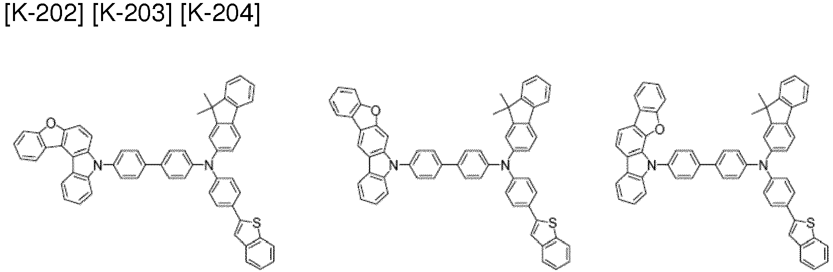

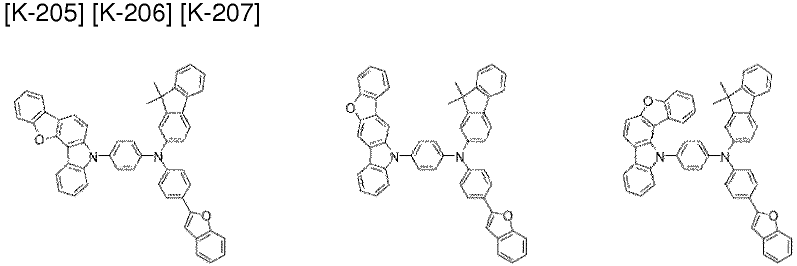

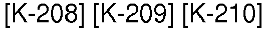

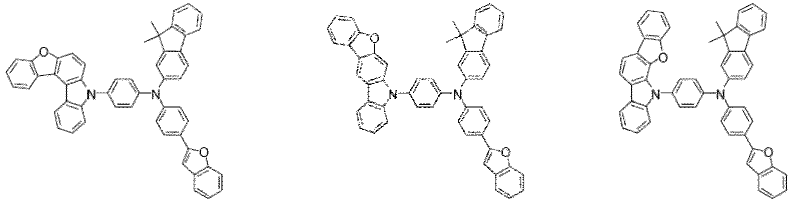

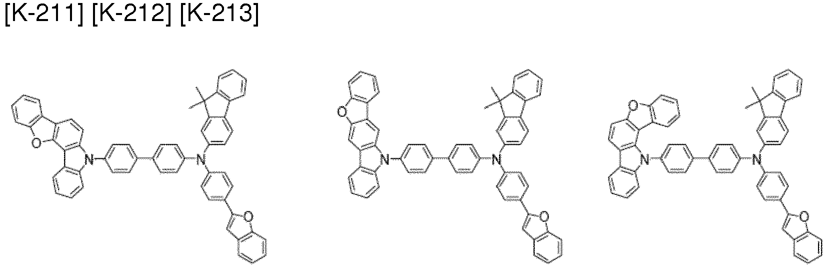

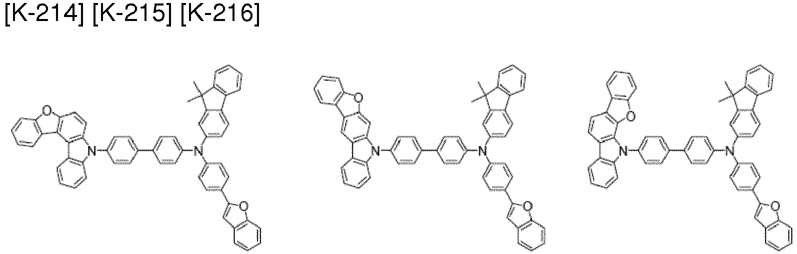

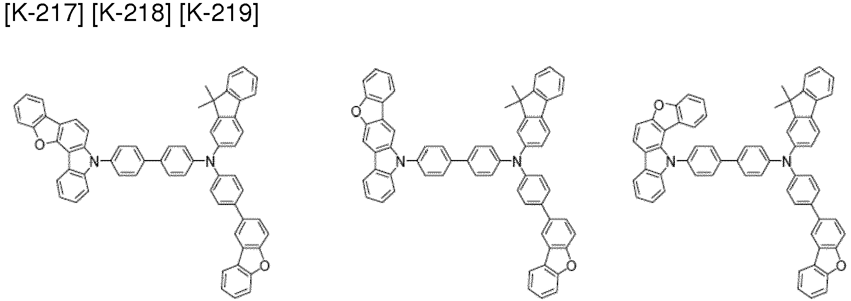

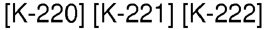

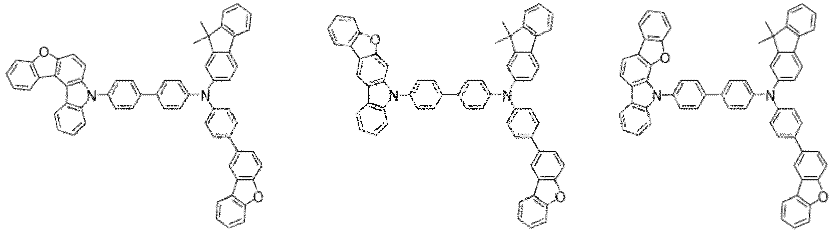

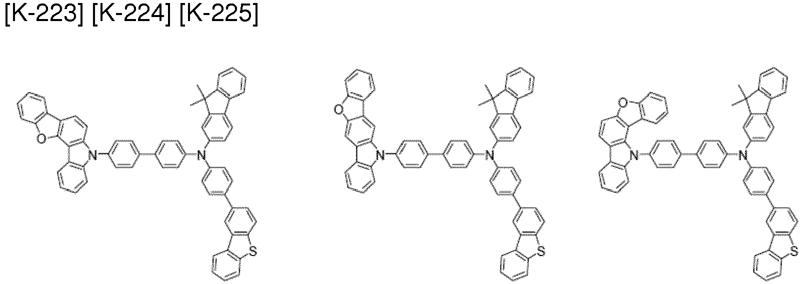

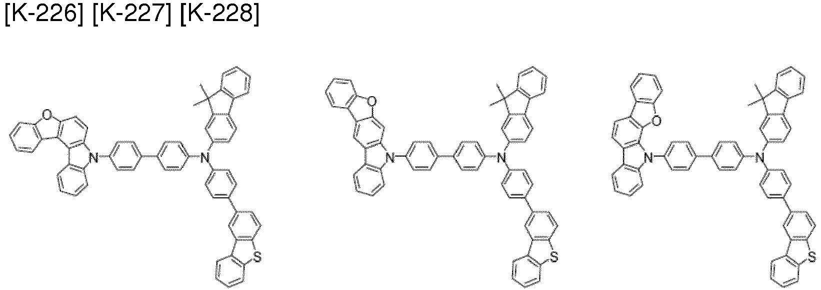

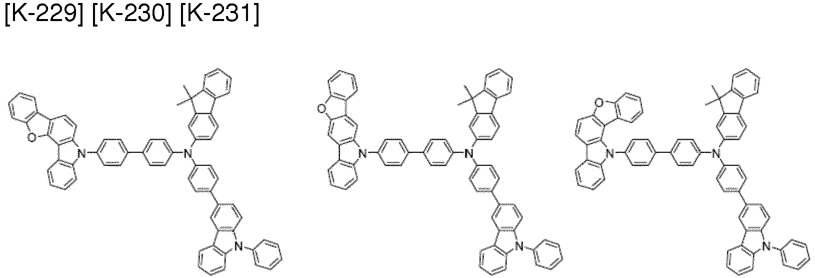

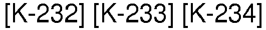

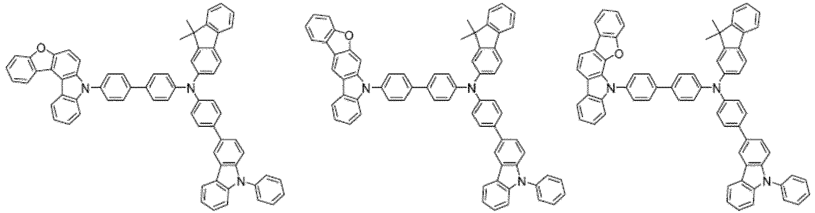

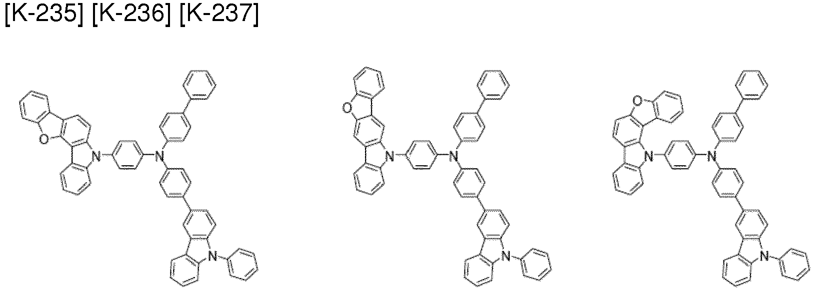

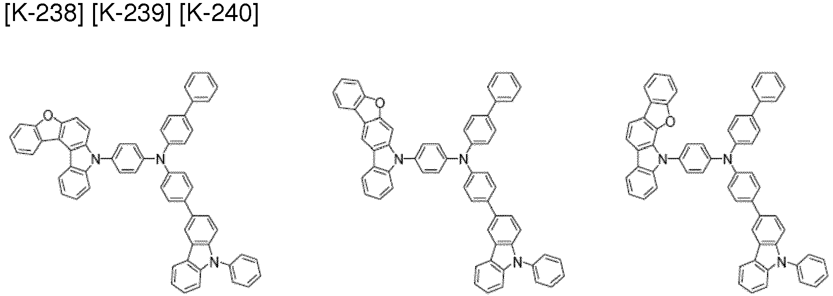

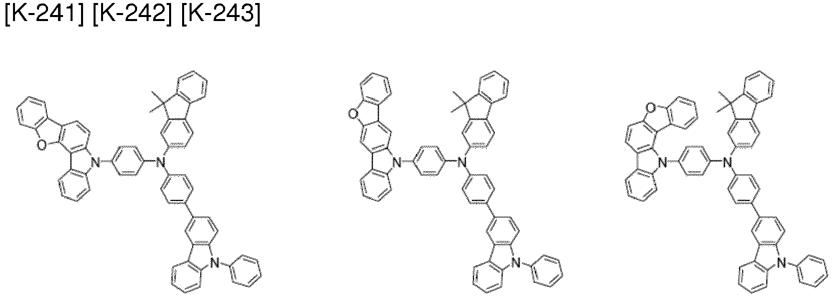

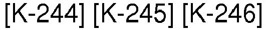

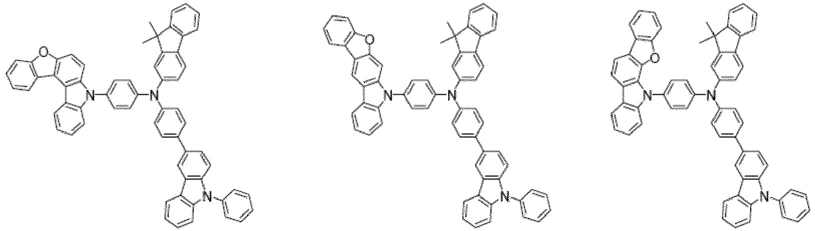

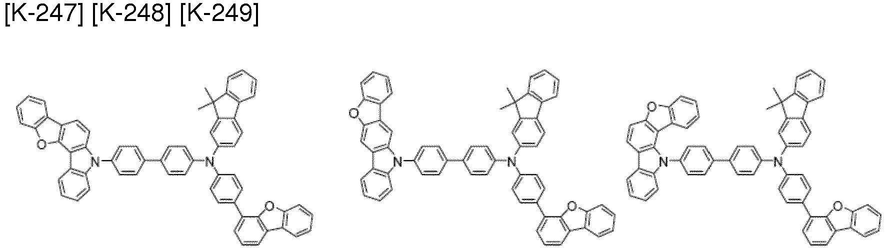

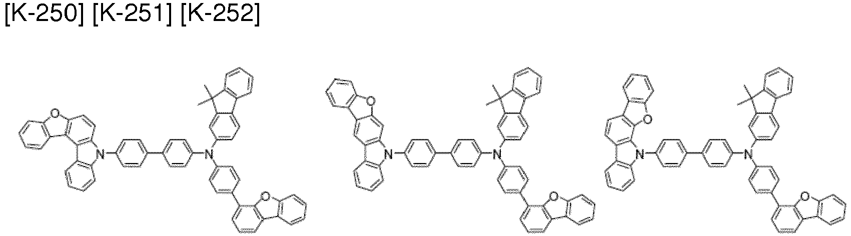

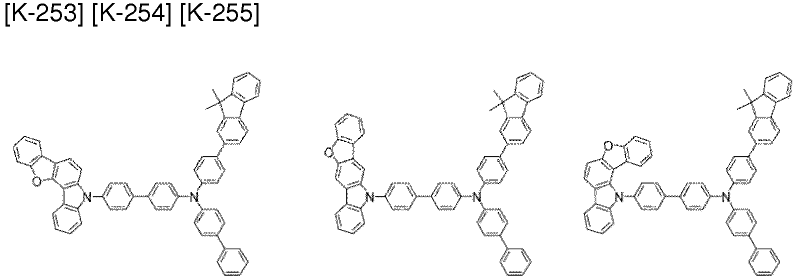

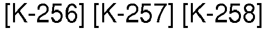

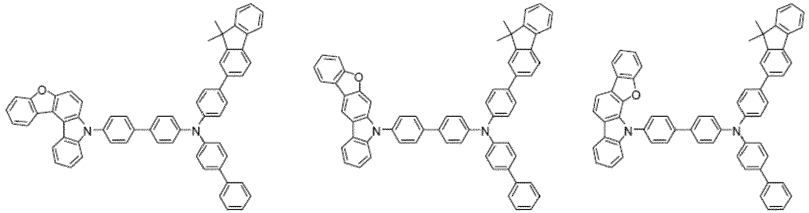

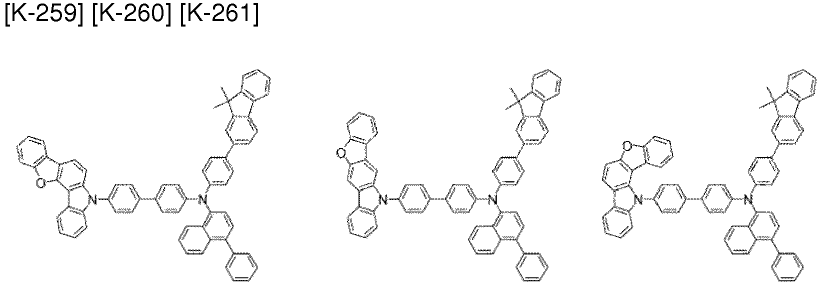

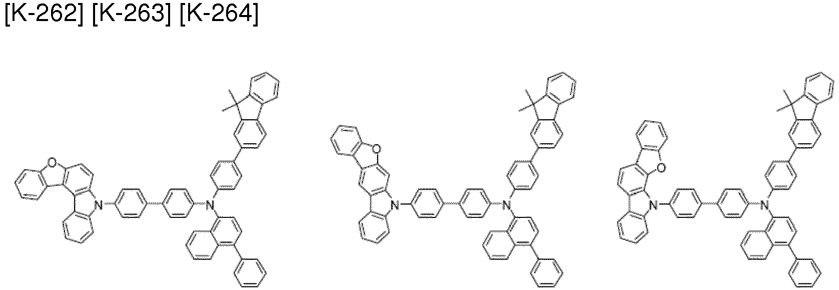

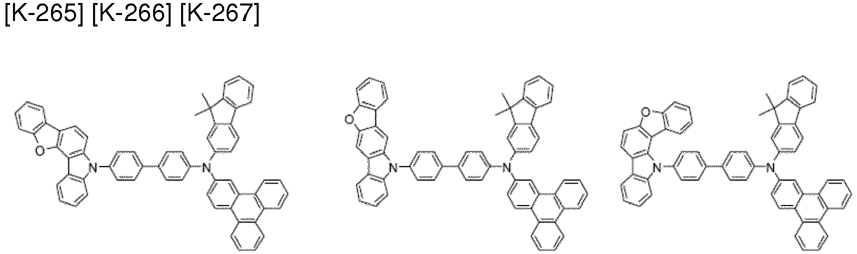

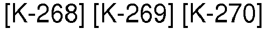

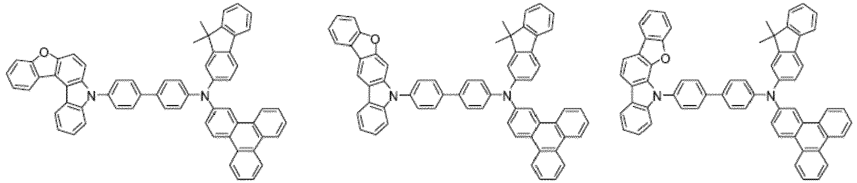

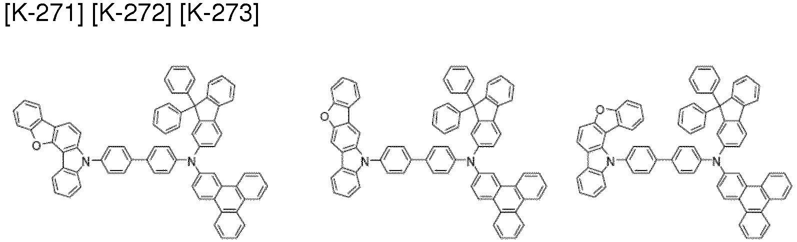

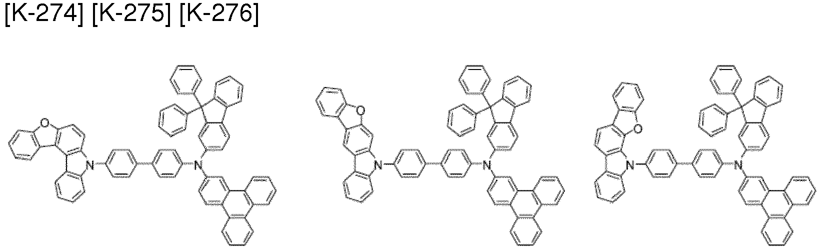

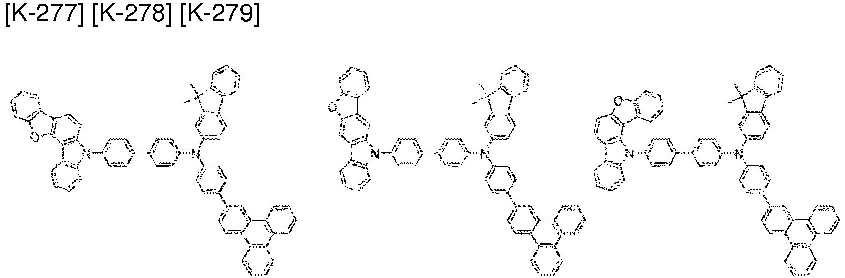

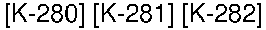

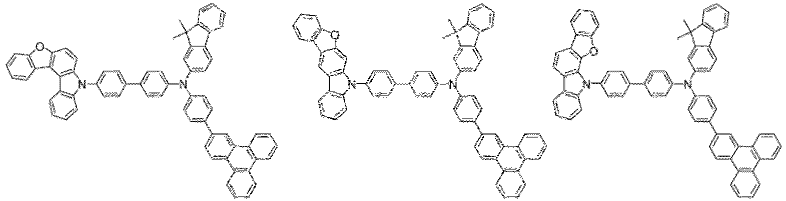

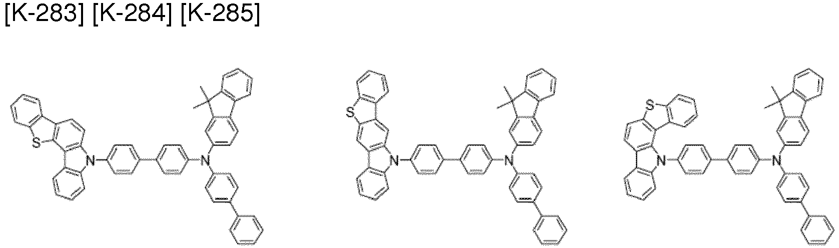

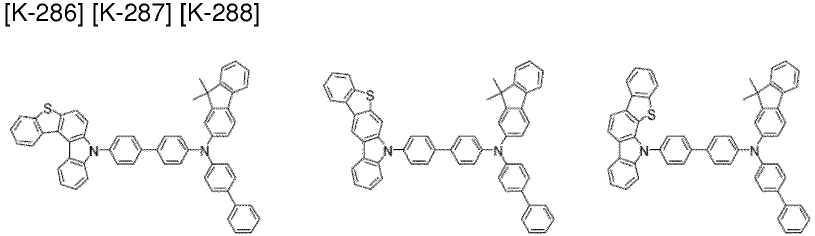

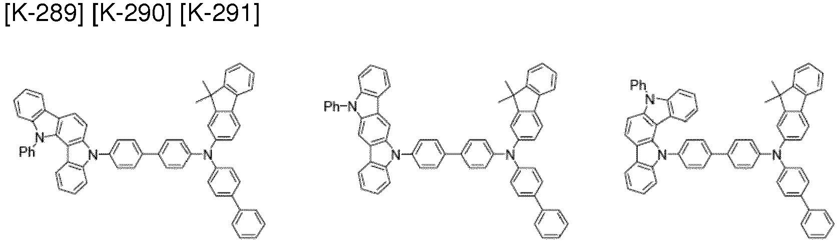

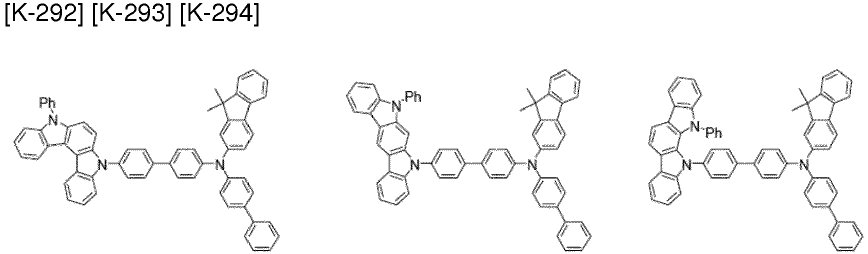

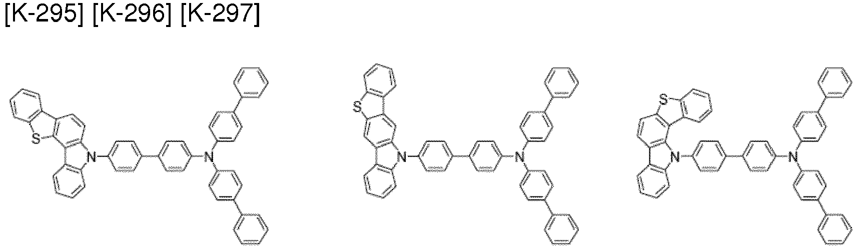

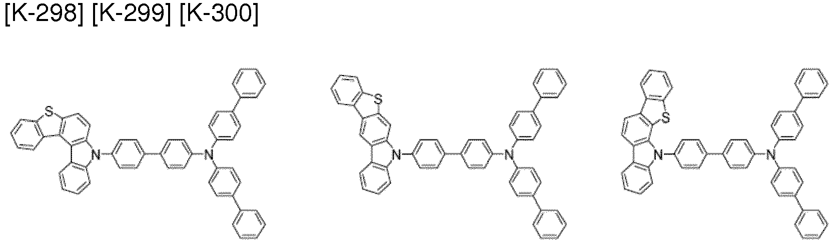

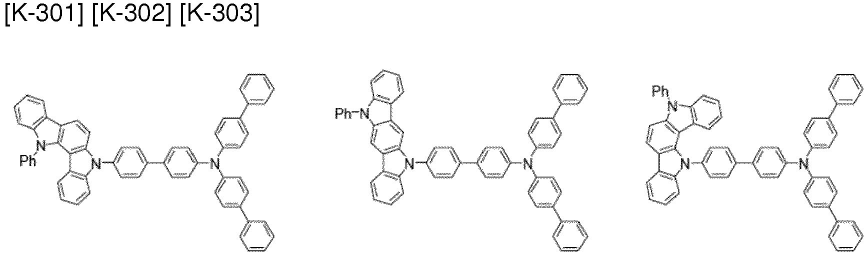

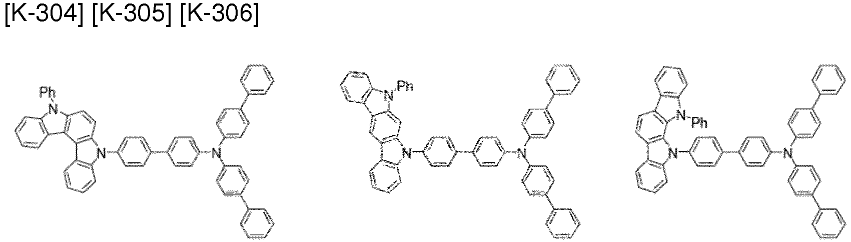

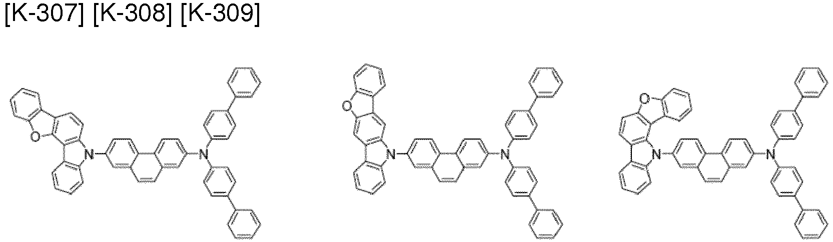

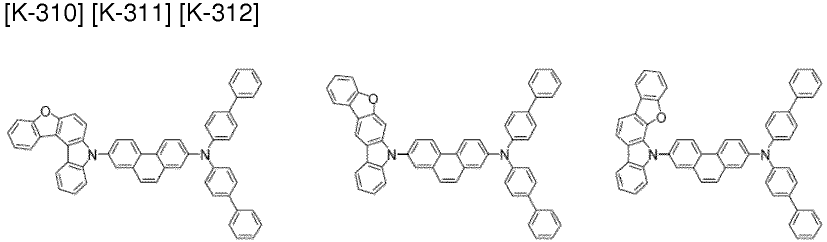

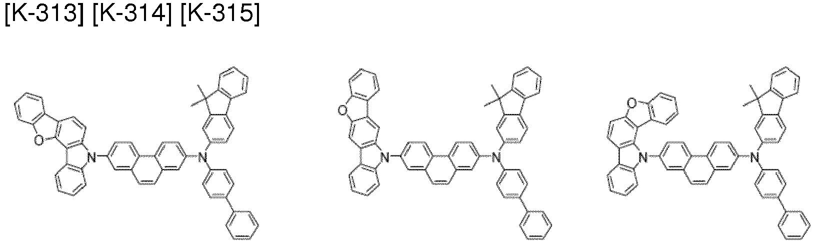

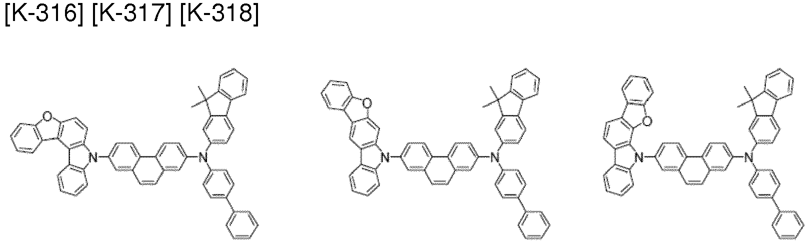

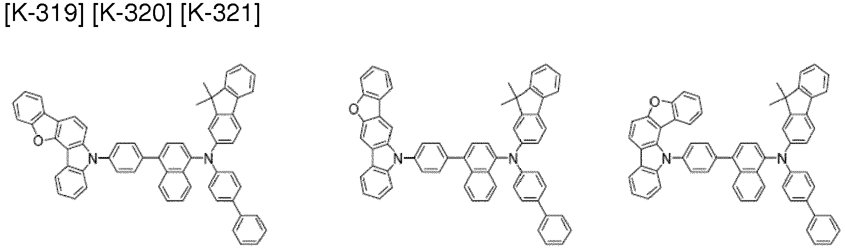

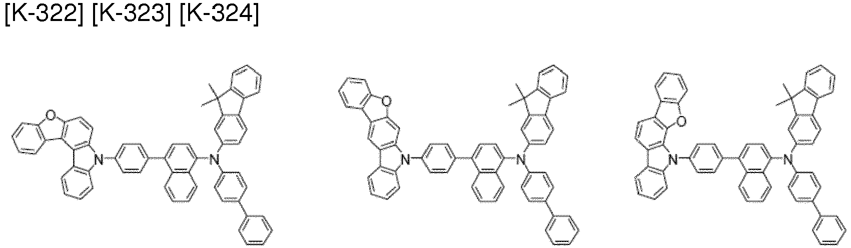

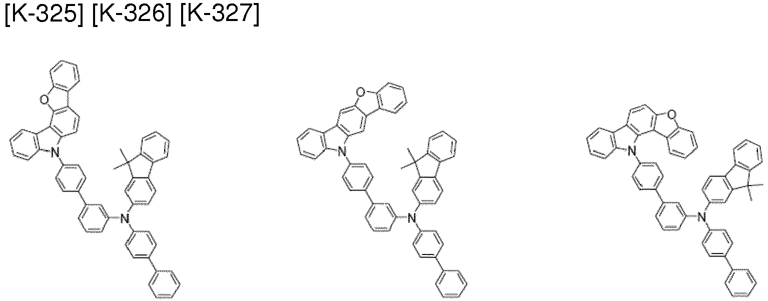

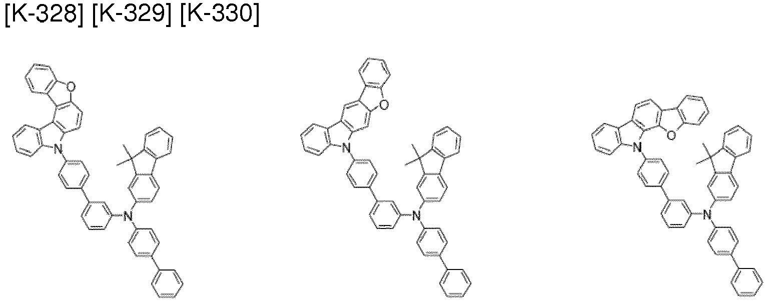

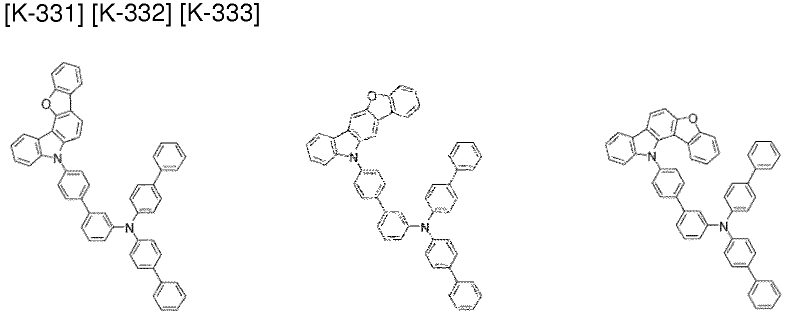

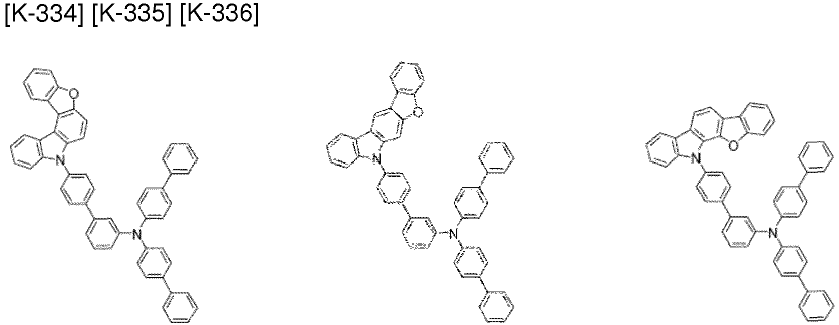

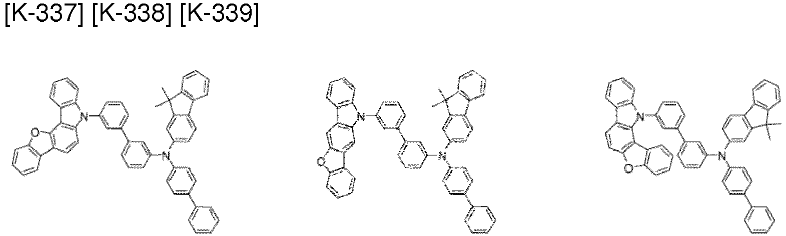

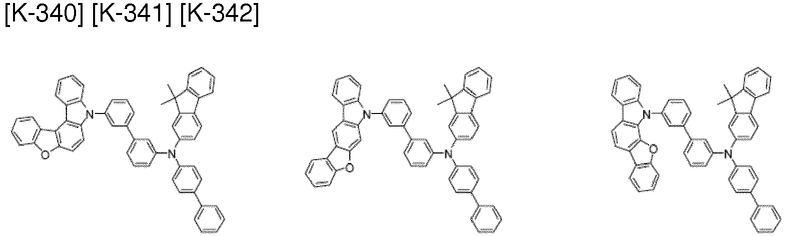

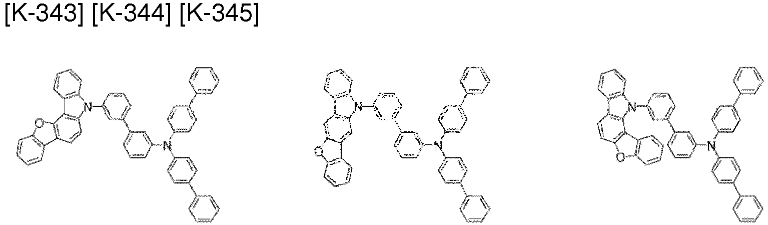

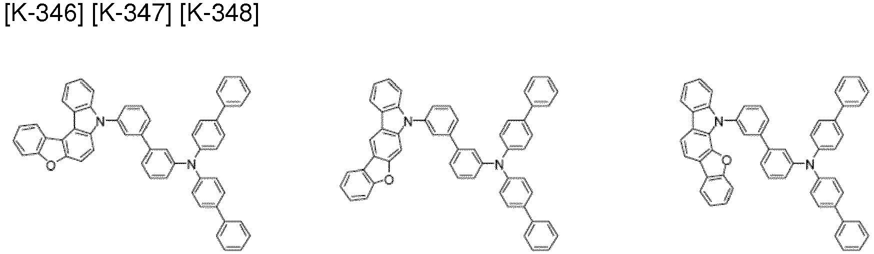

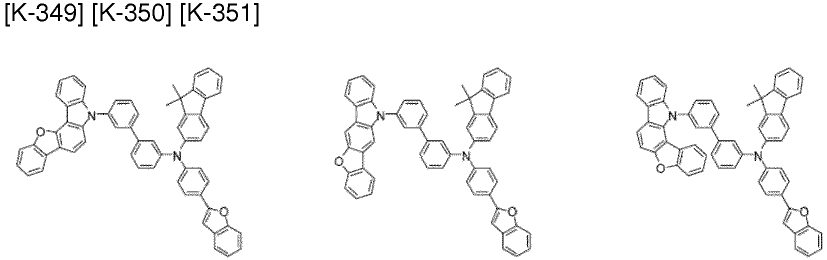

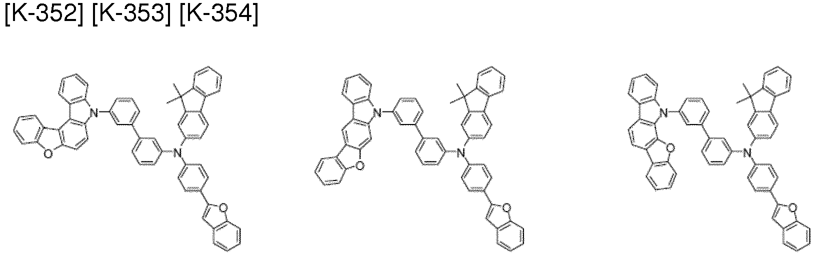

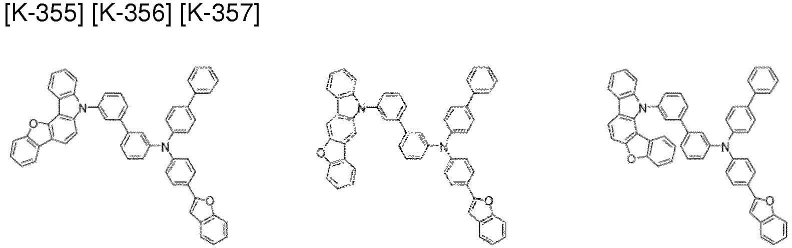

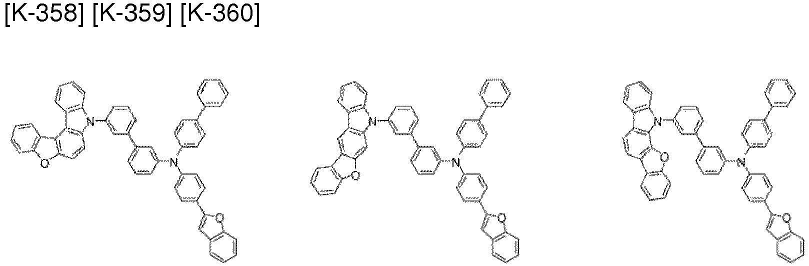

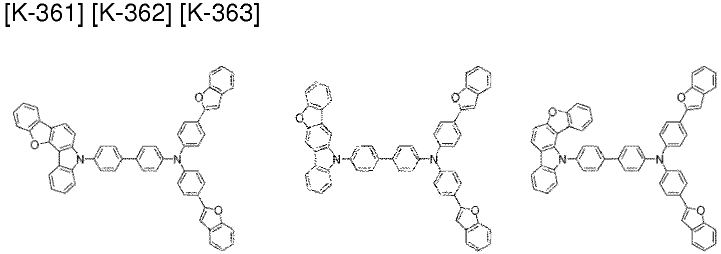

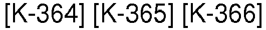

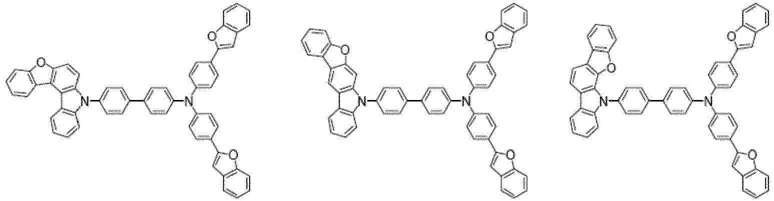

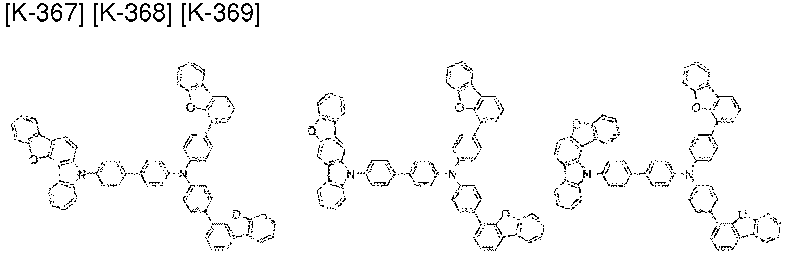

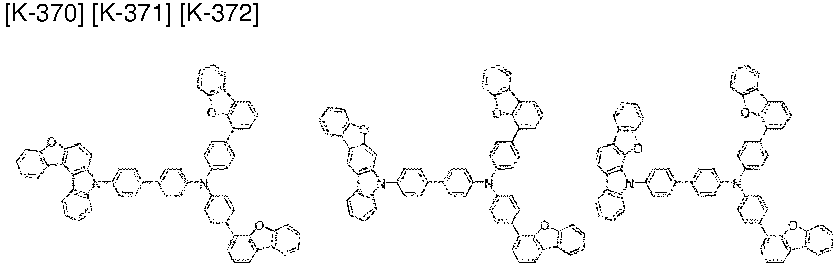

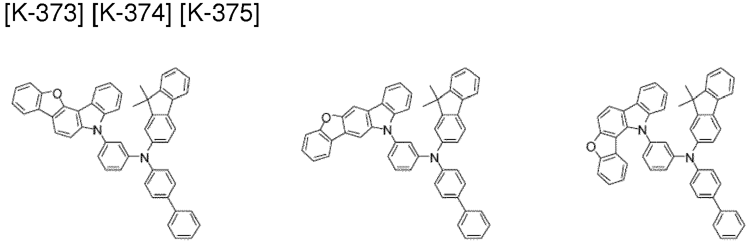

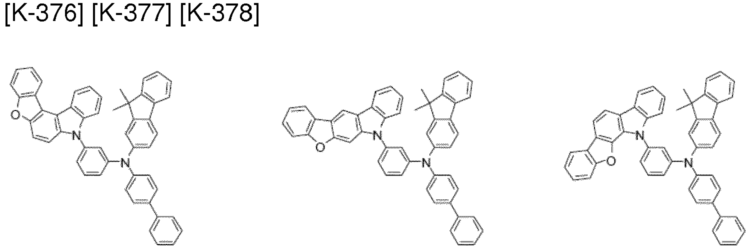

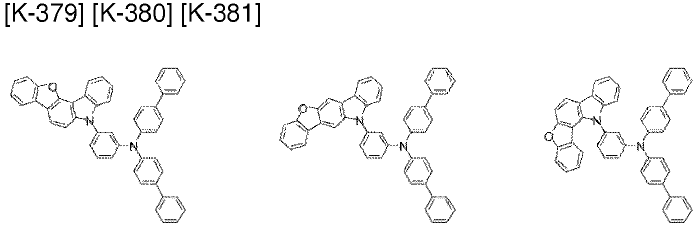

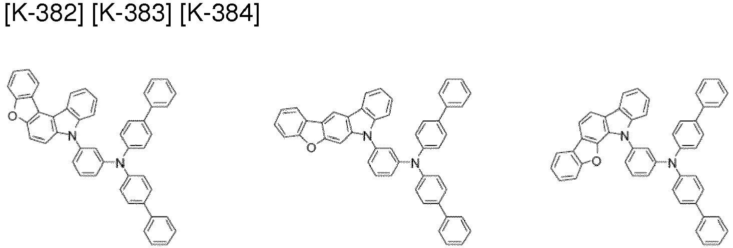

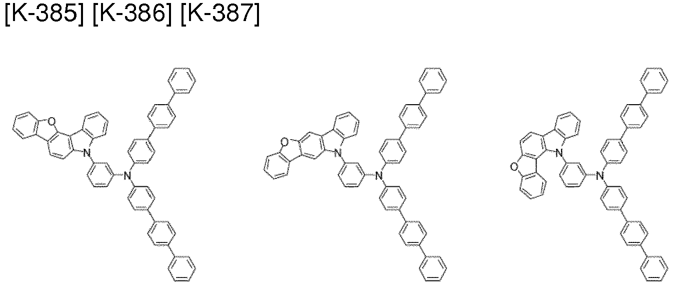

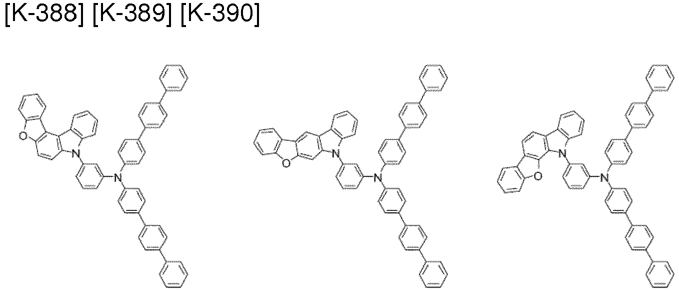

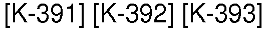

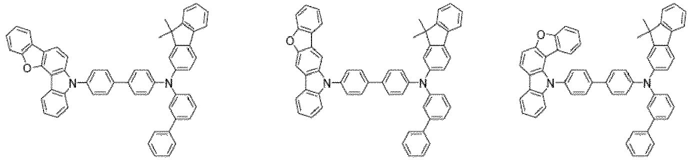

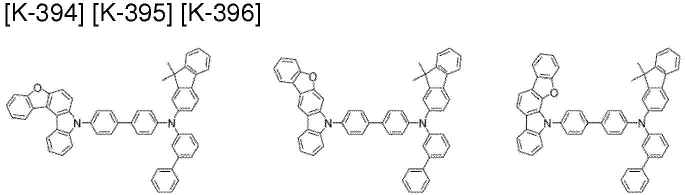

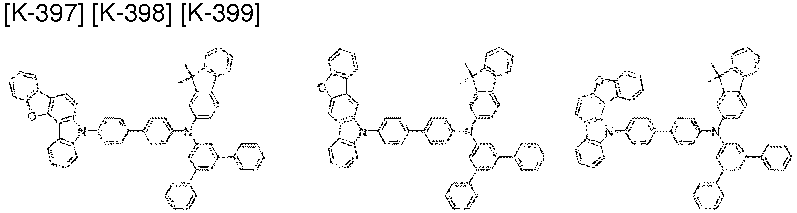

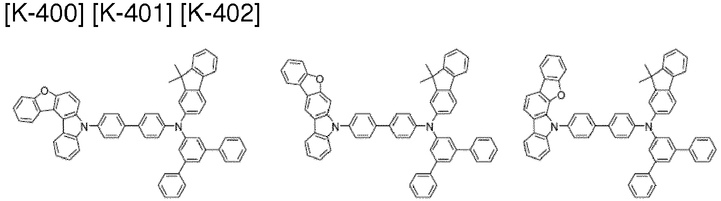

For more specific examples, the compound represented by Chemical Formula 11 (not forming part of the present invention) may be represented by the following Chemical Formula F-1 to F-182, G-1 to G-182, H-1 to H-203 or 1-1 to I-56, but is not limited thereto.

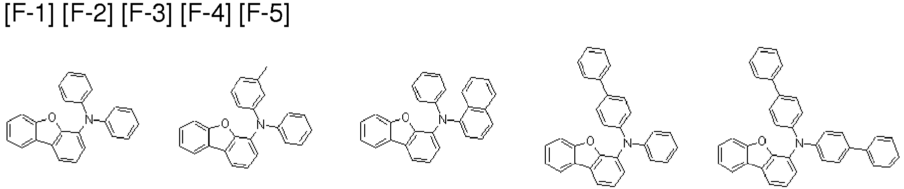

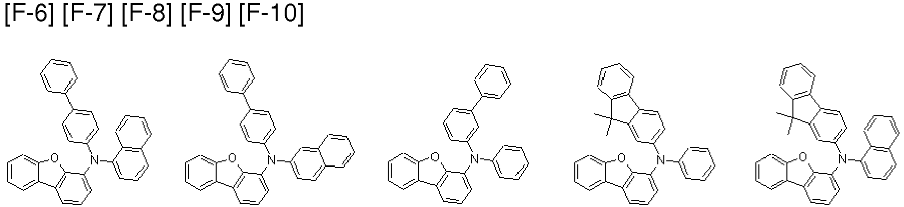

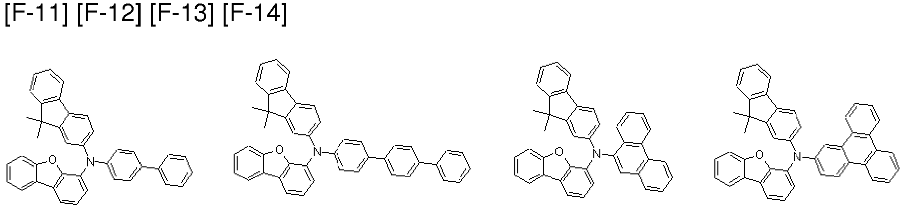

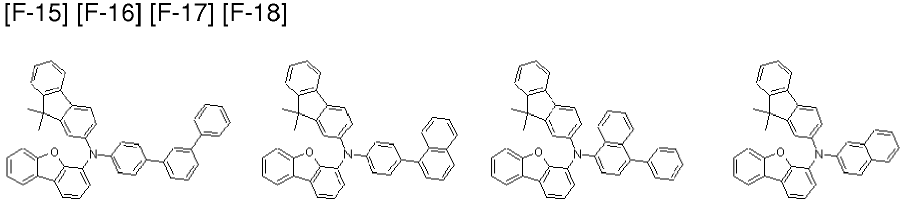

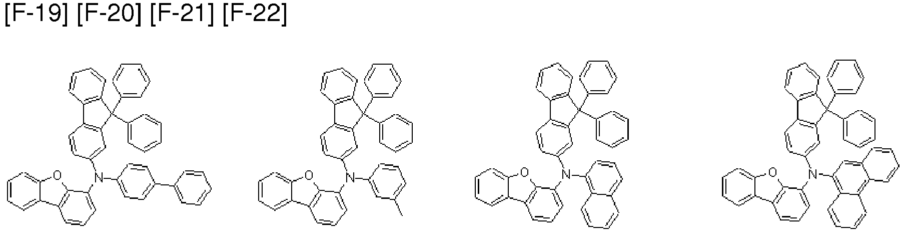

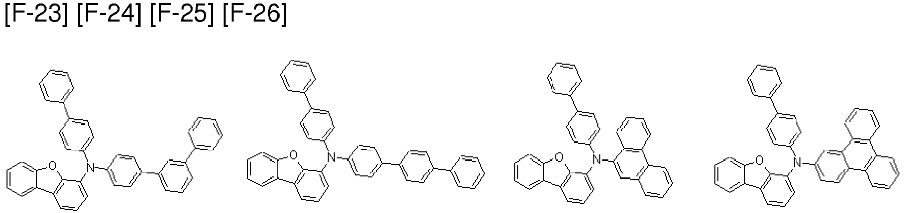

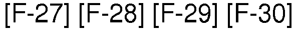

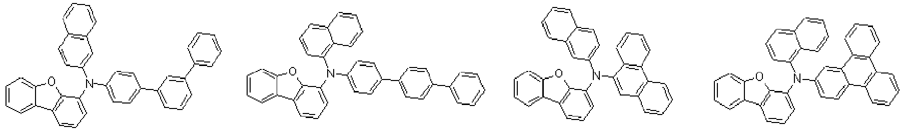

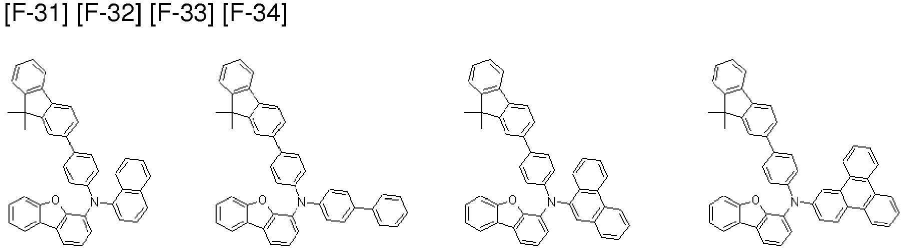

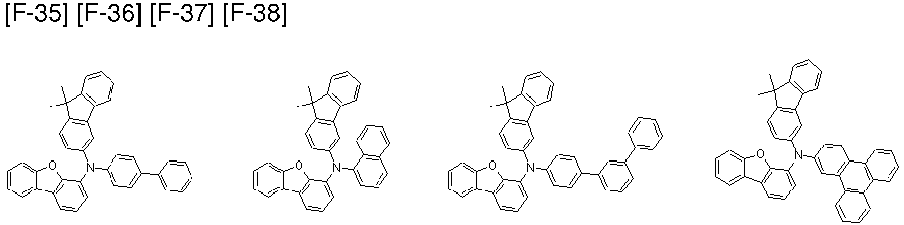

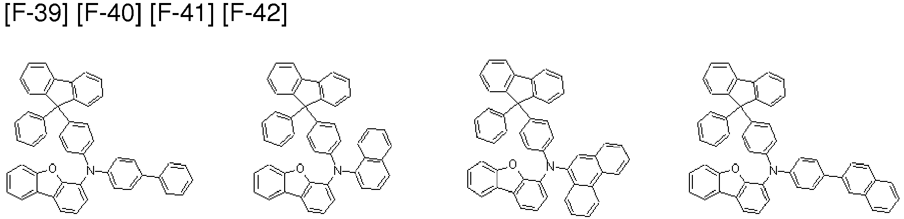

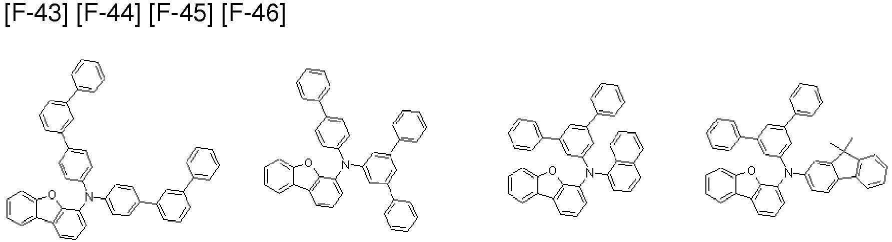

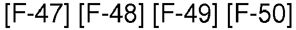

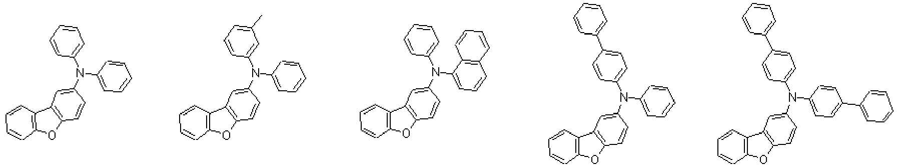

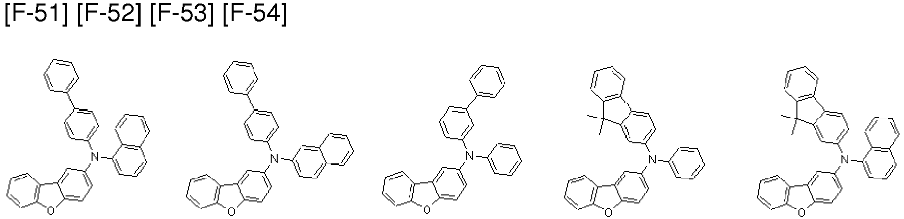

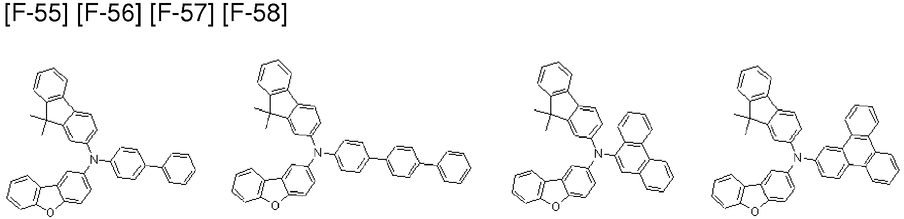

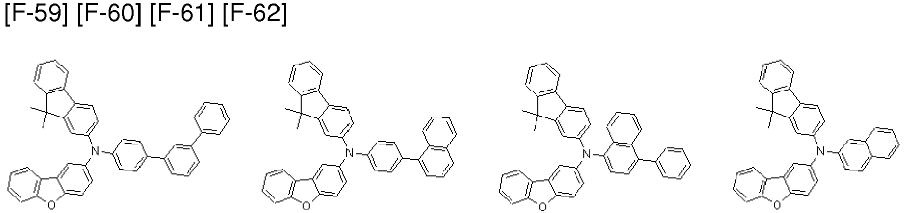

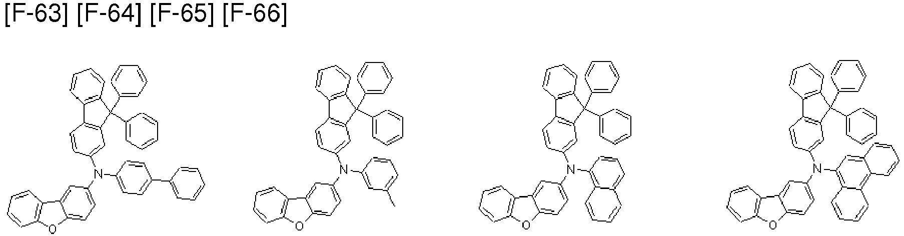

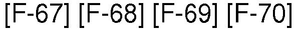

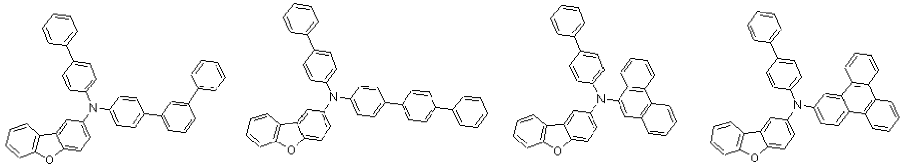

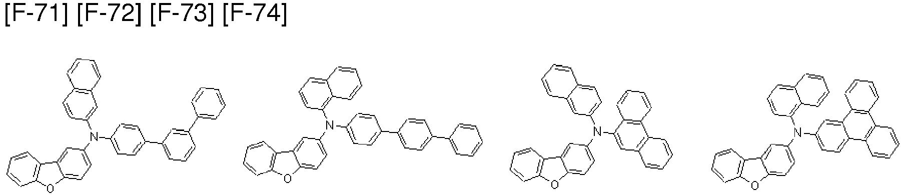

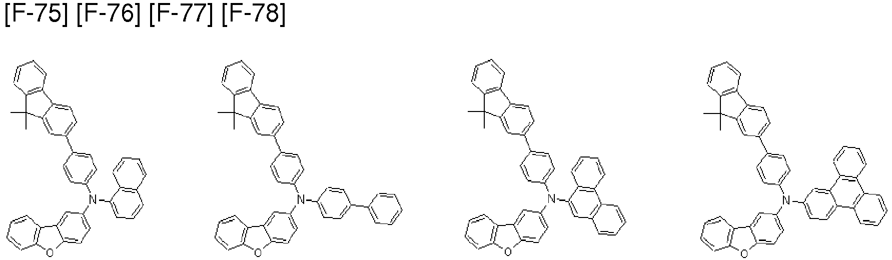

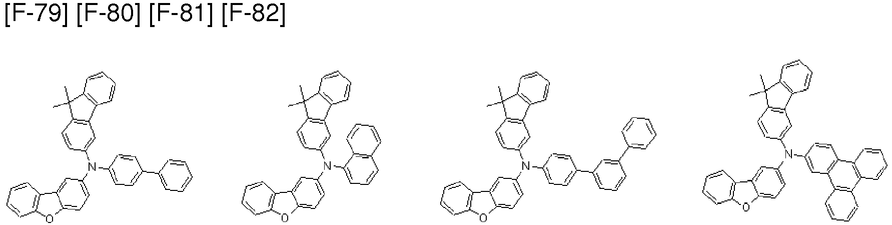

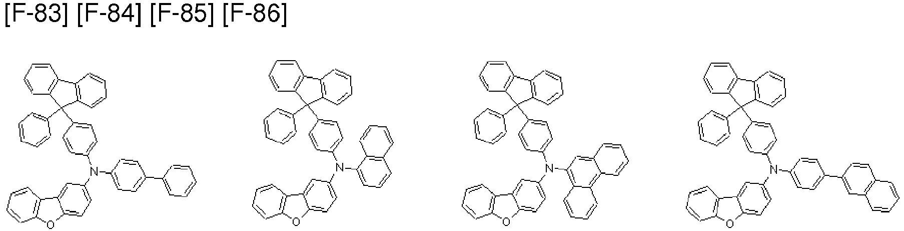

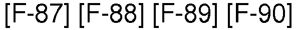

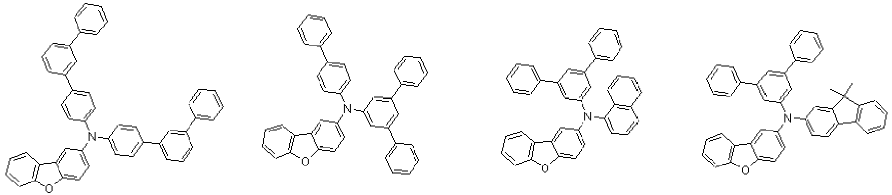

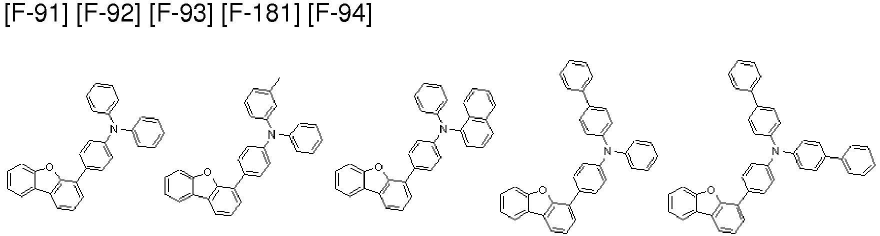

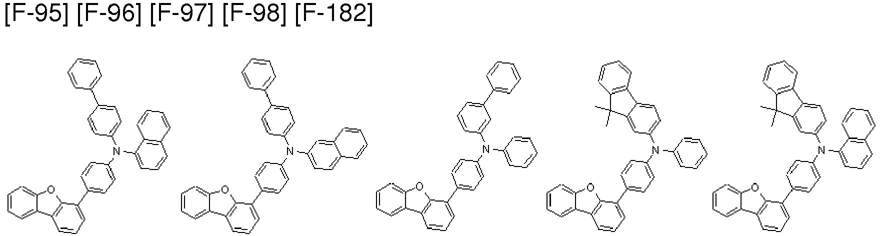

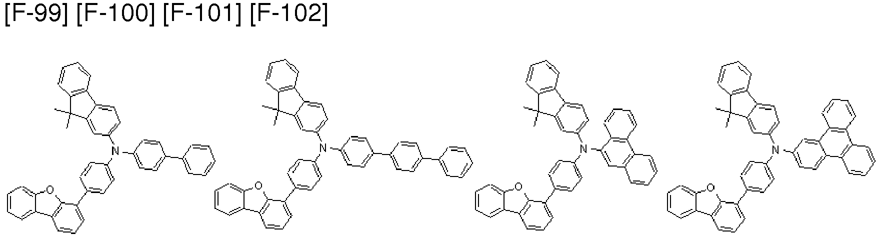

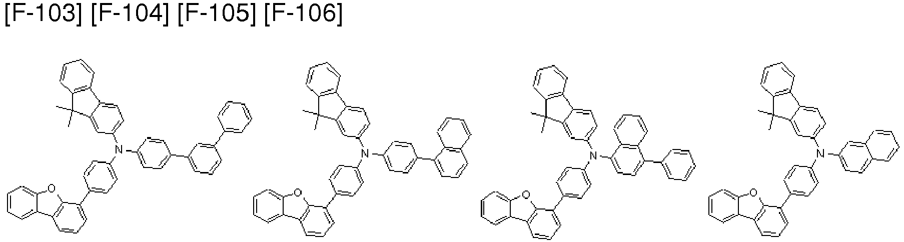

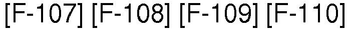

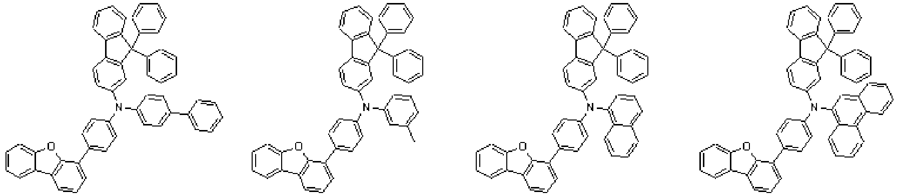

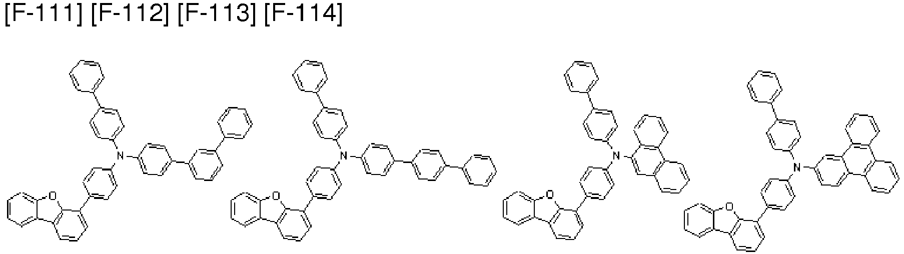

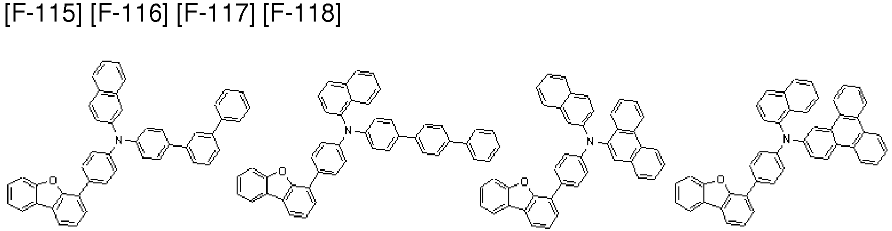

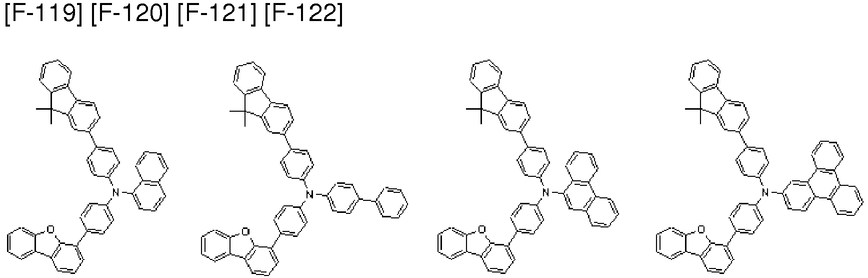

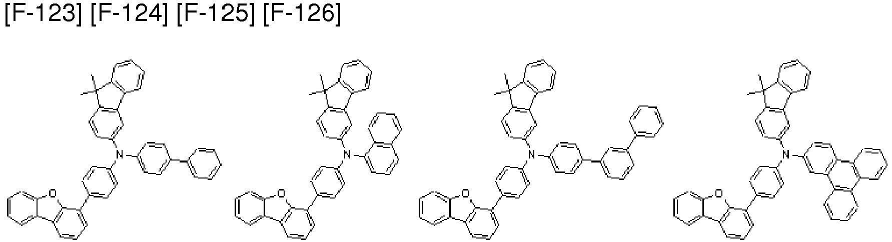

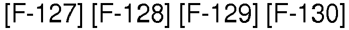

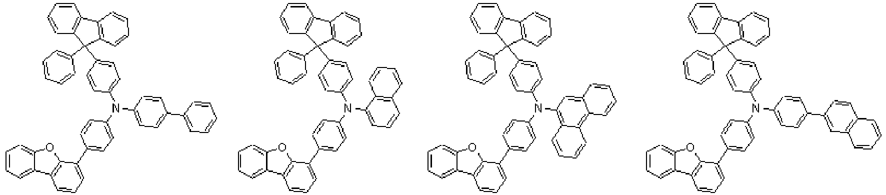

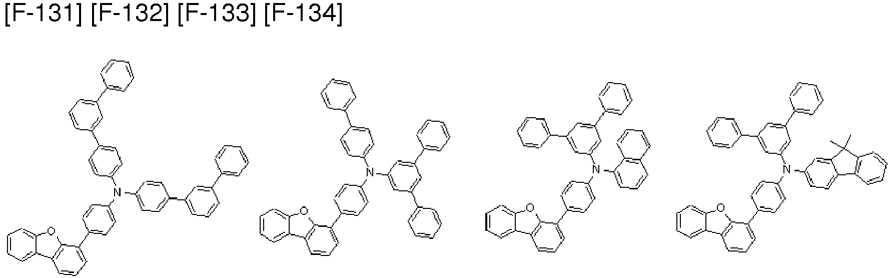

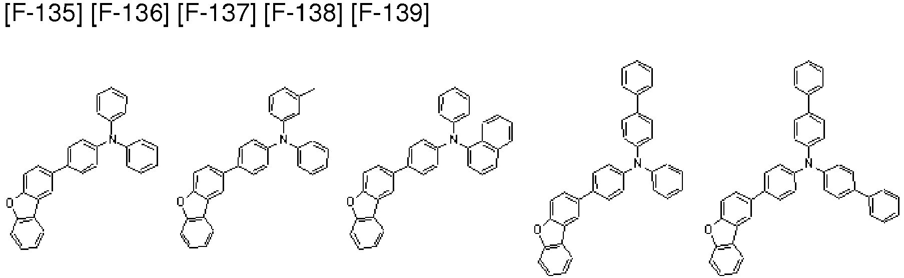

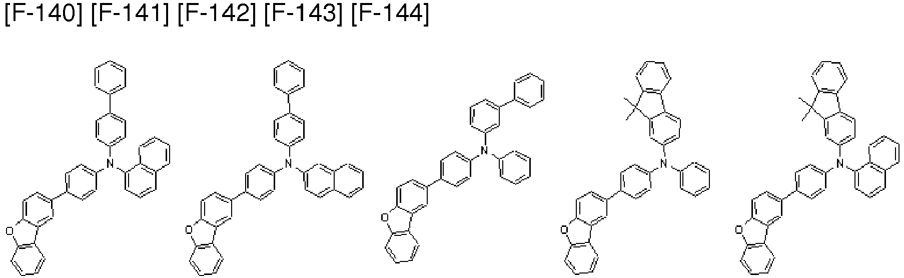

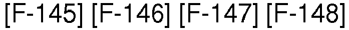

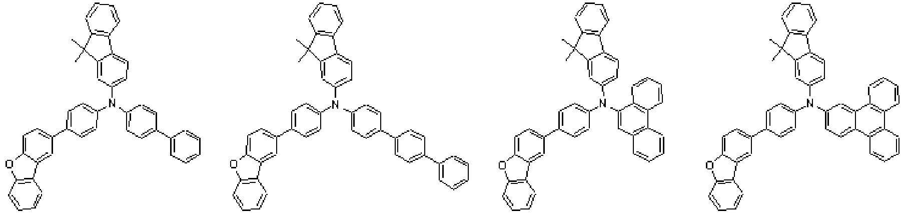

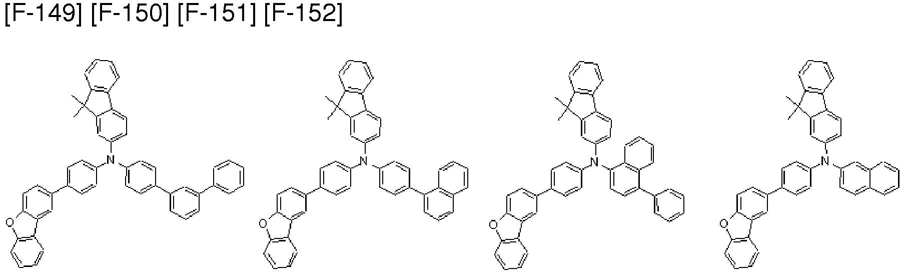

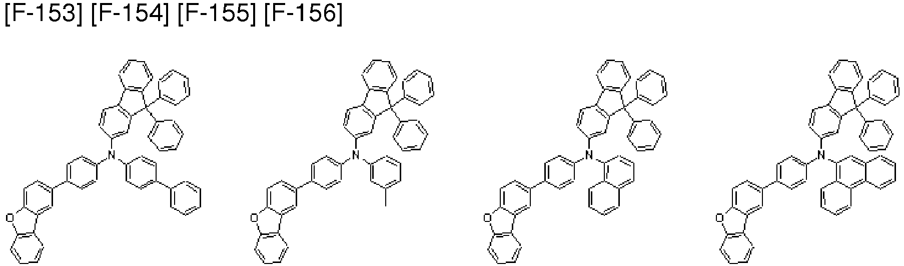

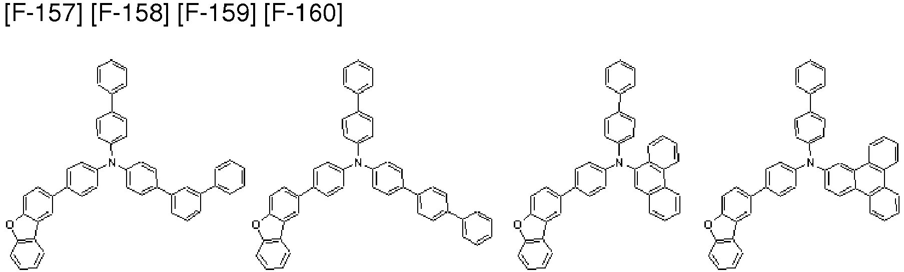

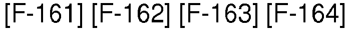

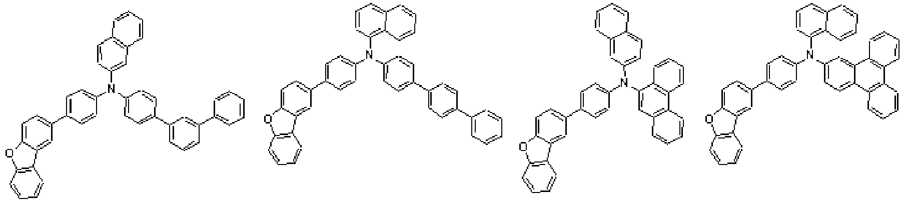

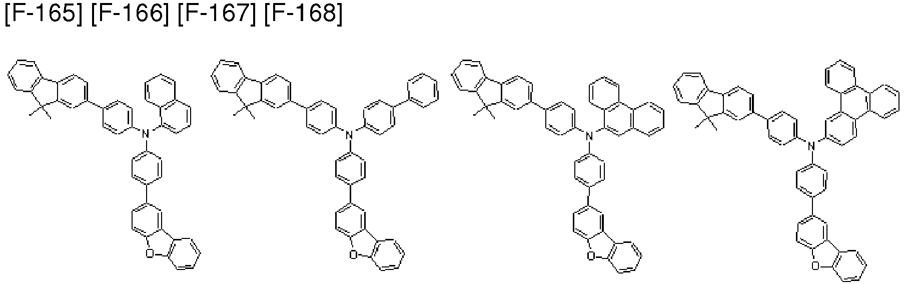

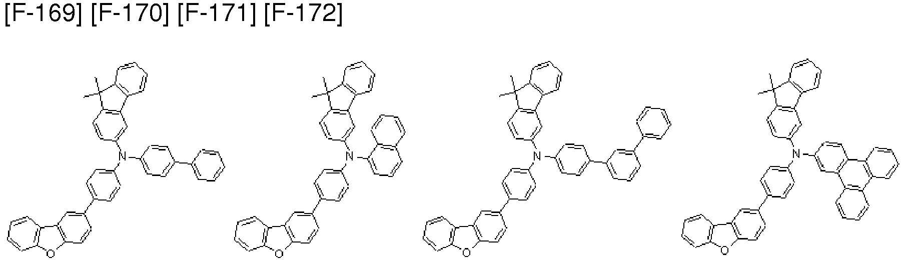

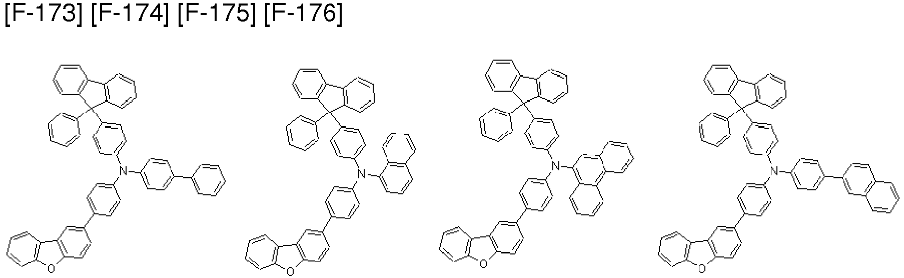

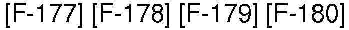

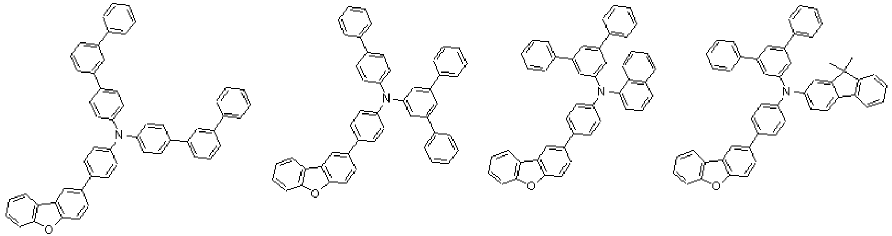

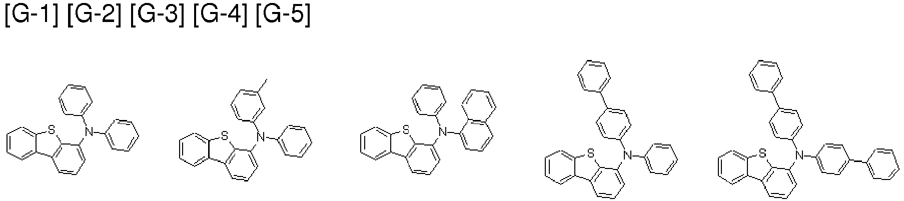

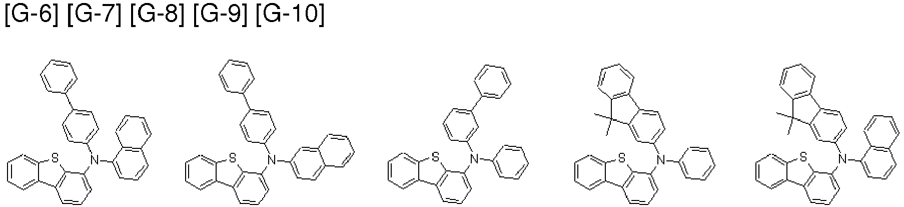

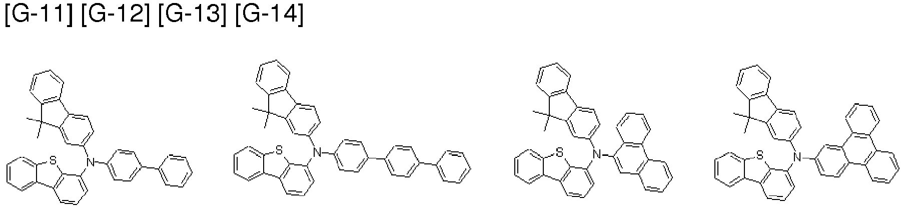

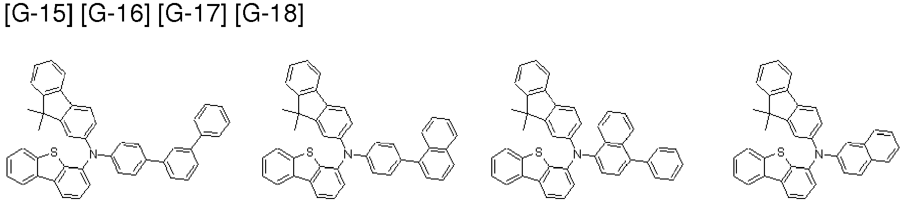

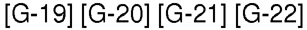

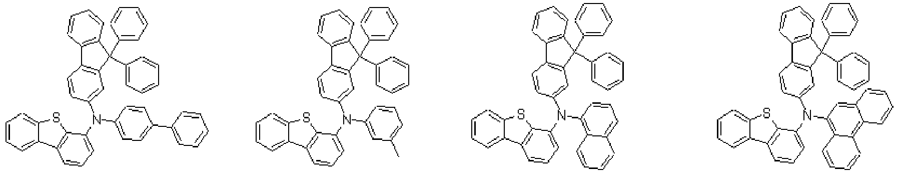

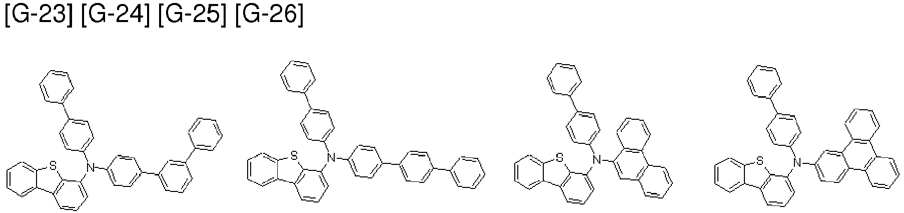

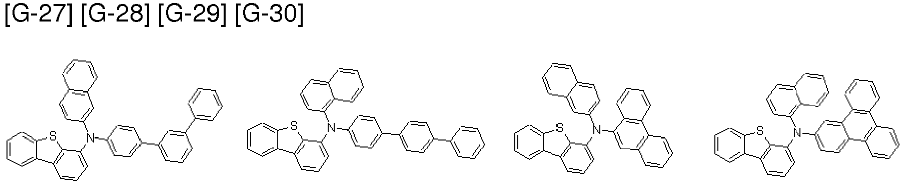

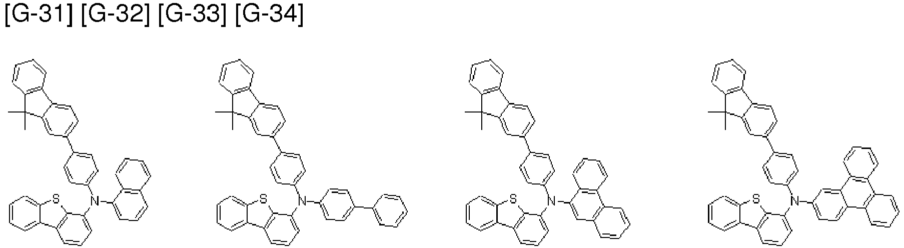

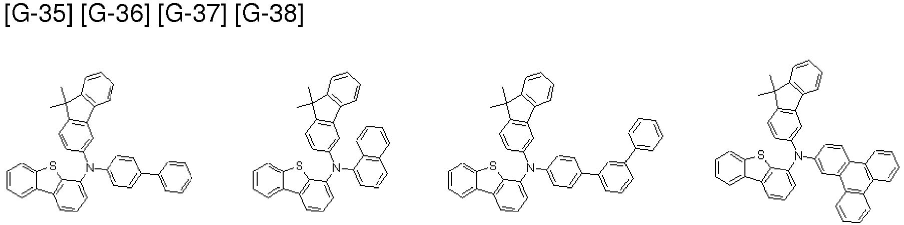

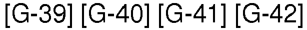

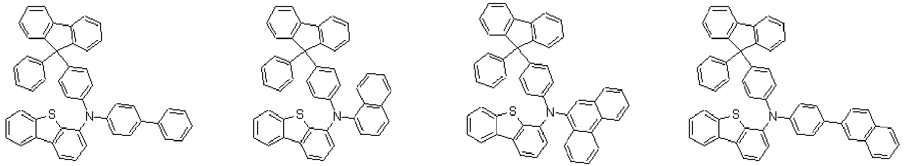

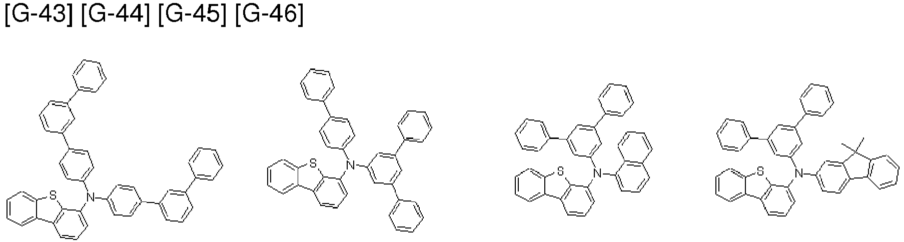

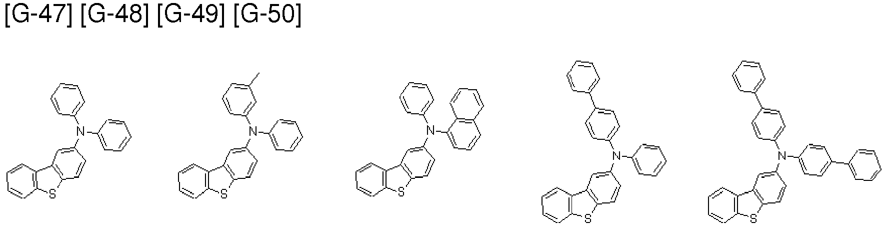

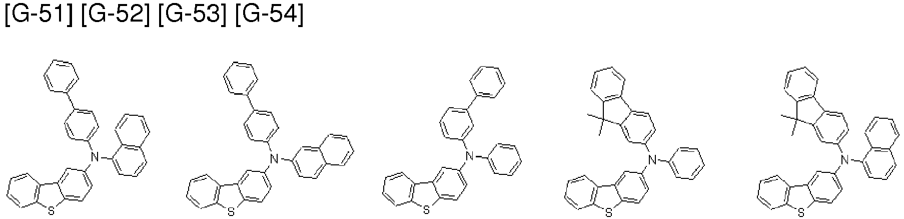

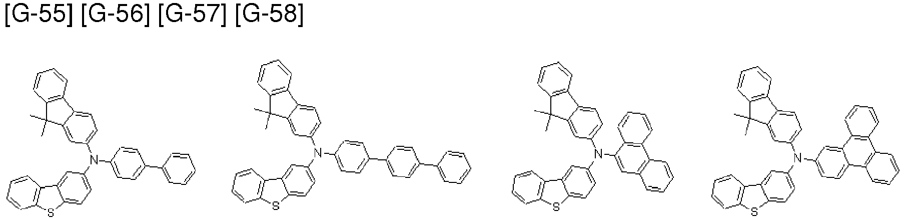

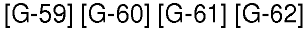

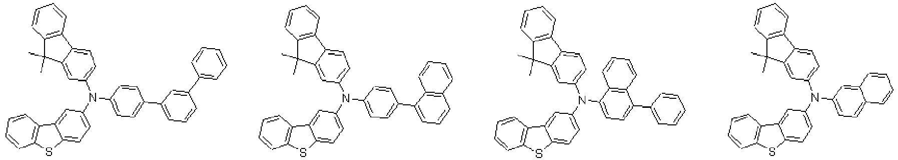

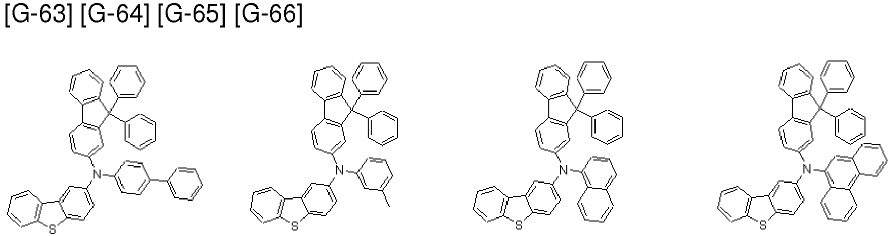

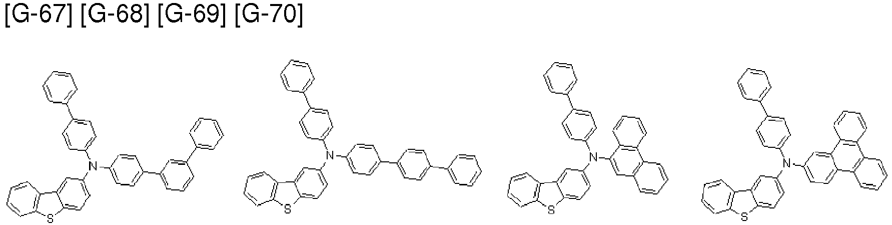

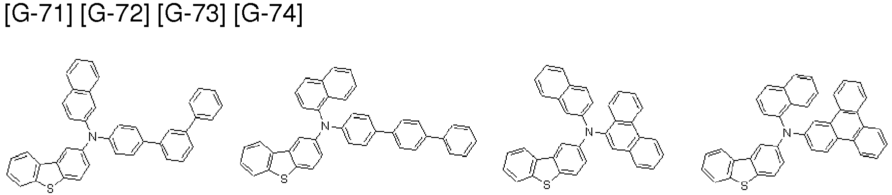

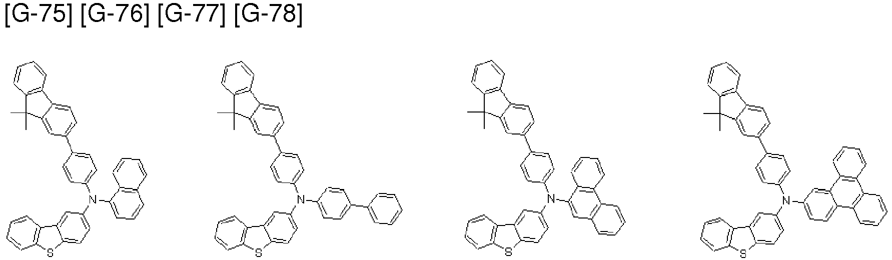

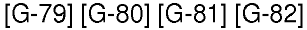

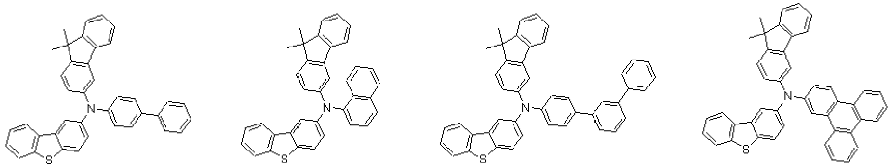

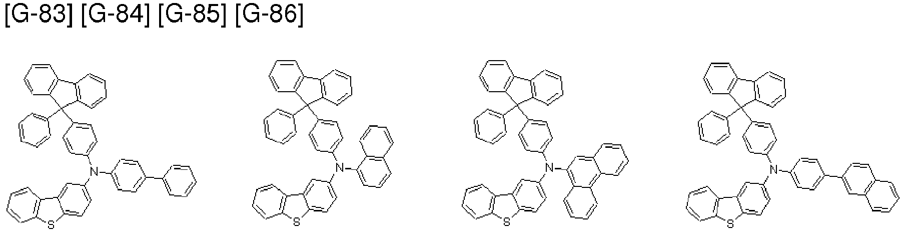

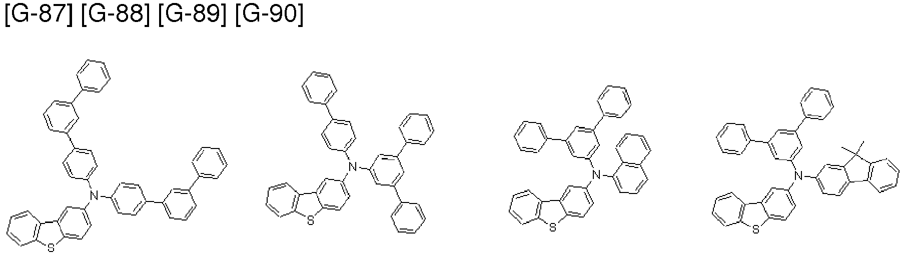

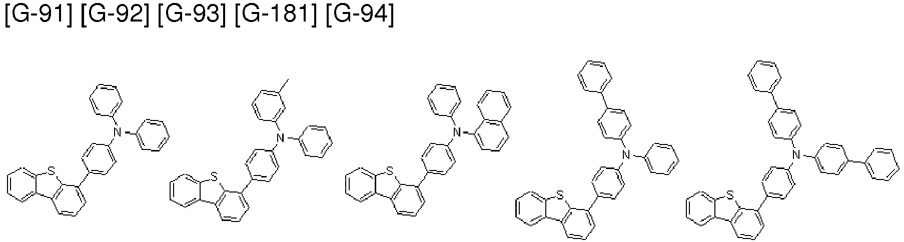

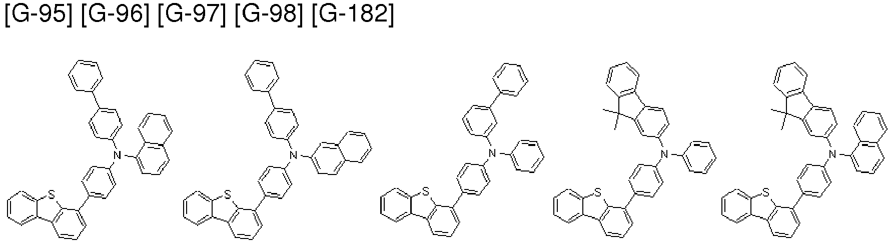

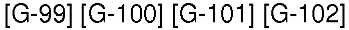

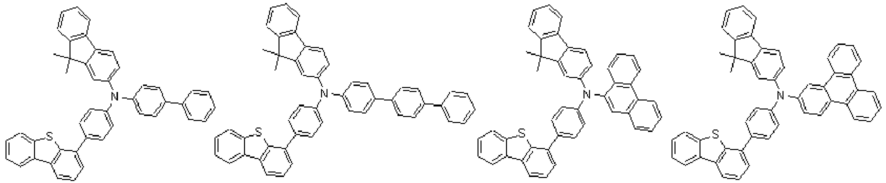

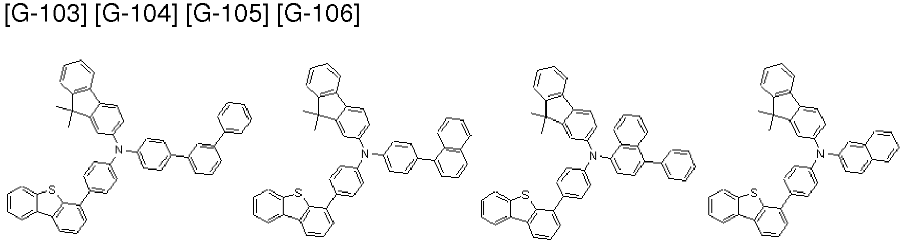

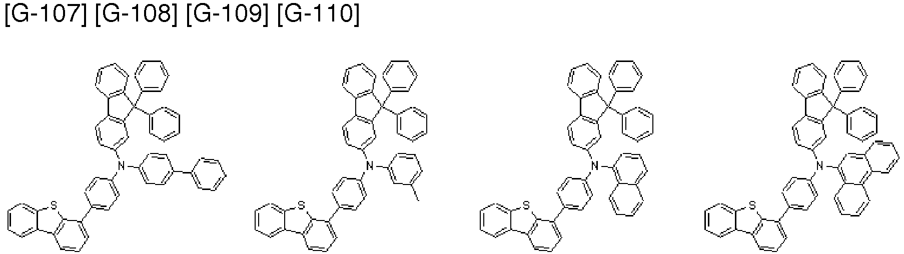

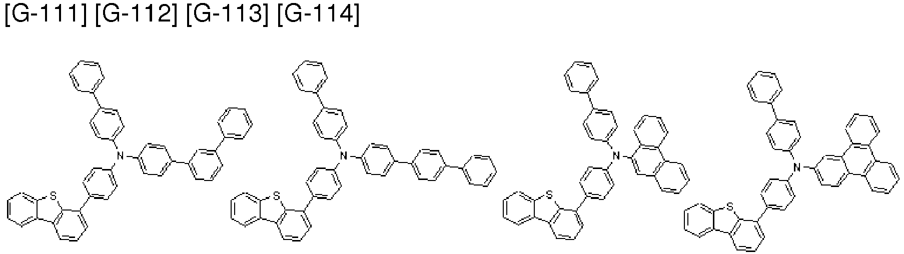

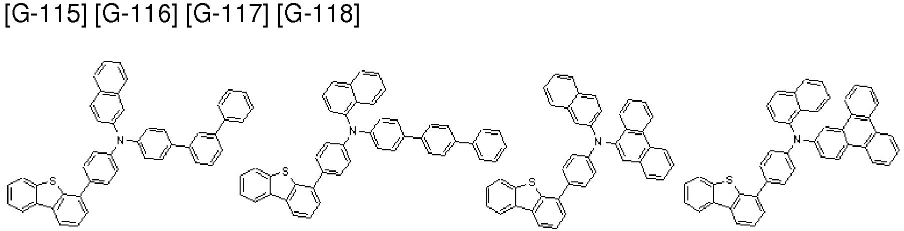

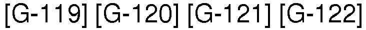

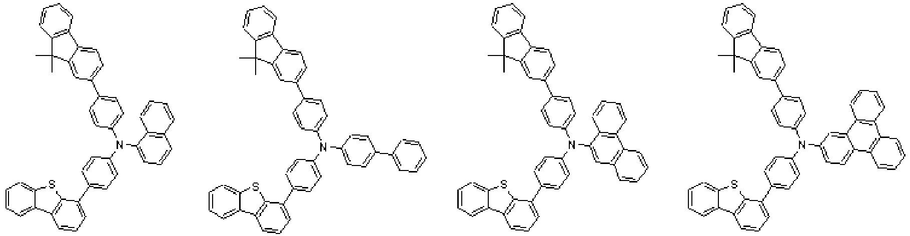

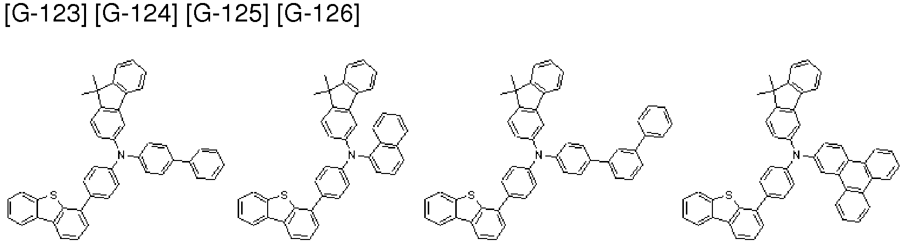

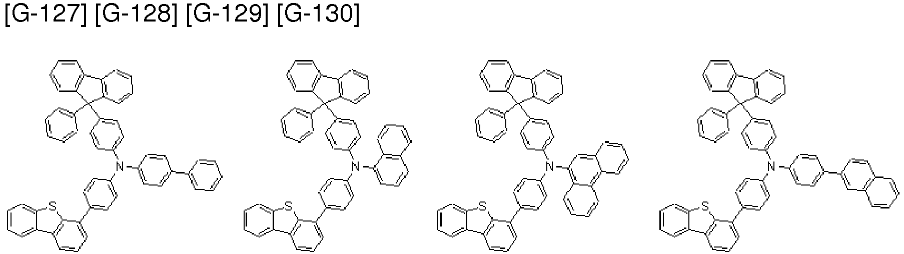

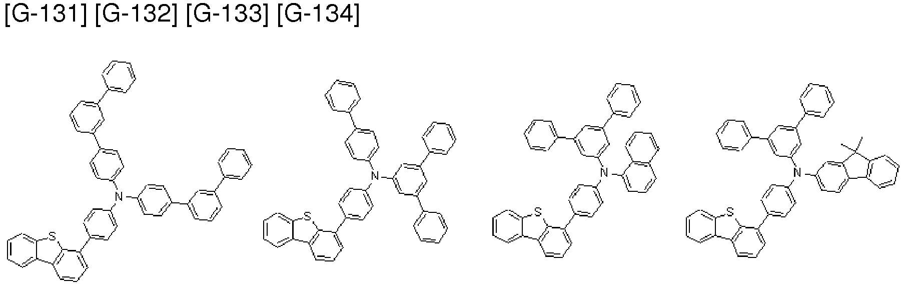

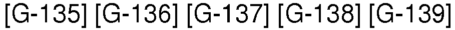

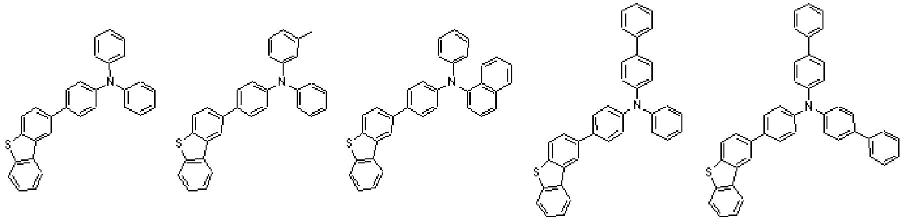

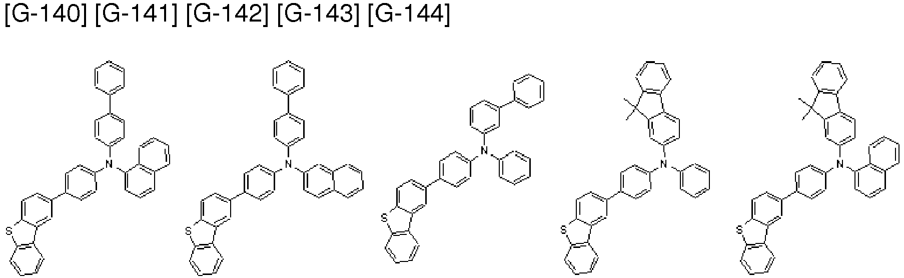

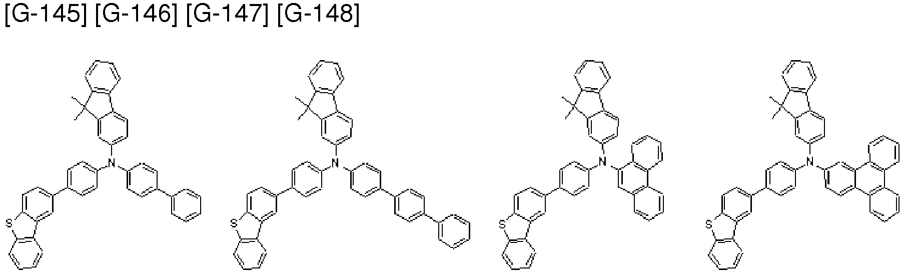

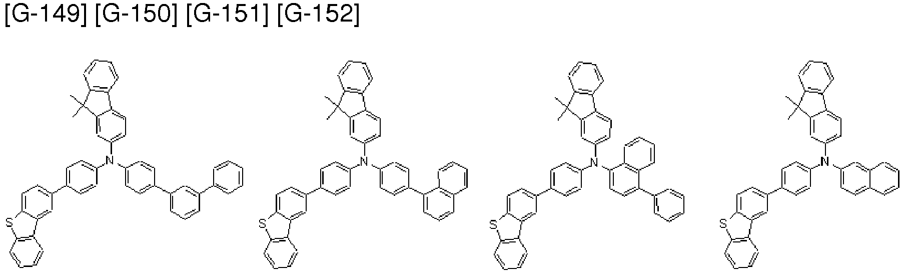

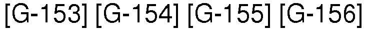

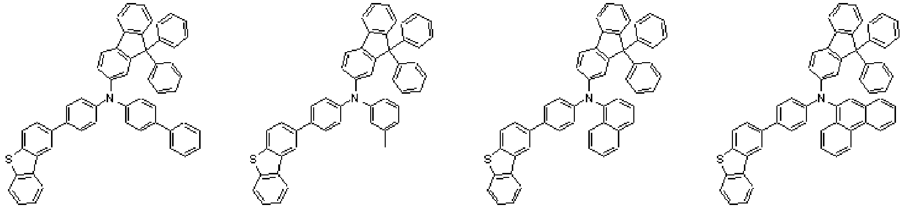

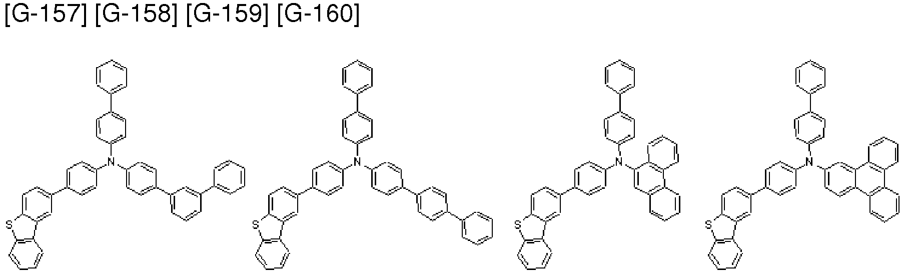

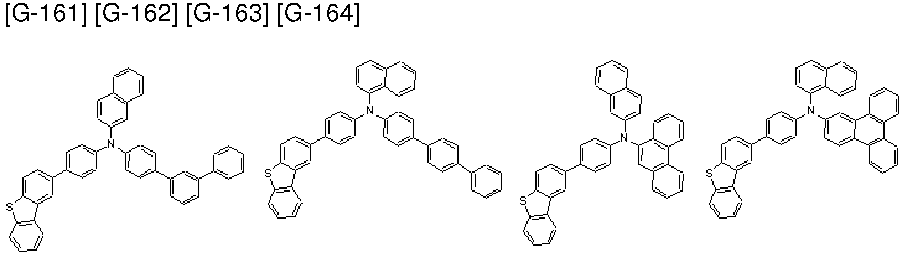

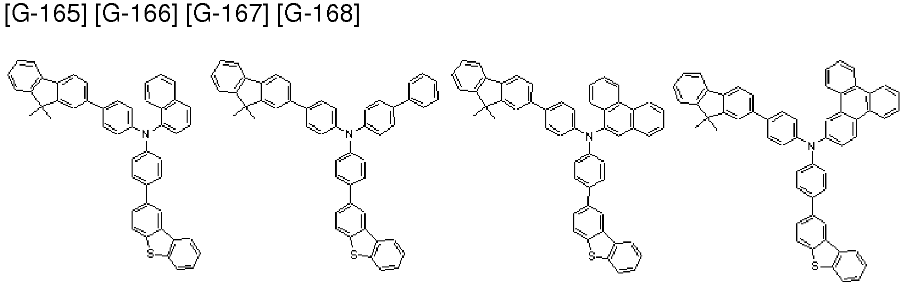

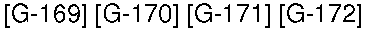

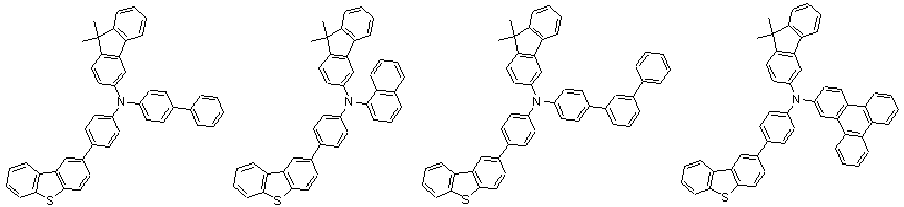

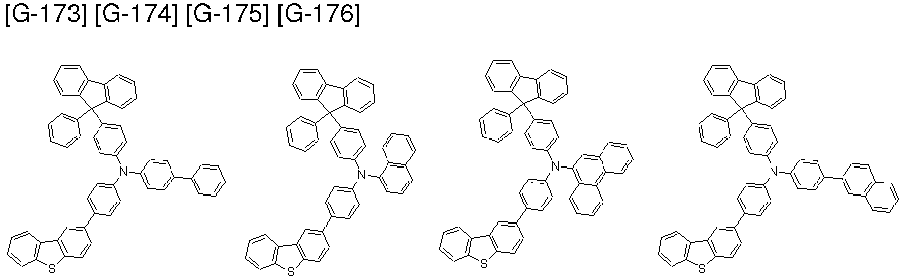

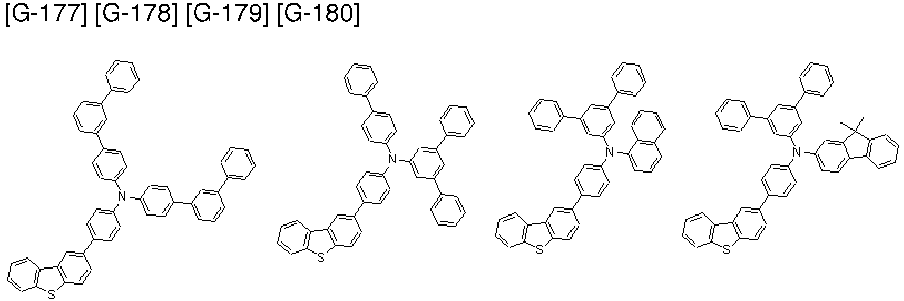

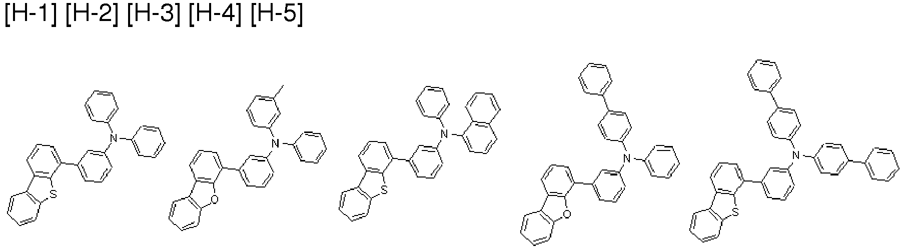

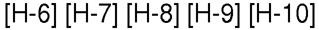

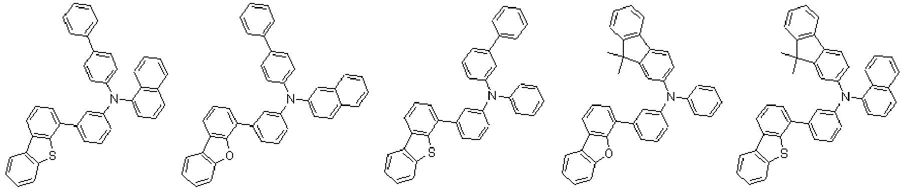

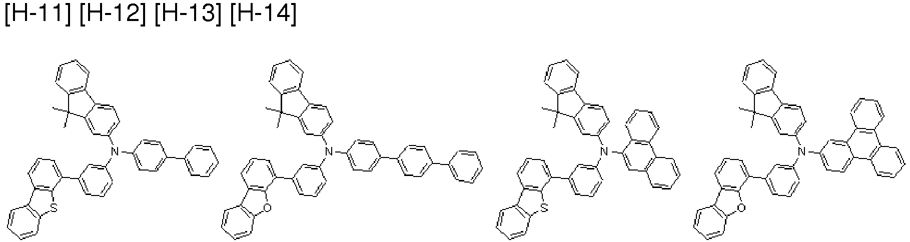

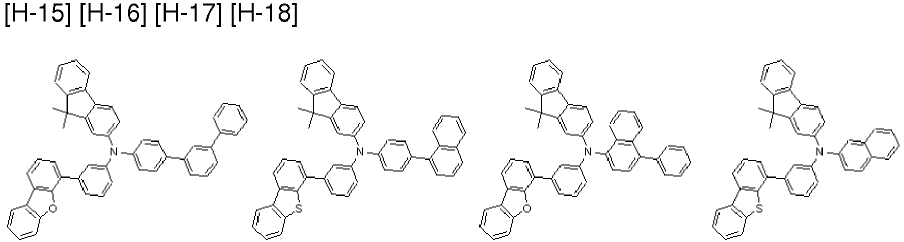

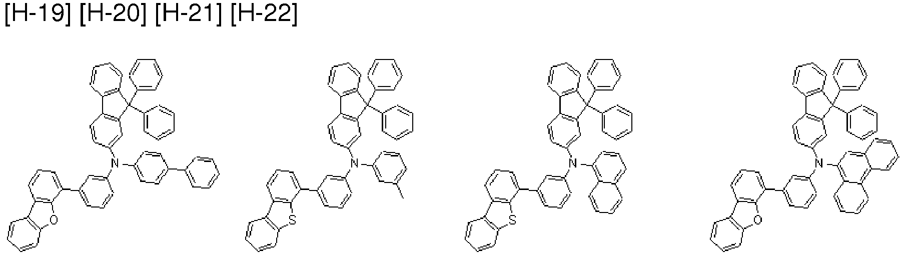

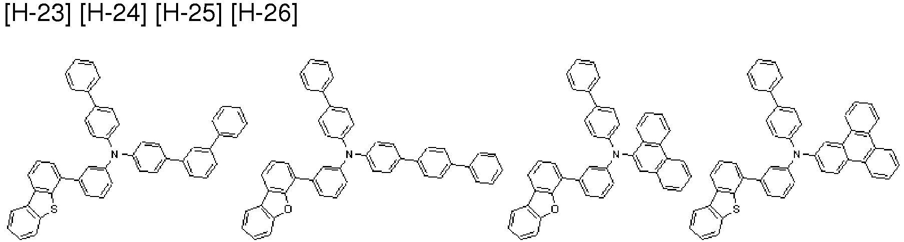

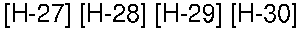

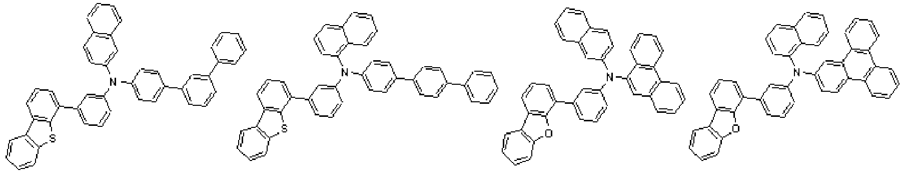

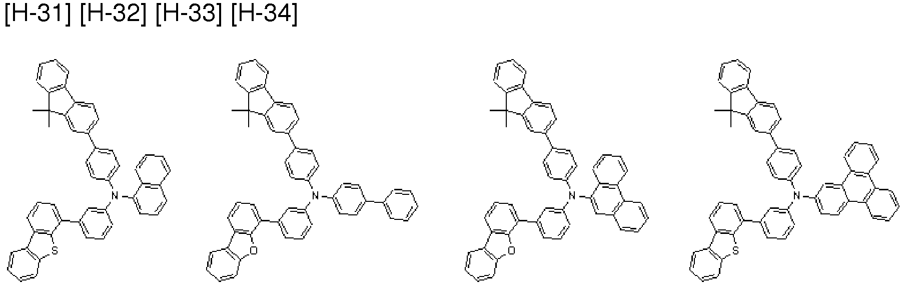

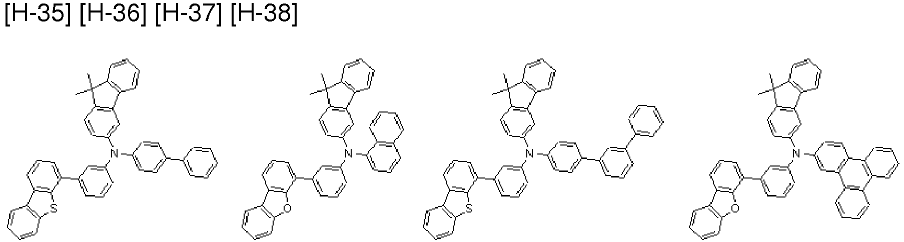

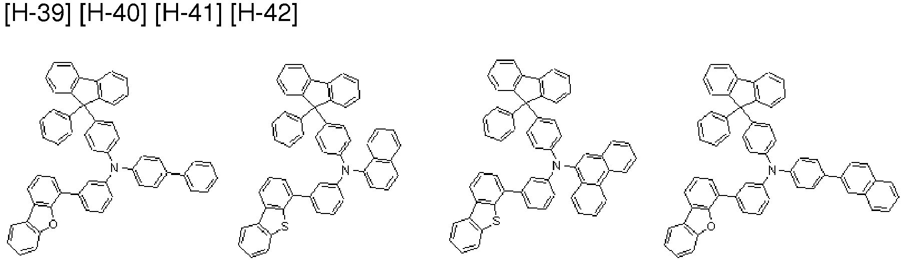

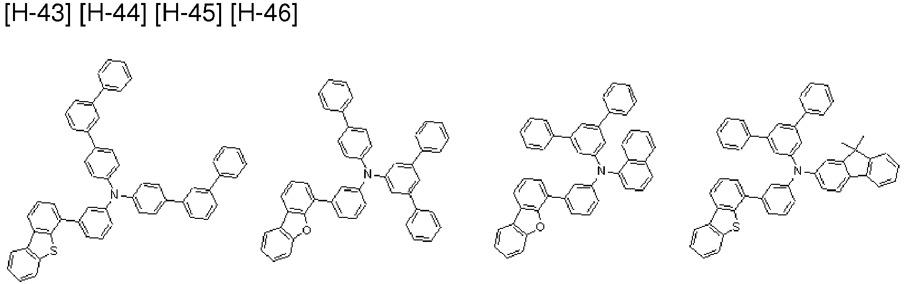

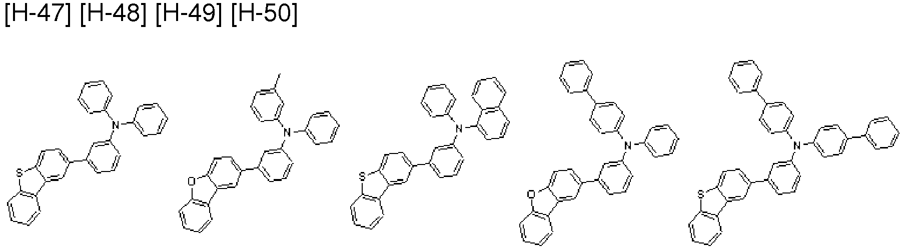

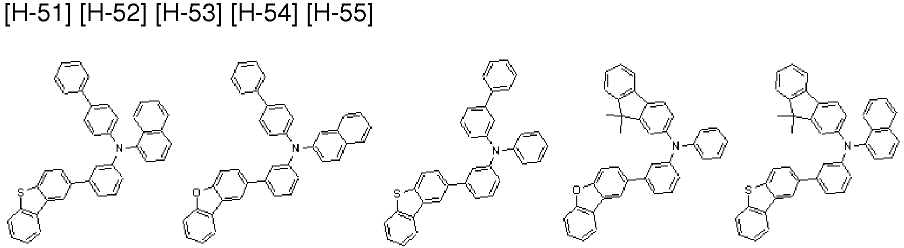

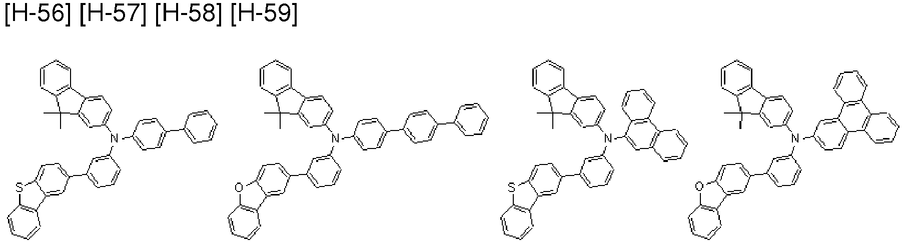

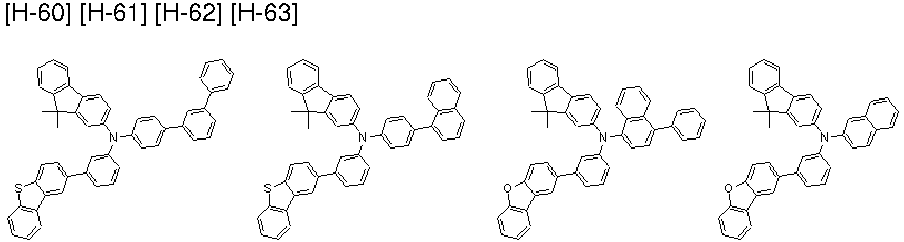

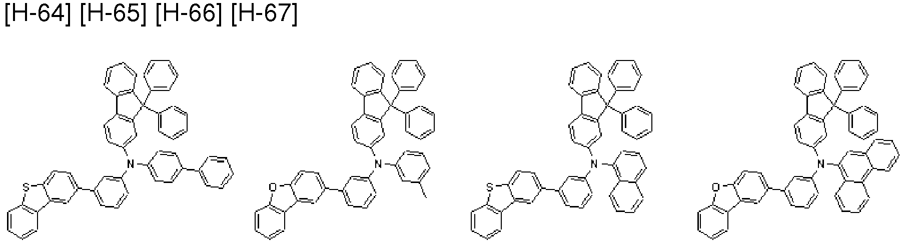

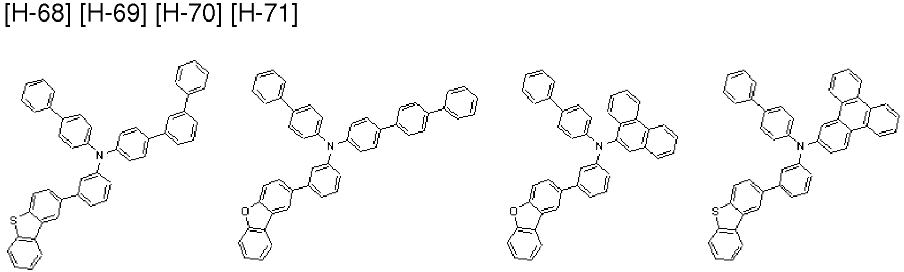

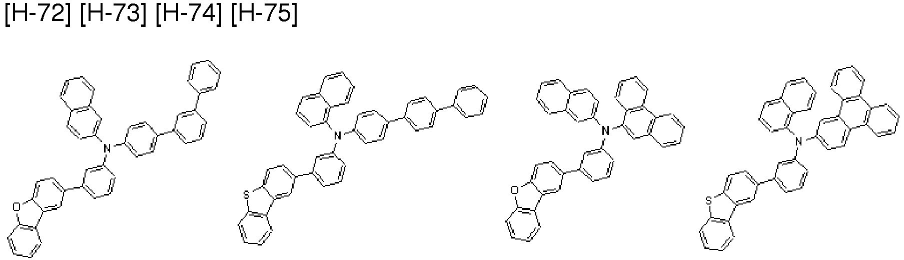

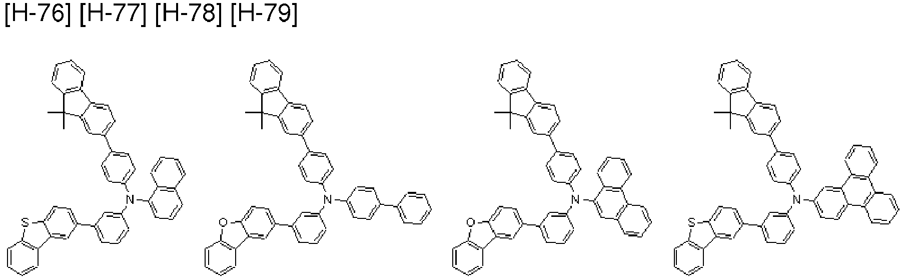

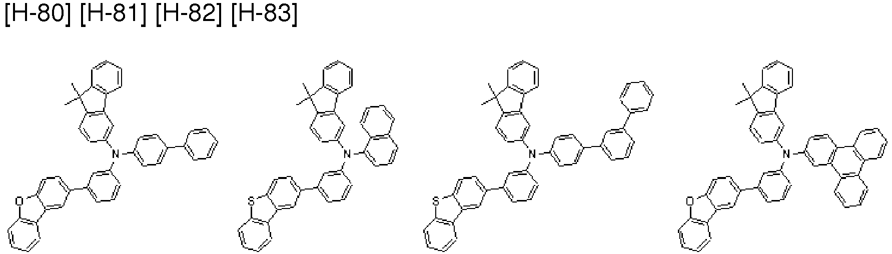

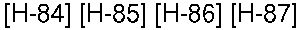

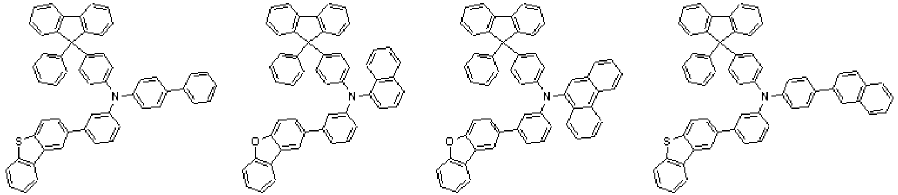

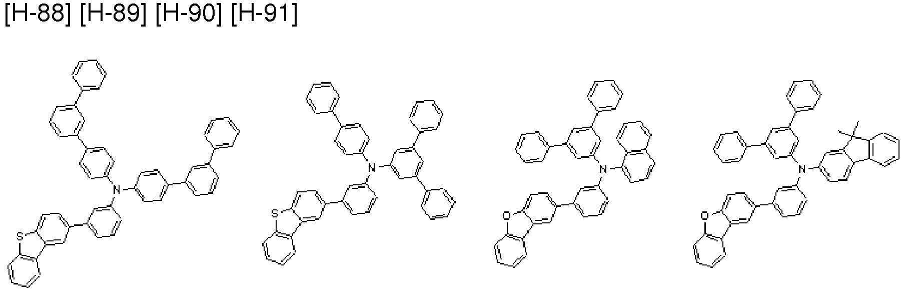

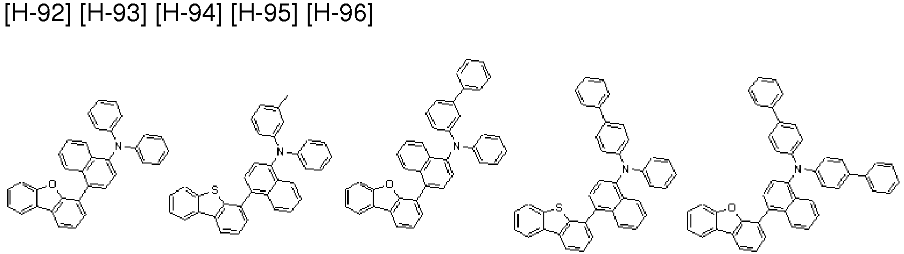

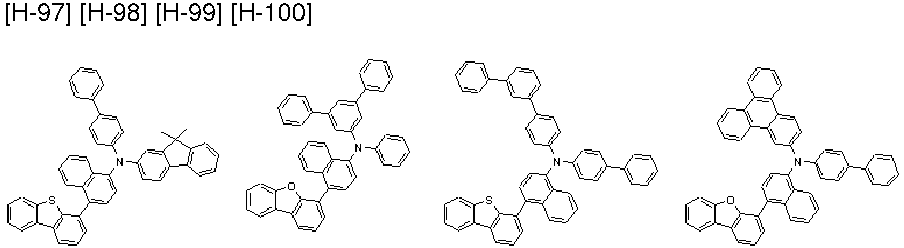

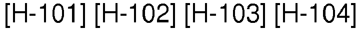

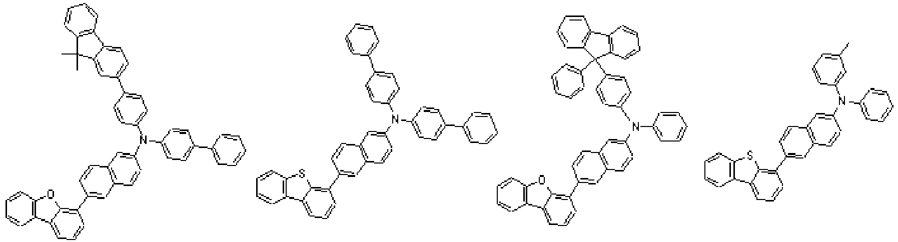

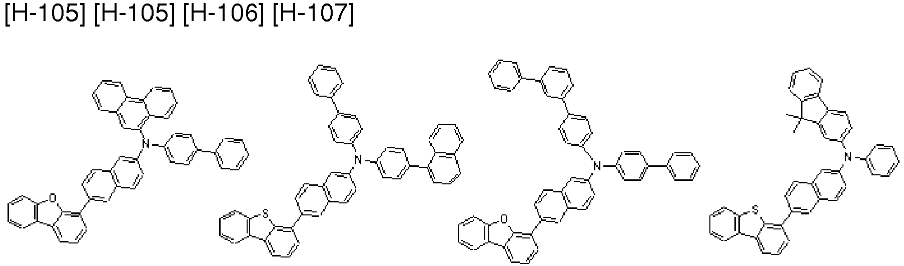

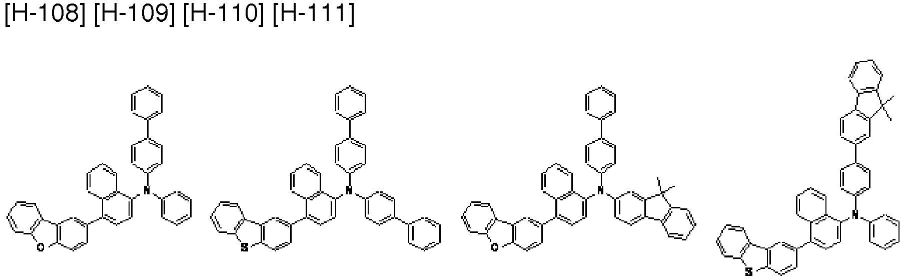

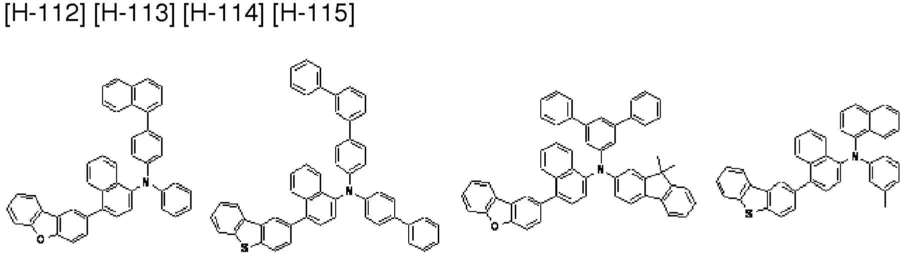

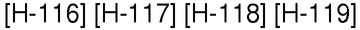

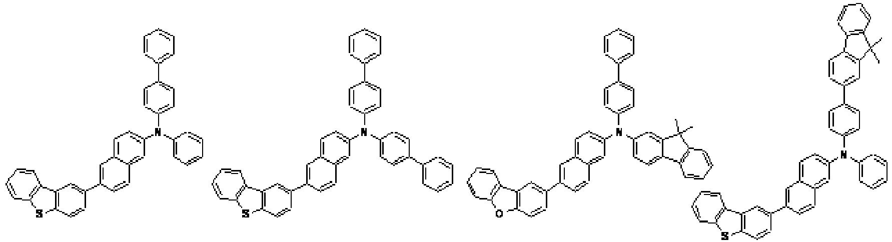

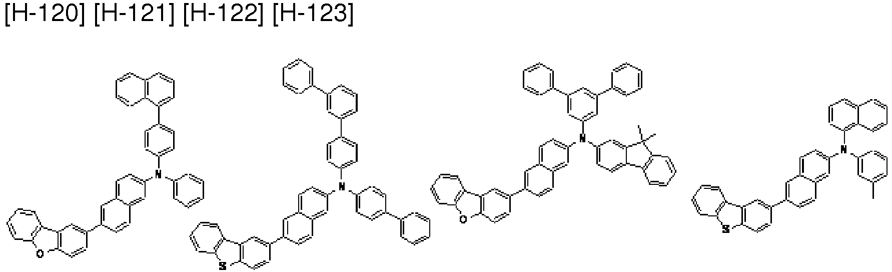

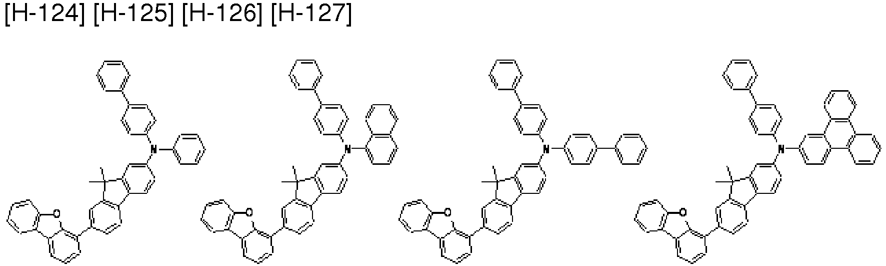

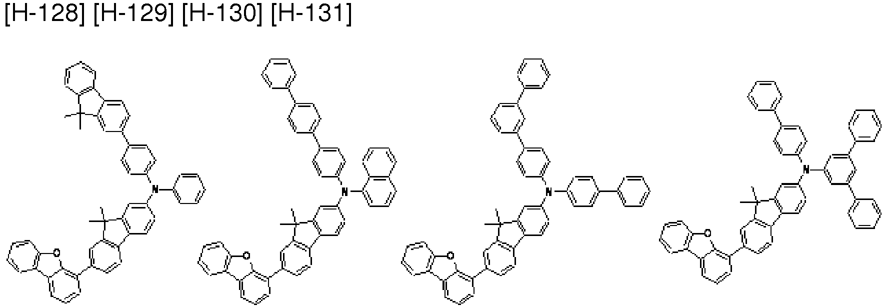

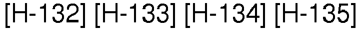

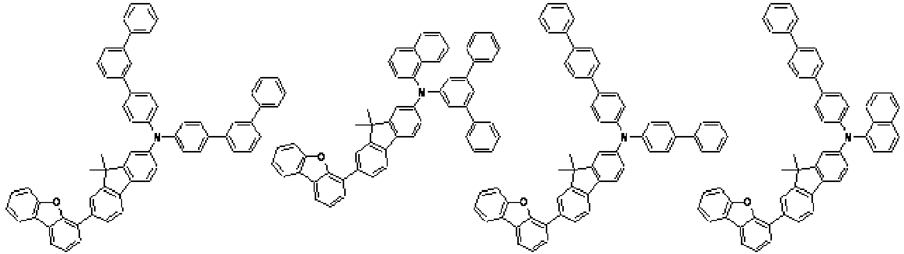

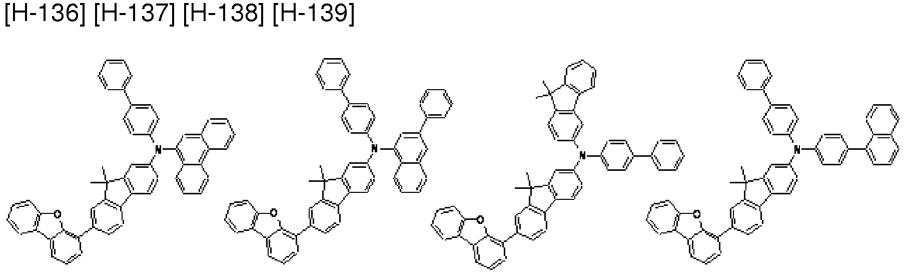

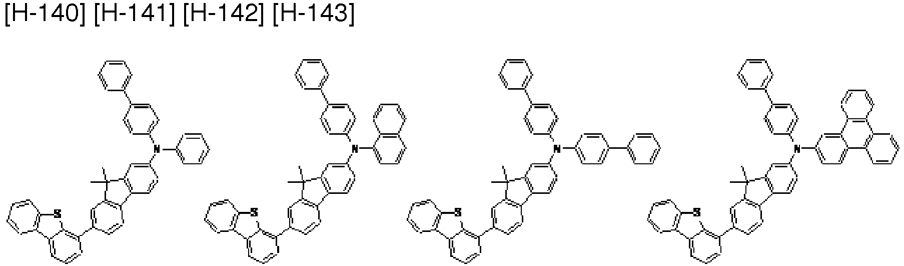

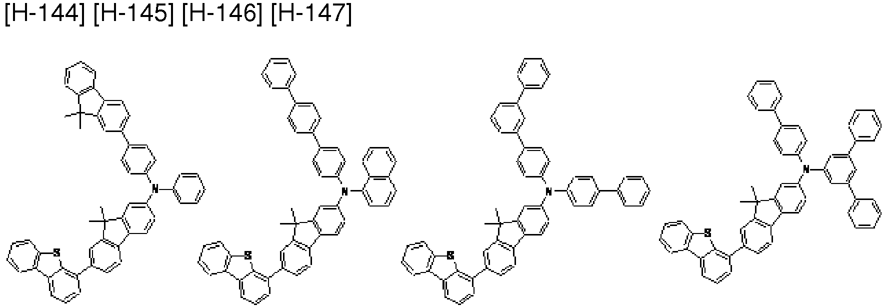

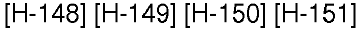

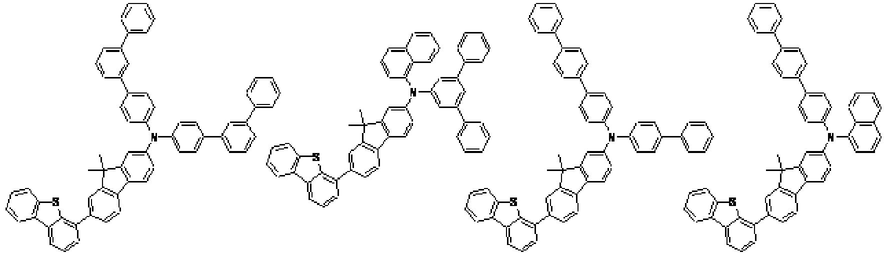

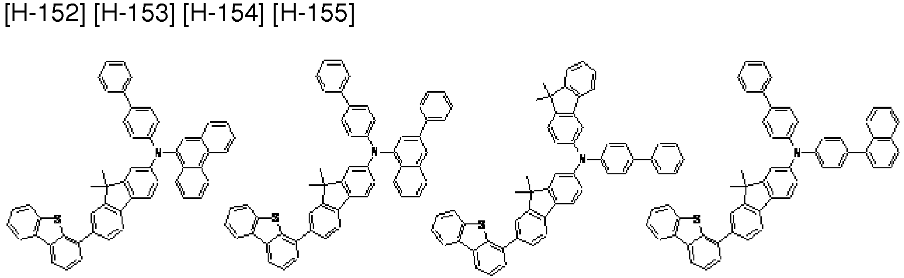

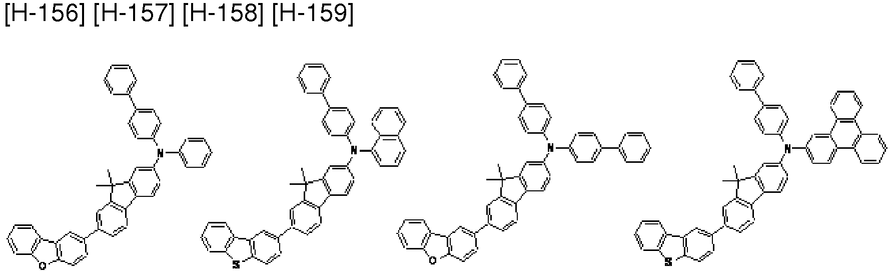

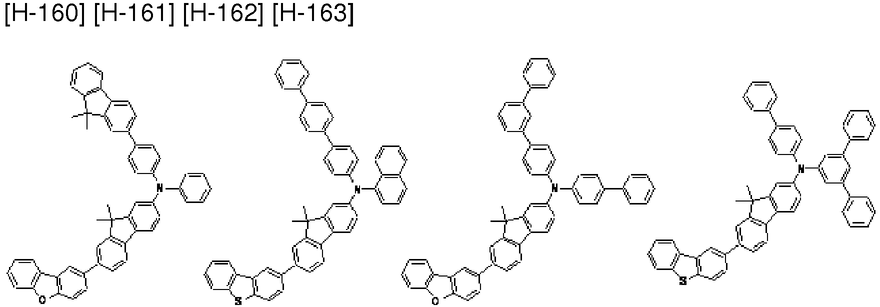

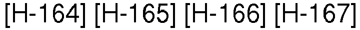

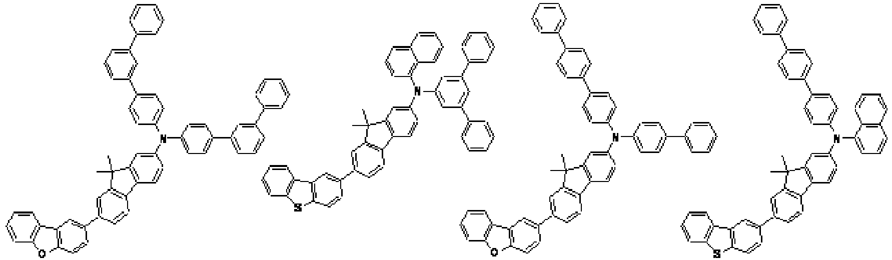

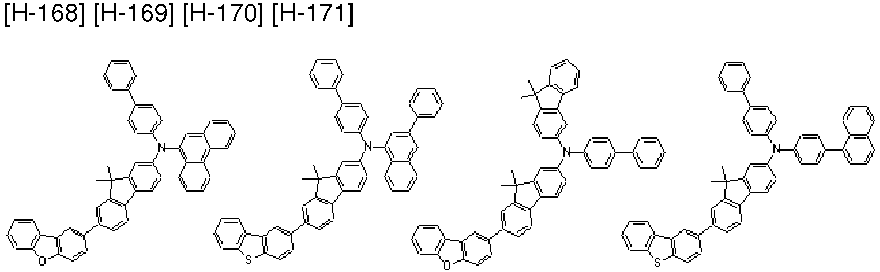

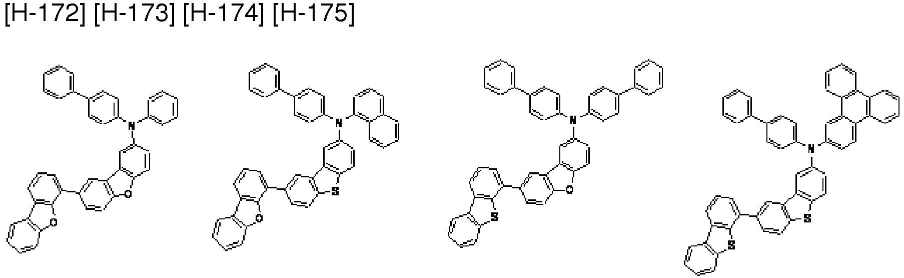

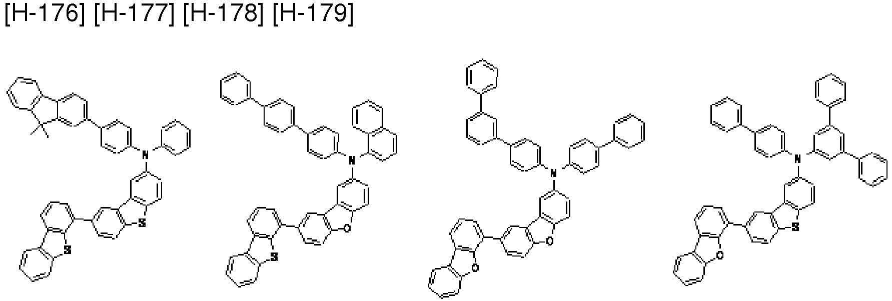

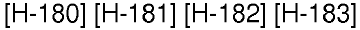

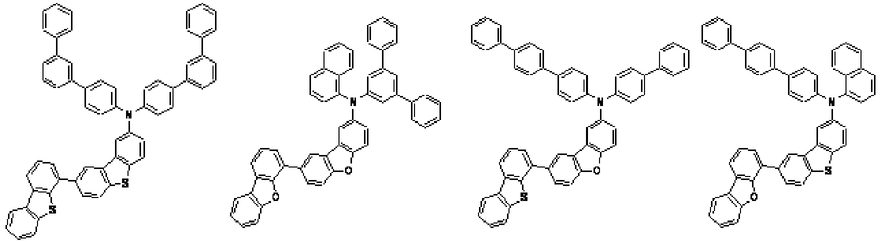

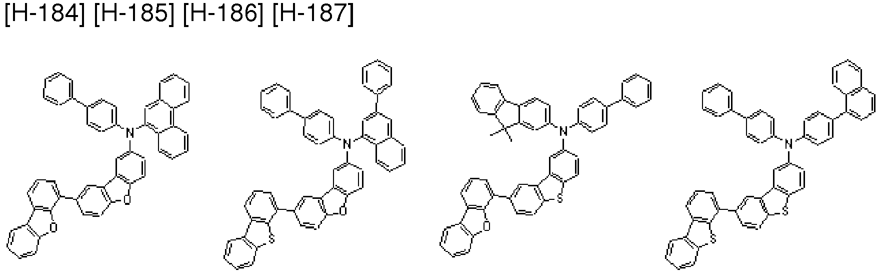

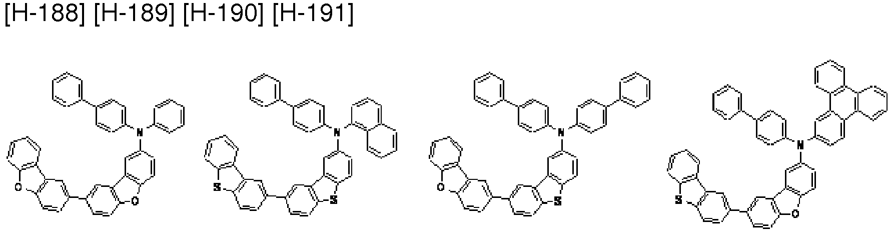

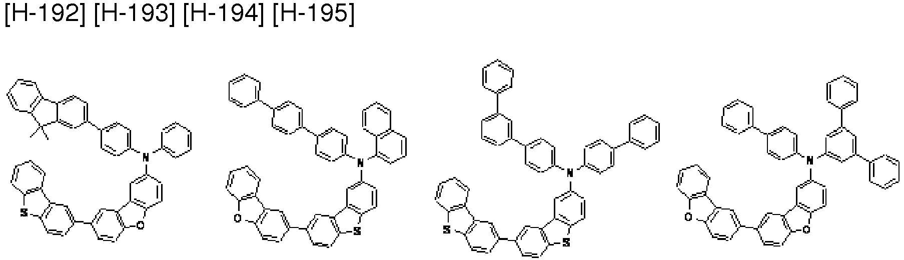

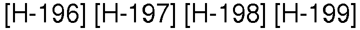

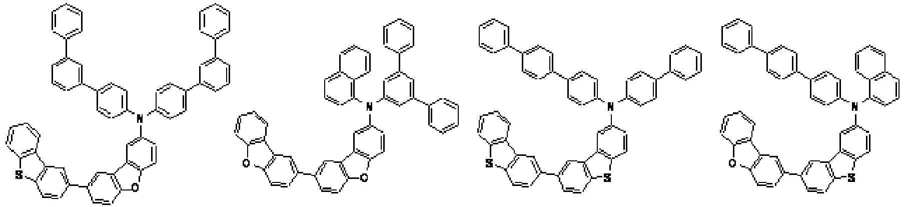

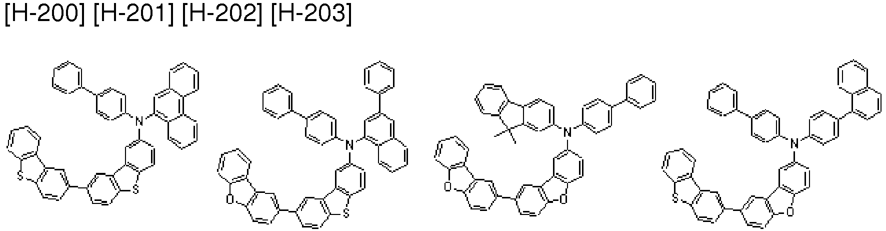

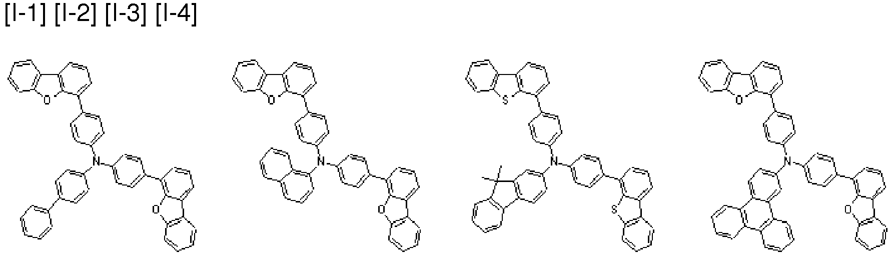

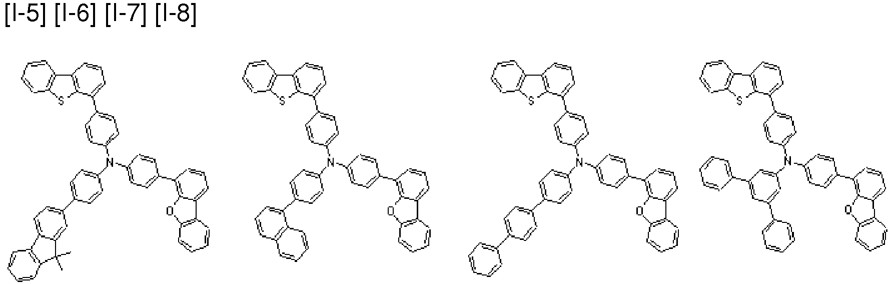

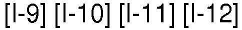

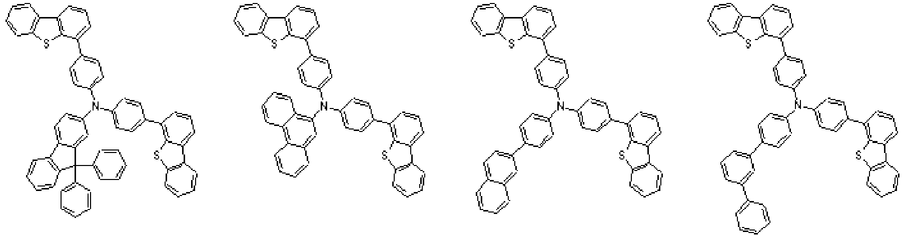

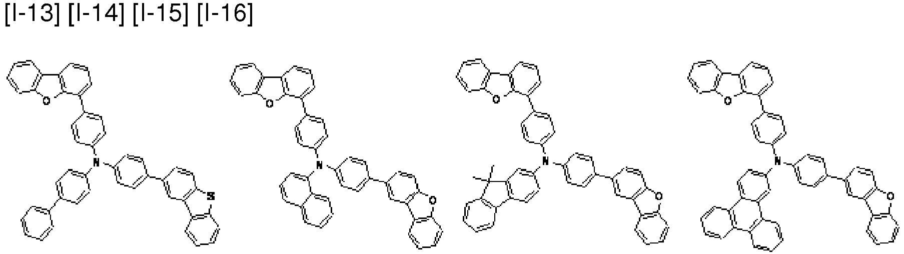

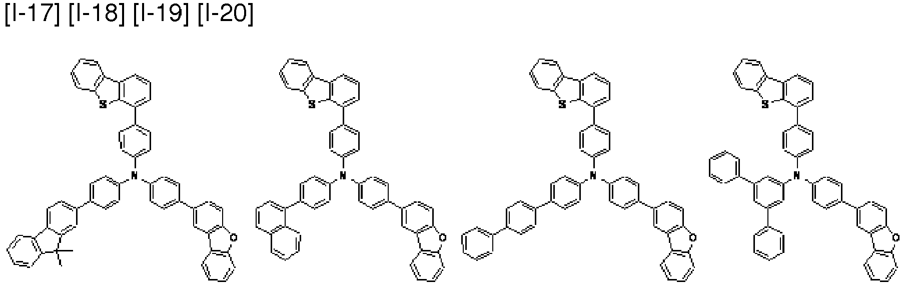

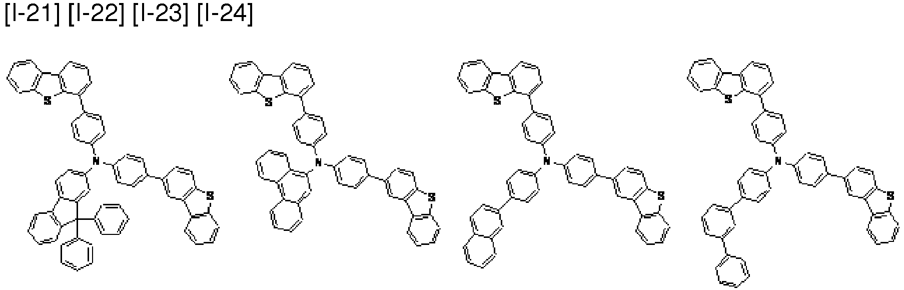

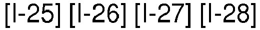

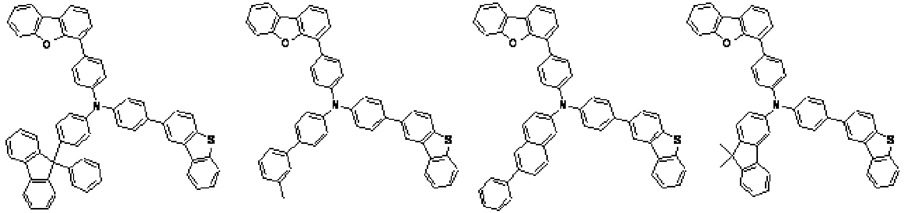

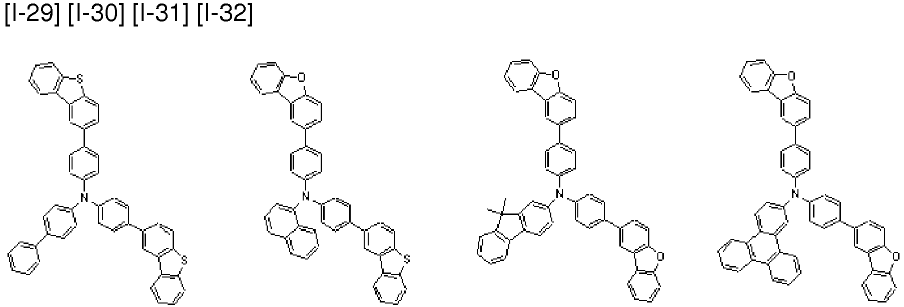

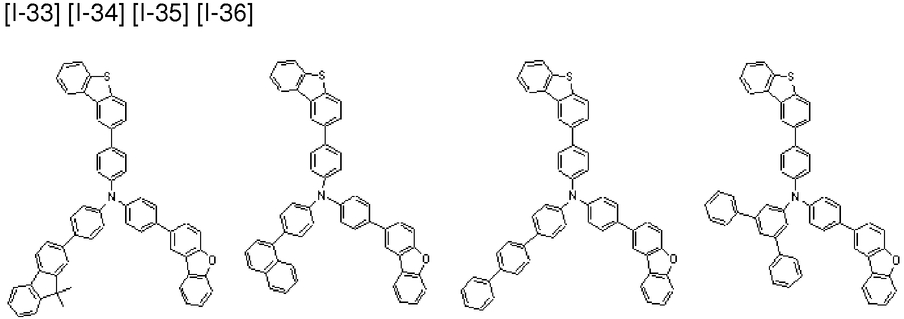

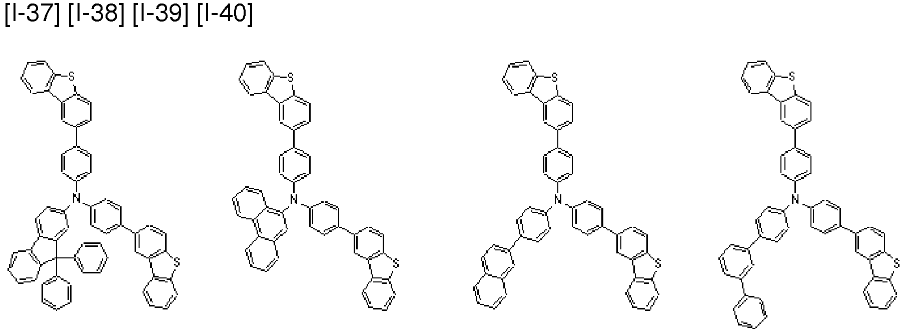

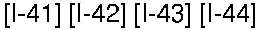

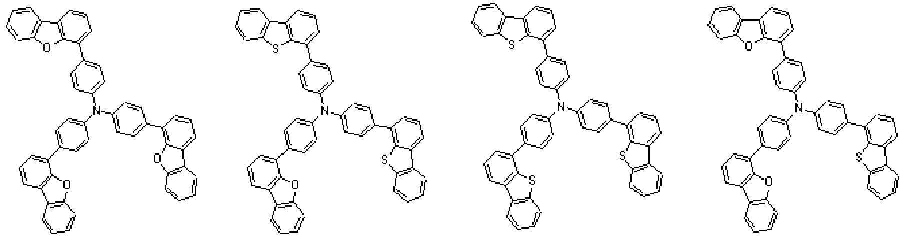

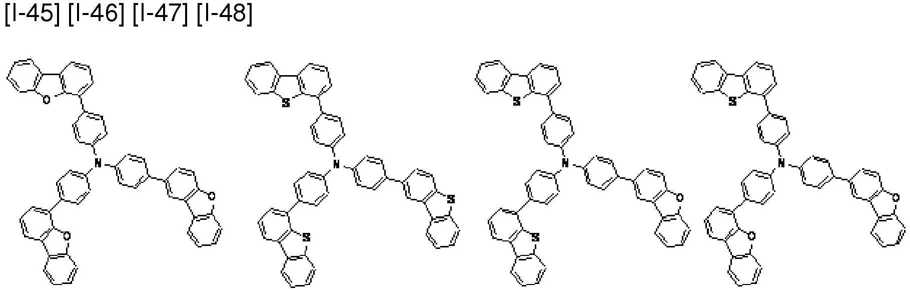

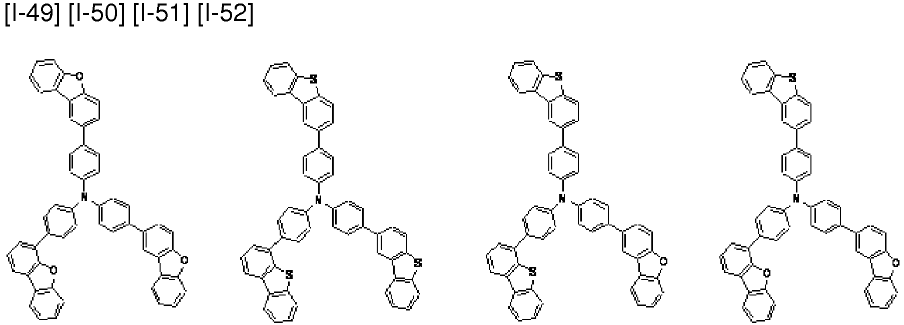

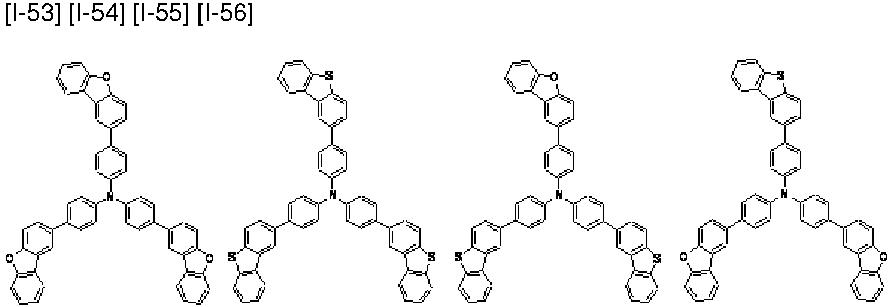

For more specific examples, the compound represented by Chemical Formula B-1 may be represented by one of the following Chemical Formula J-1 to J-144, but is not limited thereto.

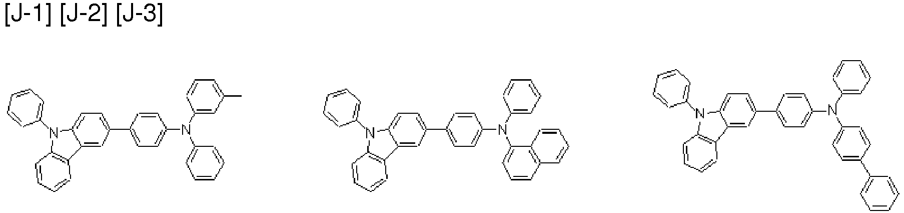

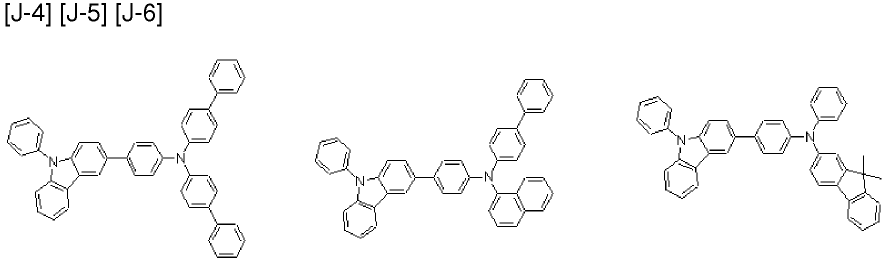

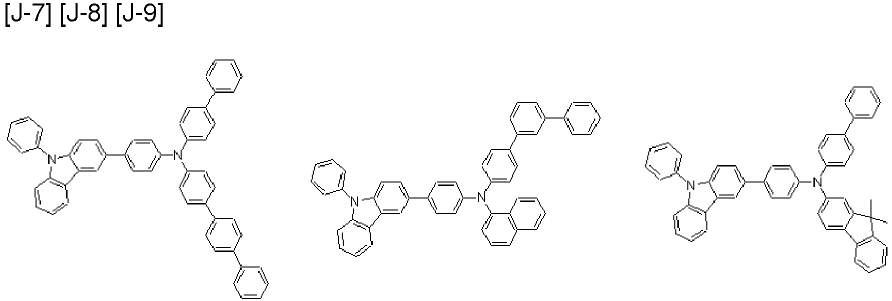

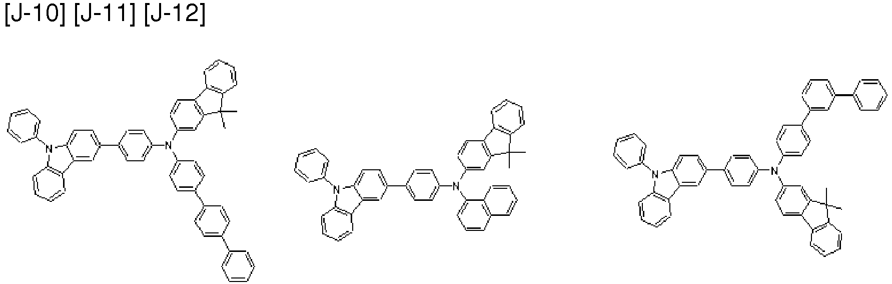

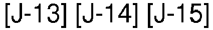

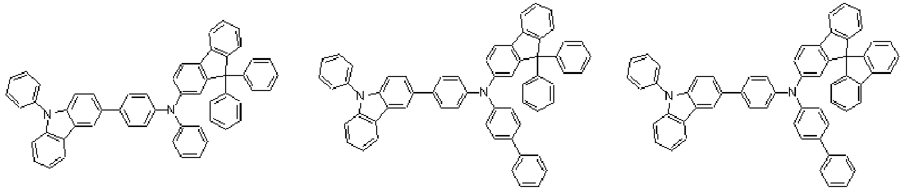

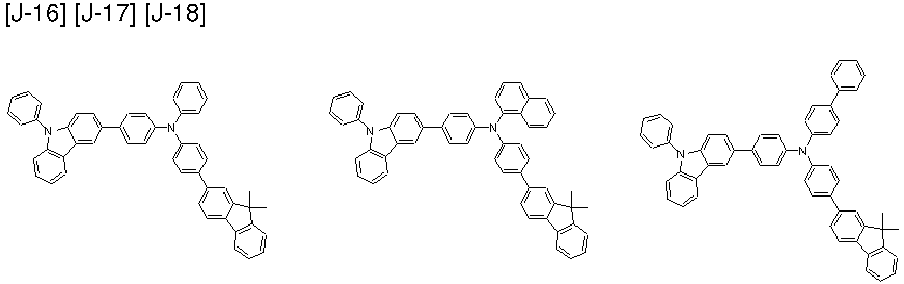

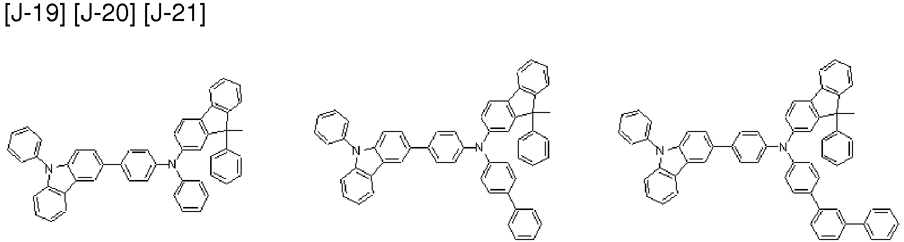

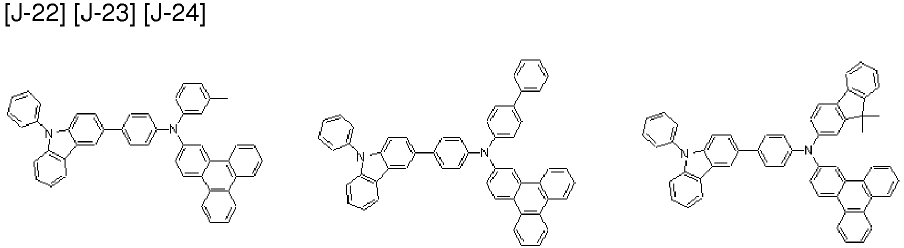

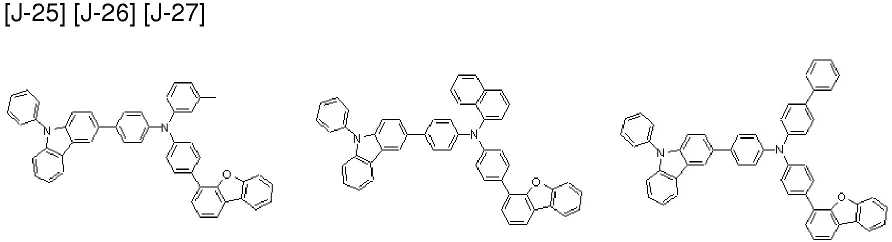

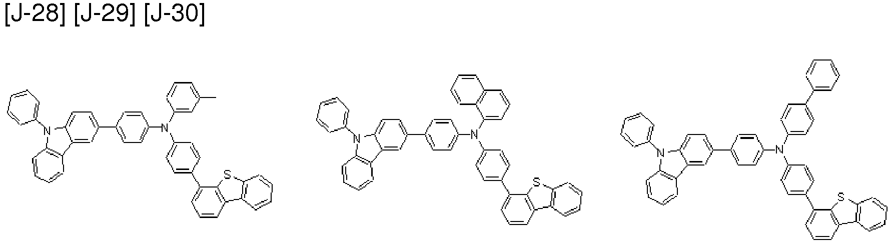

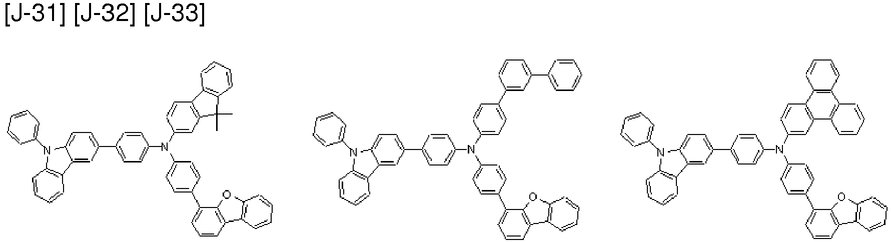

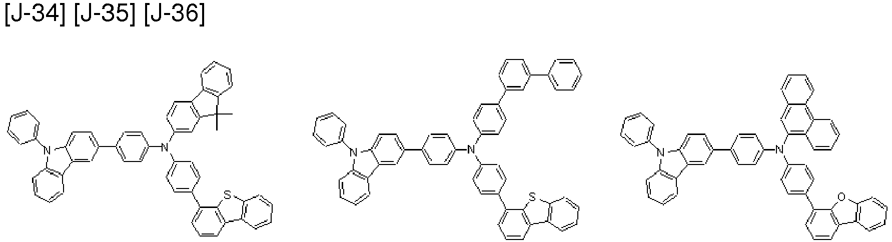

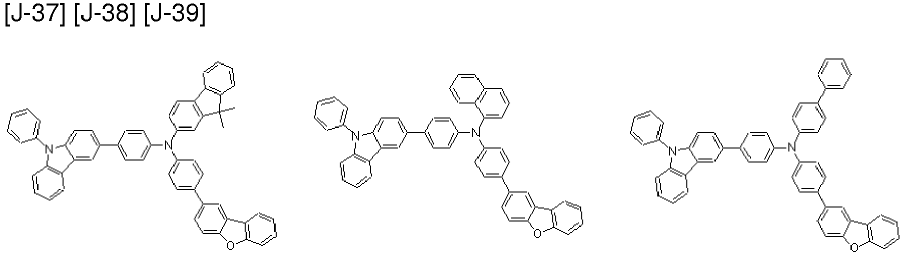

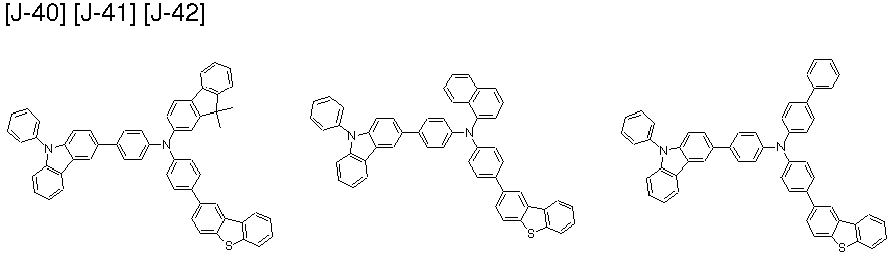

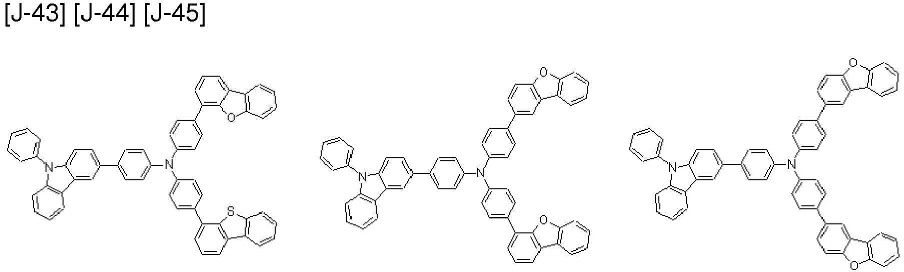

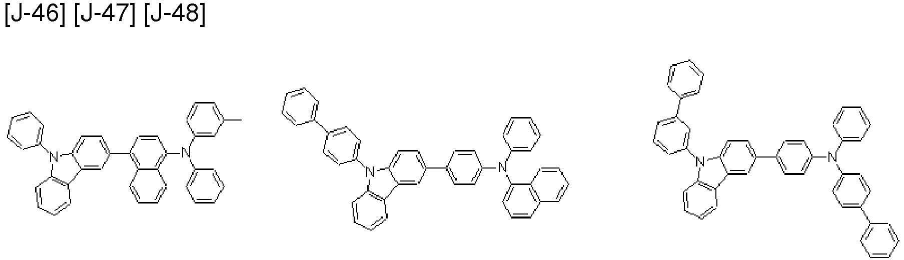

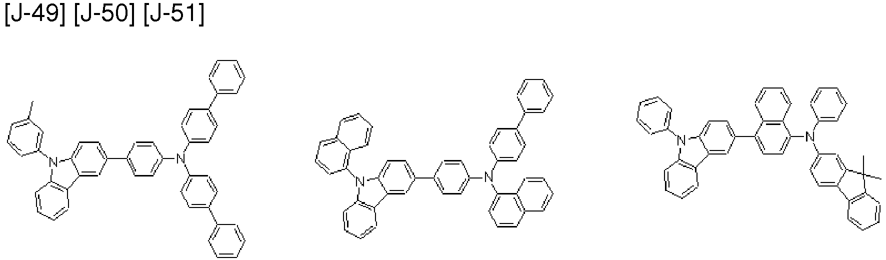

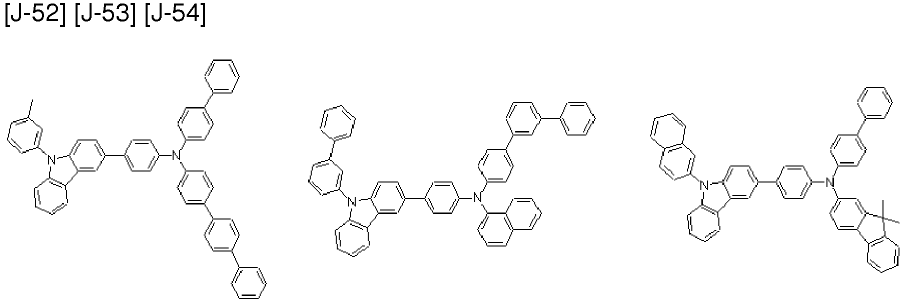

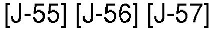

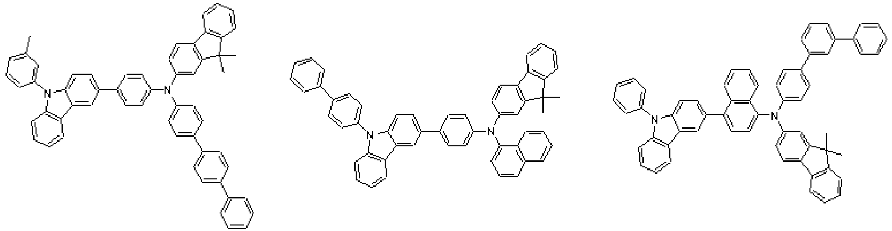

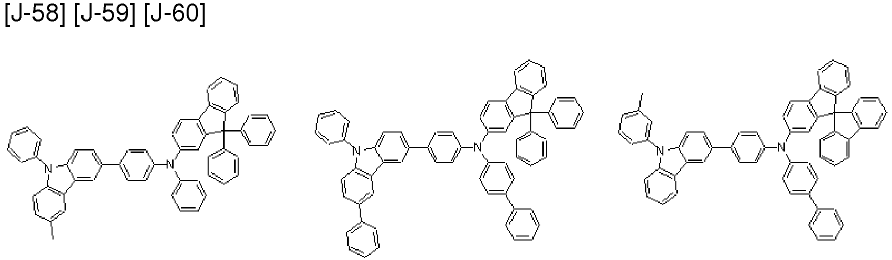

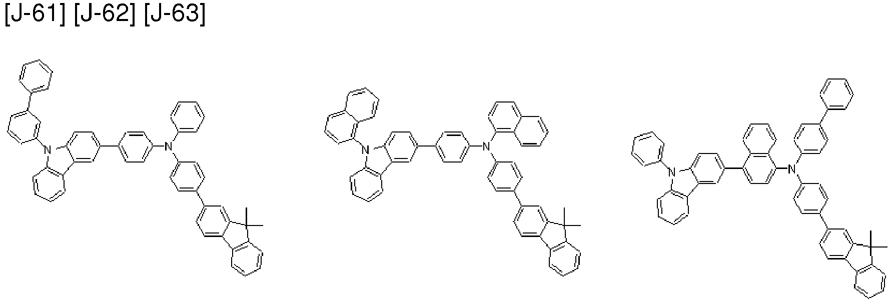

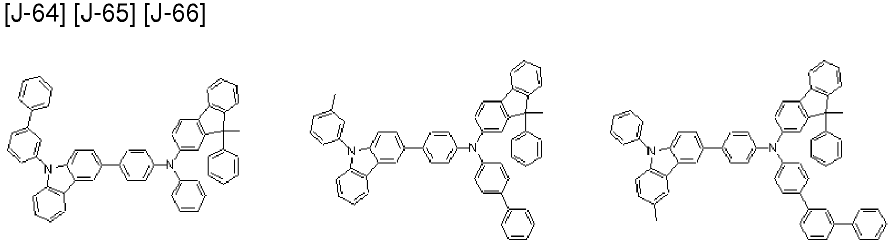

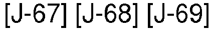

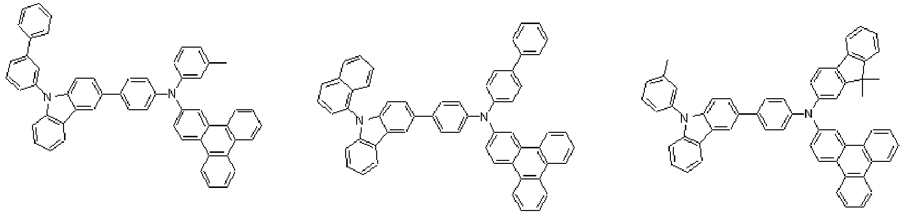

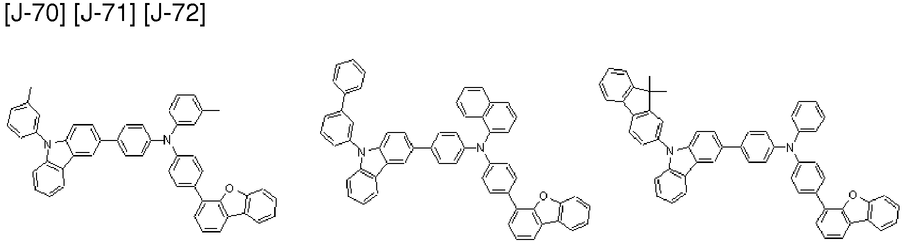

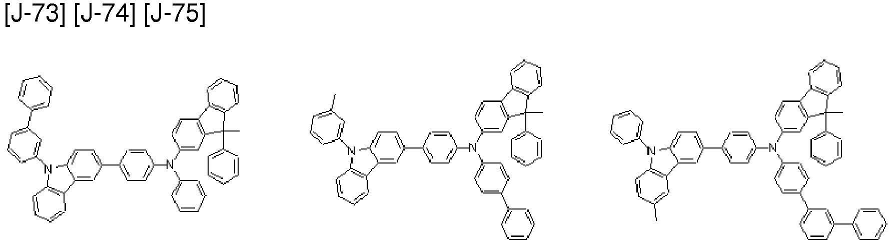

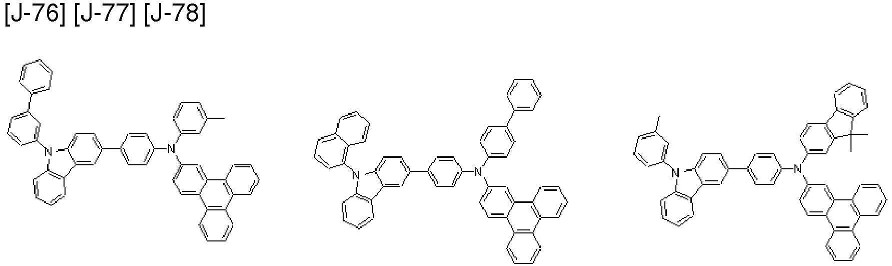

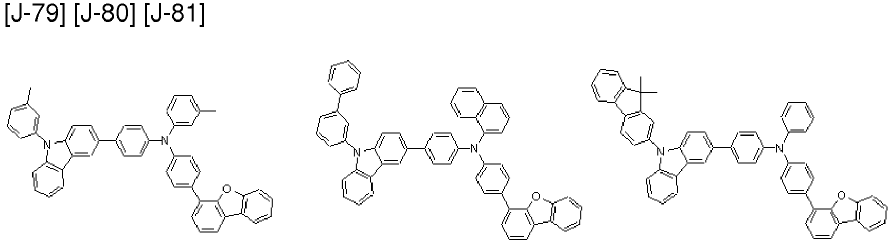

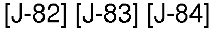

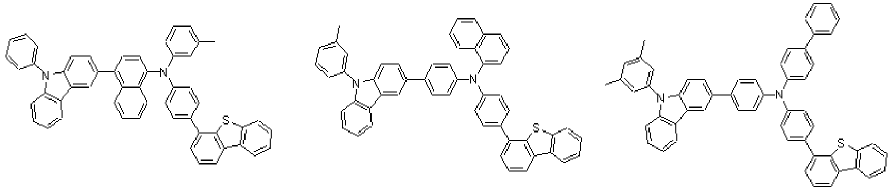

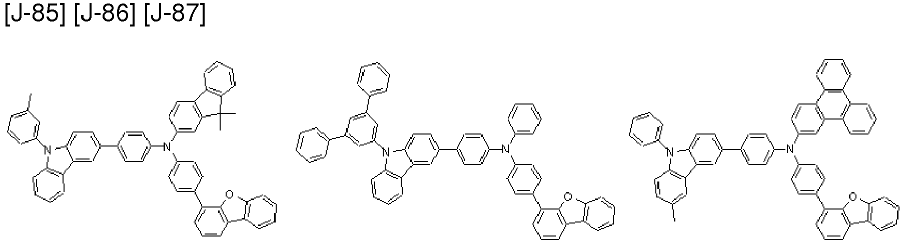

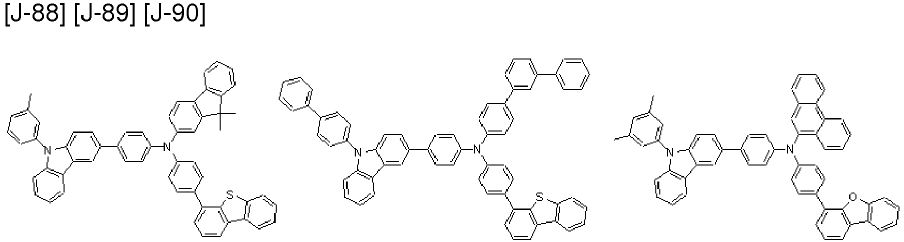

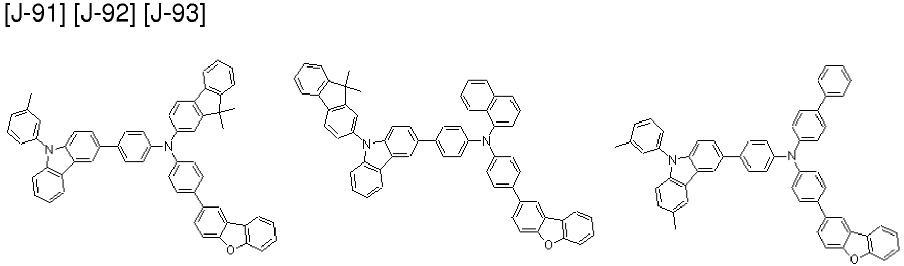

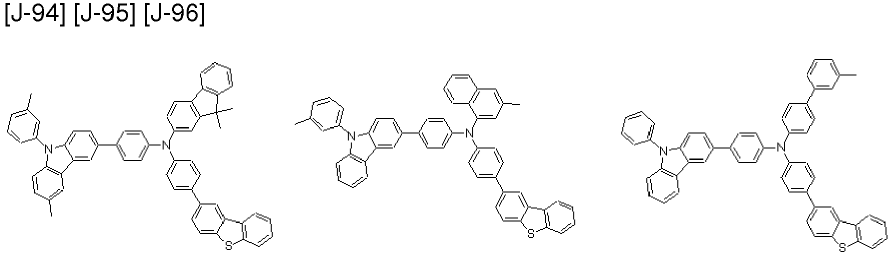

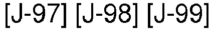

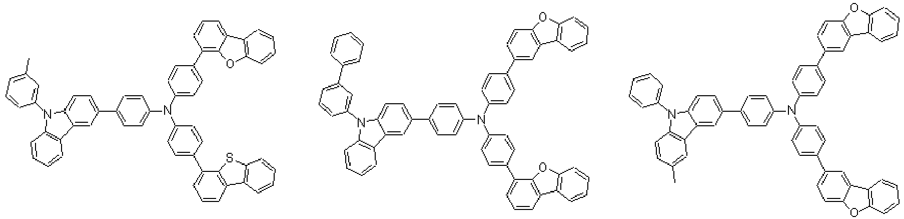

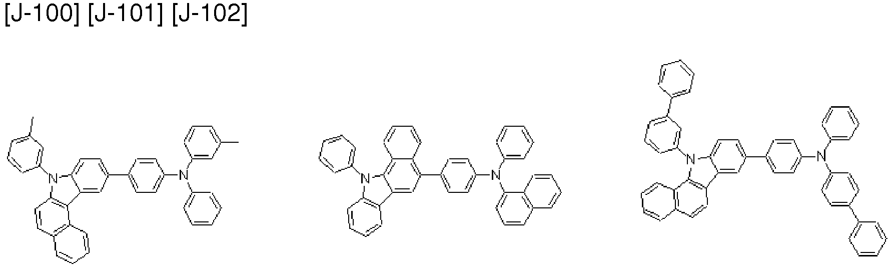

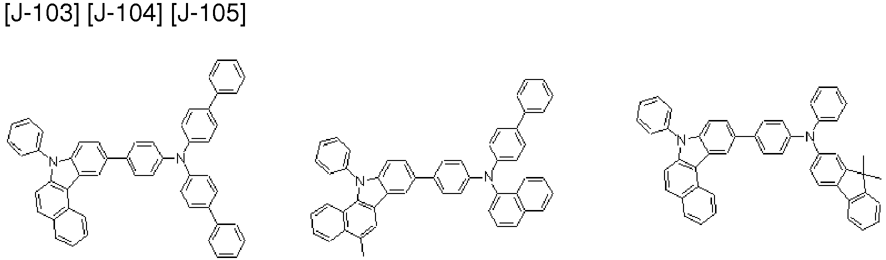

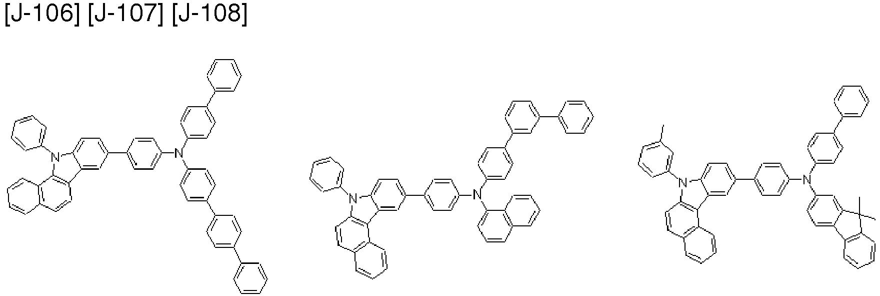

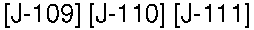

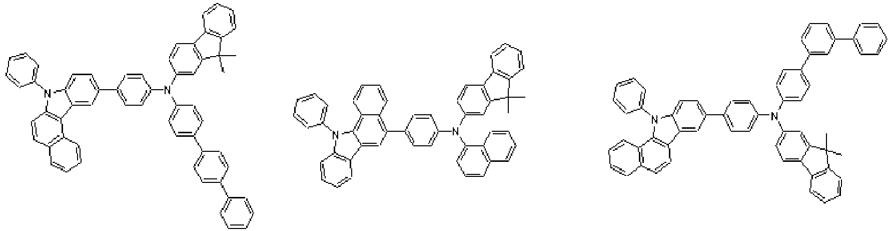

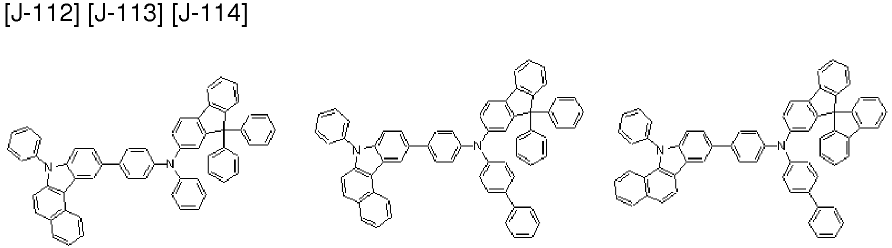

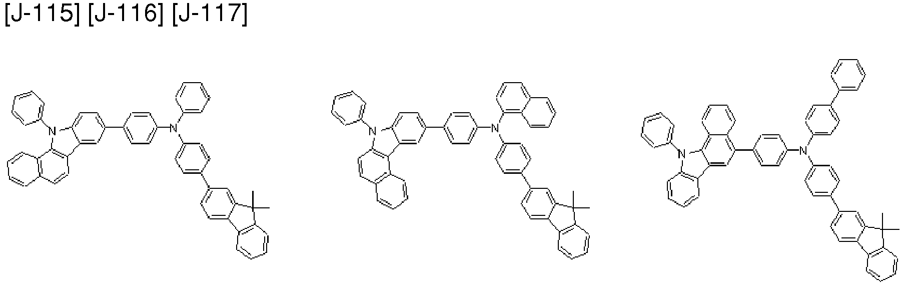

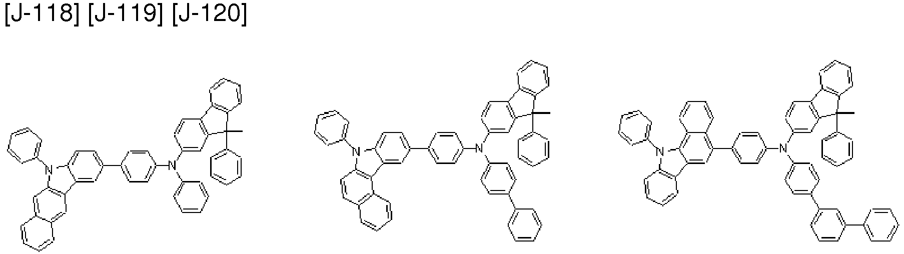

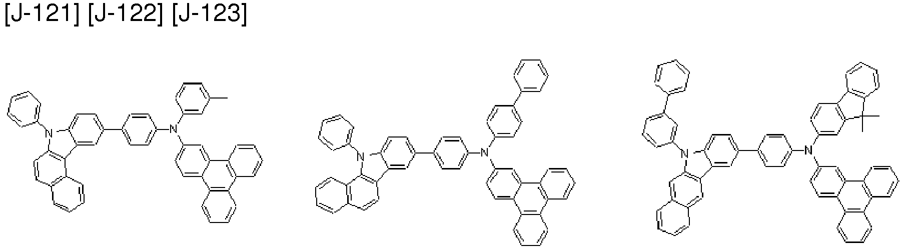

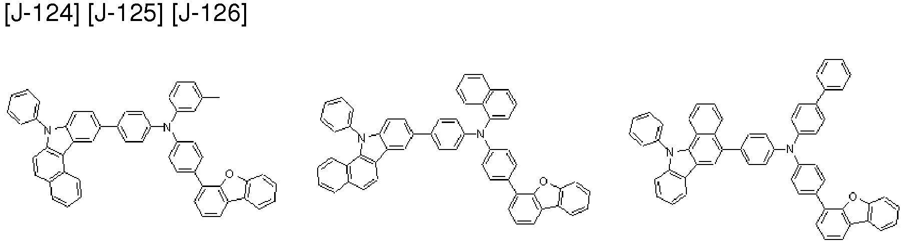

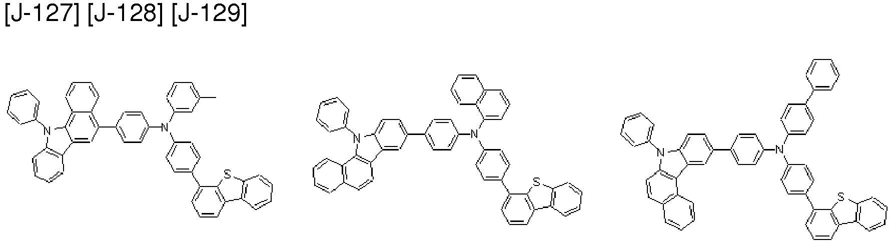

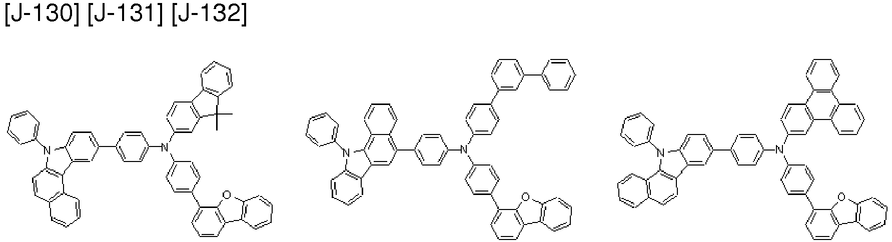

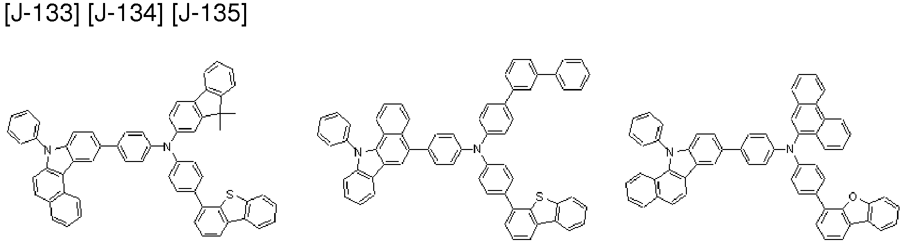

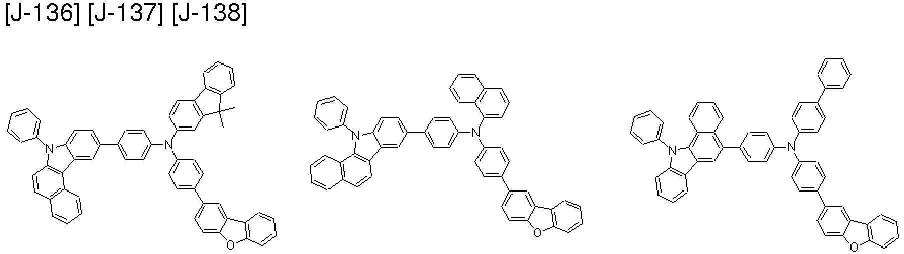

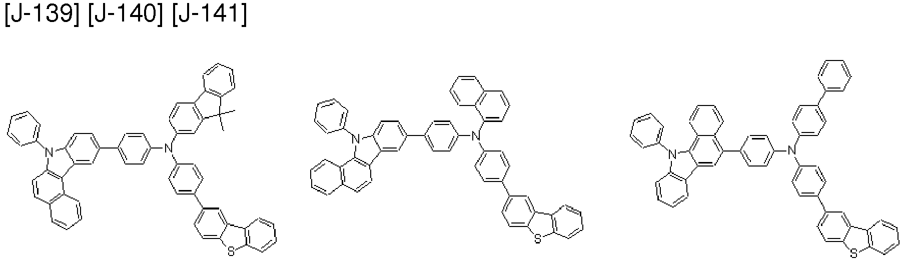

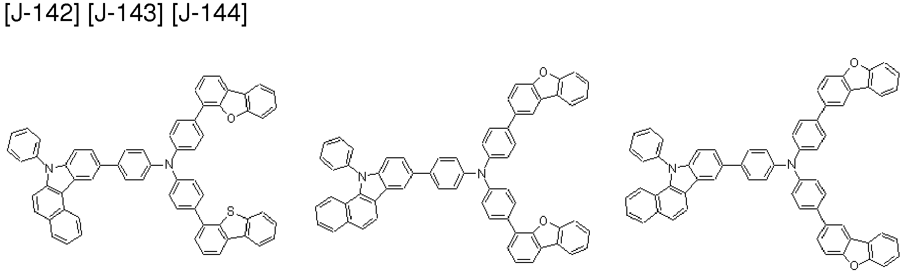

The compound for an organic optoelectronic device including the above compounds has a glass transition temperature of greater than or equal to 110° C and a thermal decomposition temperature of greater than or equal to 400°C, indicating improved thermal stability. Thereby, it is possible to produce an organic optoelectronic device having a high efficiency.

The compound for an organic optoelectronic device including the above compounds may play a role for emitting light or injection and/or transporting holes, and also act as a light emitting host with an appropriate dopantln other words, the compound for an organic optoelectronic device may be used as a phosphorescent or fluorescent host material, a blue light emitting dopant material, or an electron transport material.

Since the compound for an organic optoelectronic device according to one embodiment is used for an organic thin layer, it may improve the life-span characteristic, efficiency characteristic, electrochemical stability, and thermal stability of an organic photoelectric device and decrease the driving voltage.

The organic optoelectronic device according to one embodiment of the present invention may include an organic photoelectric device, an organic light emitting diode, an organic solar cell, an organic transistor, an organic photo conductor drum, an organic memory device, and the like. For example, the compound for an organic photoelectric device according to one embodiment may be included in an electrode or an electrode buffer layer in the organic solar cell to improve the quantum efficiency, and it may be used as an electrode material for a gate, a source-drain electrode, or the like in the organic transistor.

Hereinafter, an organic light emitting diode will be described in detail.

In one embodiment of the present invention, the organic thin layer may be selected from an emission layer, a hole transport layer, a hole injection layer, an electron transport layer, an electron injection layer, a hole blocking layer, and a combination thereof.

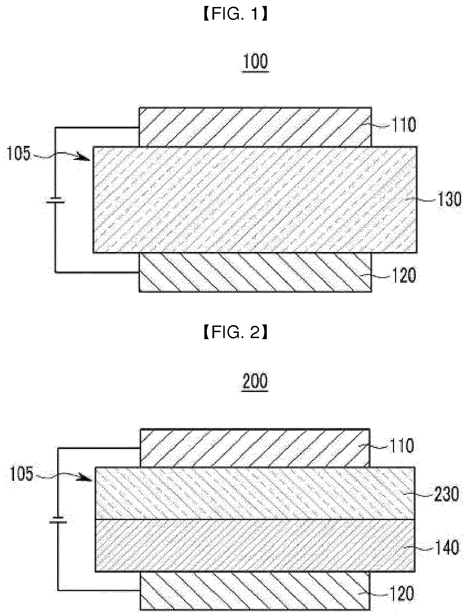

FIGS. 1 to 5 are cross-sectional views showing general organic light emitting diodes.

Referring to FIGS. 1 to 5, the organic light emitting diode 100, 200, 300, 400 and 500 includes an anode 120, a cathode 110 and at least one organic thin layer 105 interposed between the anode and the cathode.

The anode 120 includes an anode material laving a large work function to help hole injection into an organic thin layer. The anode material includes: a metal such as nickel, platinum, vanadium, chromium, copper, zinc, and gold, or alloys thereof; a metal oxide such as zinc oxide, indium oxide, indium tin oxide (ITO), and indium zinc oxide (IZO); a combined metal and oxide such as ZnO:AI or SnO₂:Sb; or a conductive polymer such as poly(3-methylthiophene), poly[3,4-(ethylene-1,2-dioxy)thiophene] (PEDT), polypyrrole, and polyaniline, but is not limited thereto. It is preferable to include a transparent electrode including indium tin oxide (ITO) as an anode.

The cathode 110 includes a cathode material having a small work function to help electron injection into an organic thin layer. The cathode material includes: a metal such as magnesium, calcium, sodium, potassium, titanium, indium, yttrium, lithium, gadolinium, aluminum, silver, tin, and lead, or alloys thereof; or a multi-layered material such as LiF/AI, Liq/AI, LiO₂/Al, LiF/Ca, LiF/AI, and BaF₂/Ca, but is not limited thereto. It is preferable to include a metal electrode including aluminum as a cathode.

Referring to FIG. 1, the organic photoelectric device 100 includes an organic thin layer 105 including only an emission layer 130.

Referring to FIG. 2, a double-layered organic photoelectric device 200 includes an organic thin layer 105 including an emission layer 230 including an electron transport layer, and a hole transport layer 140. As shown in FIG. 2, the organic thin layer 105 includes a double layer of the emission layer 230 and hole transport layer 140. The emission layer 230 also functions as an electron transport layer, and the hole transport layer 140 layer has an excellent binding property with a transparent electrode such as ITO or an excellent hole transport capability.

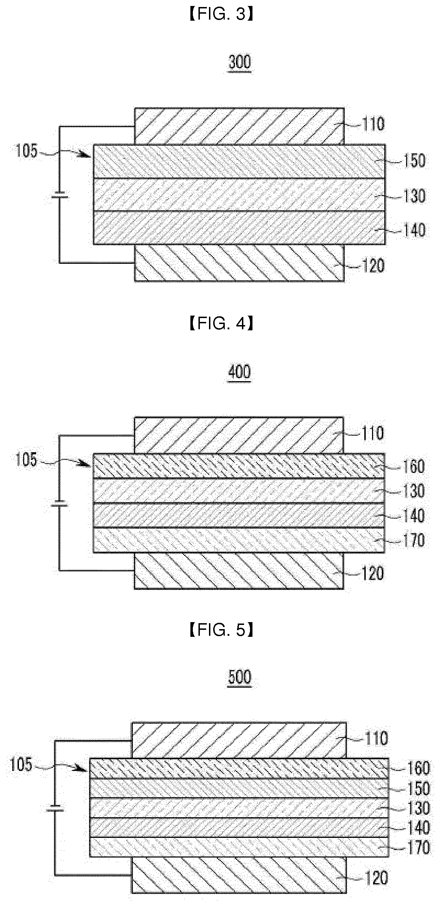

Referring to FIG. 3, a three-layered organic photoelectric device 300 includes an organic thin layer 105 including an electron transport layer 150, an emission layer 130, and a hole transport layer 140. The emission layer 130 is independently installed, and layers having an excellent electron transport capability or an excellent hole transport capability are separately stacked.

Referring to FIG. 4, a four-layered organic photoelectric device 400 includes an organic thin layer 105 including an electron injection layer 160, an emission layer 130, a hole transport layer 140, and a hole injection layer 170 for adherence with the cathode of ITO.

Referring to FIG. 5, a five layered organic photoelectric device 500 includes an organic thin layer 105 including an electron transport layer 150, an emission layer 130, a hole transport layer 140, and a hole injection layer 170, and further includes an electron injection layer 160 to achieve a low voltage.

In the structure of the organic light emitting diode, the organic optoelectronic device (e.g., organic light emitting diode) according to one embodiment of the present invention includes a plurality of a hole transport layer, and the plurality of a hole transport layer may be formed contacting the hole transport layer as shown FIGS. 2 to 5.

The organic light emitting diode may be fabricated by: forming an anode on a substrate; forming an organic thin layer in accordance with a dry coating method such as evaporation, sputtering, plasma plating, and ion plating or a wet coating method such as spin coating, dipping, and flow coating; and providing a cathode thereon.

Another embodiment of the present invention provides a display device including the organic light emitting diode according to the above embodiment.

### [Mode for Invention]

Hereinafter, the embodiments are illustrated in more detail with reference to examples. These examples, however, are not in any sense to be interpreted as limiting the scope of the invention.

### (Preparation of Compound for Organic Optoelectronic Device)

### Synthesis of Intermediate

### Synthesis of intermediate M-1

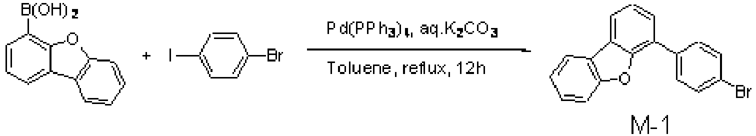

20 g (94.3 mmol) of 4-dibenzofuranboronic acid and 26.7 g (94.3 mmol) of 1-bromo-4-iodobenzene were added to 313 ml of toluene and dissolved therein in a round-bottomed flask, and then 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ dichloromethane (9:1 of a volume ratio) to obtain 27 g (a yield of 89 %) of a target compound, the intermediate M-1, a white solid.

LC-Mass (theoretical value: 322.00 g/mol, measurement value: M+ = 322.09 g/mol, M+2 = 324.04 g/mol)

### Synthesis of Intermediate M-2

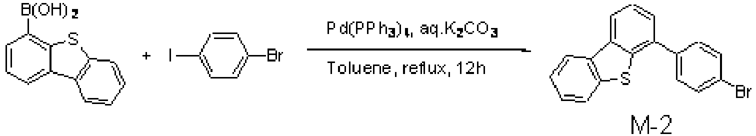

21.5 g (94.3 mmol) of 4-dibenzothiopheneboronic acid, and 26.7 g (94.3 mmol) of 1-bromo-4-iodobenzene were added to 313 ml of toluene and dissolved therein in a round-bottomed flask, and then 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ dichloromethane (9:1 of a volume ratio) to obtain 29 g (a yield of 91 %) of a target compound, the intermediate M-2, a white solid.

LC-Mass (theoretical value: 337.98 g/mol, measurement value: M+ = 338.04 g/mol, M+2 = 340.11 g/mol)

### Synthesis of intermediate M-3

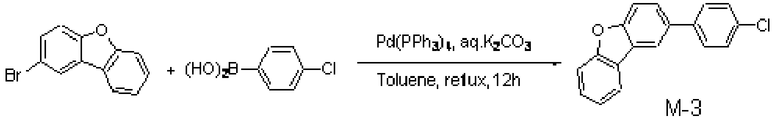

14.7 g (94.3 mmol) of 4-chlorophenylboronic acid and 23.3 g (94.3 mmol) of 2-bromodibenzofuran were added to 313 ml of toluene and dissolved therein in a round-bottomed flask, and 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ dichloromethane (9:1 of a volume ratio) to obtain 23.9 g (a yield of 91 %) of a target compound, the intermediate M-3, a white solid.

LC-Mass (theoretical value: 278.05 g/mol, measurement value: M+ = 278.12 g/mol, M+2 = 280.13 g/mol)

### Synthesis of Intermediate M-41

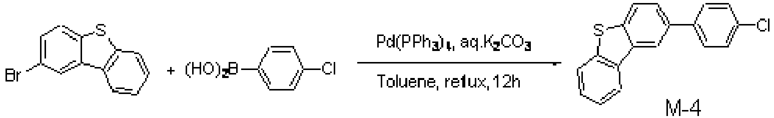

14.7 g (94.3 mmol) of 4-chlorophenylboronic acid and 24.8 g (94.3 mmol) of 2-bromodibenzothiophene were added to 313 ml of toluene and dissolved therein in a round-bottomed flask, 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ dichloromethane (9:1 of a volume ratio) to obtain 25.6 g (a yield of 92 %) of a target compound, the intermediate M-4, a white solid.

LC-Mass (theoretical value: 294.03 g/mol, measurement value: M+ = 294.16 g/mol, M+2 = 296.13 g/mol)

### Synthesis of Intermediate M-5

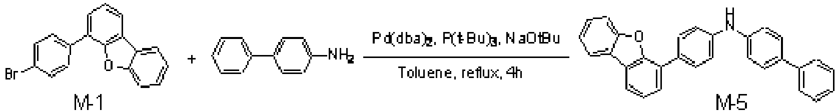

10 g (30.9 mmol) of the intermediate M-1 and 6.3 g (37.08 mmol) of 4-aminobiphenyl, and 5.35 g (55.6 mmol) of sodium t-butoxide were dissolved in 155 ml of toluene and dissolved in a round-bottomed flask. 0.178 g (0.31mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with ethylacetate and distilled water, the organic layer was dried and filtered with magnesium sulfate and concentrated under a reduced pressure. The product was purified through silica gel column chromatography with n-hexane/dichloromethane (7:3 of a volume ratio) to obtain 9.92 g (a yield of 78 %) of a compound, the intermediate M-5, a white solid.

LC-Mass (theoretical value: 411.16 g/mol, measurement value: M+ = 411.21 g/mol)

### Synthesis of intermediate M-6

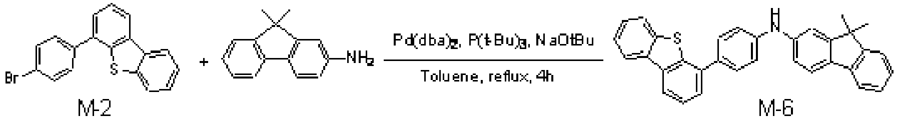

10.5 g (30.9 mmol) of the intermediate M-2, 7.8 g (37.08 mmol) of 2-amino-9,9-dimethyl-9H-fluorene, and 5.35 g (55.6 mmol) of sodium t-butoxide were added to 155 ml of toluene and dissolved therein, in around-bottomed flask. 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with ethylacetate and distilled water, the organic layer was dried and filtered with magnesium sulfate and concentrated under a reduced pressure. The product was purified through silica gel column chromatography with n-hexane/dichloromethane (7:3 of a volume ratio) to obtain 11 g (a yield of 76 %) of a target compound, the intermediate M-6, a white solid.

LC-Mass (theoretical value: 467.17 g/mol, measurement value: M+ = 467.23 g/mol)

### Synthesis of Intermediate M-7

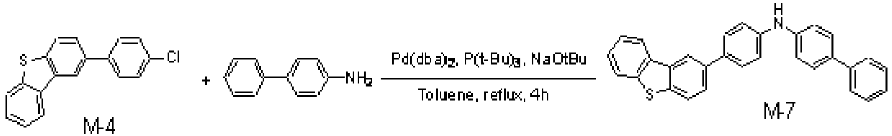

9.1 g (30.9 mmol) of the intermediate M-4, 6.3 g (37.08 mmol) of 4-aminobiphenyl, and 5.35 g (55.6 mmol) of sodium t-butoxide were added to 155 ml of toluene and dissolved therein, in a round-bottomed flask. 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with ethylacetate and distilled water, the organic layer was dried and filtered with magnesium sulfate and concentrated under a reduced pressure. The product was purified through silica gel column chromatography with n-hexane/dichloromethane (7:3 of a volume ratio) to obtain 10.6 g (a yield of 80 %) of a target compound, the intermediate M-7, a white solid.

LC-Mass (theoretical value: 427.14 g/mol, measurement value: M+ = 427.19 g/mol)

### Synthesis of Intermediate M-8

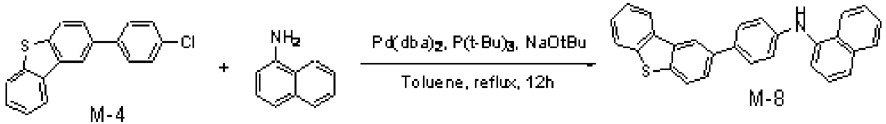

9.1 g (30.9 mmol) of the intermediate M-4, 5.3 g (37.08 mmol) of 1-aminonaphthalene, and 5.35 g (55.6 mmol) of sodium t-butoxide were added to 155 ml of toluene and dissolved therein, in a round-bottomed flask. 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with ethylacetate and distilled water, the organic layer was dried and filtered with magnesium sulfate and concentrated under a reduced pressure. The product was purified through silica gel column chromatography with n-hexane/dichloromethane (7:3 of a volume ratio) to obtain 10 g (a yield of 81 %) of a compound, the intermediate M-8, a white solid.

LC-Mass (theoretical value: 401.12 g/mol, measurement value: M+ = 401.15 g/mol)

### Synthesis of intermediate M-9

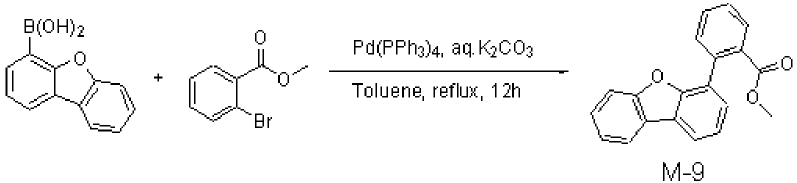

20 g (94.3 mmol) of 4-dibenzofuranboronic acid and 20.3 g (94.3 mmol) of methyl 2-bromobenzoate were added to 313 ml of toluene and dissolved therein, and 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/dichloromethane (9:1 of a volume ratio) to obtain 26.5 g (a yield of 93 %) of a target compound, the intermediate M-9.

LC-Mass (theoretical value: 302.09 g/mol, measurement value: M+ = 302.18 g/mol)

### Synthesis of intermediate M-10

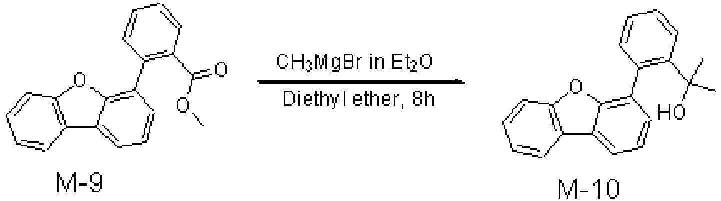

26 g (86 mmol) of the intermediate M-9 was put in a round-bottomed flask heated and dried under a reduced pressure, 430 ml of anhydrous diethylether was added thereto to dissolve the intermediate M-9, and the solution was cooled down to 0 °C and then, agitated under a nitrogen atmosphere. Then, 72 ml (215 mmol) of 3.0 M methylmagnesium bromide diethylether solution was slowly added thereto, and the mixture was agitated at room temperature under a nitrogen atmosphere for 12 hours. The reaction solution was cooled down to 0 °C, a small amount of distilled water was added thereto to complete the reaction, 108 ml of a 2.0 M ammonium chloride aqueous solution was added thereto, the mixture was extracted with diethylether, the extracted solution was dried and filtered with magnesium sulfate , and the filtered solution was concentrated under a reduced pressure. A product therefrom was not additionally purified but used in a next reaction, obtaining 25.7 g of a target compound of an intermediate M-10 (a yield of 99 %).

### Synthesis of intermediate M-11

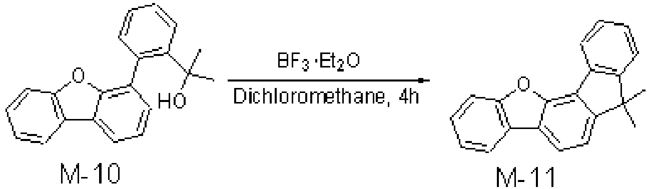

25.7 g (85.1 mmol) of the intermediate M-10 was put in a round-bottomed flask heated and dried under a reduced pressure, 255 ml of anhydrous dichloromethane was added thereto to dissolve it, and the mixture was cooled down to 0 °C and then, agitated under a nitrogen atmosphere. Then, 12.1 g (85.1 mmol) of borontrifluoride diethyletherate was added thereto and refluxed and agitated under a nitrogen atmosphere for 4 hours. The reaction solution was cooled down to 0 °C, the reaction was finished by adding a small amount of distilled water thereto, 85 ml of a 1.0 M sodium bicarbonate aqueous solution was added thereto, the mixture was extracted with dichloromethane, the extracted solution was dried and filtered with magnesium sulfate , and the filtered solution was concentrated under a reduced pressure. The product was purified through silica gel column chromatography with n-hexane/dichloromethane (9:1 of a volume ratio) to obtain 18.1 g (a yield of 75 %) of an intermediate M-11.

LC-Mass (theoretical value: 284.12 g/mol, measurement value: M+ = 284.18 g/mol)

### Synthesis of intermediate M-12

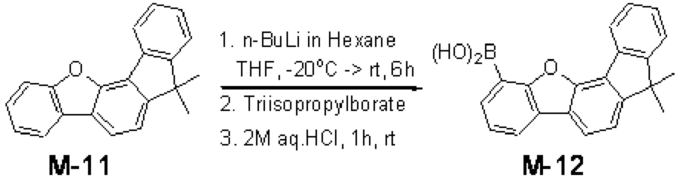

18 g (63.3 mmol) of the intermediate M-11 was put in a round-bottomed flask heated and dried under a reduced pressure, 190 ml of anhydrous tetrahydrofuran was added thereto to dissolve it, and the solution was cooled down to -20 °C and agitated under a nitrogen atmosphere. Then, 31 ml (76 mmol) of a 2.5 M n-butyllithium normal hexane solution was slowly added thereto and agitated under a nitrogen atmosphere for 6 hours. The reaction solution was cooled down to -20 °C, 14.3 g (76 mmol) of triisopropylborate was slowly added thereto, and the mixture was agitated at room temperature under a nitrogen atmosphere for 6 hours. The reaction solution was cooled down to 0 °C, the reaction was finished by adding a small amount of distilled water thereto, 114 ml of a 2.0 M hydrochloric acid aqueous solution was added thereto, the mixture was extracted with diethylether, the extracted solution was dried and filtered with magnesium sulfate under a reduced pressure. The residue was dissolved in acetone and then, recrystallized by adding n-hexane thereto. The produced solid was filtered under a reduced pressure, obtaining 15.6 g (a yield of 75 %) of a target compound of an intermediate M-12.

LC-Mass (theoretical value: 328.13 g/mol, measurement value: M+ = 328.21 g/mol)

### Synthesis of intermediate M-13

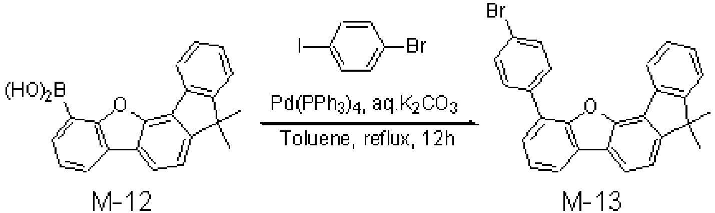

30.9 g (94.3 mmol) of M-12 and 26.7g (94.3 mmol) of 1-bromo-4-iodobenzene were added to 313 ml of toluene and dissolved therein in a round-bottomed flask, and 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ dichloromethane (9:1 of a volume ratio) to obtain 37 g (a yield of 90 %) of a target compound, the intermediate M-13.

LC-Mass (theoretical value: 438.06 g/mol, measurement value: M+ = 438.17 g/mol, M+2 = 440.21 g/mol)

### Synthesis of Intermediate M-14

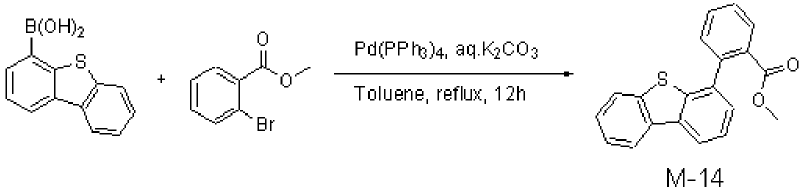

21.5 g (94.3 mmol) of 4-dibenzothiopheneboronic acid and 20.3 g (94.3 mmol) of methyl 2-bromobenzoate were added to 313 ml of toluene and dissolved therein in a round-bottomed flask, and 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ ethylacetate (9:1 of a volume ratio) to obtain 27.6 g (a yield of 92 %) of a target compound, the intermediate M-9.

LC-Mass (theoretical value: 318.07 g/mol, measurement value: M+ = 318.13 g/mol)

### Synthesis of Intermediate M-15

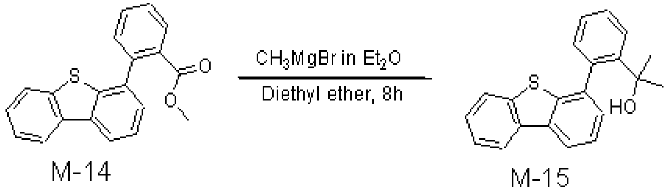

27.4 g (86 mmol) of the intermediate M-14 was put in a round-bottomed flask heated and dried under a reduced pressure, 430 ml of anhydrous diethylether was added thereto to dissolve it, and the solution was cooled down to 0 °C and then, agitated under a nitrogen atmosphere. Then, 72 ml (215 mmol) of a 3.0 M methylmagnesium bromide diethylether solution was slowly added thereto, and the mixture was agitated at room temperature under a nitrogen atmosphere for 12 hours. The reaction solution was cooled down to 0 °C, the reaction was finished by adding a small amount of distilled water thereto, 108 ml of a 2.0 M ammonium chloride aqueous solution was added thereto, the mixture was extracted with diethylether, the extracted solution was dried and filtered with magnesium sulfate, and then, the filtered solution was concentrated under a reduced pressure. The obtained product was not additionally purified but used in a next reaction, obtaining 27.1 g (a yield of 99 %) of a target compound, an intermediate M-15.

### Synthesis of Intermediate M-16

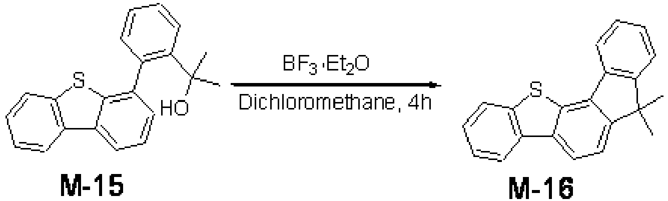

27.1 g (85.1 mmol) of the intermediate M-15 was put in a round-bottomed flask heated and dried under a reduced pressure, 255 ml of anhydrous dichloromethane was added thereto to dissolve it, and the solution was cooled down to 0 °C and then, agitated under a nitrogen atmosphere. Then, 12.1 g (85.1 mmol) of borontri-fluoride diethyletherate was slowly added thereto, and the mixture was agitated at room temperature under a nitrogen atmosphere for 4 hours. The reaction solution was cooled down to 0 °C, the reaction was finished by adding a small amount of distilled water thereto, 85 ml of a 1.0 M sodium bicarbonate aqueous solution was added thereto, the mixture was extracted with dichloromethane, the extracted solution was dried and filtered with magnesium sulfate, and the filtered solution was concentrated under a reduced pressure. The product was purified through silica gel column chromatography with n-hexane/dichloromethane (9:1 of a volume ratio) to obtain 19.4 g (a yield of 76 %) of an intermediate M-16.

LC-Mass (theoretical value: 300.10 g/mol, measurement value: M+ = 300.21 g/mol)

### Synthesis of Intermediate M-17

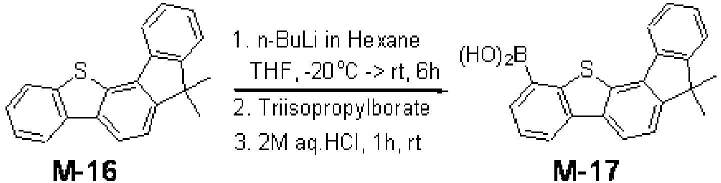

19 g (63.3 mmol) of the intermediate M-16 was put in a round-bottomed flask heated and dried under a reduced pressure, 190 ml of anhydrous tetrahydrofuran was added thereto to dissolve it, and the solution was cooled down to -20 °C and then, agitated under a nitrogen atmosphere. Then, 31 ml (76 mmol) of a 2.5 M n-butyllithium normal hexane solution was slowly added thereto and agitated under a nitrogen atmosphere for 6 hours. The reaction solution was cooled down to -20 °C, 14.3 g (76 mmol) of triisopropylborate was slowly added thereto, and the mixture was agitated at room temperature under a nitrogen atmosphere for 6 hours. Then, the reaction solution was cooled down to 0 °C, the reaction was terminated by adding a small amount of distilled water thereto, 114 ml of a 2.0 M hydrochloric acid aqueous solution was added thereto, the mixture was extracted with diethylether, the extracted solution was dried and filtered with magnesium sulfate, and the filtered solution was concentrated under a reduced pressure. The residue was dissolved in acetone and then, recrystallized by adding n-hexane thereto. The produced solid was filtered under a reduced pressure, obtaining 16.3 g (a yield of 75 %) of a target compound, an intermediate M-17.

LC-Mass (theoretical value: 344.10 g/mol, measurement value: M+ = 344.19 g/mol)

### Synthesis of Intermediate M-18

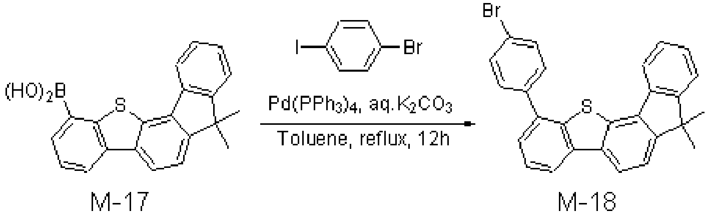

32.5 g (94.3mmol) of M-17 and 26.7g (94.3mmol) of 1-bromo-4-iodobenzene were added to 313 ml of toluene and dissolved therein in a round-bottomed flask, and 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ dichloromethane (9:1 of a volume ratio) to obtain 39.5 g (a yield of 92 %) of a target compound, an intermediate M-18.

LC-Mass (theoretical value: 454.04 g/mol, measurement value: M+ = 454.12 g/mol, M+2 = 456.11 g/mol)

### Synthesis of Intermediate M-19

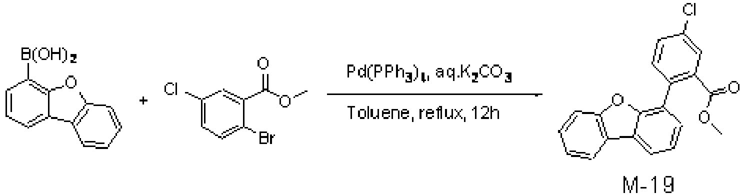

20 g (94.3 mmol) of 4-dibenzofuranboronic acid and 23.5 g (94.3 mmol) of methyl 2-bromo-5-chlorobenzoate were added to 313 ml of toluene and dissolved therein in a round-bottomed flask, and 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ ethylacetate (9:1 of a volume ratio) to obtain 30 g (a yield of 94 %) of a target compound, an intermediate M-19.

LC-Mass (theoretical value: 336.06 g/mol, measurement value: M+ = 336.18 g/mol)

### Synthesis of Intermediate M-20

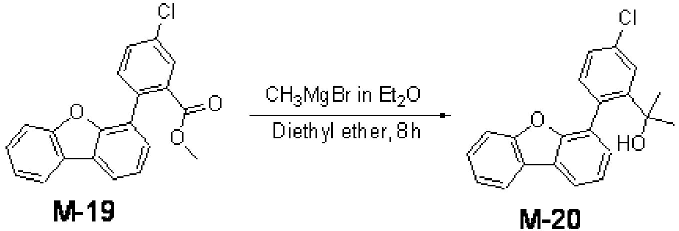

29 g (86 mmol) of the intermediate M-19 was put in a round-bottomed flask heated and dried under a reduced pressure, 430 ml of anhydrous diethylether was added thereto to dissolve it, and the solution was cooled down to 0 °C and then, agitated under a nitrogen atmosphere. Then, 72 ml (215 mmol) of a 3.0 M methylmagnesium bromide diethylether solution was slowly added thereto, and the mixture was agitated at room temperature under a nitrogen atmosphere for 12 hours. The reaction solution was cooled down to 0 °C, the reaction was terminated by adding a small amount of distilled water thereto, 108 ml of a 2.0 M ammonium chloride aqueous solution was added thereto, the mixture was extracted with diethylether, the extracted solution was dried and filtered with magnesium sulfate, and the filtered solution was concentrated under a reduced pressure. The obtained product was not additionally purified but used in a next reaction, obtaining 28.7 g (a yield of 99 %) of a target compound, an intermediate M-20.

LC-Mass (theoretical value: 336.09 g/mol, measurement value: M+ = 336.15 g/mol)

### Synthesis of Intermediate M-21

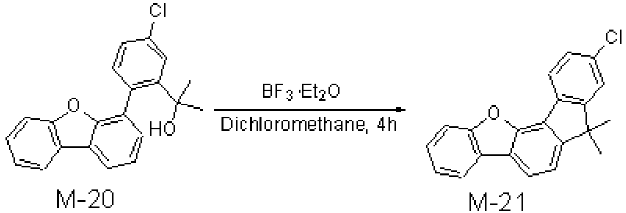

28.7 g (85.1 mmol) of the intermediate M-20 was put in a round-bottomed flask heated and dried under a reduced pressure, 255 ml of anhydrous dichloromethane to dissolve it, and the solution was cooled down to 0 °C and then, agitated under a nitrogen atmosphere. Then, 12.1 g (85.1 mmol) of a borontri-fluoride diethyletherate was slowly added thereto and the mixture was agitated at room temperature under a nitrogen atmosphere for 4 hours. The reaction solution was cooled down to 0 °C, the reaction was terminated by adding a small amount of distilled water thereto, 85 ml of a 1.0 M sodium bicarbonate aqueous solution was added thereto, the mixture was extracted with dichloromethane, the extracted solution was dried and filtered with magnesium sulfate , and the filtered solution was concentrated under a reduced pressure. The product was purified through silica gel column chromatography with n-hexane/dichloromethane (9:1 of a volume ratio) to obtain 20.1 g (a yield of 74 %) of an intermediate M-21.

LC-Mass (theoretical value: 318.08 g/mol, measurement value: M+ = 318.15 g/mol)

### Synthesis of Intermediate M-22

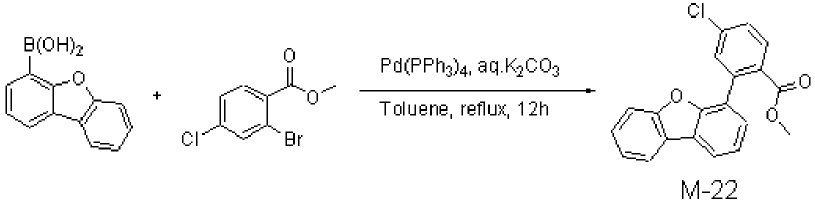

20 g (94.3 mmol) of 4-dibenzofuranboronic acid and 23.5 g (94.3 mmol) of methyl 2-bromo-4-chlorobenzoate were added to 313 ml of toluene and dissolved therein in a round-bottomed flask, and 117 ml of an aqueous solution in which 19.5 g (141.5 mmol) of potassium carbonate was dissolved was added thereto, and then, the mixture was agitated. Then, 1.09 g (0.94 mmol) of tetrakistriphenylphosphinepalladium was added thereto, and the mixture was refluxed and agitated under a nitrogen atmosphere for 12 hours. When the reaction was terminated, the resultant was extracted with ethylacetate, the extracted solution was dried and filtered with magnesium sulfate, and the filtered solution was concentrated under a reduced pressure. The product was purified through silica gel column chromatography with n-hexane/ ethylacetate (9:1 of a volume ratio) to obtain 30.2 g (a yield of 95 %) of a target compound, an intermediate M-22.

LC-Mass (theoretical value: 336.06 g/mol, measurement value: M+ = 336.14 g/mol)

### Synthesis of Intermediate M-23

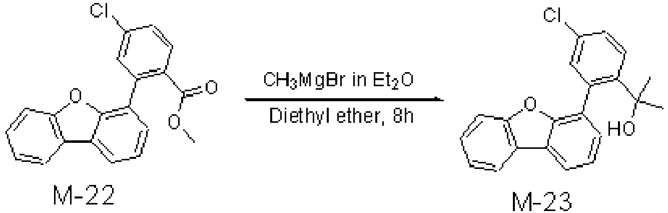

29 g (86 mmol) of the intermediate M-22 was put in a round-bottomed flask heated and dried under a reduced pressure, 430 ml of anhydrous diethylether was added thereto to dissolve it, and the solution was cooled down to 0 °C and then, agitated under a nitrogen atmosphere. Then, 72 ml (215 mmol) of a 3.0 M methylmagnesium bromide diethylether solution was slowly added thereto, and the mixture was agitated at room temperature under a nitrogen atmosphere for 12 hours. The reaction solution was cooled down to 0 °C, a small amount of distilled water was added thereto to terminate the reaction, 108 ml of a 2.0 M ammonium chloride aqueous solution was added thereto, the mixture was extracted with diethylether, the extracted solution was dried and filtered with magnesium sulfate, and the filtered solution was concentrated under a reduced pressure. The obtained product was not additionally purified but used in a next reaction, obtaining 28.7 g (a yield of 99 %) of a target compound, an intermediate M-23.

LC-Mass (theoretical value: 336.06 g/mol, measurement value: M+ = 336.14 g/mol)

### Synthesis of Intermediate M-24

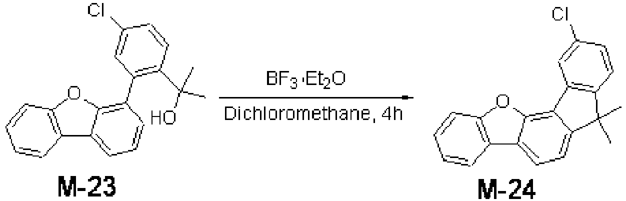

28.7 g (85.1 mmol) of the intermediate M-23 was put in a round-bottomed flask heated and dried under a reduced pressure, 255 ml of anhydrous dichloromethane was added thereto to dissolve it, and the solution was cooled down to 0 °C and agitated under a nitrogen atmosphere. Then, 12.1 g (85.1 mmol) of a borontri-fluoride diethyletherate was slowly added thereto, and the mixture was agitated at room temperature under a nitrogen atmosphere for 4 hours. The reaction solution was cooled down to 0 °C, the reaction was terminated by adding a small amount of distilled water thereto, 85 ml of a 1.0 M sodium bicarbonate aqueous solution was added thereto, the mixture was extracted with dichloromethane, the extracted solution was dried and filtered with magnesium sulfate, and the filtered solution was concentrated under a reduced pressure. The product was purified through silica gel column chromatography with n-hexane/dichloromethane (9:1 of a volume ratio) to obtain 20.6 g (a yield of 76 %) of an intermediate M-24.

LC-Mass (theoretical value: 318.08 g/mol, measurement value: M+ = 318.19 g/mol)

### Synthesis of Intermediate M-25

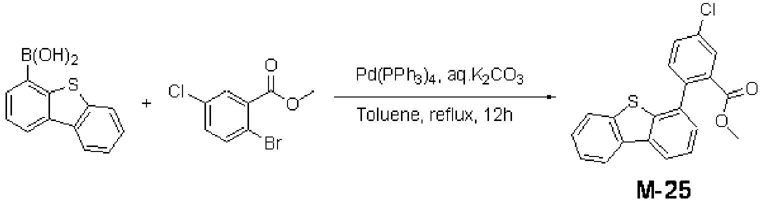

21.5 g (94.3 mmol) of 4-dibenzothiopheneboronic acid and 23.5 g (94.3 mmol) of methyl 2-bromo-5-chloro benzoate were added to 313 ml of toluene and dissolved therein in a round-bottomed flask, and 117 ml of an aqueous solution in which 19.5 g (141.5 mmol) of potassium carbonate was dissolved was added and then agitated. 1.09 g (0.94 mmol) of tetrakistriphenylphosphinepalladium was added thereto, and the mixture was refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ ethylacetate (9:1 of a volume ratio) to obtain 31.6 g (a yield of 95 %) of a target compound, an intermediate M-25.

LC-Mass (theoretical value: 352.03 g/mol, measurement value: M+ = 352.08 g/mol)

### Synthesis of Intermediate M-26

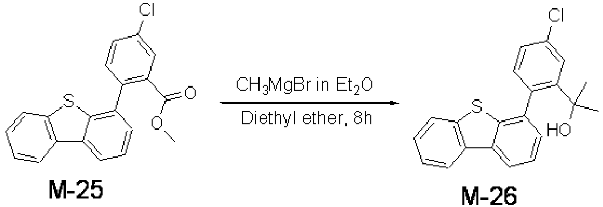

30.3 g (86 mmol) of the intermediate M-25 was put in a round-bottomed flask heated and dried under a reduced pressure drying, 430 ml of anhydrous diethylether was added thereto to dissolve it, and the solution was cooled down to 0 °C and agitated under a nitrogen atmosphere. Then, 72 ml (215 mmol) of a 3.0 M methylmagnesium bromide diethylether solution was slowly added thereto, and the mixture was agitated at room temperature under a nitrogen atmosphere for 12 hours. The reaction solution was cooled down to 0 °C, the reaction was terminated by adding a small amount of distilled water thereto to dissolve it, 108 ml of a 2.0 M ammonium chloride aqueous solution was extracted with diethylether, the extracted solution was dried and filtered with magnesium sulfate, and the filtered solution was concentrated under a reduced pressure. The obtained product was not additionally purified but used in a next reaction, obtaining 30 g (a yield of 99 %) of a target compound, an intermediate M-26.

LC-Mass (theoretical value: 352.07 g/mol, measurement value: M+ = 352.09g/mol)

### Synthesis of Intermediate M-27

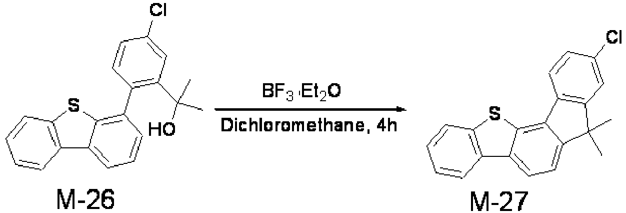

30 g (85.1 mmol) of the intermediate M-26 was put in a round-bottomed flask heated and dried under a reduced pressure, 255 ml of anhydrous dichloromethane was added thereto to dissolve it, and the solution was cooled down to 0 °C and then, agitated under a nitrogen atmosphere. Then, 12.1 g (85.1 mmol) of borontri-fluoride diethyletherate was slowly added thereto, and the mixture was agitated at room temperature under a nitrogen atmosphere for 4 hours. The reaction solution was cooled down to 0 °C, the reaction was terminated by adding a small amount of distilled water thereto, 85 ml of a 1.0M sodium bicarbonate aqueous solution was added thereto, the mixture was extracted with dichloromethane, the extracted solution was dried and filtered with magnesium sulfate, and the filtered solution was concentrated under a reduced pressure. The product was purified through silica gel column chromatography with n-hexane/dichloromethane (9:1 of a volume ratio) to obtain 21.4 g (a yield of 75 %) of an intermediate M-27.

LC-Mass (theoretical value: 334.06 g/mol, measurement value: M+ = 334.13 g/mol)

### Synthesis of Intermediate M-28

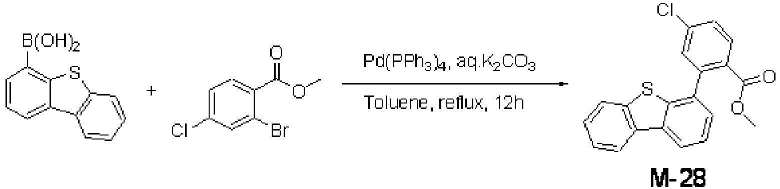

21.5 g (94.3 mmol) of 4-dibenzothiopheneboronic acid and 23.5 g (94.3 mmol) of methyl 2-bromo-4-chloro benzoate were added to 313 ml of toluene and dissolved therein in a round-bottomed flask, and 117 ml of an aqueous solution in which 19.5 g (141.5 mmol) of potassium carbonate was dissolved was added thereto, and then, the mixture was agitated. Then, 1.09 g (0.94 mmol) of tetrakistriphenylphosphinepalladium was added thereto, and the mixture was refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ ethylacetate (9:1 of a volume ratio) to obtain 31 g (a yield of 93 %) of a target compound, an intermediate M-28.

LC-Mass (theoretical value: 352.03 g/mol, measurement value: M+ = 352.07 g/mol)

### Synthesis of Intermediate M-29

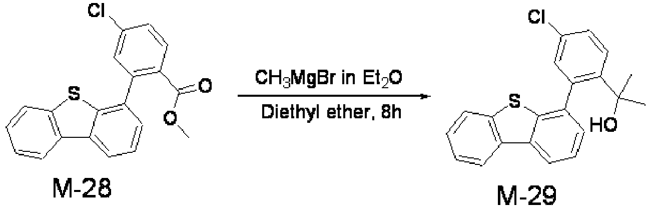

30.3 g (86 mmol) of the intermediate M-28 was put in a round-bottomed flask heated and dried under a reduced pressure, 430 ml of anhydrous diethylether was added thereto to dissolve it, and the solution was cooled down to 0 °C and then, agitated under a nitrogen atmosphere. Then, 72 ml (215 mmol) of a 3.0 M methylmagnesium bromide diethylether solution was slowly added thereto, and the mixture was agitated at room temperature under a nitrogen atmosphere for 12 hours. The reaction solution was cooled down to 0 °C, the reaction was terminated by adding a small amount of distilled water to dissolve it, 108 ml of a 2.0 M ammonium chloride aqueous solution was added thereto, the mixture was extracted with diethylether, the extracted solution was dried and filtered with magnesium sulfate, and the filtered solution was concentrated under a reduced pressure. The obtained product was not additionally purified but used in a next reaction, obtaining 30 g (a yield of 99 %) of a target compound, an intermediate M-29.

LC-Mass (theoretical value: 352.07 g/mol, measurement value: M+ = 352.21 g/mol)

### Synthesis of Intermediate M-30

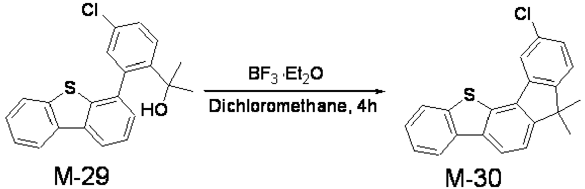

30 g (85.1 mmol) of the intermediate M-29 was put in a round-bottomed flask heated and dried under a reduced pressure, 255 ml of anhydrous dichloromethane was added thereto to dissolve it, and the solution was cooled down to 0 °C and then, agitated under a nitrogen atmosphere. 12.1 g (85.1 mmol) of a borontri-fluoride diethyletherate was slowly added thereto and the mixture was agitated at room temperature under a nitrogen atmosphere for 4 hours. The reaction solution was cooled down to 0 °C, the reaction was terminated by adding a small amount of distilled water thereto, 85 ml of a 1.0 M sodium bicarbonate aqueous solution was added thereto, the mixture was extracted with dichloromethane, the extracted solution was dried and filtered with magnesium sulfate, and the filtered solution was concentrated under a reduced pressure. The product was purified through silica gel column chromatography with n-hexane/dichloromethane (9:1 of a volume ratio) to obtain 21.1 g (a yield of 74 %) of an intermediate M-30.

LC-Mass (theoretical value: 334.06 g/mol, measurement value: M+ = 334.16 g/mol)

### Synthesis of Intermediate M-31

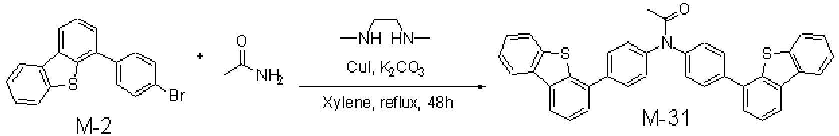

31.9g (64.7mmol) of the intermediate M-2, 1.74 g (29.4 mmol) of acetamide, and 17.3 g (117.6 mmol) of potassium carbonate were put in a round-bottomed flask, and 130 ml of xylene was added thereto to dissolve it. Then, 1.12 g (5.88 mmol) of copper iodide (I) and 1.04 g (11.8 mmol) of N,N-dimethylethylenediamine were sequentially added thereto, and the mixture was refluxed and agitated under a nitrogen atmosphere for 48 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ethylacetate (7:3 of a volume ratio) to obtain 14 g (a yield of 93 %) of a target compound, an intermediate M-31.

LC-Mass (theoretical value: 575.14 g/mol, measurement value: M+ = 575.31 g/mol)

### Synthesis of Intermediate M-32

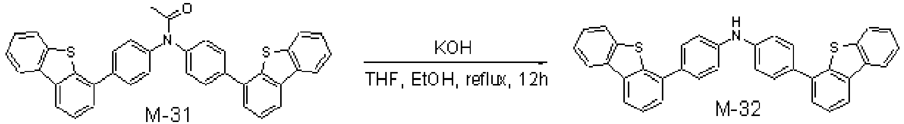

13 g (25.2 mmol) of the intermediate M-31 and 4.2 g (75.6 mmol) of potassium hydroxide were put in a round-bottomed flask, and 80 ml of tetrahydrofuran and 80 mL of ethanol were added thereto to dissolve them. The solution was refluxed and agitated under a nitrogen atmosphere for 12 hours. When the reaction was terminated, the reaction solution was concentrated under a reduced pressure, the resultant was extracted with dichloromethane and distilled water, an organic layer was dried and filtered with magnesium sulfate and concentrated under a reduced pressure. The product was purified through silica gel column chromatography with n-hexane/dichloromethane (7:3 of a volume ratio) to obtain 12.1 g (a yield of 90 %) of a target compound, an intermediate M-32.

LC-Mass (theoretical value: 533.13 g/mol, measurement value: M+ = 533.26 g/mol)

### Synthesis of Intermediate M-33

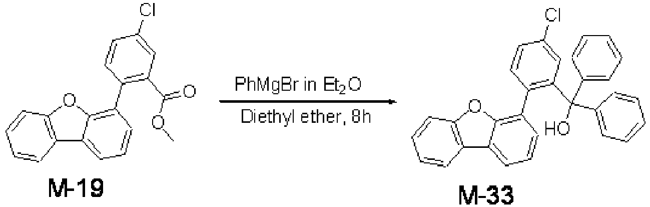

29 g (86 mmol) of the intermediate M-19 was put in a round-bottomed flask heated and dried under a reduced pressure, 430 ml of anhydrous diethylether was added thereto to dissolve it, and the solution was cooled down to 0 °C and then, agitated under a nitrogen atmosphere. Then, 72 ml (215 mmol) of a 3.0 M phenylmagnesium bromide diethylether solution was slowly added thereto, and the mixture was agitated at room temperature under a nitrogen atmosphere for 12 hours. The reaction solution was cooled down to 0 °C, the reaction was terminated by adding a small amount of distilled water thereto, 108 ml of a 2.0 M ammonium chloride aqueous solution was added thereto, the mixture was extracted with diethylether, the extracted solution was dried and filtered with magnesium sulfate, and the filtered solution was concentrated under a reduced pressure. The obtained product was not additionally purified but used in a next reaction, obtaining 39.2 g (a yield of 99 %) of a target compound, an intermediate M-33.

LC-Mass (theoretical value: 460.12 g/mol, measurement value: M+ = 460.26 g/mol)

### Synthesis of Intermediate M-34

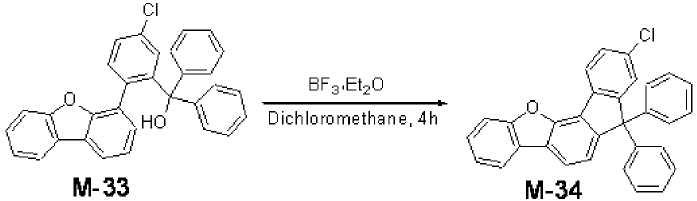

39.2 g (85.1 mmol) of the intermediate M-33 was put in a round-bottomed flask heated and dried under a reduced pressure, 255 ml of anhydrous dichloromethane was added thereto to dissolve it, and the solution was cooled down to 0 °C and agitated under a nitrogen atmosphere. Then, 12.1 g (85.1 mmol) of a borontri-fluoride diethyletherate was slowly added thereto, and the mixture was agitated at room temperature under a nitrogen atmosphere for 4 hours. The reaction solution was cooled down to 0 °C, the reaction was terminated by adding a small amount of distilled water thereto, 85 ml of a 1.0 M sodium bicarbonate aqueous solution was added thereto, the mixture was extracted with dichloromethane, the extracted solution was dried and filtered with magnesium sulfate, and the filtered solution was concentrated under a reduced pressure. The product was purified f a through silica gel column chromatography with n-hexane/dichloromethane (9:1 volume ratio) to obtain 26.4 g (a yield of 70 %) of an intermediate M-34.

LC-Mass (theoretical value: 442.11 g/mol, measurement value: M+ = 442.32 g/mol)

### Synthesis of Intermediate M-35

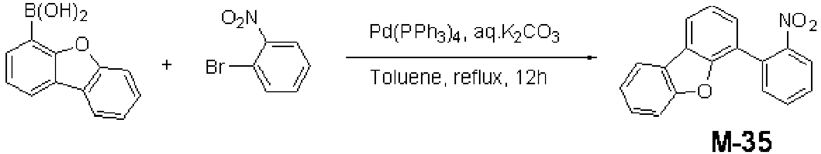

20 g (94.3 mmol) of 4-dibenzofuranboronic acid and 19.05 g (94.3 mmol) of 2-bromonitro-benzene were added to 313 ml of toluene and dissolved therein in a round-bottomed flask, and 117 ml of an aqueous solution in which 19.5 g (141.5 mmol) of potassium carbonate was dissolved was added and then agitated. Then, 1.09 g (0.94 mmol) of tetrakistriphenylphosphinepalladium was added thereto and refluxed and agitated under a nitrogen atmosphere for 12 hours.

When the reaction was terminated, the resultant was extracted with ethylacetate, the extracted solution was dried and filtered with magnesium sulfate and concentrated under a reduced pressure. The product was purified through silica gel column chromatography with n-hexane/ ethylacetate (9:1 of a volume ratio) to obtain 25.4 g (a yield of 93 %) of a target compound, an intermediate M-35.

LC-Mass (theoretical value: 289.07 g/mol, measurement value: M+ = 289.16 g/mol)

### Synthesis of Intermediate M-36

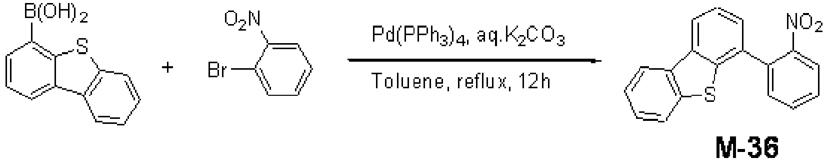

21.5 g (94.3 mmol) of 4-dibenzothiopheneboronic acid and 19.05 g (94.3 mmol) of 2-bromo-nitrobenzene were added to 313 ml of toluene and dissolved therein in a round-bottomed flask, and 117 ml of an aqueous solution in which 19.5 g (141.5 mmol) of potassium carbonate was dissolved was added and then agitated. Then, 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ ethylacetate (9:1 of a volume ratio) to obtain 27.4 g (a yield of 95 %) of a target compound, an intermediate M-36.

LC-Mass (theoretical value: 305.05 g/mol, measurement value: M+ = 305.29 g/mol)

### Synthesis of Intermediate M-37

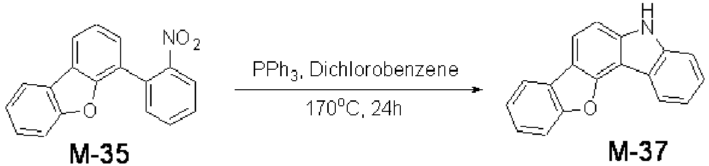

25 g (86.4 mmol) of the intermediate M-35 and 45.3 g (173 mmol) of triphenylphosphine were added to 260 ml of dichlorobenzene and dissolved therein in a round-bottomed flask, and then agitated under a nitrogen atmosphere for 24 hours at 170 °C. When the reaction was terminated, the resultant was extracted with toluene and distilled water, the extracted solution was dried and filtered with magnesium sulfate and concentrated under a reduced pressure. The product was purified through silica gel column chromatography with n-hexane/ dichloromethane (7:3 of a volume ratio) to obtain 16.7 g (a yield of 75 %) of a target compound, an intermediate M-37.

LC-Mass (theoretical value: 257.08 g/mol, measurement value: M+ = 257.21 g/mol)

### Synthesis of Intermediate M-38

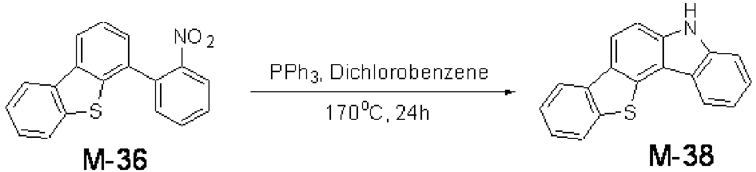

26.4 g (86.4 mmol) of the intermediate M-36 and 45.3 g (173 mmol) of triphenylphosphine were added to 260 ml of dichlorobenzene and dissolved therein in a round-bottomed flask, and then agitated under a nitrogen atmosphere for 24 hours at 170°C. When the reaction was terminated, the resultant was extracted with toluene and distilled water, the extracted solution was dried and filtered with magnesium sulfate and concentrated under a reduced pressure. The product was purified through silica gel column chromatography with n-hexane/ dichloromethane (7:3 of a volume ratio) to obtain 17.5 g (a yield of 74 %) of a target compound, an intermediate M-38.

LC-Mass (theoretical value: 273.06 g/mol, measurement value: M+ = 273.19 g/mol)

### Synthesis of Intermediate M-39

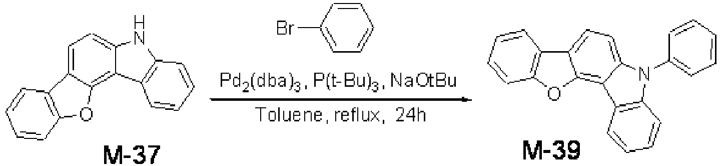

16 g (62.2 mmol) of the intermediate M-37, 14.6 g (93.3 mmol) of bromobenzene, and 9.0 g (93.3 mmol) of sodium t-butoxide were added to 190 ml of toluene and dissolved therein, in a round-bottomed flask. Then, 1.07 g (1.87 mmol) of Pd(dba)2 and 1.13 g (5.60 mmol) of tri-tertiary-butylphosphine were sequentially added and then refluxed and agitated under a nitrogen atmosphere for 24 hours. When the reaction was terminated, the resultant was extracted with toluene and distilled water, and an organic layer was dried and filtered with magnesium sulfate and concentrated under a reduced pressure. The product was purified through silica gel column chromatography with n-hexane/dichloromethane (8:2 of a volume ratio) to obtain 17.6 g (a yield of 85 %) of a target compound, an intermediate M-39

LC-Mass (theoretical value: 333.12 g/mol, measurement value: M+ = 333.16 g/mol)

### Synthesis of Intermediate M-40

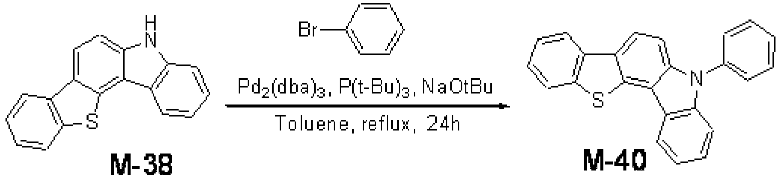

17 g (62.2 mmol) of the intermediate M-38, 14.6 g (93.3 mmol) of bromobenzene, and 9.0 g (93.3 mmol) of sodium t-butoxide were added to 190 ml of toluene and dissolved therein, in a round-bottomed flask. 1.07 g (1.87 mmol) of Pd(dba)2 and 1.13 g (5.60 mmol) of tri-tertiary-butylphosphine were sequentially added and then refluxed and agitated under a nitrogen atmosphere for 24 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 18 g (a yield of 83 %) of a target compound, an intermediate M-40.

LC-Mass (theoretical value: 349.09 g/mol, measurement value: M+ = 349.13 g/mol)

### Synthesis of Intermediate M-41

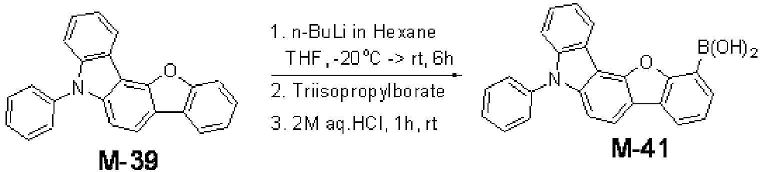

21.1 g (63.3 mmol) of the intermediate M-39 was put in a round-bottomed flask heated and dried under a reduced pressure, 190 ml of anhydrous tetrahydrofuran was added thereto to dissolve it, and the solution was cooled down to -20 °C and agitated under a nitrogen atmosphere. Then, 31 ml (76 mmol) of a 2.5 M n-butyllithium normal hexane solution was slowly added thereto and agitated under a nitrogen atmosphere for 6 hours. The reaction solution was cooled down to -20 °C, 14.3 g (76 mmol) of triisopropylborate was slowly added thereto, and the mixture was agitated at room temperature under a nitrogen atmosphere for 6 hours. The reaction solution was cooled down to 0 °C, the reaction was terminated by adding a small amount of distilled water thereto, 114 ml of a 2.0M hydrochloric acid aqueous solution was added thereto, the mixture was extracted with diethylether, the extracted solution as dried and filtered with magnesium sulfate, and the filtered solution was concentrated under a reduced pressure. The residue was dissolved in acetone and then, recrystallized in n-hexane. The produced solid was filtered under a reduced pressure, obtaining 17.0 g (a yield of 71 %) of a target compound, an intermediate M-41.

LC-Mass (theoretical value: 377.12 g/mol, measurement value: M+ = 377.15 g/mol)

### Synthesis of Intermediate M-42

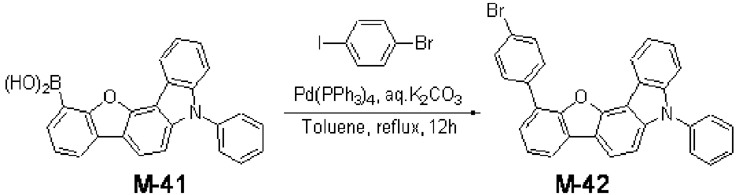

35.6 g (94.3 mmol) of M-41 and 26.7 g (94.3 mmol) of 1-bromo-4-iodobenzene were added to 313 ml of toluene and dissolved therein in a round-bottomed flask, and 117 ml of an aqueous solution in which 19.5 g (141.5 mmol) of potassium carbonate was dissolved was added and then agitated. Then, 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ dichloromethane (9:1 of a volume ratio) to obtain 41.4 g (a yield of 90 %) of a target compound, an intermediate M-42.

LC-Mass (theoretical value: 487.06 g/mol, measurement value: M+ = 487.13 g/mol, M+2 = 489.19 g/mol)

### Synthesis of Intermediate M-43

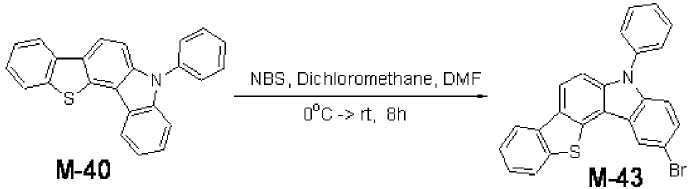

18 g (51.5 mmol) of the intermediate M-40 was put in a round-bottomed flask, and 160 ml of dichloromethane was added thereto to dissolve it. Then, 9.17 g (51.5 mmol) of N-bromosuccinimide dissolved in 45 mL of N,N-dimethyl formamide was slowly added thereto in a dropwise fashion at 0 °C. The reaction solution was heated up to room temperature and agitated under a nitrogen atmosphere for 8 hours. When the reaction was terminated, a potassium carbonate aqueous solution was added, the resultant was extracted with dichloromethane and distilled water, an organic layer was dried and filtered with magnesium sulfate and concentrated under a reduced pressure. The product was purified through silica gel column chromatography with n-hexane/ dichloromethane (8:2 of a volume ratio) to obtain 15.9 g (a yield of 72 %) of a target compound, an intermediate M-43.

LC-Mass (theoretical value: 427.00 g/mol, measurement value: M+ = 427.12 g/mol, M+2 =429.23)

### Synthesis of Intermediate M-44

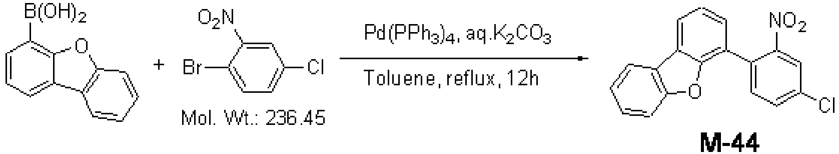

20 g (94.3 mmol) of 4-dibenzofuranboronic acid and 22.3 g (94.3 mmol) of 2-bromo-4-chloronitrobenzene were added to 313 ml of toluene and dissolved therein, in a round-bottomed flask, and 117 ml of an aqueous solution in which 19.5 g (141.5 mmol) of potassium carbonate was dissolved was added and then agitated. 1.09 g (0.94 mmol) of tetrakistriphenylphosphinepalladium was added thereto and refluxed and agitated under a nitrogen atmosphere for 12 hours. When the reaction was terminated, the resultant was extracted with ethylacetate, the extracted solution was dried and filtered with magnesium sulfate and concentrated under a reduced pressure. The product was purified through silica gel column chromatography with n-hexane/ ethylacetate (9:1 of a volume ratio) to obtain 27.8 g (a yield of 91 %) of a target compound, an intermediate M-44.

LC-Mass (theoretical value: 323.03 g/mol, measurement value: M+ = 323.18 g/mol)

### Synthesis of Intermediate M-45

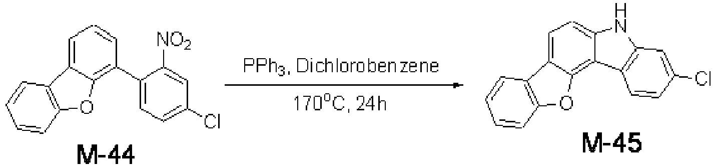

28 g (86.4 mmol) of the intermediate M-44 and 45.3 g (173 mmol) of triphenylphosphine were added to 260 ml of dichlorobenzene and dissolved therein in round-bottomed flask, and then agitated under a nitrogen atmosphere for 24 hours at 170 °C. When the reaction was terminated, the resultant was extracted with toluene and distilled water, the extracted solution was dried and filtered with magnesium sulfate and concentrated under a reduced pressure.

The product was purified through silica gel column chromatography with n-hexane/ dichloromethane (7:3 of a volume ratio) to obtain 18.1 g (a yield of 72 %) of a target compound, an intermediate M-45.

LC-Mass (theoretical value: 291.05 g/mol, measurement value: M+ = 291.13 g/mol)

### Synthesis of Intermediate M-46

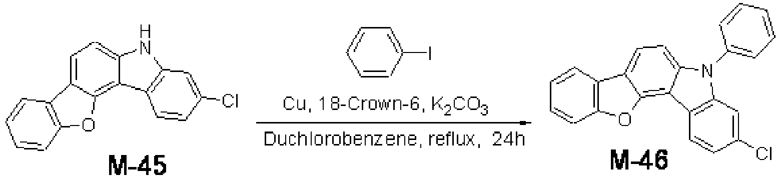

18 g (61.7 mmol) of the intermediate M-45, 19 g (93.3 mmol) of iodobenzene, and 12.9 g (93.3 mmol) of potassium carbonate were added to 190 ml of dichlorobenzene and dissolved therein, in a round-bottomed flask. 0.39 g (6.17 mmol) of a copper powder and 1.63 g (6.17 mmol) of 18-crown-6-ether were sequentially added thereto, and then refluxed and agitated under a nitrogen atmosphere for 24 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 19.3 g (a yield of 85 %) of a target compound, an intermediate M-46.

LC-Mass (theoretical value: 367.08 g/mol, measurement value: M+ = 367.16 g/mol)

### Synthesis of Intermediate M-47

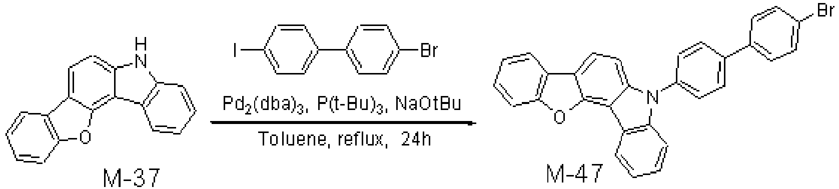

16 g (62.2 mmol) of the intermediate M-37, 33.5 g (93.3 mmol) of 4-bromo-4'-iodobiphenyl, and 9.0 g (93.3 mmol) of sodium t-butoxide were added to 190 ml of toluene and dissolved therein, in a round-bottomed flask. 1.07 g (1.87 mmol) of Pd(dba)2 and 1.13 g (5.60 mmol) of tri-tertiary-butylphosphine were sequentially added and then refluxed and agitated under a nitrogen atmosphere for 24 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 21.6 g (a yield of 71 %) of a target compound, an intermediate M-47.

LC-Mass (theoretical value: 487.06 g/mol, measurement value: M+ = 487.24 g/mol)

### Synthesis of Intermediate M-48

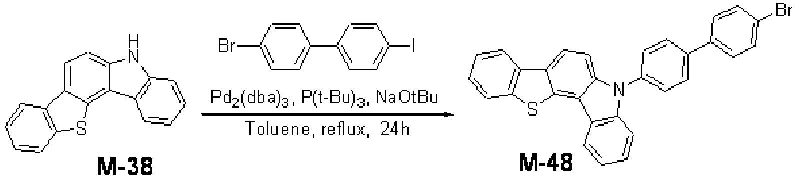

17 g (62.2 mmol) of the intermediate M-38, 33.5 g (93.3 mmol) of 4-bromo-4'-iodobiphenyl, and 9.0 g (93.3 mmol) of sodium t-butoxide were added to 190 ml of toluene and dissolved therein, in a round-bottomed flask. Then, 1.07 g (1.87 mmol) of Pd(dba)2 and 1.13 g (5.60 mmol) of tri-tertiary-butylphosphine were sequentially added and then refluxed and agitated under a nitrogen atmosphere for 24 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 22 g (a yield of 70 %) of a target compound, an intermediateM-48.

LC-Mass (theoretical value: 503.03 g/mol, measurement value: M+ = 503.33 g/mol)

### Example 1 : Preparation of Compound F-94 (not forming part of the present invention)

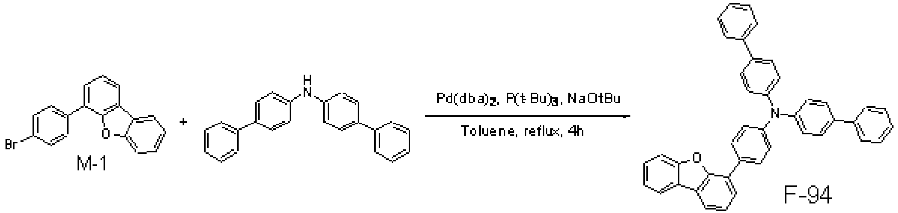

10 g (30.9 mmol) of the intermediate M-1, 9.9 g (30.9 mmol) of bis (4-biphenyl)amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 16 g (a yield of 92 %) of a target compound F-94.

LC-Mass (theoretical value: 563.22 g/mol, measurement value: M+ = 563.28 g/mol)

### Example 2 : Preparation of Compound G-94 (not forming part of the present invention)

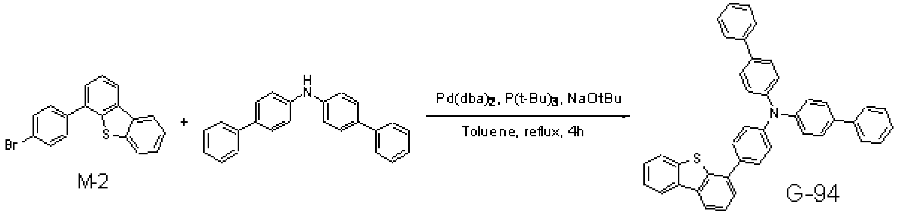

10.5 g (30.9 mmol) of the intermediate M-2, 9.9 g (30.9 mmol) of bis (4-biphenyl)amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 16.8 g (a yield of 94 %) of a target compound G-94.

LC-Mass (theoretical value: 579.20 g/mol, measurement value: M+ = 579.32 g/mol)

### Example 3 : Preparation of Compound F-99 (not forming part of the present invention)

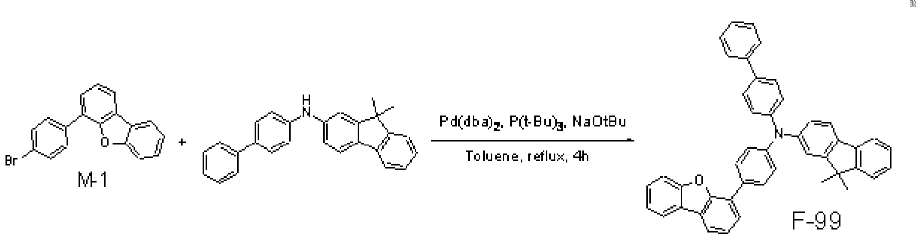

10 g (30.9 mmol) of the intermediate M-1, 11.2 g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 17.2 g (a yield of 92 %) of a target compound F-99.

LC-Mass (theoretical value: 603.26 g/mol, measurement value: M+ = 603.31 g/mol)

### Example 4 : Preparation of Compound G-99 (not forming part of the present invention)

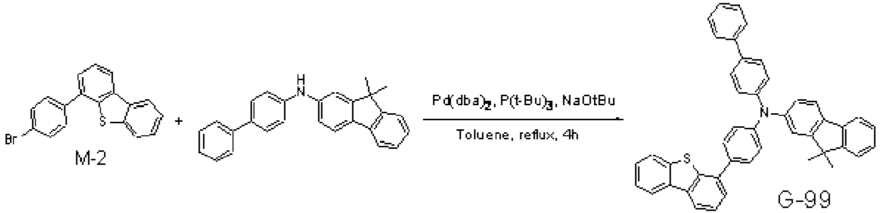

10.5 g (30.9 mmol) of the intermediate M-2, 11.2 g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 17.6 g (a yield of 92 %) of a target compound G-99.

LC-Mass (theoretical value: 619.23 g/mol, measurement value: M+ = 619.34 g/mol)

### Example 5 : Preparation of Compound I-1 (not forming part of the present invention)

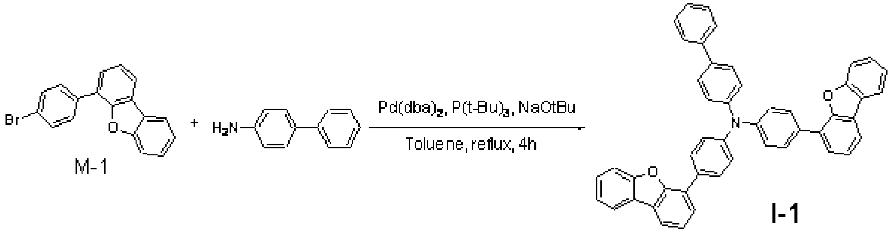

15 g (46.4 mmol) of the intermediate M-1, 3.9 g (23.2 mmol) of 4-aminobiphenyl, and 6.7 g (69.6 mmol) of sodium t-butoxide were added to 155 ml of toluene and dissolved therein, in a round-bottomed flask. Then, 0.53 g (0.928 mmol) of Pd(dba)2 and 0.38 g (1.86 mmol) of tri-tertiary-butylphosphine were sequentially added thereto and the mixture was refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 13.7 g (a yield of 90 %) of a target compound 1-1, a white solid.

LC-Mass (theoretical value: 653.24 g/mol, measurement value: M+ = 653.31 g/mol)

### Example 6 : Preparation of Compound I-3 (not forming part of the present invention)

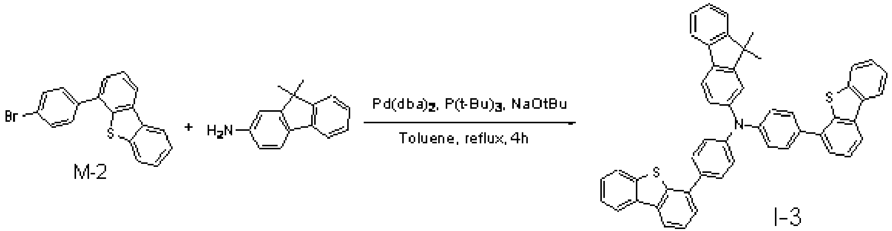

15.7 g (46.4 mmol) of the intermediate M-2, 4.86 g (23.2 mmol) of 2-amino-9,9-dimethyl-9H-fluorene, and 6.7 g (69.6 mmol) of sodium t-butoxide were added to 155 ml of toluene and dissolved therein, in a round-bottomed flask. Then, 0.53 g (0.928 mmol) of Pd(dba)2 and 0.38 g (1.86 mmol) of tri-tertiary-butylphosphine were sequentially added thereto and the mixture was refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 15.5 g (a yield of 92 %) of a target compound I-3, a white solid.

LC-Mass (theoretical value: 725.22 g/mol, measurement value: M+ = 725.36 g/mol)

### Example 7 : Preparation of Compound G-140 (not forming part of the present invention)

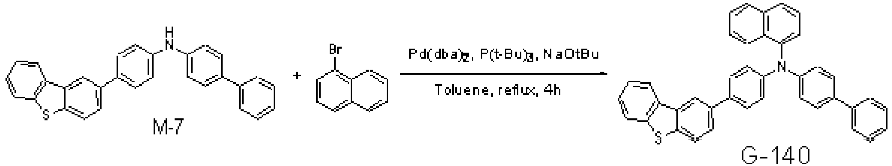

13.2 g (30.9 mmol) of the intermediate M-7, 6.4 g (30.9 mmol) of 1-bromonaphthalene, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain15.9 g (a yield of 93 %) of a target compound G-140.

LC-Mass (theoretical value: 553.19 g/mol, measurement value: M+ = 553.29 g/mol)

### Example 8 : Preparation of Compound I-13 (not forming part of the present invention)

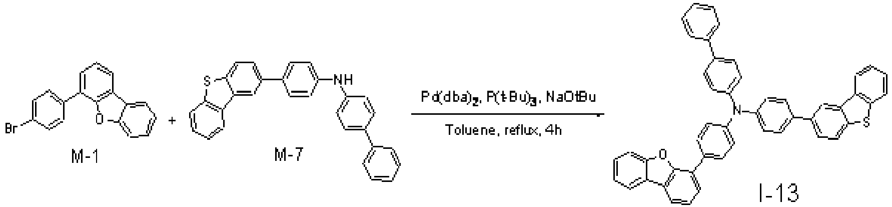

13.2 g (30.9 mmol) of the intermediate M-7, 10 g (30.9 mmol) of the intermediate M-1, and 4.5 g (46.35 mmol) of sodium t-butoxide were added to 155 ml of toluene and dissolved therein, in a round-bottomed flask. 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 18.6 g (a yield of 90 %) of a target compound 1-13.

LC-Mass (theoretical value: 669.21 g/mol, measurement value: M+ = 669.36 g/mol)

### Example 9 : Preparation of Compound I-29 (not forming part of the present invention)

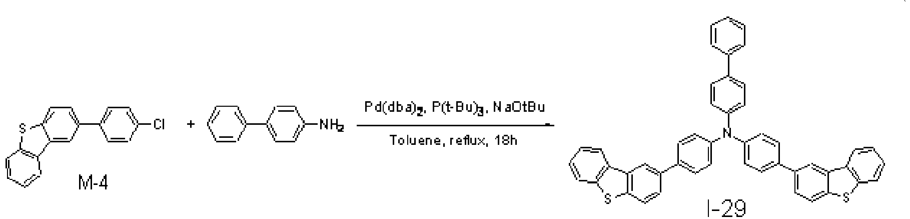

13.7 g (46.4 mmol) of the intermediate M-4, 3.9 g (23.2 mmol) of 4-aminobiphenyl, and 6.7 g (69.6 mmol) of sodium t-butoxide were added to 155 ml of toluene and dissolved therein, in a round-bottomed flask. Then, 0.53 g (0.928 mmol) of Pd(dba)2 and 0.38 g (1.86 mmol) of tri-tertiary-butylphosphine were sequentially added thereto and refluxed and agitated under a nitrogen atmosphere for 18 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 14 g (a yield of 88 %) of a target compound I-29, a white solid.

LC-Mass (theoretical value: 685.19 g/mol, measurement value: M+ = 685.26 g/mol)

### Example 10 : Preparation of Compound I-30 (not forming part of the present invention)

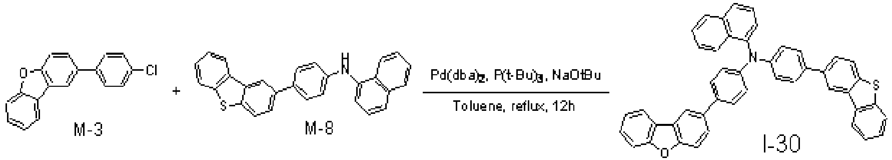

8.6 g (30.9 mmol) of the intermediate M-3, 12.4 g (30.9 mmol) of the intermediate M-8, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 17.9 g (a yield of 90 %) of a target compound I-30.

LC-Mass (theoretical value: 643.20 g/mol, measurement value: M+ = 643.29 g/mol)

### Example 11 : Preparation of Compound I-43 (not forming part of the present invention)

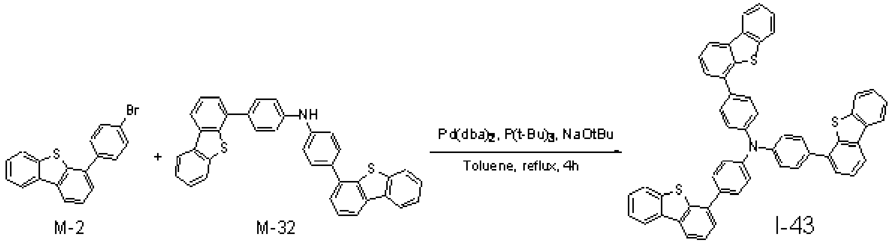

10.5 g (30.9 mmol) of the intermediate M-2, 16.5 g (30.9 mmol) of the intermediate M-32, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 22.5 g (a yield of 92 %) of a target compound I-43.

LC-Mass (theoretical value: 791.18 g/mol, measurement value: M+ = 791.23 g/mol)

### Example 12 : Preparation of Compound C-1

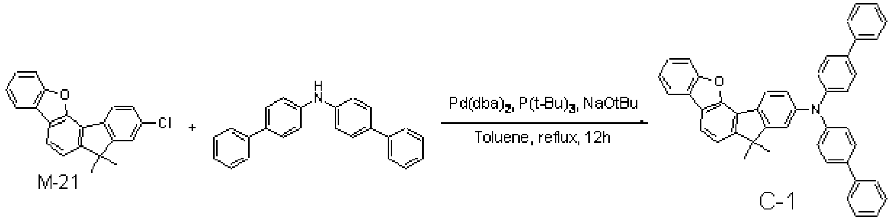

9.9 g (30.9 mmol) of the intermediate M-21, 9.9 g (30.9 mmol) of bis(4-biphenyl)amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 17.0 g (a yield of 91 %) of a target compound C-1.

LC-Mass (theoretical value: 603.26 g/mol, measurement value: M+ = 603.30 g/mol)

### Example 13 : Preparation of Compound C-2

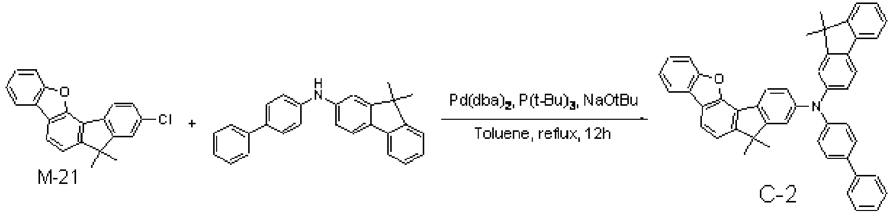

9.9 g (30.9 mmol) of the intermediate M-21, 11.2g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 18.1 g (a yield of 91 %) of a target compound C-2.

LC-Mass (theoretical value: 643.29 g/mol, measurement value: M+ = 643.38 g/mol)

### Example 14 : Preparation of Compound C-34

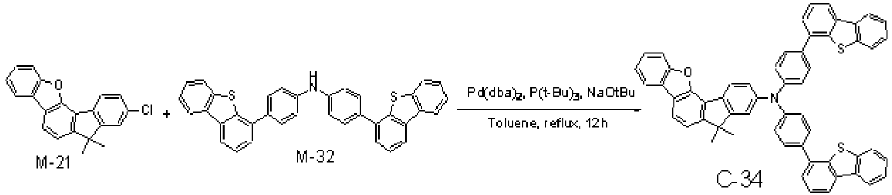

9.9 g (30.9 mmol) of the intermediate M-21, 16.5 g (30.9 mmol) of the intermediate M-32, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 22.7 g (a yield of 90 %) of a target compound C-34.

LC-Mass (theoretical value: 815.23 g/mol, measurement value: M+ = 815.41 g/mol)

### Example 15 : Preparation of Compound C-5

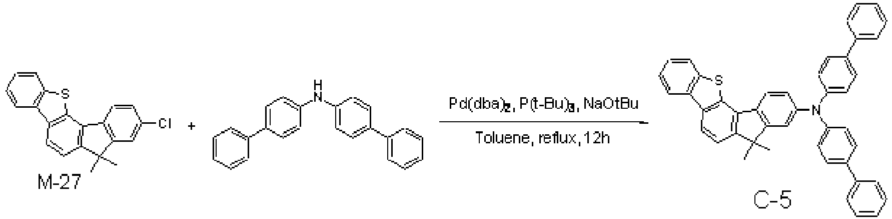

10.3g (30.9mmol) of the intermediate M-27, 9.9g (30.9mmol) of bis (4-biphenyl)amine, and 4.5g (46.35mmol) of sodium t-butoxide were added to 155 ml of toluene and dissolved therein, in a round-bottomed flask. Then, 0.178 g (0.31mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 17.2 g (a yield of 90 %) of a target compound C-5.

LC-Mass (theoretical value: 619.23 g/mol, measurement value: M+ = 619.33 g/mol)

### Example 16 : Preparation of Compound C-6

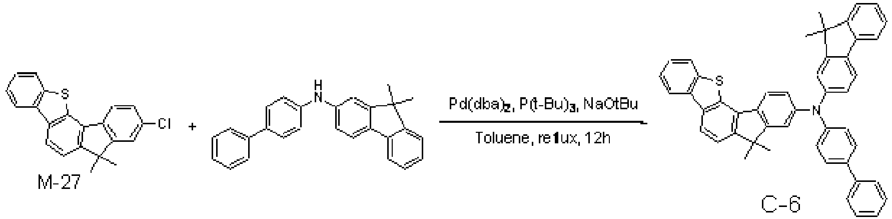

10.3 g (30.9 mmol) of the intermediate M-27, 11.2 g (30.9 mmol) of biphenyl-4-yl-(9,9-dimethyl-9H-fluoren-2-yl)-amine, 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 18.1 g (a yield of 89 %) of a target compound C-6.

LC-Mass (theoretical value: 659.26 g/mol, measurement value: M+ = 659.31 g/mol)

### Example 17 : Preparation of Compound C-3

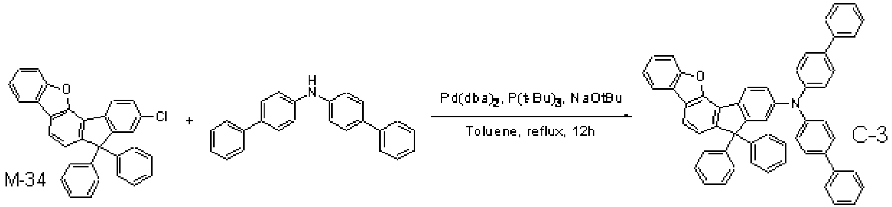

13.7 g (30.9 mmol) of the intermediate M-34, 9.9 g (30.9 mmol) of bis(4-biphenyl)amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 19.8 g (a yield of 88 %) of a target compound C-3.

LC-Mass (theoretical value: 727.29 g/mol, measurement value: M+ = 727.41 g/mol)

### Example 18 : Preparation of Compound C-77

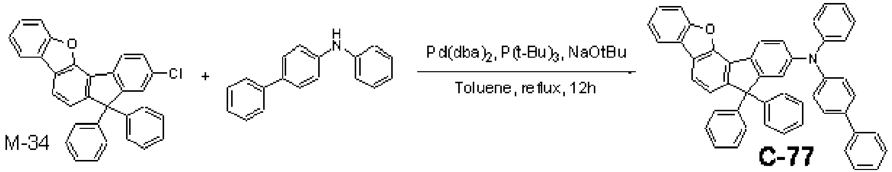

13.7 g (30.9 mmol) of the intermediate M-34, 7.6 g (30.9 mmol) of biphenyl-4-yl-phenyl amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 18.3 g (a yield of 91 %) of a target compound C-77.

LC-Mass (theoretical value: 651.26 g/mol, measurement value: M+ = 651.44 g/mol)

### Example 19 : Preparation of Compound C-20

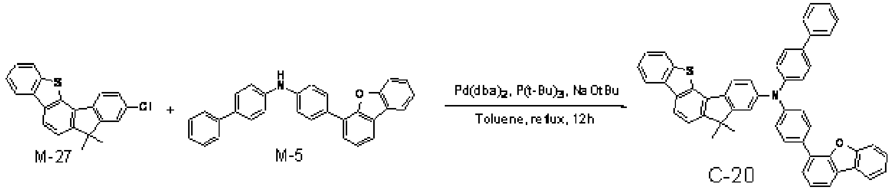

10.3 g (30.9 mmol) of the intermediate M-27, 12.7 g (30.9 mmol) of the intermediate M-5, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 19.3 g (a yield of 88 %) of a target compound C-20.

LC-Mass (theoretical value: 709.24 g/mol, measurement value: M+ = 709.31 g/mol)

### Example 20 : Preparation of Compound E-4

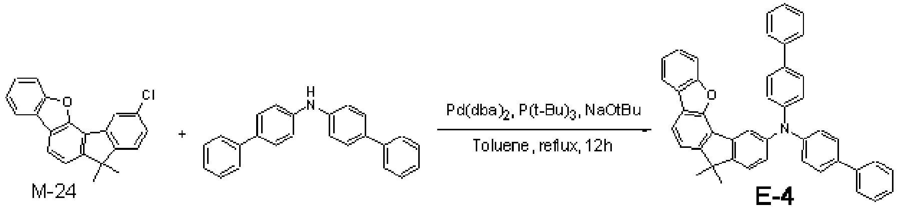

9.9 g (30.9 mmol) of the intermediate M-24, 9.9 g (30.9 mmol) of bis (4-biphenyl)amine, 4.5 g (46.35 mmol) of sodium t-butoxide were added to 155 ml of toluene and dissolved therein, in a round-bottomed flask. Then, 0.178 g (0.31mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 16.6 g (a yield of 89 %) of a target compound E-4.

LC-Mass (theoretical value: 603.26 g/mol, measurement value: M+ = 603.29 g/mol)

### Example 21 : Preparation of Compound E-3

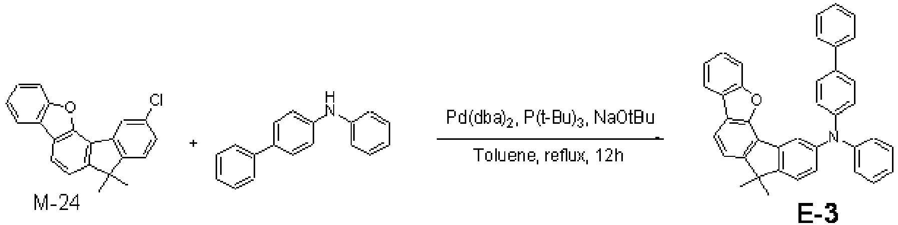

9.9 g (30.9 mmol) of the intermediate M-24, 7.6 g (30.9 mmol) of biphenyl-4-yl-phenyl amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 14.7 g (a yield of 90 %) of a target compound E-3.

LC-Mass (theoretical value: 527.22 g/mol, measurement value: M+ = 527.32 g/mol)

### Example 22 : Preparation of Compound E-9

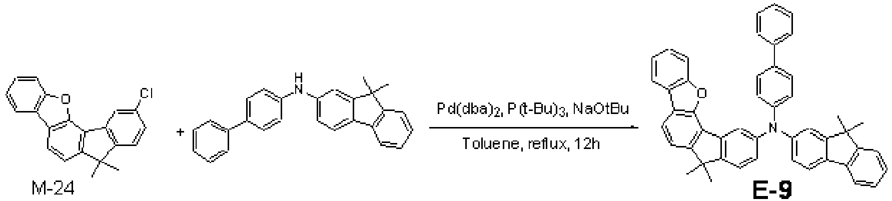

9.9 g (30.9 mmol) of the intermediate M-24, 11.2 g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein in a round-bottomed flask, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 17.7 g (a yield of 89 %) of a target compound E-9.

LC-Mass (theoretical value: 643.29 g/mol, measurement value: M+ = 643.34 g/mol)

### Example 23 : Preparation of Compound E-97

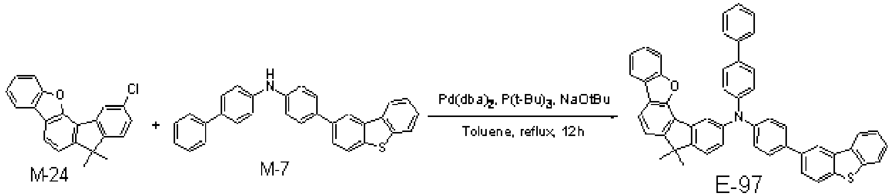

9.9 g (30.9 mmol) of the intermediate M-24, 13.2 g (30.9 mmol) of intermediate M-7, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 19.7 g (a yield of 90 %) of a target compound E-97.

LC-Mass (theoretical value: 709.24 g/mol, measurement value: M+ = 709.33 g/mol)

### Example 24 : Preparation of Compound E-20

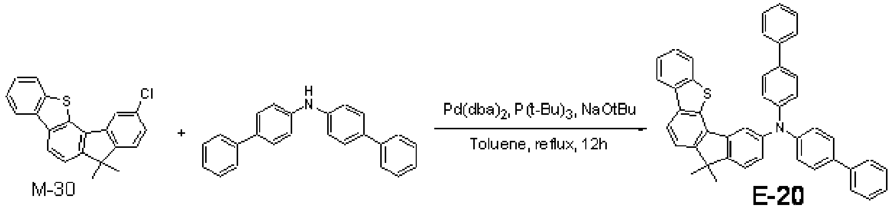

10.4 g (30.9 mmol) of the intermediate M-30, 9.9 g (30.9 mmol) of bis (4-biphenyl)amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 16.7 g (a yield of 87 %) of a target compound E-20.

LC-Mass (theoretical value: 619.23 g/mol, measurement value: M+ = 619.29 g/mol)

### Example 25 : Preparation of Compound E-19

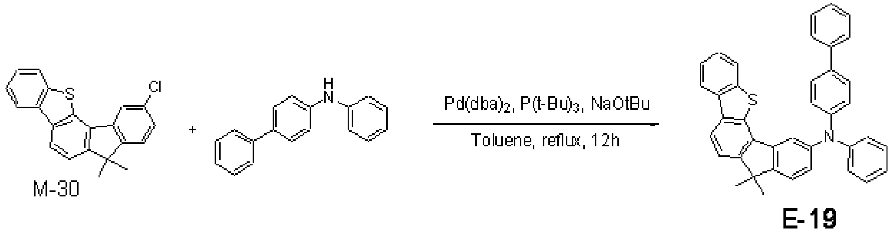

10.4 g (30.9 mmol) of the intermediate M-30, 7.6 g (30.9 mmol) of biphenyl-4-yl-phenyl amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 15.3 g (a yield of 91 %) of a target compound E-19.

LC-Mass (theoretical value: 543.20 g/mol, measurement value: M+ = 543.36 g/mol)

### Example 26 : Preparation of Compound E-25

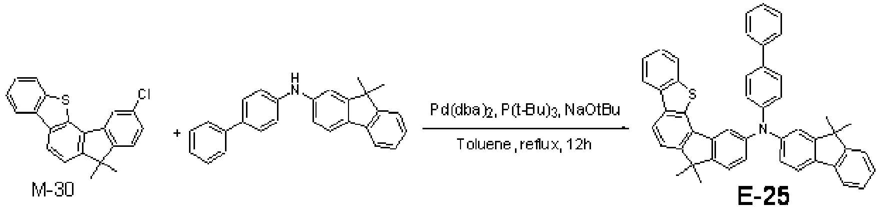

10.4 g (30.9 mmol) of the intermediate M-30, 11.2 g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 17.7 g (a yield of 87 %) of a target compound E-25.

LC-Mass (theoretical value: 659.26 g/mol, measurement value: M+ = 659.31 g/mol)

### Example 27 : Preparation of Compound E-23

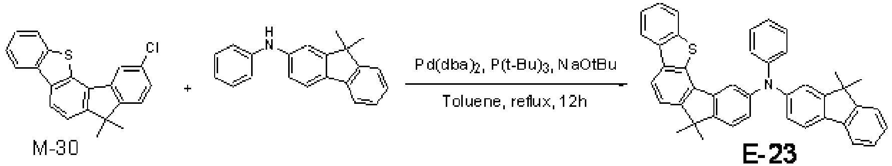

10.4 g (30.9 mmol) of the intermediate M-30, 8.8 g (30.9 mmol) of (9,9-dimethyl-9H-fluoren-2-yl)-phenyl-amine, and 4.5 g (46.35 mmol) of sodium t-butoxide were added to 155 ml of toluene and dissolved therein, in a round-bottomed flask. 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 16.2 g (a yield of 90 %) of a target compound E-23.

LC-Mass (theoretical value: 598.23 g/mol, measurement value: M+ = 598.33 g/mol)

### Example 28 : Preparation of Compound A-97

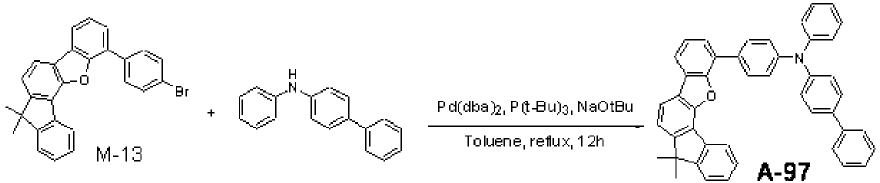

13.6 g (30.9 mmol) of the intermediate M-13, 7.6 g (30.9 mmol) of biphenyl-4-yl-phenyl amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 17.3 g (a yield of 93 %) of a target compound A-97.

LC-Mass (theoretical value: 603.26 g/mol, measurement value: M+ = 603.29 g/mol)

### Example 29 : Preparation of Compound A-21

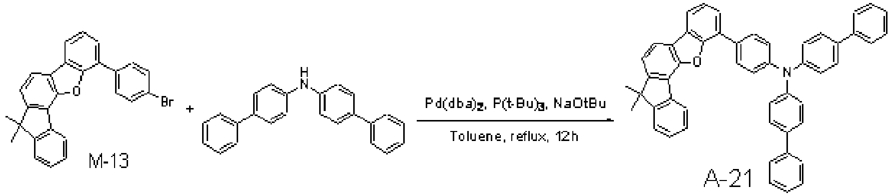

13.6 g (30.9 mmol) of the intermediate M-13, 9.9 g (30.9 mmol) of bis (4-biphenyl)amine, and 4.5 g (46.35 mmol) of sodium t-butoxide were added to 155 ml of toluene and dissolved therein, in a round-bottomed flask. 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 19.1 g (a yield of 91 %) of a target compound A-21.

LC-Mass (theoretical value: 679.29 g/mol, measurement value: M+ = 679.32 g/mol)

### Example 30 : Preparation of Compound A-25

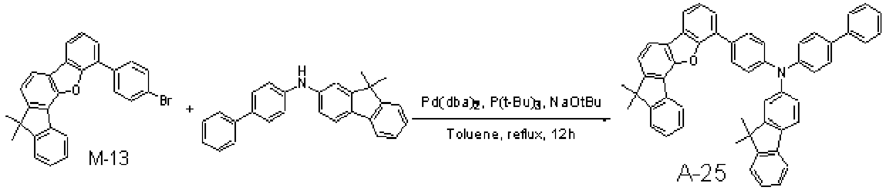

13.6 g (30.9 mmol) of the intermediate M-13, 11.2 g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein, in a round-bottomed flask. 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 20.2 g (a yield of 91 %) of a target compound A-25.

LC-Mass (theoretical value: 719.32 g/mol, measurement value: M+ = 719.42 g/mol)

### Example 31 : Preparation of Compound A-23

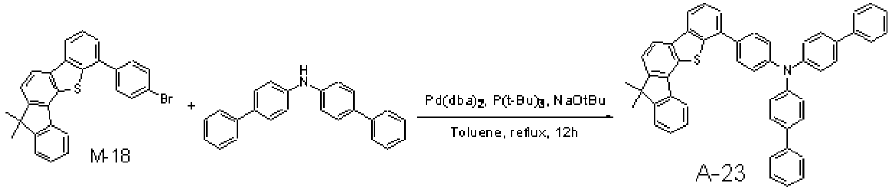

14.1 g (30.9 mmol) of the intermediate M-18, 9.9 g (30.9 mmol) of bis(4-biphenyl)amine, and 4.5 g (46.35 mmol) of sodium t-butoxide were added to 155 ml of toluene and dissolved therein, in a round-bottomed flask. 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/dichloromethane (8:2 of a volume ratio) to obtain 19.8 g (a yield of 92 %) of a target compound A-23.

LC-Mass (theoretical value: 695.26 g/mol, measurement value: M+ = 695.37 g/mol)

### Example 32 : Preparation of Compound A-27

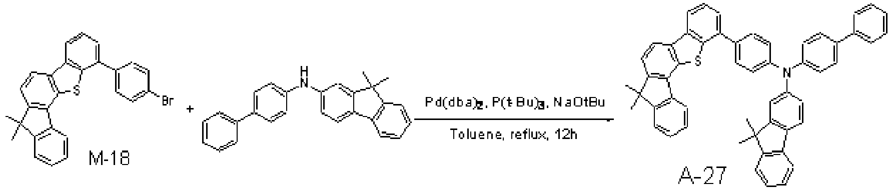

14.1 g (30.9 mmol) of the intermediate M-18, 11.2 g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 20.9 g (a yield of 92 %) of a target compound A-27.

LC-Mass (theoretical value: 735.30 g/mol, measurement value: M+ = 735.32 g/mol)

### Example 33 : Preparation of Compound A-117

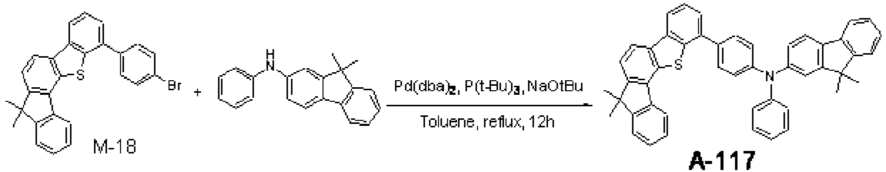

14.1 g (30.9 mmol) of the intermediate M-18, 8.8 g (30.9 mmol) of (9,9-dimethyl-9H-fluoren-2-yl)-phenyl-amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 18.6 g (a yield of 91 %) of a target compound A-117.

LC-Mass (theoretical value: 659.26 g/mol, measurement value: M+ = 659.36 g/mol)

### Example 34 : Preparation of Compound C-90

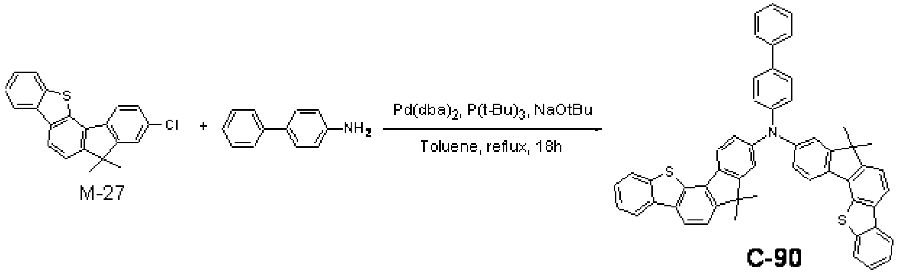

15.5 g (46.4 mmol) of the intermediate M-27, 3.9 g (23.2 mmol) of 4-aminobiphenyl, and 6.7 g (69.6 mmol) of sodium t-butoxide were added to 155 ml of toluene and dissolved therein, in a round-bottomed flask. 0.53 g (0.928 mmol) of Pd(dba)2 and 0.38 g (1.86 mmol) of tri-tertiary-butylphosphine were sequentially added thereto and refluxed and agitated under a nitrogen atmosphere for 18 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 15.3 g (a yield of 86 %) of a target compound C-90, a white solid.

LC-Mass (theoretical value: 765.25 g/mol, measurement value: M+ = 765.39 g/mol)

### Example 35 : Preparation of Compound C-92

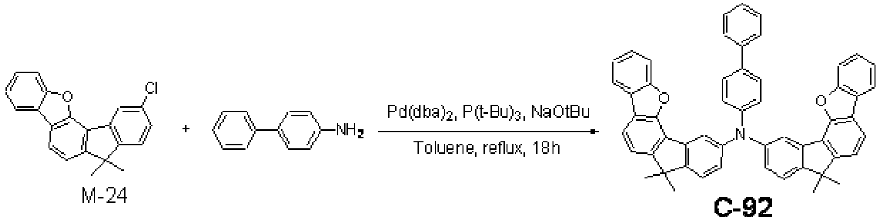

14.8 g (46.4 mmol) of the intermediate M-24, 3.9 g (23.2 mmol) of 4-aminobiphenyl, and 6.7 g (69.6 mmol) of sodium t-butoxide were added to 155 ml of toluene and dissolved therein, in a round-bottomed flask. 0.53 g (0.928 mmol) of Pd(dba)2 and 0.38 g (1.86 mmol) of tri-tertiary-butylphosphine were sequentially added thereto and refluxed and agitated under a nitrogen atmosphere for 18 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 15.2 g (a yield of 89 %) of a target compound C-92, a white solid.

LC-Mass (theoretical value: 733.30 g/mol, measurement value: M+ = 733.42 g/mol)

### Example 36-1 : Preparation of Compound B-13

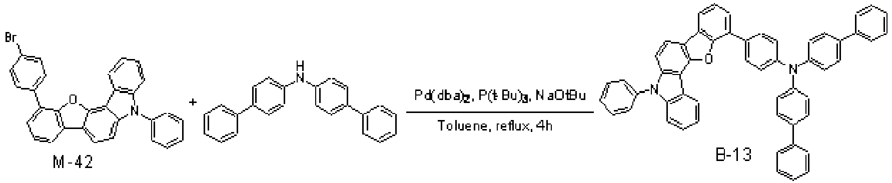

15.1 g (30.9 mmol) of the intermediate M-42, 9.9 g (30.9 mmol) of bis (4-biphenyl)amine, and 4.5 g (46.35 mmol) of sodium t-butoxide were added to 155 ml of toluene and dissolved therein, in a round-bottomed flask. Then, 0.178 g (0.31mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 20.7 g (a yield of 92 %) of a target compound B-13.

LC-Mass (theoretical value: 728.28 g/mol, measurement value: M+ = 728.21 g/mol)

### Example 36-2 : Preparation of Compound D-1

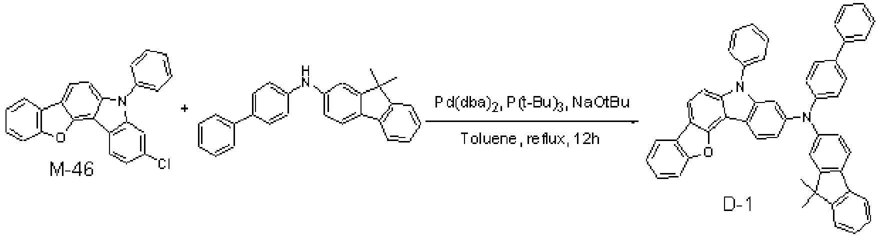

11.4 g (30.9 mmol) of the intermediate M-46, 11.2 g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 18.8 g (a yield of 88 %) of a target compound D-1.

LC-Mass (theoretical value: 692.28 g/mol, measurement value: M+ = 692.16 g/mol)

### Example 37 : Preparation of Compound D-13

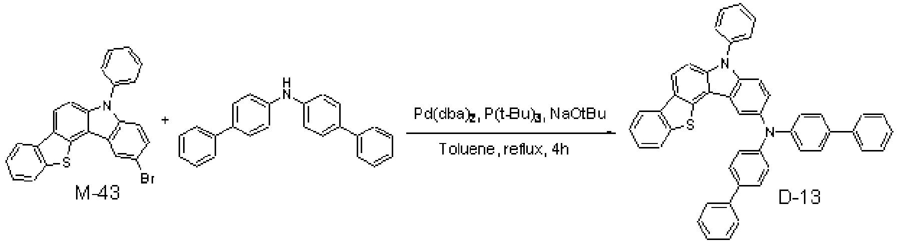

13.2 g (30.9 mmol) of the intermediate M-43, 9.9 g (30.9 mmol) of bis(4-biphenyl)amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 19.2 g (a yield of 93 %) of a target compound D-13.

LC-Mass (theoretical value: 668.23 g/mol, measurement value: M+ = 668.26 g/mol)

### Example 38 : Preparation of Compound K-79

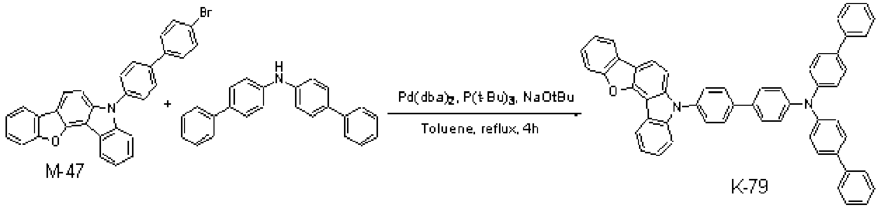

15.1 g (30.9 mmol) of the intermediate M-47, 9.9 g (30.9 mmol) of bis(4-biphenyl)amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 4 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 19.2 g (a yield of 91 %) of a target compound K-79.

LC-Mass (theoretical value: 728.28 g/mol, measurement value: M+ = 728.32 g/mol)

**Example 39 : Preparation of Compound K-283**

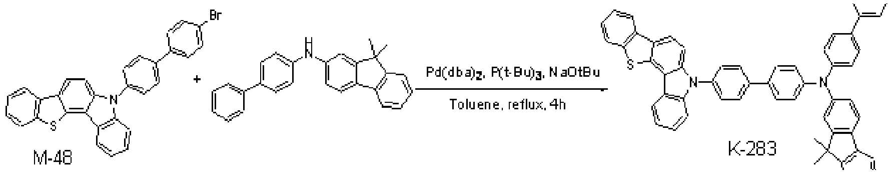

15.6 g (30.9 mmol) of the intermediate M-48, 11.2 g (30.9 mmol) of biphenyl-4-yl-(9,9-dimethyl-9H-fluoren-2-yl)-amine, and 4.5 g (46.35 mmol) of sodium t-butoxide were added to 155 ml of toluene and dissolved therein, in a round-bottomed flask. Then, 0.178 g (0.31 mmol) of Pd(dba)2 and 0.125 g (0.62 mmol) of tri-tertiary-butylphosphine were sequentially added and then refluxed and agitated under a nitrogen atmosphere for 12 hours. When the reaction was terminated, the resultant was extracted with toluene and distilled water, an organic layer was dried and filtered with magnesium sulfate and concentrated under a reduced pressure. The product was purified through silica gel column chromatography with n-hexane/ dichloromethane (8:2 of a volume ratio) to obtain 21.8 g (a yield of 90 %) of a target compound K-283.

LC-Mass (theoretical value: 784.29 g/mol, measurement value: M+ = 734.36 g/mol)

### (Manufacture of Organic Light Emitting Diode)

### Manufacture of Green Organic Light Emitting Diode

### Example 40 (not forming part of the present invention)

A glass substrate was coated with ITO (indium tin oxide) to be 1500Å thick and then, ultrasonic wave-washed with a distilled water. After washing with distilled water, the glass substrate was ultrasonic wave-washed with a solvent such as isopropylalcohol, acetone, methanol and the like, dried, moved to a plasma-cleaner, and then, cleaned with oxygen plasma for 5 minutes and moved to a vacuum depositor. The obtained ITO transparent electrode was used as an anode, and a 700Å-thick hole injection and transport layer was formed on the ITO substrate by vacuum-depositing HT-1. Subsequently, a 100 Å-thick auxiliary hole transport layer was formed thereon by vacuum-depositing the compound of Example 4. (4,4'-N,N'-dicarbazole)biphenyl [CBP] as a host and 5wt% of tris (2-phenylpyridine)iridium(III) [lr(ppy)3] as a dopant were vacuum-deposited to form a 300Å-thick emission layer.

Subsequently, biphenoxy-bis(8-hydroxyquinoline)aluminum [Balq] was vacuum-deposited on the emission layer to form a 50 Å-thick hole blocking layer. Tris (8-hydroxyquinoline)aluminum [Alq3] was vacuum-deposited on the hole blocking layer upper to form a 250Å-thick electron transport layer, and 10 Å-thick LiF and 1000 Å-thick Al were sequentially vacuum-deposited on the electron transport layer to form a cathode, manufacturing an organic light emitting diode.

The organic light emitting diode had a structure of having five organic thin layers, specifically

Al 1000Å/LiF 10Å/Alq3 250Å/Balq 50Å/EML[CBP:Ir(ppy)3=95:5] 300Å/auxiliary HTL 100Å/HT-1 700Å/ITO 1500Å.

### Example 41 (not forming part of the present invention)

An organic light emitting diode was manufactured according to the same method as Example 40 except for using the compound of Example 11 instead of the compound of Example 4.

### Example 42 (not forming part of the present invention)

An organic light emitting diode was manufactured according to the same method as Example 40 except for using the compound of Example 5 instead of the compound of Example 4.

### Example ₄₃ (not forming part of the present invention)

An organic light emitting diode was manufactured according to the same method as Example 40 except for using the compound of Example 3 instead of the compound of Example 4.

### Example 44

An organic light emitting diode was manufactured according to the same method as Example 40 except for using the compound of Example 29 instead of the compound of Example 4.

### Example 45

An organic light emitting diode was manufactured according to the same method as Example 40 except for using the compound of Example 32 instead of the compound of Example 4.

### Example 46

An organic light emitting diode was manufactured according to the same method as Example 40 except for using the compound of Example 20 instead of the compound of Example 4.

### Example 47

An organic light emitting diode was manufactured according to the same method as Example 40 except for using the compound of Example 12 instead of the compound of Example 4.

### Comparative Example 1

An organic light emitting diode was manufactured according to the same method as Example 40 except for using N,N'-di(1-naphthyl)-N,N'-diphenylbenzidine [NPB] instead of HT-1 and for using N,N'-di(1-naphthyl)-N,N'-diphenylbenzidine [NPB] instead of the compound of Example 4.

### Comparative Example 2

An organic light emitting diode was manufactured according to the same method as Example 40 except for using N,N'-di(1-naphthyl)-N,N'-diphenylbenzidine [NPB] instead of HT-1 and for using tris (4,4',4"- (9-carbazolyl))-triphenylamine [TCTA] instead of the compound of Example 4.

### Comparative Example 3

An organic light emitting diode was manufactured according to the same method as Example 40 except for using HT-1 instead of the compound of Example 4.

### Manufacture of Red Organic Light Emitting Diode

### Example 48

A glass substrate was coated with ITO (indium tin oxide) to be 1500 Å thick and then, ultrasonic wave-washed with a distilled water. After washing with distilled water, the glass substrate was ultrasonic wave-washed with a solvent such as isopropylalcohol, acetone, methanol and the like, dried, moved to a plasma-cleaner, and then, cleaned with oxygen plasma for 5 minutes and moved to a vacuum depositor. The obtained ITO transparent electrode was used as an anode, and a 600Å-thick hole injection layer was formed on the ITO substrate by vacuum-depositing 4,4'-bis[N-[4-{N,N-bis(3-methylphenyl)amino}-phenyl]-N-phenylamino]biphenyl (DNTPD). Subsequently, a 200 Å-thick hole transport layer was formed thereon by vacuum-depositing HT-1. On the hole transport layer, a 100 Å-thick auxiliary hole transport layer was formed by vacuum-depositing the compound of Example 32. On the auxiliary hole transport layer, (4,4'-N,N'-dicarbazole)biphenyl [CBP] as a host and 7 wt% of bis (2-phenylquinoline) (acetylacetonate)iridium (III) [lr(pq)2acac] as a dopant were vacuum-deposited to form a 300 Å-thick emission layer.

Subsequently, biphenoxy-bis(8-hydroxyquinoline)aluminum [Balq] was vacuum-deposited on the emission layer to form a 50 Å-thick hole blocking layer. Tris (8-hydroxyquinoline)aluminum [Alq3] was vacuum-deposited on the hole blocking layer upper to form a 250Å-thick electron transport layer, and 10 Å-thick LiF and 1000 Å-thick Al were sequentially vacuum-deposited on the electron transport layer to form a cathode, manufacturing an organic light emitting diode.

The organic light emitting diode had a structure of having six organic thin layers, specifically

Al 1000Å/LiF 10Å/Alq3 250Å/Balq 50Å/EML[CBP: Ir (pq)2acac =93:7] 300Å/ auxiliary HTL 100Å/HT-1 700Å/ DNTPD 600Å/ITO 1500Å.

### Example 49

An organic light emitting diode was manufactured according to the same method as Example 48 except for using the compound of Example 28 instead of the compound of Example 32.

### Example 50

An organic light emitting diode was manufactured according to the same method as Example 48 except for using the compound of Example 20 instead of the compound of Example 32.

### Example 51

An organic light emitting diode was manufactured according to the same method as Example 48 except for using the compound of Example 15 instead of the compound of Example 32.

### Example 52

An organic light emitting diode was manufactured according to the same method as Example 48 except for using the compound of Example 13 instead of the compound of Example 32.

### Example 53 (not forming part of the present invention)

An organic light emitting diode was manufactured according to the same method as Example 48 except for using the compound of Example 3 instead of the compound of Example 32.

### Example 54 (not forming part of the present invention)

An organic light emitting diode was manufactured according to the same method as Example 48 except for using the compound of Example 6 instead of the compound of Example 32.

### Example 55

An organic light emitting diode was manufactured according to the same method as Example 48 except for using the compound of Example 38 instead of the compound of Example 32.

### Example 56

An organic light emitting diode was manufactured according to the same method as Example 48 except for using the compound of Example 39 instead of the compound of Example 32.

### Comparative Example 4

An organic light emitting diode was manufactured according to the same method as Example 48 except for using N,N'-di(1-naphthyl)-N,N'-diphenylbenzidine [NPB] instead of HT-1 and for using N,N'-di(1-naphthyl)-N,N'-diphenylbenzidine [NPB] instead of the compound of Example 32.

### Comparative Example 5

An organic light emitting diode was manufactured according to the same method as Example 48 except for using N,N'-di(1-naphthyl)-N,N'-diphenylbenzidine [NPB] instead of HT-1 and for using tris (4,4',4"-(9-carbazolyl))-triphenylamine [TCTA] instead of the compound of Example 32.

### Comparative Example 6

An organic light emitting diode was manufactured according to the same method as Example 48 except for using HT-1 instead of the compound of Example 32.

The DNTPD, NPB, HT-1, TCTA, CBP, Balq, Alq3, Ir(ppy)3, and Ir(pq)2acac used to manufacture the organic light emitting diode have the following structures.

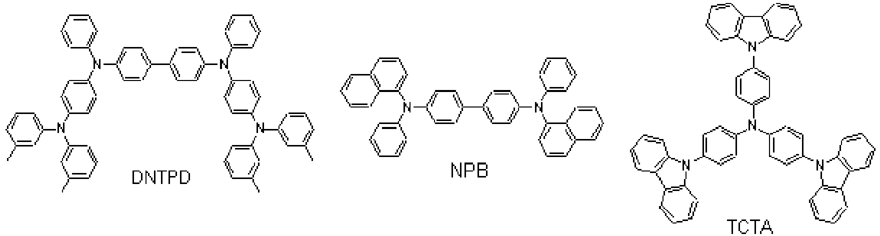

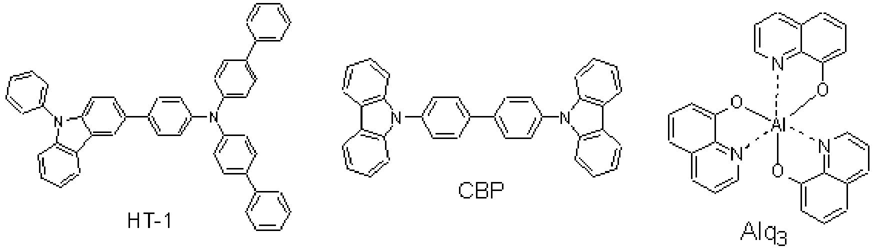

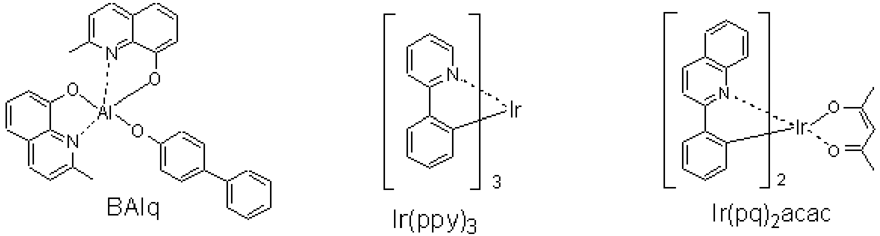

### (Analysis and Characteristics of the Prepared Compounds)

### ¹H-NMR Analysis Results

The molecular weights of the intermediate compounds M-1 to M-46 and the compounds of Examples 1 to 37 were measured by using LC-MS for their structural analyses, and in addition, their 1H-NMR's were measured by respectively dissolving the compounds in a CD2CI2 solvent and using a 300MHz NMR equipment.

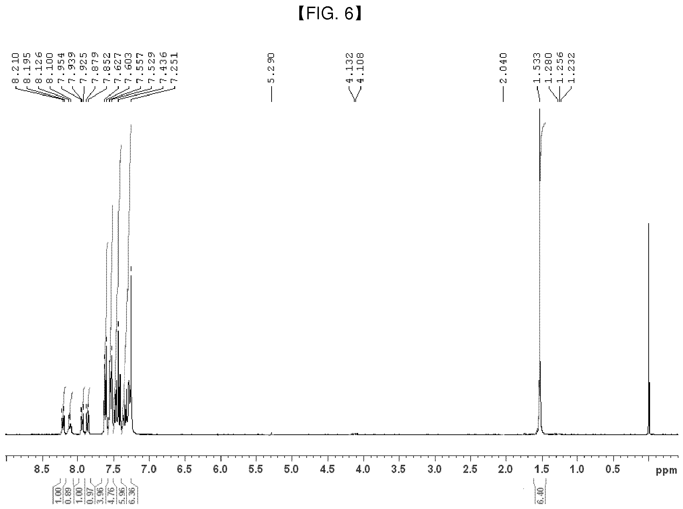

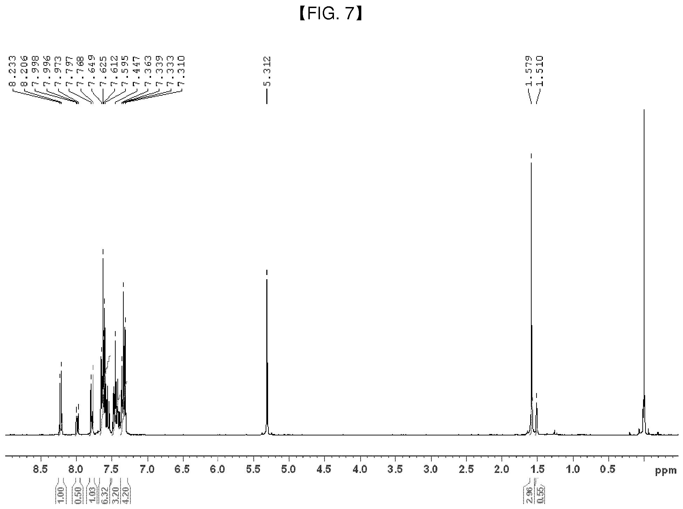

For example, the 1H-NMR result of the compound C-5 of Example 15 was provided in FIG. 6, and the 1H-NMR result of the compound A-23 of Example 31 was provided in FIG. 7.

### Analysis of Fluorescence Characteristics

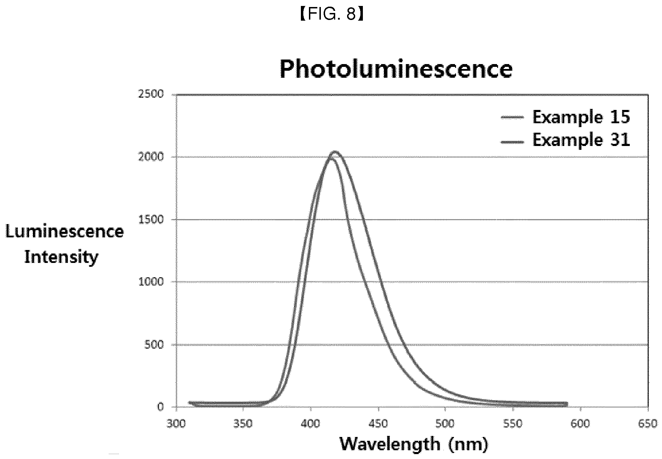

Fluorescence characteristics of the Examples were measured by respectively dissolving the compounds of the Examples in THF and then, measuring their PL (photoluminescence) wavelengths with HITACHI F-4500. The PL wavelength results of Examples 15 and 31 were provided in FIG. 8.

### Electrochemical Characteristics

The electrochemical characteristics of the compounds of Examples 4, 15, 17, 20 and 31 were measured by using cyclic-voltammetry equipment, and the results are provided in the following Table 1.

**[Table 1]**

| Synthesis Examples | Example 4 G-99 | Example 15 C-5 | Example 17 C-3 | Example 20 E-4 | Example 31 A-23 |
|---|---|---|---|---|---|
| HOMO (eV) | 5.56 | 5.51 | 5.51 | 5.49 | 5.60 |
| LUMO (eV) | 2.35 | 2.44 | 2.45 | 2.32 | 2.46 |
| Band gap(eV) | 3.21 | 3.07 | 3.06 | 3.17 | 3.14 |

Referring to Table 1, the compounds of Examples 4 (not forming part of the present invention), 15, 17, 20 and 31 turned out to be used to form a hole transport layer and an electron blocking layer.

### (Performance Measurement of Organic Light Emitting Diode)

Current density change, luminance change, and luminous efficiency of each organic light emitting diode according to Examples 40 to 56 (examples 40-43, 53 and 54 not forming part of the present invention) and Comparative Examples 1 to 6 were measured. Specific measurement methods are as follows, and the results are shown in the following Tables 2 and 3.
(1) Measurement of Current Density Change Depending on Voltage Change

The obtained organic light emitting diodes were measured for current value flowing in the unit device while increasing the voltage from 0 V to 10 V using a current-voltage meter (Keithley 2400), the measured current value was divided by area to provide the results.
(2) Measurement of Luminance Change Depending on Voltage Change

Luminance was measured by using a luminance meter (Minolta Cs-1000A), while the voltage of the organic light emitting diodes was increased from 0 V to 10 V.
(3) Measurement of Luminous Efficiency

The luminance, current density, and voltage obtained from the (1) and (2) were used to calculate current efficiency (cd/A) at the same luminance (cd/m²).
(4) Life-span

The life-span of the organic light emitting diodes were measured by using a Polanonix life-span-measuring system, and herein, the green organic light emitting diodes of Examples 40 to 47 and Comparative Examples 1 to 3 were respectively made to emit light with initial luminance of 3,000 nit, their half-life spans were obtained by measuring their luminance decrease as time went and finding out a point where the initial luminance decreased down to 1/2, while the red organic light emitting diodes of Examples 48 to 56 and Comparative Examples 4 to 6 were respectively made to emit light with initial luminance of 1,000 nit, and their T80 life-spans were obtained by measuring their luminance decrease as time went and then, finding out a point where the initial luminance decreased down to 80 %.

**[Table 2]**

| Devices | HTL | Auxiliary HTL | Driving voltage (V) | Luminous efficiency (cd/A) | EL peak (nm) | Half life-span (h) @3000 nit |
|---|---|---|---|---|---|---|
| Example 40 | HT-1 | G-99 | 7.4 | 45.5 | 516 | 272 |
| Example 41 | HT-1 | I-43 | 8.7 | 44.4 | 516 | 220 |
| Example 42 | HT-1 | I-1 | 7.9 | 44.8 | 516 | 231 |
| Example 43 | HT-1 | F-94 | 8.1 | 46.2 | 516 | 243 |
| Example 44 | HT-1 | A-21 | 7.3 | 48.5 | 516 | 221 |
| Example 45 | HT-1 | A-27 | 7.3 | 47.6 | 516 | 240 |
| Example 46 | HT-1 | E-4 | 7.0 | 49.4 | 516 | 235 |
| Example 47 | HT-1 | C-1 | 7.0 | 44.1 | 516 | 220 |
| Comparative Example 1 | NPB | NPB | 8.2 | 25.8 | 516 | 175 |
| Comparative Example 2 | NPB | TCTA | 7.1 | 45.0 | 516 | 181 |
| Comparative Example 3 | HT-1 | HT-1 | 7.4 | 37.2 | 516 | 220 |

(The driving voltage and luminous efficiency were measured at 1.000nit)

Referring to the result of Table 2, as for a green phosphorescence organic light emitting diode, Examples 44 to 47 using the compound of the present invention as an auxiliary hole transport layer improved luminous efficiency and life-span of an organic light emitting diode compared with Comparative Example 1 or 3 using no auxiliary hole transport layer. Note, that Examples 40-43 in Table 2 are using compounds not forming part of the present invention.

Particularly, an exemplary embodiment of the present invention showed at least 18 % to at most greater than or equal to 30 % increased luminous efficiency compared with Comparative Example 3, at least greater than or equal to 20 % to greater than or equal to 50 % increased life-span of a light emitting element compared with Comparative Example 2 using conventionally-known TCTA as an auxiliary hole transport layer, and this life-span is sufficient enough to be commercialized considering that the life-span of a conventional device has been the most serious problem in terms of commercialization.

**[Table 3]**

| Devices | HTL | Auxiliary HTL | Driving voltage (V) | Luminous efficiency (cd/A) | EL peak (nm) | T80 life-span(h) @1000nit |
|---|---|---|---|---|---|---|
| Example 48 | HT-1 | A-27 | 8.5 | 19.9 | 600 | 850 |
| Example 49 | HT-1 | A-97 | 8.4 | 20.8 | 600 | 805 |
| Example 50 | HT-1 | E-4 | 8.3 | 20.4 | 600 | 845 |
| Example 51 | HT-1 | C-5 | 8.2 | 19.2 | 600 | 824 |
| Example 52 | HT-1 | C-2 | 8.4 | 18.6 | 600 | 820 |
| Example 53 | HT-1 | F-99 | 8.8 | 19.5 | 600 | 900 |
| Example 54 | HT-1 | I-3 | 9.0 | 18.2 | 600 | 840 |
| Example 55 | HT-1 | K-79 | 9.1 | 18.8 | 600 | 880 |
| Example 56 | HT-1 | K-283 | 9.1 | 19.5 | 600 | 870 |
| Comparative Example 4 | NPB | NPB | 8.7 | 15.1 | 600 | 720 |
| Comparative Example 5 | NPB | TCTA | 9.1 | 17.3 | 600 | 650 |
| Comparative Example 6 | HT-1 | HT-1 | 8.5 | 16.5 | 600 | 800 |

(The driving voltage and luminous efficiency were measured at 800 nits)

Referring to the results of Table 3, as for a red phosphorescence organic light emitting diode, Examples 48 to 52, 55 and 56 using the compound of the present invention as an auxiliary hole transport layer improved luminous efficiency and life-span of an organic light emitting diode compared with Comparative Example 4 or 6 using no auxiliary hole transport layer. Note that Examples 53 and 54 in Table 3 are using a compound not forming part of the present invention. Particularly, an exemplary embodiment of the present invention improved at least greater than or equal to 5 % to at most greater than or equal to 20 % luminous efficiency compared with Comparative Example 4 and increased at least greater than or equal to 23 % to at most greater than or equal to 38 % life-span of a light emitting element, and largely improve overall main characteristics of the red phosphorescence device by lowering its driving voltage compared with Comparative Example 5 using conventionally-known TCTA as an auxiliary hole transport layer. Accordingly, the results of the exemplary embodiments were sufficient enough to be commercialized considering that the life span of a device is the most serious problem in terms of commercialization.

### <Description of Symbols>

| | |
|---|---|
| 100: organic light emitting diode | 110: cathode |
| 120: anode | 105: organic thin layer |
| 130: emission layer | 140: hole transport layer |
| 150: electron transport layer | 160: electron injection layer |
| 170: hole injection layer | |
| 230: emission layer + electron transport layer | |

## Claims

1. An organic optoelectronic device comprising
an anode, a cathode and at least one organic thin layer interposed between the anode and the cathode,
wherein the organic thin layer comprises an emission layer and a plurality of hole transport layers,
the hole transport layer contacting the emission layer of the plurality of hole transport layers comprises a compound represented by a combination of the following Chemical Formula 1; Chemical Formula 2 or 3; and Chemical Formula 4, and
one of the hole transport layers not contacting the emission layer comprises a compound represented by the following Chemical Formula B-1: 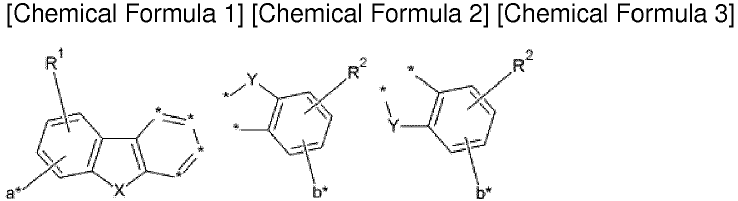 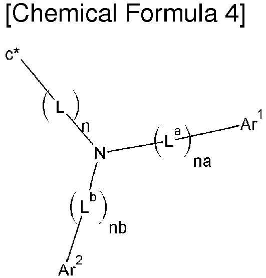 wherein, in Chemical Formulae 1 to 4,
X is O, S, N(-d*), SO₂(O=S=O), PO (P=O), or CO(C=O),
Y is O, S, SO₂(O=S=O), PO (P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L, L^{a} and L^{b} are independently, a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof,
n, na and nb are independently integers of 0 to 3,
the two adjacent two *'s of Chemical Formula 1 are bound to the two adjacent *'s of Chemical Formula 2 or 3 to provide a fused ring,
a* of Chemical Formula 1, d* of Chemical Formula 1 or b* of Chemical Formula 2 or 3 is linked to c* of Chemical Formula 4 by a sigma bond, and
the remaining a*; d* or b* that is not bound to c* is hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group or a combination thereof: 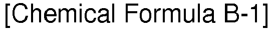 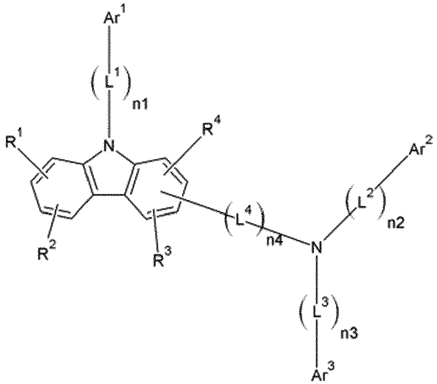
wherein, in Chemical Formula B-1,
R¹ to R⁴ are independently, hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof,
R¹ and R² are independently present or linked to each other to provide a fused ring,
R³ and R⁴ are independently present or linked to each other to provide a fused ring,
Ar¹ to Ar³ are independently a substituted or unsubstituted C6 to C30 aryl group or a substituted or unsubstituted C2 to C30 heteroaryl group,
L¹ to L⁴ are independently, a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, and
n1 to n4 are independently integers of 0 to 3,
except a combination, wherein one hole transport layer comprises a compound represented by the following Chemical Formula Z-1 and one hole transport layer comprises a compound represented by the following Chemical Formula Z-2:

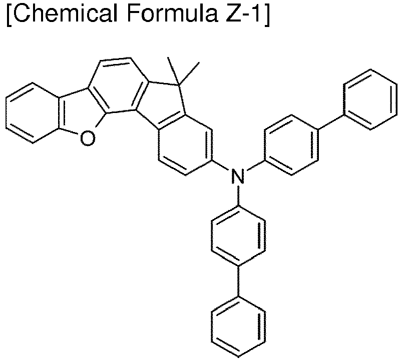

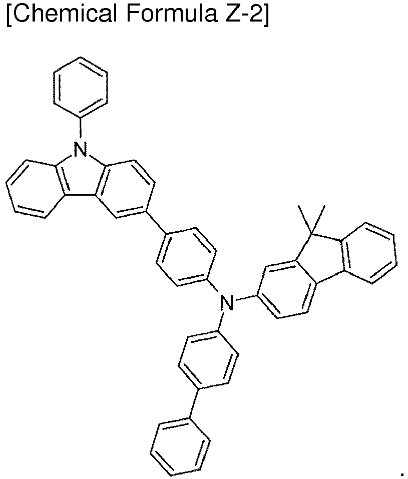

2. The organic optoelectronic device of claim 1, wherein the compound represented by a combination of the Chemical Formula 1; the Chemical Formula 2 or 3; and the Chemical Formula 4 is represented by a combination of the following Chemical Formula 5 and the Chemical Formula 4: 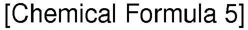 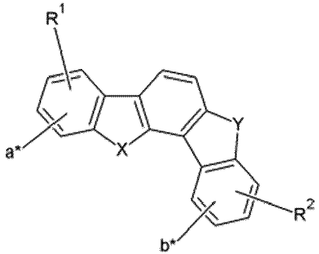 wherein, in Chemical Formula 5,
X is O, S, N(-d*), SO₂(O=S=O), PO(P=O), or CO(C=O),
Y is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
a* of Chemical Formula 5; d* of Chemical Formula 5; or b* of Chemical Formula 5 ; is linked to c* of Chemical Formula 4 by a sigma bond, and
the remaining a*; d* or b* that is not bound to c* is hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group or a combination thereof.

3. The organic optoelectronic device of claim 1 or 2, wherein the compound represented by a combination of the Chemical Formula 1; the Chemical Formula 2 or 3; and the Chemical Formula 4 is represented by any of the the following Chemical Formula 6 to 10: 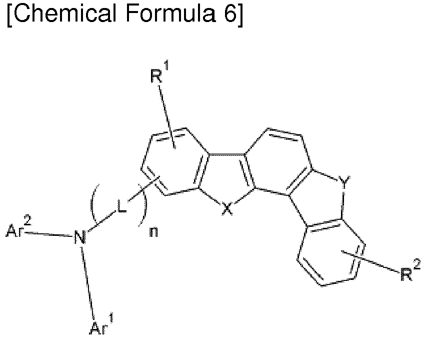 wherein, in Chemical Formula 6,
X is O, S, SO₂(O=S=O), PO(P=O), or CO(C=O),
Y is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n is an integer of 0 to 3. 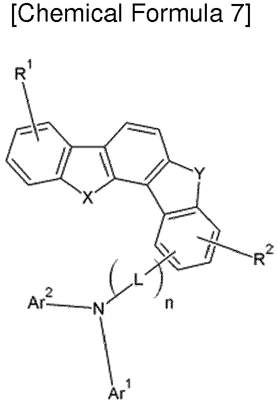
wherein, in Chemical Formula 7,
X is O, S, SO₂(O=S=O), PO(P=O), or CO(C=O),
Y is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n is an integer of 0 to 3. 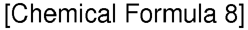 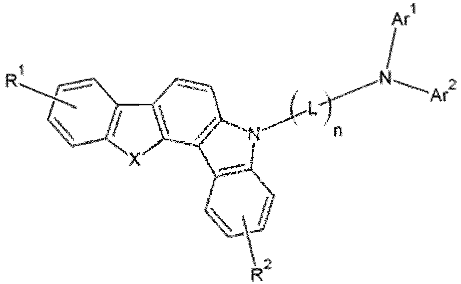
wherein, in Chemical Formula 8,
X is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n is an integer of 0 to 3. 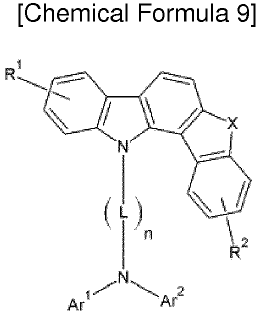
wherein, in Chemical Formula 9,
X is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n is an integer of 0 to 3. 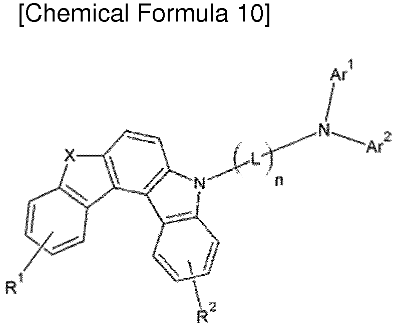
wherein, in Chemical Formula 10,
X is O, S, SO₂(O=S=O), PO(P=O), CR'R " or NR',
R', R " , R¹ and R² are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof,
Ar¹ and Ar² are independently a substituted or unsubstituted C6 to C30 aryl group or a substituted or unsubstituted C2 to C30 heteroaryl group,
L is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted heteroarylene group, or a combination thereof, and
n is an integer of 0 to 3.

4. The organic optoelectronic device of any of the claims 1 to 3 wherein the R', R " , R¹ and R² are independently hydrogen, deuterium, a substituted or unsubstituted methyl group, a substituted or unsubstituted ethyl group, a substituted or unsubstituted propyl group, a substituted or unsubstituted phenyl group, a substituted or unsubstituted biphenyl group, a substituted or unsubstituted naphthyl group, a substituted or unsubstituted anthracenyl group, a substituted or unsubstituted phenanthrenyl group, or a substituted or unsubstituted C3 to C40 silyl group.

5. The organic optoelectronic device of any of the claims 1 to 4, wherein the Ar¹ and Ar² of the Chemical Formula 4 are independently, a substituted or unsubstituted phenyl group, a substituted or unsubstituted biphenyl group, a substituted or unsubstituted fluorenyl group, a substituted or unsubstituted benzofuran, a substituted or unsubstituted benzothiophenyl group, a substituted or unsubstituted dibenzofuranyl group, or a substituted or unsubstituted dibenzothiophenyl group, and /or
wherein Ar¹ of the Chemical Formula B-1 is a substituted or unsubstituted phenyl group, substituted or unsubstituted biphenyl group, and Ar² and Ar³ are independently one of a substituted or unsubstituted phenyl group, a substituted or unsubstituted biphenyl group, a substituted or unsubstituted fluorene group, a substituted or unsubstituted bisfluorene group, a substituted or unsubstituted triphenylene group, a substituted or unsubstituted anthracene group, a substituted or unsubstituted terphenyl group, a substituted or unsubstituted dibenzofuran group, and a substituted or unsubstituted dibenzothiophenyl group.

6. The organic optoelectronic device of any of the claims 1 to 5, wherein the organic optoelectronic device is an organic photoelectric device, an organic light emitting diode, an organic solar cell, an organic transistor, an organic photo conductor, or an organic memory device.

7. A display device comprising the organic optoelectronic device of any of the claims 1 to 6.

## Patentansprüche

1. Organisches optoelektronisches Bauelement, mit
einer Anode, einer Kathode und mindestens einer zwischen der Anode und der Kathode angeordneten organischen Dünnschicht,
wobei die organische Dünnschicht eine Emissionsschicht und mehrere Lochtransportschichten aufweist,
die mit der Emissionsschicht in Kontakt stehende Lochtransportschicht der mehreren Lochtransportschichten eine Verbindung aufweist, die durch eine Kombination der chemischen Formel 1, der chemischen Formel 2 oder 3 und der chemischen Formel 4 dargestellt ist, und
eine der Lochtransportschichten, die nicht mit der Emissionsschicht in Kontakt steht, eine Verbindung aufweist, die durch die folgende chemische Formel B-1 dargestellt ist: 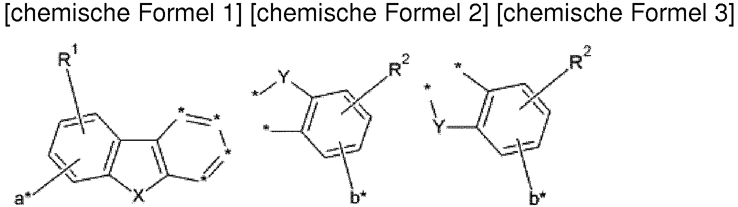 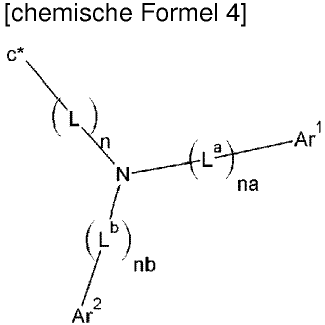
wobei in den chemischen Formeln 1 bis 4
X O, S, N(-d*), SO₂(O=S=O), PO(P=O) oder CO(C=O) ist,
Y O, S, SO₂(O=S=O), PO(P=O), CR'R" oder NR' ist,
R', R", R¹ und R² unabhängig voneinander Wasserstoff, Deuterium, ein Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiogruppe, eine substituierte oder unsubstituierte C6- bis C20-Arylthiolgruppe, eine substituierte oder unsubstituierte C1- bis C20-Heterocyclothiolgruppe, eine substituierte oder unsubstituierte C1- bis C20-Ureidgruppe, eine substituierte oder unsubstituierte C3- bis C40-Silylgruppe oder eine Kombination davon sind,
Ar¹ und Ar² unabhängig voneinander eine substituierte oder unsubstituierte C6- bis C30-Arylgruppe oder eine substituierte oder unsubstituierte C2- bis C30-Heteroarylgruppe sind,
L, L^{a} und L^{b} unabhängig voneinander eine Einfachbindung, eine substituierte oder unsubstituierte C2- bis C6-Alkenylengruppe, eine substituierte oder unsubstituierte C2- bis C6-Alkinylengruppe, eine substituierte oder unsubstituierte C6- bis C30-Arylengruppe, eine substituierte oder unsubstituierte Heteroarylengruppe oder eine Kombination davon sind,
n, na und nb unabhängig voneinander ganze Zahlen von 0 bis 3 sind,
die zwei benachbarten * der chemischen Formel 1 an die beiden benachbarten * der chemischen Formel 2 oder 3 gebunden sind, um einen kondensierten Ring zu bilden,
a* der chemischen Formel 1, d* der chemischen Formel 1 oder b* der chemischen Formel 2 oder 3 durch eine Sigma-Bindung mit c* der chemischen Formel 4 verbunden ist, und
die verbleibende Komponente a*, d* oder b*, die nicht an c* gebunden ist, Wasserstoff, Deuterium, ein Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1-bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycar-bonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiogruppe, eine substituierte oder unsubstituierte C6- bis C20-Arylthiolgruppe, eine substituierte oder unsubstituierte C1- bis C20-Heterocyclothiolgruppe, eine substituierte oder unsubstituierte C1- bis C20-Ureidgruppe, a substituierte oder unsubstituierte C3- bis C40-Silylgruppe oder eine Kombination davon ist: 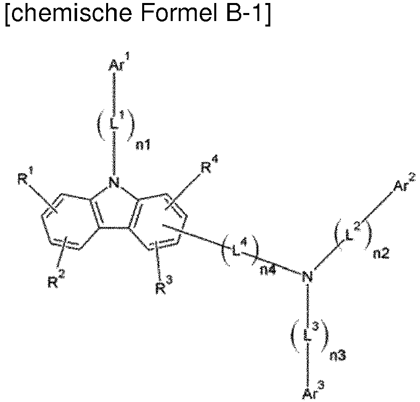
wobei in der chemischen Formel B-1
R¹ bis R⁴ unabhängig voneinander Wasserstoff, Deuterium, eine substituierte oder unsubstituierte C1- bis C10-Alkylgruppe, eine substituierte oder unsubstituierte C6- bis C30-Arylgruppe, eine substituierte oder unsubstituierte C2- bis C30-Heteroarylgruppe oder eine Kombination davon sind,
R¹ und R² unabhängig voneinander vorhanden oder miteinander verbunden sind, um einen kondensierten Ring zu bilden,
R³ und R⁴ unabhängig voneinander vorhanden oder miteinander verbunden sind, um einen kondensierten Ring zu bilden,
Ar¹ bis Ar³ unabhängig voneinander eine substituierte oder unsubstituierte C6- bis C30-Arylgruppe oder eine substituierte oder unsubstituierte C2- bis C30-Heteroarylgruppe sind,
L¹ bis L⁴ unabhängig voneinander eine substituierte oder unsubstituierte C2- bis C10-Alkenylengruppe, eine substituierte oder unsubstituierte C2- bis C10-Alkinylengruppe, eine substituierte oder unsubstituierte C6- bis C30-Arylengruppe, eine substituierte oder unsubstituierte C2- bis C30-Heteroarylengruppe oder eine Kombination davon sind, und
n1 bis n4 unabhängig ganze Zahlen von 0 bis 3 sind,
mit Ausnahme einer Kombination, bei der eine Lochtransportschicht eine Verbindung aufweist, die durch die folgende chemische Formel Z-1 dargestellt ist, und eine Lochtransportschicht eine Verbindung aufweist, die durch die folgende chemische Formel Z-2 dargestellt ist:

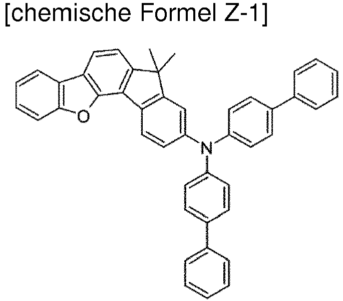

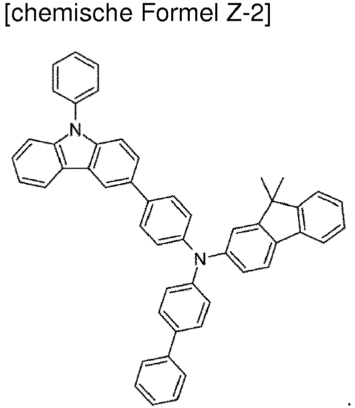

2. Organisches optoelektronisches Bauelement nach Anspruch 1, wobei die durch eine Kombination der chemischen Formel 1, der chemischen Formel 2 oder 3 und der chemischen Formel 4 dargestellte Verbindung durch eine Kombination der chemischen Formel 5 und der chemische Formel 4 dargestellt ist: 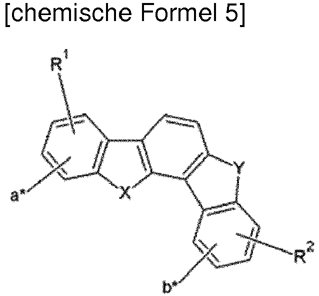 wobei in der chemischen Formel 5
X O, S, N (-d*), SO₂(O=S=O), PO(P=O) oder CO(C=O) ist,
Y O, S, SO₂(O=S=O), PO(P=O), CR'R"oder NR' ist,
R', R", R¹ und R² unabhängig voneinander Wasserstoff, Deuterium, ein Halogen, eine Cyanogruppe eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2 bis C20-Acyloxygruppe, a substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- C20-Sulfonylgruppe, eine substituierte oder unsubstituierte C1- C20-Alkylthiolgruppe, eine substituierte oder unsubstituierte C6- bis C20-Arylthiogruppe, eine substituierte oder unsubstituierte C1- bis - C20-Heterocyclothiolgruppe, a substituierte oder unsubstituierte C1- bis C20-Ureidgruppe, eine substituierte oder unsubstituierte C3- bis C40-Silylgruppe oder eine Kombination davon sind,
a* der chemischen Formel 5, d* der chemischen Formel 5 oder b* der chemischen Formel 5 mit c* der chemischen Formel 4 durch eine Sigma-Bindung verbunden sind, und
die verbleibende Komponente a*; d* oder b*, die nicht mit c* verbunden ist, Wasserstoff, Deuterium, ein Halogen, eine Cyanogruppe, eine Hydroxylgruppe, eine Aminogruppe, eine substituierte oder unsubstituierte C1-bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1-bis C20-Acylgruppe, eine substituierte oder unsubstituierte C2- bis C20-Alkoxycarbonylgruppe, eine substituierte oder unsubstituierte C2- bis C20-Acyloxygruppe, ein substituiertes oder unsubstituiertes C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiogruppe, eine substituierte oder unsubstituierte C6- bis C20-Arylthiolgruppe, eine substituierte oder unsubstituierte C1- bis C20-Heterocyclothiolgruppe, eine substituierte oder unsubstituierte C1- bis C20-Ureidgruppe, eine substituierte oder unsubstituierte C3- bis C40-Silylgruppe oder eine Kombination davon sind.

3. Organisches optoelektronisches Bauelement nach Anspruch 1 oder 2, wobei die durch eine Kombination der chemischen Formel 1, der chemischen Formel 2 oder 3 und der chemischen Formel 4 dargestellte Verbindung durch eine der folgenden chemischen Formel 6 bis 10 dargestellt ist: 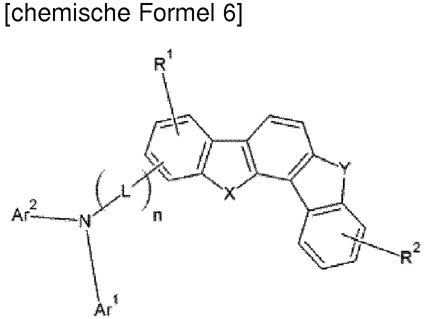 wobei in der chemischen Formel 6
X O, S, SO₂(O=S=O), PO (P=O) oder CO(C=O) ist,
Y O, S, SO₂(O=S=O), PO (P=O), CR'R" oder NR' ist,
R', R", R¹ und R² unabhängig voneinander Wasserstoff, Deuterium, ein Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiolgruppe, eine substituierte oder unsubstituierte C6- bis C20-Arylthiolgruppe, eine substituierte oder unsubstituierte C1- bis C20-Heterocyclothiolgruppe, eine substituierte oder unsubstituierte C1- bis C20-Ureidgruppe, eine substituierte oder unsubstituierte C3- bis C40-Silylgruppe oder eine Kombination davon sind,
Ar¹ und Ar² unabhängig voneinander eine substituierte oder unsubstituierte C6- bis C30-Arylgruppe oder eine substituierte oder unsubstituierte C2- bis C30-Heteroarylgruppe sind,
L eine Einfachbindung, eine substituierte oder unsubstituierte C2- bis C6-Alkenylengruppe, eine substituierte oder unsubstituierte C2- bis C6-Alkinylengruppe, eine substituierte oder unsubstituierte C6- bis C30-Arylengruppe, eine substituierte oder unsubstituierte Heteroarylengruppe oder eine Kombination davon ist, und
n eine ganze Zahl von 0 bis 3 ist. 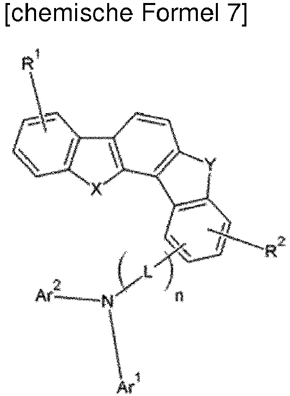
wobei in der chemischen Formel 7
X O, S, SO₂(O=S=O), PO (P=O) oder CO(C=O) ist,
Y O, S, SO₂(O=S=O), PO (P=O), CR'R" oder NR' ist,
R', R", R¹ und R² unabhängig voneinander Wasserstoff, Deuterium, ein Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiolgruppe, eine substituierte oder unsubstituierte C6- bis C20-Arylthiolgruppe, eine substituierte oder unsubstituierte C1- bis C20-Heterocyclothiolgruppe, eine substituierte oder unsubstituierte C1- bis C20-Ureidgruppe, eine substituierte oder unsubstituierte C3- bis C40-Silylgruppe oder eine Kombination davon sind,
Ar¹ und Ar² unabhängig voneinander eine substituierte oder unsubstituierte C6- bis C30-Arylgruppe oder eine substituierte oder unsubstituierte C2- bis C30-Heteroarylgruppe sind,
L eine Einfachbindung, eine substituierte oder unsubstituierte C2- bis C6-Alkenylengruppe, eine substituierte oder unsubstituierte C2- bis C6-Alkinylengruppe, eine substituierte oder unsubstituierte C6- bis C30-Arylengruppe, eine substituierte oder unsubstituierte Heteroarylengruppe oder eine Kombination davon ist, und
n ist eine ganze Zahl von 0 bis 3 ist. 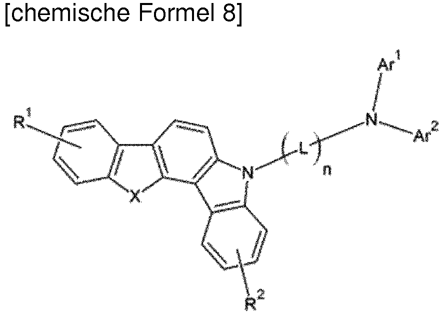
wobei in der chemischen Formel 8
X O, S, SO₂(O=S=O), PO (P=O), CR'R" oder NR' ist,
R', R", R¹ und R² unabhängig voneinander Wasserstoff, Deuterium, ein Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiolgruppe, eine substituierte oder unsubstituierte C6- bis C20-Arylthiolgruppe, eine substituierte oder unsubstituierte C1- bis C20-Heterocyclothiolgruppe, eine substituierte oder unsubstituierte C1- bis C20-Ureidgruppe, eine substituierte oder unsubstituierte C3- bis C40-Silylgruppe oder eine Kombination davon sind,
Ar¹ und Ar² unabhängig voneinander eine substituierte oder unsubstituierte C6- bis C30-Arylgruppe oder eine substituierte oder unsubstituierte C2- bis C30-Heteroarylgruppe sind,
L eine Einfachbindung, eine substituierte oder unsubstituierte C2- bis C6-Alkenylengruppe, eine substituierte oder unsubstituierte C2- bis C6-Alkinylengruppe, eine substituierte oder unsubstituierte C6- bis C30-Arylengruppe, eine substituierte oder unsubstituierte Heteroarylengruppe oder eine Kombination davon ist, und
n ist eine ganze Zahl von 0 bis 3 ist. 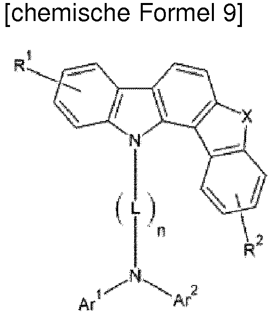
wobei in der chemischen Formel 9
X O, S, SO₂(O=S=O), PO (P=O), CR'R" oder NR' ist,
R', R", R1 und R2 unabhängig voneinander Wasserstoff, Deuterium, ein Halogen, eine Cyanogruppe, eine Hydroxylgruppe, eine Aminogruppe, eine substituierte oder unsubstituierte C1-bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiolgruppe, eine substituierte oder unsubstituierte C6- bis C20-Arylthiolgruppe, eine substituierte oder unsubstituierte C1- bis C20-Heterocyclothiolgruppe, eine substituierte oder unsubstituierte C1- bis C20-Ureidgruppe, eine substituierte oder unsubstituierte C3- bis C40-Silylgruppe oder eine Kombination davon sind,
Ar¹ und Ar² unabhängig voneinander eine substituierte oder unsubstituierte C6- bis C30-Arylgruppe oder eine substituierte oder unsubstituierte C2- bis C30-Heteroarylgruppe sind,
L eine Einfachbindung, eine substituierte oder unsubstituierte C2- bis C6-Alkenylengruppe, eine substituierte oder unsubstituierte C2- bis C6-Alkinylengruppe, eine substituierte oder unsubstituierte C6- bis C30-Arylengruppe, eine substituierte oder unsubstituierte Heteroarylengruppe oder eine Kombination davon ist, und
n eine ganze Zahl von 0 bis 3 ist. 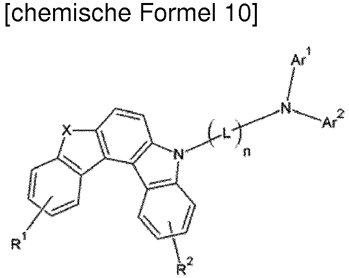
wobei in der chemischen Formel 10
X O, S, SO₂(O=S=O), PO (P=O), CR'R" oder NR' ist,
R', R", R¹ und R² unabhängig voneinander Wasserstoff, Deuterium, ein Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiolgruppe, eine substituierte oder unsubstituierte C6- bis C20-Arylthiolgruppe, eine substituierte oder unsubstituierte C1- bis C20-Heterocyclothiolgruppe, eine substituierte oder unsubstituierte C1- bis C20-Ureidgruppe, eine substituierte oder unsubstituierte C3- bis C40-Silylgruppe oder eine Kombination davon sind,
Ar¹ und Ar² unabhängig voneinander eine substituierte oder unsubstituierte C6- bis C30-Arylgruppe oder eine substituierte oder unsubstituierte C2- bis C30-Heteroarylgruppe sind,
L eine Einfachbindung, eine substituierte oder unsubstituierte C2- bis C6-Alkenylengruppe, eine substituierte oder unsubstituierte C2- bis C6-Alkinylengruppe, eine substituierte oder unsubstituierte C6- bis C30-Arylengruppe, eine substituierte oder unsubstituierte Heteroarylengruppe oder eine Kombination davon ist, und
n ist eine ganze Zahl von 0 bis 3.

4. Organisches optoelektronisches Bauelement nach einem der Ansprüche 1 bis 3, wobei R', R", R¹ und R² unabhängig voneinander Wasserstoff, Deuterium, eine substituierte oder unsubstituierte Methylgruppe, eine substituierte oder unsubstituierte Ethylgruppe, eine substituierte oder unsubstituierte Propylgruppe, eine substituierte oder unsubstituierte Phenylgruppe, eine substituierte oder unsubstituierte Biphenylgruppe, eine substituierte oder unsubstituierte Naphthylgruppe, eine substituierte oder unsubstituierte Anthracenylgruppe, eine substituierte oder unsubstituierte Phenanthrenylgruppe oder eine substituierte oder unsubstituierte C3- bis C40-Silylgruppe sind.

5. Organisches optoelektronisches Bauelement nach einem der Ansprüche 1 bis 4, wobei die Komponenten Ar¹ und Ar² der chemischen Formel 4 unabhängig voneinander eine substituierte oder unsubstituierte Phenylgruppe, eine substituierte oder unsubstituierte Biphenylgruppe, eine substituierte oder unsubstituierte Fluorenylgruppe, ein substituiertes oder unsubstituiertes Benzofuran, eine substituierte oder unsubstituierte Benzothiophenylgruppe, eine substituierte oder unsubstituierte Dibenzofuranylgruppe oder eine substituierte oder unsubstituierte Dibenzothiophenylgruppe sind, und/oder
wobei Ar¹ der chemischen Formel B-1 eine substituierte oder unsubstituierte Phenylgruppe, eine substituierte oder unsubstituierte Biphenylgruppe ist, und Ar² und Ar³ unabhängig voneinander eine substituierte oder unsubstituierte Phenylgruppe, eine substituierte oder unsubstituierte Biphenylgruppe, eine substituierte oder unsubstituierte Fluorengruppe, eine substituierte oder unsubstituierte Bisfluorengruppe, eine substituierte oder unsubstituierte Triphenylengruppe, eine substituierte oder unsubstituierte Anthracengruppe, eine substituierte oder unsubstituierte Terphenylgruppe, eine substituierte oder unsubstituierte Dibenzofurangruppe oder eine substituierte oder unsubstituierte Dibenzothiophenylgruppe sind.

6. Organisches optoelektronisches Bauelement nach einem der Ansprüche 1 bis 5, wobei das organische optoelektronische Bauelement eine organische photoelektrische Vorrichtung, eine organische Leuchtdiode, eine organische Solarzelle, ein organischer Transistor, ein organischer Fotoleiter oder eine organische Speichervorrichtung ist.

7. Anzeigevorrichtung mit dem organischen optoelektronischen Bauelement nach einem der Ansprüche 1 bis 6.

## Revendications

1. Dispositif optoélectronique organique comprenant
une anode, une cathode et au moins une couche mince organique intercalée entre l'anode et la cathode,
dans laquelle la couche mince organique comprend une couche d'émission et une pluralité de couches de transport de trous,
la couche de transport de trous de la pluralité de couches de transport de trous en contact avec la couche d'émission comprend un composé représenté par une combinaison des Formule Chimique 1 ; Formule Chimique 2 ou 3 ; et Formule Chimique 4 suivantes, et
une des couches de transport de trous qui n'est pas en contact avec la couche d'émission comprend un composé représenté par la Formule Chimique B-1 suivante: 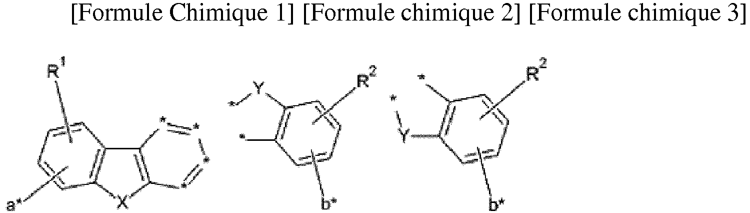 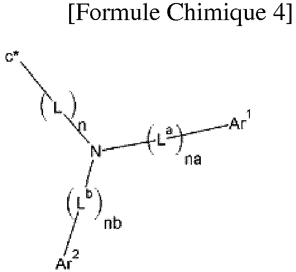 où, dans les Formules Chimiques 1 à 4,
X est O, S, N(-d*), SO₂(O=S=O), PO (P=O), ou CO (C=O),
Y est O, S, SO₂(O=S=O), PO (P=O), CR'R" ou NR',
R', R", R¹ et R² sont indépendamment hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci,
Ar¹ et Ar² sont indépendamment un groupement aryle en C6 à C30 substitué ou non-substitué ou un groupement hétéroaryle en C2 à C30 substitué ou non-substitué,
L, L^{a} et L^{b} sont indépendamment, une simple liaison, un groupement alcénylène en C2 à C6 substitué ou non-substitué, un groupement alcynylène en C2 à C6 substitué ou non-substitué, un groupement arylène en C6 à C30 substitué ou non-substitué, un groupement hétéroarylène substitué ou non-substitué, ou une combinaison de ceux-ci,
n, na, nb, sont indépendamment des entiers allant de 0 à 3,
les deux *'s adjacentes de la Formule Chimique 1 sont liées aux deux *'s adjacentes des Formules Chimiques 2 ou 3 pour former un cycle fusionné,
a* de la Formule Chimique 1, d* de la Formule Chimique 1 ou b* des Formules Chimiques 2 ou 3 est lié à c* de la Formule Chimique 4 par une liaison sigma, et
le a* ; d* ou b* restant qui n'est pas lié à c* est hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci : 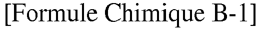 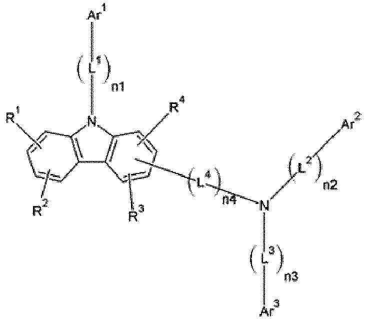
où, dans la Formule Chimique B-1,
R¹ à R⁴ sont indépendamment, hydrogène, deutérium, un groupement alkyle en C1 à C10 substitué ou non-substitué, un groupement aryle en C6 à C30 substitué ou non-substitué, un groupement hétéroaryle en C2 à C30 substitué ou non-substitué, ou une combinaison de ceux-ci,
R¹ et R² sont indépendamment présents ou liés entre eux pour former un cycle fusionné,
R³ et R⁴ sont indépendamment présents ou liés entre eux pour former un cycle fusionné,
Ar¹ à Ar³ sont indépendamment un groupement aryle en C6 à C30 substitué ou non-substitué, ou un groupement hétéroaryle en C2 à C30 substitué ou non-substitué,
L¹ à L⁴ sont indépendamment un groupement alcénylène en C2 à C10 substitué ou non-substitué, un groupement alcynylène en C2 à C10 substitué ou non-substitué, un groupement arylène en C6 à C30 substitué ou non-substitué, un groupement hétéroarylène en C2 à C30 substitué ou non-substitué, ou une combinaison de ceux-ci, et
n1 à n4 sont indépendamment des entiers allant de 0 à 3,
excepté une combinaison, dans laquelle une couche de transport de trous comprend un composé représenté par la Formule Chimique Z-1 suivante et une couche de transport de trous comprend un composé représenté par la Formule Chimique Z-2 suivante:

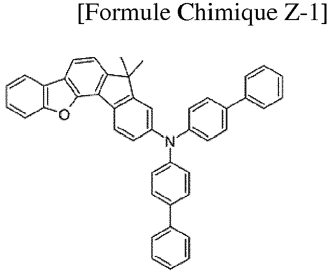

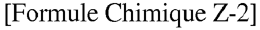

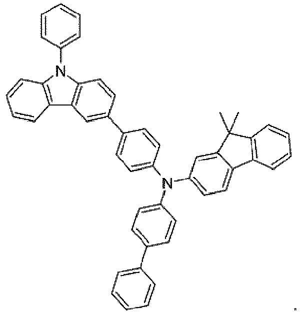

2. Dispositif optoélectronique organique selon la revendication 1, dans lequel le composé représenté par une combinaison des Formule Chimique 1 ; Formule Chimique 2 ou 3 ; et Formule Chimique 4 est représenté par une combinaison de la Formule Chimique 5 suivante et de la Formule Chimique 4 : 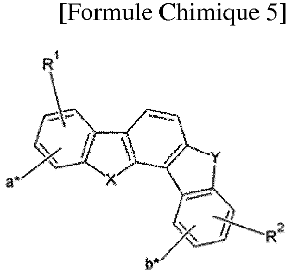 où, dans la Formule Chimique 5,
X est O, S, N(-d*), SO₂(O=S=O), PO (P=O), ou CO (C=O),
Y est O, S, SO₂(O=S=O), PO (P=O), CR'R" ou NR',
R', R", R¹ et R² sont indépendamment hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci,
a* de la Formule Chimique 5, d* de la Formule Chimique 5 ou b* de la Formule Chimique 5 est lié à c* de la Formule Chimique 4 par une liaison sigma, et
le a* ; d* ou b* restant qui n'est pas lié à c* est hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci.

3. Dispositif optoélectronique organique selon la revendication 1 ou la revendication 2, dans lequel le composé représenté par une combinaison des Formule Chimique 1 ; Formule Chimique 2 ou 3 ; et Formule Chimique 4 est représenté par l'une quelconque des Formules Chimiques 6 à 10 suivantes : 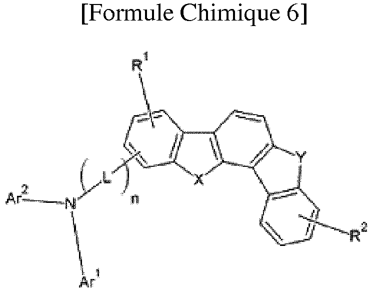 où, dans la Formule Chimique 6,
X est O, S, SO₂(O=S=O), PO (P=O), ou CO (C=O),
Y est O, S, SO₂(O=S=O), PO (P=O), CR'R" ou NR',
R', R", R¹ et R² sont indépendamment hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci,
Ar¹ et Ar² sont indépendamment un groupement aryle en C6 à C30 substitué ou non-substitué, ou un groupement hétéroaryle en C2 à C30 substitué ou non-substitué,
L est une simple liaison, un groupement alcénylène en C2 à C6 substitué ou non-substitué, un groupement alcynylène en C2 à C6 substitué ou non-substitué, un groupement arylène en C6 à C30 substitué ou non-substitué, un groupement hétéroarylène substitué ou non-substitué, ou une combinaison de ceux-ci,
n est un entier allant de 0 à 3. 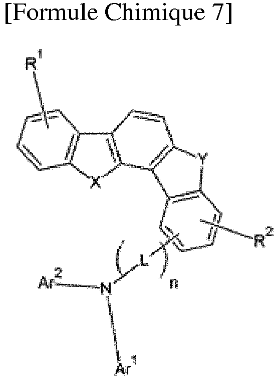
où, dans la Formule Chimique 7,
X est O, S, SO₂(O=S=O), PO (P=O), ou CO (C=O),
Y est O, S, SO₂(O=S=O), PO (P=O), CR'R" ou NR',
R', R", R¹ et R² sont indépendamment hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci,
Ar¹ et Ar² sont indépendamment un groupement aryle en C6 à C30 substitué ou non-substitué, ou un groupement hétéroaryle en C2 à C30 substitué ou non-substitué,
L est une simple liaison, un groupement alcénylène en C2 à C6 substitué ou non-substitué, un groupement alcynylène en C2 à C6 substitué ou non-substitué, un groupement arylène en C6 à C30 substitué ou non-substitué, un groupement hétéroarylène substitué ou non-substitué, ou une combinaison de ceux-ci,
n est un entier allant de 0 à 3. 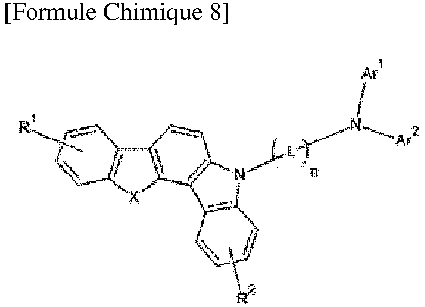
où, dans la Formule Chimique 8,
X est O, S, SO₂(O=S=O), PO (P=O), CR'R" ou NR',
R', R", R¹ et R² sont indépendamment hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci,
Ar¹ et Ar² sont indépendamment un groupement aryle en C6 à C30 substitué ou non-substitué, ou un groupement hétéroaryle en C2 à C30 substitué ou non-substitué,
L est une simple liaison, un groupement alcénylène en C2 à C6 substitué ou non-substitué, un groupement alcynylène en C2 à C6 substitué ou non-substitué, un groupement arylène en C6 à C30 substitué ou non-substitué, un groupement hétéroarylène substitué ou non-substitué, ou une combinaison de ceux-ci,
n est un entier allant de 0 à 3. 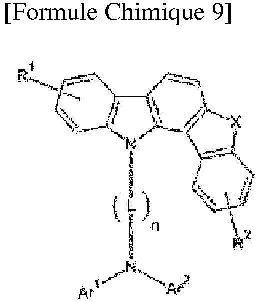
où, dans la Formule Chimique 9,
X est O, S, SO₂(O=S=O), PO (P=O), CR'R" ou NR',
R', R", R¹ et R² sont indépendamment hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci,
Ar¹ et Ar² sont indépendamment un groupement aryle en C6 à C30 substitué ou non-substitué, ou un groupement hétéroaryle en C2 à C30 substitué ou non-substitué,
L est une simple liaison, un groupement alcénylène en C2 à C6 substitué ou non-substitué, un groupement alcynylène en C2 à C6 substitué ou non-substitué, un groupement arylène en C6 à C30 substitué ou non-substitué, un groupement hétéroarylène substitué ou non-substitué, ou une combinaison de ceux-ci,
n est un entier allant de 0 à 3. 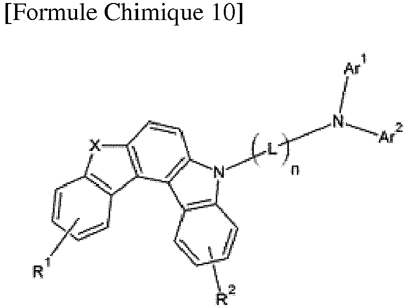
où, dans la Formule Chimique 10,
X est O, S, SO₂(O=S=O), PO (P=O), CR'R" ou NR',
R', R", R¹ et R² sont indépendamment hydrogène, deutérium, un halogène, un groupement cyano, un groupement hydroxyle, un groupement amino, un groupement amine en C1 à C20 substitué ou non-substitué, un groupement nitro, un groupement carboxyle, un groupement ferrocényle, un groupement alkyle en C1 à C20 substitué ou non-substitué, un groupement aryle en C6 à C30 substitué ou non-substitué, un groupement hétéroaryle en C2 à C30 substitué ou non-substitué, un groupement alcoxy en C1 à C20 substitué ou non-substitué, un groupement aryloxy en C6 à C20 substitué ou non-substitué, un groupement silyloxy en C3 à C40 substitué ou non-substitué, un groupement acyle en C1 à C20 substitué ou non-substitué, un groupement alcoxycarbonyle en C2 à C20 substitué ou non-substitué, un groupement acyloxy en C2 à C20 substitué ou non-substitué, un groupement acylamino en C2 à C20 substitué ou non-substitué, un groupement alcoxycarbonylamino en C2 à C20 substitué ou non-substitué, un groupement aryloxycarbonylamino en C7 à C20 substitué ou non-substitué, un groupement sulfamoylamino en C1 à C20 substitué ou non-substitué, un groupement sulfonyle en C1 à C20 substitué ou non-substitué, un groupement alkylthiol en C1 à C20 substitué ou non-substitué, un groupement arylthiol en C6 à C20 substitué ou non-substitué, un groupement hétérocyclothiol en C1 à C20 substitué ou non-substitué, un groupement uréide en C1 à C20 substitué ou non-substitué, un groupement silyle en C3 à C40 substitué ou non-substitué, ou une combinaison de ceux-ci,
Ar¹ et Ar² sont indépendamment un groupement aryle en C6 à C30 substitué ou non-substitué, ou un groupement hétéroaryle en C2 à C30 substitué ou non-substitué,
L est une simple liaison, un groupement alcénylène en C2 à C6 substitué ou non-substitué, un groupement alcynylène en C2 à C6 substitué ou non-substitué, un groupement arylène en C6 à C30 substitué ou non-substitué, un groupement hétéroarylène substitué ou non-substitué, ou une combinaison de ceux-ci,
n est un entier allant de 0 à 3.

4. Dispositif optoélectronique organique selon l'une quelconque des revendications 1 à 3, dans lequel R', R", R¹ et R² sont indépendamment hydrogène, deutérium, un groupement méthyle substitué ou non-substitué, un groupement éthyle substitué ou non-substitué, un groupement phényle substitué ou non-substitué, un groupement biphényle substitué ou non-substitué, un groupement naphtyle substitué ou non-substitué, un groupement anthracényle substitué ou non-substitué, un groupement phénanthrényle substitué ou non-substitué, un groupement sylile substitué ou non-substitué en C3 à C40.

5. Dispositif optoélectronique organique selon l'une quelconque des revendications 1 à 4, dans lequel Ar¹ et Ar² de la Formule Chimique 4 sont indépendamment, un groupement phényle substitué ou non-substitué, un groupement biphényle substitué ou non-substitué, un groupement fluorényle substitué ou non-substitué, un groupement benzofurane substitué ou non-substitué, un groupement benzothiophényle substitué ou non-substitué, un groupement dibenzofuranyle substitué ou non-substitué, un groupement dibenzothiophényle substitué ou non-substitué, et/ou
dans lequel Ar¹ de la Formule Chimique B-1 est un groupement phényle substitué ou non-substitué, un groupement biphényle substitué ou non-substitué, et Ar² et Ar³ de la Formule Chimique 4 sont indépendamment un d'un groupement phényle substitué ou non-substitué, un groupement biphényle substitué ou non-substitué, un groupement fluorène substitué ou non-substitué, un groupement bisfluorène substitué ou non-substitué, un groupement triphénylène substitué ou non-substitué, un groupement anthracène substitué ou non-substitué, un groupement terphényle substitué ou non-substitué, un groupement dibenzofurane substitué ou non-substitué, et un groupement phényle substitué ou non-substitué, un groupement dibenzothiophényle substitué ou non-substitué.

6. Dispositif optoélectronique organique selon l'une quelconque des revendications 1 à 5, dans lequel le dispositif optoélectronique organique est un dispositif organique photoélectrique, une diode électroluminescente organique, une cellule photovoltaïque organique, un transistor organique, un photoconducteur organique, ou un dispositif de stockage organique.

7. Dispositif d'affichage comprenant le dispositif optoélectronique organique selon l'une quelconque des revendications 1 à 6.
